(19) Europäisches Patentamt
European Patent Office
Office européen des brevets

(11) EP 3 887 479 B1

(12) # EUROPÄISCHE PATENTSCHRIFT

(45) Veröffentlichungstag und Bekanntmachung des Hinweises auf die Patenterteilung:
**03.08.2022 Patentblatt 2022/31**

(21) Anmeldenummer: **19812736.7**

(22) Anmeldetag: **26.11.2019**

(51) Internationale Patentklassifikation (IPC):
***C09K 11/06*** *(2006.01)* ***C07D 413/00*** *(2006.01)*
***C07D 471/10*** *(2006.01)* ***H01L 51/50*** *(2006.01)*
***H01L 51/00*** *(2006.01)*

(52) Gemeinsame Patentklassifikation (CPC):
**C09K 11/06; H01L 51/008;** C09K 2211/1007; C09K 2211/1011; C09K 2211/1014; C09K 2211/1029; C09K 2211/1033; C09K 2211/1037; C09K 2211/1074; C09K 2211/1096; H01L 51/5012; H01L 51/5072

(86) Internationale Anmeldenummer:
**PCT/EP2019/082504**

(87) Internationale Veröffentlichungsnummer:
**WO 2020/109269 (04.06.2020 Gazette 2020/23)**

(54) **ELEKTRONISCHE VORRICHTUNG**
ELECTRONIC DEVICE
DISPOSITIF ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.11.2018 EP 18209047**

(43) Veröffentlichungstag der Anmeldung:
**06.10.2021 Patentblatt 2021/40**

(73) Patentinhaber: **Merck Patent GmbH**
**64293 Darmstadt (DE)**

(72) Erfinder:
- **ENGELHART, Jens**
**64285 DARMSTADT (DE)**
- **MEYER, Sebastian**
**60594 FRANKFURT AM MAIN (DE)**
- **LACKNER, Aaron**
**68165 MANNHEIM (DE)**
- **RODRIGUEZ, Lara-Isabel**
**64285 DARMSTADT (DE)**
- **ANÉMIAN, Rémi Manouk**
**60318 FRANKFURT AM MAIN (DE)**
- **MAIER-FLAIG, Florian**
**69469 WEINHEIM (DE)**

(56) Entgegenhaltungen:
**WO-A1-2018/069167**
**WO-A1-2018/095394**
**CN-A- 108 610 357**
**KR-A- 20170 113 426**
**US-A1- 2018 069 182**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 887 479 B1

## Beschreibung

Die vorliegende Anmeldung betrifft eine elektronische Vorrichtung, die emittierende Verbindungen eines bestimmten Strukturtyps in einer emittierenden Schicht enthält, und die bestimmte Fluorenyl- oder Spirobifluorenyl-Verbindungen in einer anderen Schicht enthält. Die andere Schicht ist bevorzugt eine elektronentransportierende Schicht.

Unter elektronischen Vorrichtungen im Sinne dieser Anmeldung werden sogenannte organische elektronische Vorrichtungen verstanden (organic electronic devices), welche organische Halbleitermaterialien als Funktionsmaterialien enthalten. Insbesondere werden darunter OLEDs (organische Elektrolumineszenzvorrichtungen) verstanden. Unter der Bezeichnung OLEDs werden elektronische Vorrichtungen verstanden, die eine oder mehrere Schichten enthaltend organische Verbindungen aufweisen und unter Anlegen von elektrischer Spannung Licht emittieren. Der Aufbau und das allgemeine Funktionsprinzip von OLEDs sind dem Fachmann bekannt.

Bei elektronischen Vorrichtungen, insbesondere OLEDs, besteht unverändert großes Interesse an einer Verbesserung der Leistungsdaten.

Als Materialien für elektronentransportierende Schichten in elektronischen Vorrichtungen sind eine Vielzahl unterschiedlicher Materialien bekannt. Eine wichtige Stoffklasse sind Verbindungen, die eine Gruppe gewählt aus Spirobifluoren und Fluoren, und eine Gruppe gewählt aus elektronenarmen stickstoffhaltigen Heteroaromaten, insbesondere Triazin und Pyrimidin, aufweisen.

Als emittierende Verbindungen in elektronischen Vorrichtungen sind ebenfalls eine Vielzahl unterschiedlicher Verbindungen bekannt. Im Wesentlichen werden für diese Verwendung fluoreszierende Verbindungen eingesetzt, beispielsweise Indenofluorenamin-Derivate, oder phosphoreszierende Verbindungen, die üblicherweise gewählt sind aus Übergangsmetallkomplexen mit organometallischer Bindung, insbesondere Iridiumkomplexen wie $Ir(PPy)_3$ (Tris[2-phenylpyridinato-$C^2$,*N*]iridium(III)). Als fluoreszierende Verbindungen wurden auch verbrückte Triarylbor-Verbindungen mit bestimmter Struktur eingesetzt. Für diese Verbindungen wurde in bestimmten Aufbauten eine hohe externe Quanteneffizienz bei der Verwendung als Emitter in OLEDs gefunden.

Es besteht daher ein großes Interesse daran, diese Verbindungen in geeigneter Weise mit anderen Verbindungen in anderen Schichten der elektronischen Vorrichtung zu kombinieren, um gute Eigenschaften der elektronischen Vorrichtung zu erzielen, insbesondere in Bezug auf Lebensdauer, Effizienz, Betriebsspannung, geringer Roll-off und schmale Emissionsbande, d.h. eine Emissionsbande mit einer möglichst kleinen Halbwertsbreite.

Es wurde nun gefunden, dass die Kombination der oben genannten Triarylbor-Derivate in einer emittierenden Schicht mit bestimmten Spirobifluorenyl-Derivaten und Fluorenyl-Derivaten in einer anderen Schicht zu besonders guten Eigenschaften der elektronischen Vorrichtung führt. Insbesondere wurden lange Lebensdauer, hohe Effizienz, niedrige Betriebsspannung, geringer Roll-off und Emission mit möglichst geringer Halbwertsbreite als vorteilhafte Eigenschaften gefunden.

Gegenstand der vorliegenden Erfindung ist damit eine elektronische Vorrichtung, enthaltend eine erste Elektrode, eine zweite Elektrode, und dazwischen angeordnet

- eine emittierende Schicht, enthaltend eine Verbindung einer Formel (EM-1),

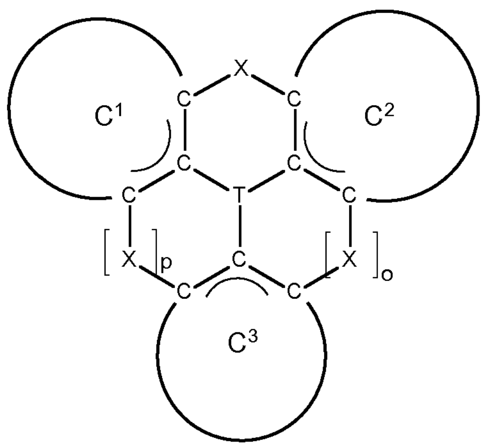

Formel (EM-1),

für die gilt:

T ist B, P, P(=O) oder $SiR^{E1}$;

X ist bei jedem Auftreten gleich oder verschieden gewählt aus O, S, $NR^{E2}$ und $C(R^{E2})_2$, wobei mindestens ein X vorhanden sein muss, das gewählt ist aus O, S und $NR^{E2}$;

$C^1$, $C^2$ und $C^3$ sind gleich oder verschieden gewählt aus Ringsystemen mit 5 bis 40 Ringatomen, die mit Resten $R^{E3}$ substituiert sind;

$R^{E1}$ ist gewählt aus H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit Resten $R^{E4}$ substituiert sind; und wobei eine oder mehrere $CH_2$-Gruppen in den genannten Alkyl-, Alkoxy-, Alkenyl- und Alkinylgruppen durch $-R^{E4}C=CR^{E4}-$, $-C\equiv C-$, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO oder $SO_2$ ersetzt sein können;

$R^{E2}$ ist bei jedem Auftreten gleich oder verschieden gewählt aus H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit Resten $R^{E4}$ substituiert sind; und wobei eine oder mehrere $CH_2$-Gruppen in den genannten Alkyl-, Alkoxy-, Alkenyl- und Alkinylgruppen durch $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO oder $SO_2$ ersetzt sein können; wobei zwei oder mehr Reste $R^{E2}$ miteinander verknüpft sein können und einen Ring bilden können, und wobei ein oder mehrere Reste $R^{E2}$ über ihre Reste $R^{E4}$ mit einem Ring gewählt aus $C^1$, $C^2$ und $C^3$ verknüpft sein können und einen Ring bilden können;

$R^{E3}$ ist bei jedem Auftreten gleich oder verschieden gewählt aus H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^{E3}$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^{E4}$ substituiert sind; und wobei eine oder mehrere $CH_2$-Gruppen in den genannten Alkyl-, Alkoxy-, Alkenyl- und Alkinylgruppen durch $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO oder $SO_2$ ersetzt sein können;

$R^{E4}$ ist bei jedem Auftreten gleich oder verschieden gewählt aus H, D, F, Cl, Br, I, $C(=O)R^{E5}$, CN, $Si(R^{E5})_3$, $N(R^{E5})_2$, $P(=O)(R^{E5})_2$, $OR^{E5}$, $S(=O)R^{E5}$, $S(=O)_2R^{E5}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^{E4}$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^{E5}$ substituiert sind; und wobei eine oder mehrere $CH_2$-Gruppen in den genannten Alkyl-, Alkoxy-, Alkenyl- und Alkinylgruppen durch $-R^{E5}C=CR^{E5}-$, -C=C-, $Si(R^{E5})_2$, C=O, $C=NR^{E5}$, -C(=O)O-, $-C(=O)NR^{E5}-$, $NR^{E5}$, $P(=O)(R^{E5})$, -O-, -S-, SO oder $SO_2$ ersetzt sein können;

$R^{E5}$ ist bei jedem Auftreten gleich oder verschieden gewählt aus H, D, F, Cl, Br, I, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^{E5}$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können;

o und p sind gleich oder verschieden 0 oder 1, wobei p=0 bzw. o = 0 bedeutet, dass die mit p bzw. o indizierte Gruppe X zusammen mit ihren Bindungen an die Ringe $C^1$, $C^2$ bzw. $C^3$ wegfällt;

- eine Schicht E, die zwischen der emittierenden Schicht und der zweiten Elektrode angeordnet ist, und die eine Verbindung einer Formel (E-1) enthält

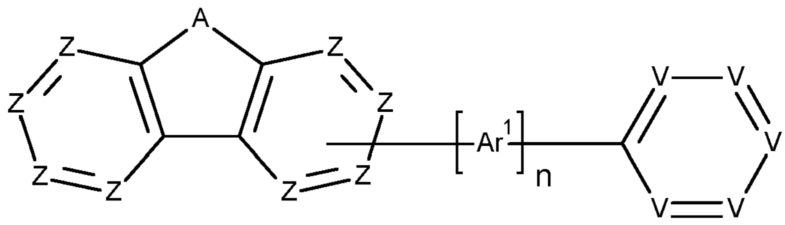

Formel (E-1),

wobei

A gleich

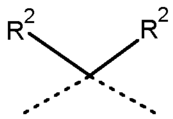

,

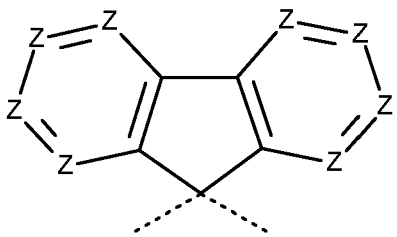

,

O oder S ist, wobei die gestrichelten Bindungen die Bindungen von A zum Rest der Formel kennzeichnen;

Z, wenn keine Gruppe

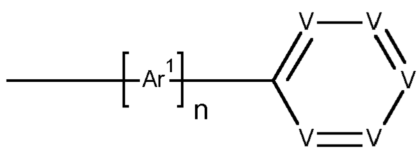

daran gebunden ist, bei jedem Auftreten gleich oder verschieden gewählt ist aus N und $CR^1$,

und wenn eine Gruppe

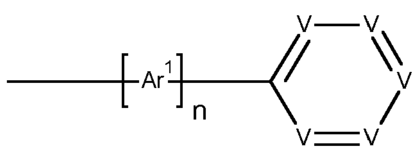

daran gebunden ist, gleich C ist;

V bei jedem Auftreten gleich oder verschieden gewählt ist aus N und $CR^4$, wobei mindestens zwei Gruppen V im Ring gleich N sein müssen;

$Ar^1$ bei jedem Auftreten gleich oder verschieden gewählt ist aus aromatischen Ringsystemen mit 6 bis 40 aromatischen Ringatomen, die mit Resten $R^3$ substituiert sind, und heteroaromatischen Ringsystemen mit 5

bis 40 aromatischen Ringatomen, die mit Resten $R^3$ substituiert sind;

$R^1$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^1$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^2$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^2$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, $-C\equiv C-$, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^3$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^3$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, $-C\equiv C-$, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^4$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^4$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^5$ ist bei jedem Auftreten gleich oder verschieden gewählt aus H, D, F, Cl, Br, I, $C(=O)R^6$, CN, $Si(R^6)_3$, $N(R^6)_2$, $P(=O)(R^6)_2$, $OR^6$, $S(=O)R^6$, $S(=O)_2R^6$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^5$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^6$ substituiert sind; und wobei eine oder mehrere $CH_2$-Gruppen in den genannten Alkyl-, Alkoxy-, Alkenyl- und Alkinylgruppen durch $-R^6C=CR^6-$, $-C\equiv C-$, $Si(R^6)_2$, C=O, $C=NR^6$, -C(=O)O-, $-C(=O)NR^6-$ , $NR^6$, $P(=O)(R^6)$, -O-, -S-, SO oder $SO_2$ ersetzt sein können;

$R^6$ ist bei jedem Auftreten gleich oder verschieden gewählt aus H, D, F, Cl, Br, I, CN, Alkyl- oder Alkoxygruppen

mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^6$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können;

n gleich 0, 1, 2, 3, oder 4 ist.

Die Gruppen "C" in Formel (EM-1) kennzeichnen Kohlenstoffatome, die Teil der Ringsysteme $C^1$, $C^2$ bzw. $C^3$ sind. Der Bogen zwischen den C-Atomen kennzeichnet, dass Doppelbindungen in der Weise vorliegen, dass alle C-Atome jeweils vier Bindungen und jeweils drei an sie gebundene Gruppen aufweisen.

Im Fall von n=0 ist die Gruppe $Ar^1$ nicht vorhanden und die beiden Gruppen, die in Formel (E-1) an die Gruppe $Ar^1$ binden, sind direkt miteinander verbunden. Im Fall von n=2, 3, bzw. 4 sind 2, 3, bzw. 4 Gruppen $Ar^1$ hintereinander gebunden. WO 2018/069167 A1 offenbart eine elektronische Vorrichtung enthaltend eine Verbindung der Formel (E-1). WO 2018/095394 A1 offenbart eine elektronische Vorrichtung enthaltend eine Verbindung gemäß der Formel (ETM-1).

Die folgenden Definitionen gelten für die chemischen Gruppen, die in der vorliegenden Anmeldung verwendet werden. Sie gelten, soweit keine spezielleren Definitionen angegeben sind.

Unter dem Begriff "Ringsystem" werden beliebige Ringe verstanden, die Einzelringe sein können, oder ein System enthaltend mehrere miteinander kondensierte Einzelringe, wie es zum Beispiel beim Decalin oder Fluoren auftritt. Die Ringe können dabei gleich oder verschieden aliphatisch, heteroaliphatisch, aromatisch oder heteroaromatisch sein. Die Ringatome können gewählt sein aus Kohlenstoff und Heteroatomen, insbesondere C, O, S, Si, B, P und N.

Unter einer Arylgruppe im Sinne dieser Erfindung wird entweder ein einzelner aromatischer Cyclus, also Benzol, oder ein kondensierter aromatischer Polycyclus, beispielsweise Naphthalin, Phenanthren oder Anthracen, verstanden. Ein kondensierter aromatischer Polycyclus besteht im Sinne der vorliegenden Anmeldung aus zwei oder mehr miteinander kondensierten einzelnen aromatischen Cyclen. Unter Kondensation zwischen Cyclen ist dabei zu verstehen, dass die Cyclen mindestens eine Kante miteinander teilen. Eine Arylgruppe im Sinne dieser Erfindung enthält 6 bis 40 aromatische Ringatome, von denen keines ein Heteroatom ist.

Unter einer Heteroarylgruppe im Sinne dieser Erfindung wird entweder ein einzelner heteroaromatischer Cyclus, beispielsweise Pyridin, Pyrimidin oder Thiophen, oder ein kondensierter heteroaromatischer Polycyclus, beispielsweise Chinolin oder Carbazol, verstanden. Ein kondensierter heteroaromatischer Polycyclus besteht im Sinne der vorliegenden Anmeldung aus zwei oder mehr miteinander kondensierten einzelnen aromatischen oder heteroaromatischen Cyclen, wobei wenigstens einer der aromatischen und heteroaromatischen Cyclen ein heteroaromatischer Cyclus ist. Unter Kondensation zwischen Cyclen ist dabei zu verstehen, dass die Cyclen mindestens eine Kante miteinander teilen. Eine Heteroarylgruppe im Sinne dieser Erfindung enthält 5 bis 40 aromatische Ringatome, von denen mindestens eines ein Heteroatom darstellt. Die Heteroatome der Heteroarylgruppe sind bevorzugt ausgewählt aus N, O und S.

Unter einer Aryl- oder Heteroarylgruppe, die jeweils mit den oben genannten Resten substituiert sein kann werden insbesondere Gruppen verstanden, welche abgeleitet sind von Benzol, Naphthalin, Anthracen, Phenanthren, Pyren, Dihydropyren, Chrysen, Perylen, Triphenylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Benzimidazolo[1,2-a]benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Ein aromatisches Ringsystem im Sinne dieser Erfindung ist ein System, welches nicht notwendigerweise nur Arylgruppen enthält, sondern welches zusätzlich einen oder mehrere nicht-aromatische Ringe enthalten kann, die mit wenigstens einer Arylgruppe kondensiert sind. Diese nicht-aromatischen Ringe enthalten ausschließlich Kohlenstoffatome als Ringatome. Beispiele für Gruppen, die von dieser Definition umfasst sind, sind Tetrahydronaphthalin, Fluoren und Spirobifluoren. Weiterhin umfasst der Begriff aromatisches Ringsystem Systeme, die aus zwei oder mehr aromatischen Ringsystemen bestehen, die über Einfachbindungen miteinander verbunden sind, beispielsweise Biphenyl, Terphenyl, 7-Phenyl-2-fluorenyl, Quaterphenyl und 3,5-Diphenyl-1-phenyl. Ein aromatisches Ringsystem im Sinne dieser Erfindung enthält 6 bis 40 C-Atome und keine Heteroatome im Ringsystem. Die Definition von "aromatisches Ringsystem" umfasst nicht Heteroarylgruppen.

Ein heteroaromatisches Ringsystem entspricht der oben genannten Definition eines aromatischen Ringsystems, mit dem Unterschied dass es mindestens ein Heteroatom als Ringatom enthalten muss. Wie es beim aromatischen

Ringsystem der Fall ist, muss das heteroaromatische Ringsystem nicht ausschließlich Arylgruppen und Heteroarylgruppen enthalten, sondern es kann zusätzlich einen oder mehrere nicht-aromatische Ringe enthalten, die mit wenigstens einer Aryl- oder Heteroarylgruppe kondensiert sind. Die nicht-aromatischen Ringe können ausschließlich C-Atome als Ringatome enthalten, oder sie können zusätzlich ein oder mehrere Heteroatome enthalten, wobei die Heteroatome bevorzugt gewählt sind aus N, O und S. Ein Beispiel für ein derartiges heteroaromatisches Ringsystem ist Benzopyranyl. Weiterhin werden unter dem Begriff "heteroaromatisches Ringsystem" Systeme verstanden, die aus zwei oder mehr aromatischen oder heteroaromatischen Ringsystemen bestehen, die miteinander über Einfachbindungen verbunden sind, wie beispielsweise 4,6-Diphenyl-2-triazinyl. Ein heteroaromatisches Ringsystem im Sinne dieser Erfindung enthält 5 bis 40 Ringatome, die gewählt sind aus Kohlenstoff und Heteroatomen, wobei mindestens eines der Ringatome ein Heteroatom ist. Die Heteroatome des heteroaromatischen Ringsystems sind bevorzugt ausgewählt aus N, O und S.

Die Begriffe "heteroaromatisches Ringsystem" und "aromatisches Ringsystem" gemäß der Definition der vorliegenden Anmeldung unterscheiden sich damit dadurch voneinander, dass ein aromatisches Ringsystem kein Heteroatom als Ringatom aufweisen kann, während ein heteroaromatisches Ringsystem mindestens ein Heteroatom als Ringatom aufweisen muss. Dieses Heteroatom kann als Ringatom eines nicht-aromatischen heterocyclischen Rings oder als Ringatom eines aromatischen heterocyclischen Rings vorliegen.

Entsprechend der obenstehenden Definitionen ist jede Arylgruppe vom Begriff "aromatisches Ringsystem" umfasst, und jede Heteroarylgruppe ist vom Begriff "heteroaromatisches Ringsystem" umfasst.

Unter einem aromatischen Ringsystem mit 6 bis 40 aromatischen Ringatomen oder einem heteroaromatischen Ringsystem mit 5 bis 40 aromatischen Ringatomen, werden insbesondere Gruppen verstanden, die abgeleitet sind von den oben unter Arylgruppen und Heteroarylgruppen genannten Gruppen sowie von Biphenyl, Terphenyl, Quaterphenyl, Fluoren, Spirobifluoren, Dihydrophenanthren, Dihydropyren, Tetrahydropyren, Indenofluoren, Truxen, Isotruxen, Spirotruxen, Spiroisotruxen, Indenocarbazol, oder von Kombinationen dieser Gruppen.

Im Rahmen der vorliegenden Erfindung werden unter einer geradkettigen Alkylgruppe mit 1 bis 20 C-Atomen bzw. einer verzweigten oder cyclischen Alkylgruppe mit 3 bis 20 C-Atomen bzw. einer Alkenyl- oder Alkinylgruppe mit 2 bis 40 C-Atomen, in der auch einzelne H-Atome oder $CH_2$-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden.

Unter einer Alkoxy- oder Thioalkylgruppe mit 1 bis 20 C-Atomen, in der auch einzelne H-Atome oder $CH_2$-Gruppen durch die oben bei der Definition der Reste genannten Gruppen substituiert sein können, werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet.

T ist bevorzugt gleich B.

X ist bei jedem Auftreten bevorzugt gleich gewählt. Besonders bevorzugt ist X bei jedem Auftreten gleich gewählt und ist $NR^{E2}$. Bevorzugt ist mindestens einer der Indices o und p gleich 1, so dass mindestens zwei Gruppen X in der Formel (EM-1) vorliegen, und mindestens zwei Gruppen X in der Formel (EM-1) sind gewählt aus O, S und $NR^E$, besonders bevorzugt $NR^E$.

$C^1$, $C^2$ und $C^3$ sind bevorzugt bei jedem Auftreten gleich gewählt. Weiterhin bevorzugt sind sie gewählt aus Ringsystemen, bei denen die Ringatome gewählt sind aus C, Si, N, P, O, S, B. Die Ringsysteme können aliphatisch, aromatisch, heteroaliphatisch oder heteroaromatisch sein. Bevorzugt ist der einzelne Ring, der die in Formel (EM-1) gezeigten C-Atome enthält, aromatisch oder heteroaromatisch, besonders bevorzugt aromatisch.

Bevorzugt sind $C^1$, $C^2$ und $C^3$ aromatisch oder heteroaromatisch, besonders bevorzugt aromatisch. $C^1$, $C^2$ und $C^3$ sind bevorzugt bei jedem Auftreten gleich oder verschieden, bevorzugt gleich, gewählt aus Benzol, Naphthalin, Fluoren, Carbazol, Dibenzofuran und Dibenzothiophen, die jeweils mit Resten $R^{E3}$ substituiert sind. Besonders bevorzugt sind $C^1$, $C^2$ und $C^3$ gleich Benzol, das jeweils mit Resten $R^{E3}$ substituiert ist.

Bevorzugt ist $R^{E1}$ ein aromatisches oder heteroaromatisches Ringsystem, das mit einem oder mehreren Resten

$R^{E4}$ substituiert ist.

Bevorzugt ist $R^{E2}$ bei jedem Auftreten gleich oder verschieden gewählt aus geradkettigen Alkylgruppen mit 1 bis 20 C-Atomen, verzweigten oder cyclischen Alkylgruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkylgruppen und die genannten aromatischen Ringsysteme und heteroaromatischen Ringsysteme jeweils mit Resten $R^{E4}$ substituiert sind, wobei zwei oder mehr Reste $R^{E2}$ miteinander verknüpft sein können und einen Ring bilden können, und wobei ein oder mehrere Reste $R^{E2}$ über ihre Reste $R^{E4}$ mit einem Ring gewählt aus $C^1$, $C^2$ und $C^3$ verknüpft sein können und einen Ring bilden können. Besonders bevorzugt ist $R^{E2}$ bei jedem Auftreten gleich oder verschieden gewählt aus aromatischen Ringsystemen mit 6 bis 40 aromatischen Ringatomen, die jeweils mit Resten $R^{E4}$ substituiert sind, wobei zwei oder mehr Reste $R^{E2}$ miteinander verknüpft sein können und einen Ring bilden können und wobei ein oder mehrere Reste $R^{E2}$ über ihre Reste $R^{E4}$ mit einem Ring gewählt aus $C^1$, $C^2$ und $C^3$ verknüpft sein können und einen Ring bilden können.

Gemäß einer bevorzugten Ausführungsform sind die Reste $R^{E2}$ bei jedem Auftreten gleich gewählt. Weiterhin sind gemäß einer bevorzugten Ausführungsform $C^1$, $C^2$, $C^3$ und alle Reste $R^{E2}$ gleich gewählt, insbesondere gleich Phenyl, das entsprechend substituiert sein kann, wobei bevorzugt dann alle betreffenden Phenylgruppen gleich substituiert sind.

Bevorzugt ist $R^{E3}$ bei jedem Auftreten gleich oder verschieden gewählt aus H, D, F, CN, $Si(R^{E4})_3$, $N(R^{E4})_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^{E4}$ substituiert sind; und wobei in den genannten Alkyl- oder Alkoxygruppen eine oder mehrere $CH_2$-Gruppen durch -C=C-, $-R^{E4}C=CR^{E4}-$, $Si(R^{E4})_2$, C=O, $C=NR^{E4}$, $-NR^{E4}-$, -O-, -S-, -C(=O)O- oder $-C(=O)NR^{E4}-$ ersetzt sein können.

Besonders bevorzugt ist mindestens ein Rest $R^{E3}$ in Formel (EM-1) gewählt aus Alkylgruppen mit 1 bis 10 C-Atomen, $N(R^{E4})_2$, aromatischen Ringsystemen mit 6 bis 40 aromatischen Ringatomen, und heteroaromatischen Ringsystemen mit 5 bis 40 aromatischen Ringatomen, wobei die genannten Alkylgruppen, die genannten aromatischen Ringsysteme und die genannten heteroaromatischen Ringsysteme jeweils mit Resten $R^{E4}$ substituiert sind. Ganz besonders bevorzugt ist mindestens ein Rest $R^{E3}$ in Formel (EM-1) gewählt aus Alkylgruppen mit 1 bis 10 C-Atomen, die mit Resten $R^{E4}$ substituiert sind, und $N(R^{E4})_2$.

Bevorzugt ist $R^{E4}$ bei jedem Auftreten gleich oder verschieden gewählt aus H, D, F, CN, $Si(R^{E5})_3$, $N(R^{E5})_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^{E5}$ substituiert sind; und wobei in den genannten Alkyl- oder Alkoxygruppen eine oder mehrere $CH_2$-Gruppen durch -C≡C-, $-R^{E5}C=CR^{E5}-$, $Si(R^{E5})_2$, C=O, $C=NR^{E5}$, $-NR^{E5}-$, -O-, -S-, -C(=O)O- oder $-C(=O)NR^{E5}-$ ersetzt sein können.

Bevorzugt ist mindestens einer der Indices o und p gleich 1. Besonders bevorzugt ist einer der Indices o und p gleich 1, und der andere der Indices o und p ist gleich 0.

Bevorzugt ist die Verbindung der Formel (EM-1) eine spiegelsymmetrische Verbindung einer Formel (EM-1S)

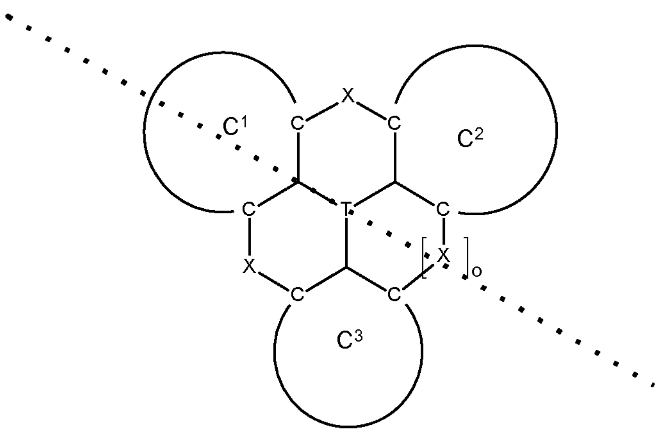

Formel (EM-1S),

wobei die Gruppen X gleich gewählt sind, die Gruppen $C^2$ und $C^3$ gleich gewählt sind, und alle auftretenden Gruppen

so gewählt sind, dass die Verbindung spiegelsymmetrisch ist, mit einer Spiegelebene, die die gestrichelte Linie enthält und senkrecht zur Papierebene steht.

Gemäß einer bevorzugten Ausführungsform der Erfindung entspricht die Verbindung der Formel (EM-1) der Formel (EM-1 -1)

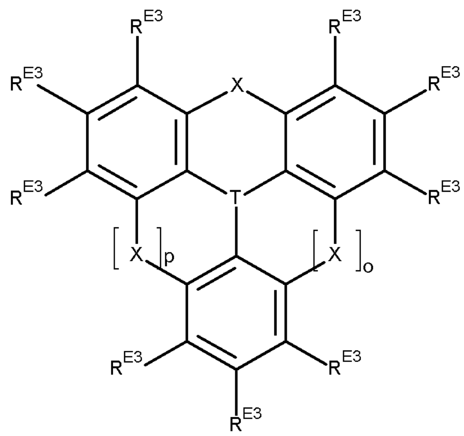

Formel (EM-1-1),

wobei die auftretenden Variablen definiert sind wie oben.

Gemäß einer bevorzugten Ausführungsform entspricht die Verbindung der Formel (EM-1-1) einer spiegelsymmetrischen Verbindung der Formel (EM-1-1S)

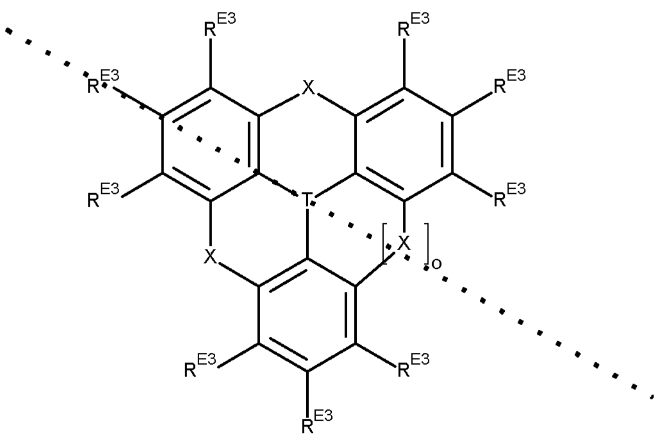

Formel (EM-1-1S),

wobei die Gruppen X gleich gewählt sind, und alle auftretenden Gruppen so gewählt sind, dass die Verbindung spiegelsymmetrisch ist, mit einer Spiegelebene, die die gestrichelte Linie enthält und senkrecht zur Papierebene steht.

Gemäß einer alternativen bevorzugten Ausführungsform ist die Verbindung der Formel (EM-1-1) nicht spiegelsymmetrisch bezüglich der in Formel (EM-1-1S) gezeigten Spiegelebene.

Insbesondere bevorzugt ist es, wenn in Formel (EM-1-1)

- T gleich B ist, und/oder
- X gleich $NR^{E2}$ ist, und/oder
- einer der Indices p und o gleich 1 ist, und der andere der Indices p und o gleich 0 ist.
- mindestens ein Rest $R^{E3}$ gewählt ist aus Alkylgruppen mit 1 bis 10 C-Atomen, $N(R^{E4})_2$, aromatischen Ringsystemen mit 6 bis 40 aromatischen Ringatomen, und heteroaromatischen Ringsystemen mit 5 bis 40 aromatischen Ringatomen, wobei die genannten Alkylgruppen, die genannten aromatischen Ringsysteme und die genannten heteroaromatischen Ringsysteme jeweils mit Resten $R^{E4}$ substituiert sind.

Bevorzugt ist in Formel (EM-1-1) $R^{E2}$ gleich Phenyl, das mit Resten $R^{E4}$ substituiert ist.

Ganz besonders bevorzugt ist mindestens ein Rest $R^{E3}$ in Formel (EM-1-1) gewählt aus Alkylgruppen mit 1 bis 10 C-Atomen, die mit Resten $R^{E4}$ substituiert sind, und $N(R^{E4})_2$.

Besonders bevorzugt ist die Formel (EM-1-1-1)

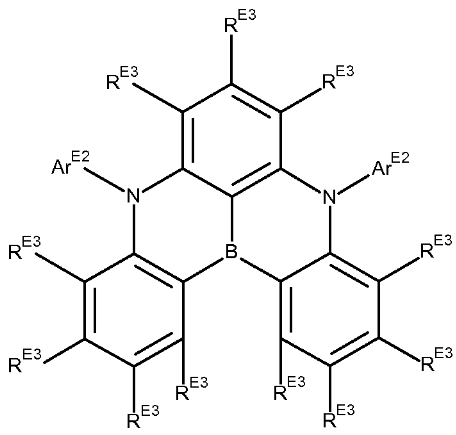

Formel (EM-1-1-1),

wobei $Ar^{E2}$ bei jedem Auftreten gleich oder verschieden gewählt ist aus aromatischen Ringsystemen mit 6 bis 40 aromatischen Ringatomen, die mit Resten $R^{E4}$ substituiert sind, und heteroaromatischen Ringsystemen mit 5 bis 40 aromatischen Ringatomen, die mit Resten $R^{E4}$ substituiert sind, besonders bevorzugt Phenyl oder Biphenyl, die jeweils mit Resten $R^{E4}$ substituiert ist. Gemäß einer bevorzugten Ausführungsform sind die Reste $Ar^{E2}$ bei jedem Auftreten gleich gewählt. Gemäß einer alternativen bevorzugten Ausführungsform sind die Reste $Ar^{E2}$ bei jedem Auftreten unterschiedlich gewählt.

Die sonstigen auftretenden Variablen sind definiert wie oben.

Bevorzugt ist in der Formel mindestens ein Rest $R^{E3}$ gewählt aus Alkylgruppen mit 1 bis 10 C-Atomen, $N(R^{E4})_2$, aromatischen Ringsystemen mit 6 bis 40 aromatischen Ringatomen, und heteroaromatischen Ringsystemen mit 5 bis 40 aromatischen Ringatomen, wobei die genannten Alkylgruppen, die genannten aromatischen Ringsysteme und die genannten heteroaromatischen Ringsysteme jeweils mit Resten $R^{E4}$ substituiert sind. Ganz besonders bevorzugt ist in der Formel mindestens ein Rest $R^{E3}$ gewählt aus Alkylgruppen mit 1 bis 10 C-Atomen, die mit Resten $R^{E4}$ substituiert sind, und $N(R^{E4})_2$.

Gemäß einer bevorzugten Ausführungsform ist die Verbindung der Formel (EM-1 -1 -1) spiegelsymmetrisch gegenüber einer Spiegelebene, die senkrecht auf der Papierebene steht und die Bindung vom Bor zur obersten der drei gezeigten Phenylgruppen enthält. Bevorzugt ist in diesem Fall in Formel (EM-1-1-1) $R^{E2}$ gleich Phenyl oder Biphenyl, die jeweils mit Resten $R^{E4}$ substituiert sind.

Gemäß einer alternativen bevorzugten Ausführungsform ist die Verbindung der Formel (EM-1 -1 -1) nicht spiegelsymmetrisch gegenüber einer Spiegelebene, die senkrecht auf der Papierebene steht und die Bindung vom Bor zur obersten der drei gezeigten Phenylgruppen enthält. Bevorzugt ist in diesem Fall in Formel (EM-1-1-1) $R^{E2}$ gleich oder verschieden gewählt aus Phenyl und Biphenyl, die jeweils mit Resten $R^{E4}$ substituiert sind.

Ganz besonders bevorzugt sind die Formeln (EM-1-1-1-1) und (EM-1-1-1-2)

| | |
|---|---|
| 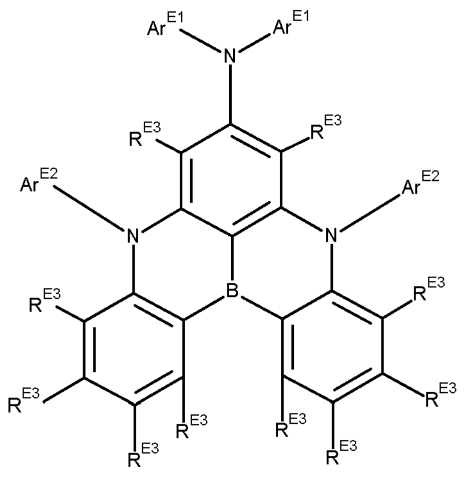 | 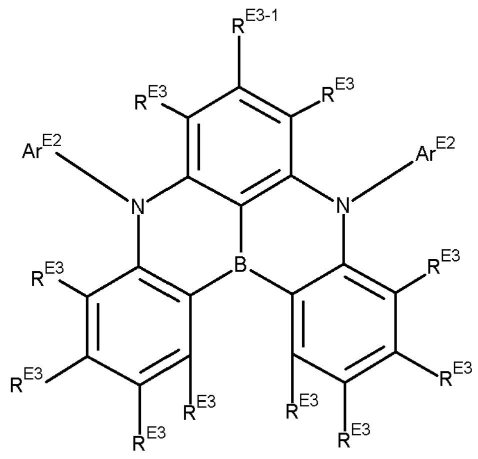 |
| Formel (EM-1-1-1-1) | Formel (EM-1-1-1-2) |

wobei $Ar^{E1}$ bei jedem Auftreten gleich oder verschieden gewählt ist aus aromatischen Ringsystemen mit 6 bis 40 aromatischen Ringatomen, die mit Resten $R^{E5}$ substituiert sind, und heteroaromatischen Ringsystemen mit 5 bis 40 aromatischen Ringatomen, die mit Resten $R^{E5}$ substituiert sind, und

wobei $Ar^{E2}$ bei jedem Auftreten gleich oder verschieden gewählt ist aus aromatischen Ringsystemen mit 6 bis 40 aromatischen Ringatomen, die mit Resten $R^{E4}$ substituiert sind, und heteroaromatischen Ringsystemen mit 5 bis 40 aromatischen Ringatomen, die mit Resten $R^{E4}$ substituiert sind, besonders bevorzugt Phenyl oder Biphenyl, die jeweils mit Resten $R^{E4}$ substituiert sind, und

wobei $R^{E3-1}$ gewählt ist aus Alkylgruppen mit 1 bis 10 C-Atomen, die mit Resten $R^{E4}$ substituiert sind, bevorzugt Methyl, Ethyl, n-Propyl, i-Propyl und tert-Butyl, besonders bevorzugt Methyl.

Die sonstigen auftretenden Variablen sind definiert wie oben.

$Ar^{E1}$ ist bevorzugt bei jedem Auftreten gleich oder verschieden gewählt aus Phenyl, Biphenyl, Terphenyl, Fluorenyl, Naphthyl, Dibenzofuranyl, Dibenzothiophenyl und Carbazolyl, die jeweils mit Resten $R^{E5}$ substituiert sind, und Kombinationen aus zwei oder mehr dieser Gruppen. Besonders bevorzugt ist $Ar^{E1}$ bei jedem Auftreten gleich oder verschieden gewählt aus Phenyl, o-Biphenyl, m-Biphenyl, p-Biphenyl, Terphenyl, p-Tolyl, m-Tolyl, o-Tolyl, p-tert-Butyl-Phenyl, m-tert-Butyl-Phenyl, o-tert-Butyl-Phenyl, 9,9'-Dimethylfluorenyl, 9,9'-Diphenylfluorenyl, Naphthyl, Naphthyl, Dibenzothiophenyl, Dibenzofuranyl, Naphthyl-Phenylen, Dibenzofuranyl-Phenylen, Dibenzothiophenyl-Phenylen, Carbazolyl-Phenylen, insbesondere N-Carbazolyl-Phenylen.

Gemäß einer bevorzugten Ausführungsform ist die Verbindung der Formel (EM-1 -1 -1 -1) oder (EM-1 -1 -1 -2) spiegelsymmetrisch gegenüber einer Spiegelebene, die senkrecht auf der Papierebene steht und die Bindung vom Bor zur obersten der drei gezeigten Phenylgruppen enthält. Die beiden Gruppen $Ar^{E1}$ können dabei gleich oder verschieden gewählt sein und sind bevorzugt gleich gewählt.

Gemäß einer alternativen bevorzugten Ausführungsform ist die Verbindung der Formel (EM-1 -1 -1 -1) oder (EM-1 -1 -1 -2) nicht spiegelsymmetrisch gegenüber einer Spiegelebene, die senkrecht auf der Papierebene steht und die Bindung vom Bor zur obersten der drei gezeigten Phenylgruppen enthält. Die beiden Gruppen $Ar^{E1}$ können dabei gleich oder verschieden gewählt sein und sind bevorzugt verschieden gewählt.

Am stärksten bevorzugt sind die Formeln (EM-1-1-1-1-1) und (EM-1-1-1-1-2)

| |
|---|
| 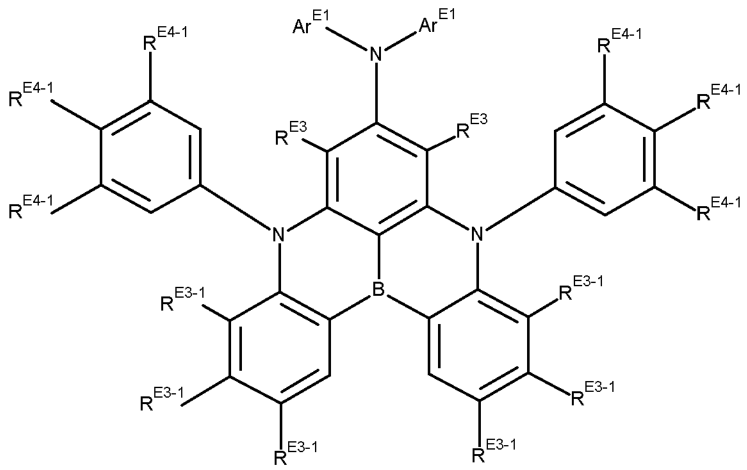 |
| Formel (EM-1-1-1-1-1) |
| 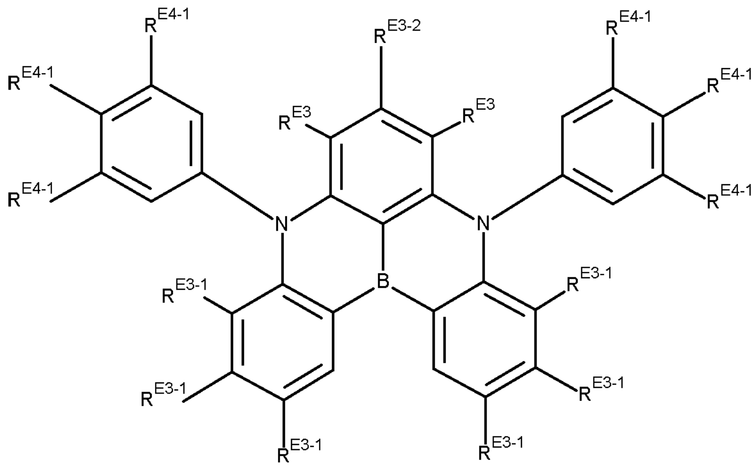 |
| Formel (EM-1-1-1-1-2), |

wobei $R^{E3-1}$ definiert ist wie $R^{E3}$; und $R^{E3-2}$ gewählt ist aus Alkylgruppen mit 1 bis 10 C-Atomen, die mit Resten $R^{E4}$ substituiert sind, bevorzugt Methyl, Ethyl, iso-Propyl und tert-Butyl, besonders bevorzugt Methyl; und $R^{E4-1}$ definiert ist wie $R^{E4}$, und wobei die sonstigen Variablen definiert sind wie oben.

Bevorzugt sind in Formel (EM-1 -1 -1 -1 -1) und (EM-1 -1 -1 -1 -2) $R^{E3-1}$ und $R^{E4-1}$ bei jedem Auftreten gleich oder verschieden gewählt aus H, Alkylgruppen mit 1 bis 10 C-Atomen, die mit Resten $R^{E4}$ bzw. $R^{E5}$ substituiert sind und bevorzugt unsubstituiert sind, und aromatischen Ringsystemen mit 6 bis 40 Ringatomen, die mit Resten $R^{E4}$ bzw. $R^{E5}$ substituiert sind. Bevorzugt sind genau genau ein oder zwei Reste $R^{E3-1}$ bzw. $R^{E4-1}$ je Benzolring gewählt aus Alkylgruppen mit 1 bis 10 C-Atomen, die mit Resten $R^{E4}$ bzw. $R^{E5}$ substituiert sind und bevorzugt unsubstituiert sind, und aromatischen Ringsystemen mit 6 bis 40 Ringatomen, die mit Resten $R^{E4}$ bzw. $R^{E5}$ substituiert sind, und die anderen Reste $R^{E3-1}$ bzw. $R^{E4-1}$ sind gleich H.

Gemäß einer bevorzugten Ausführungsform sind die in Formel (EM-1-1-1-1)

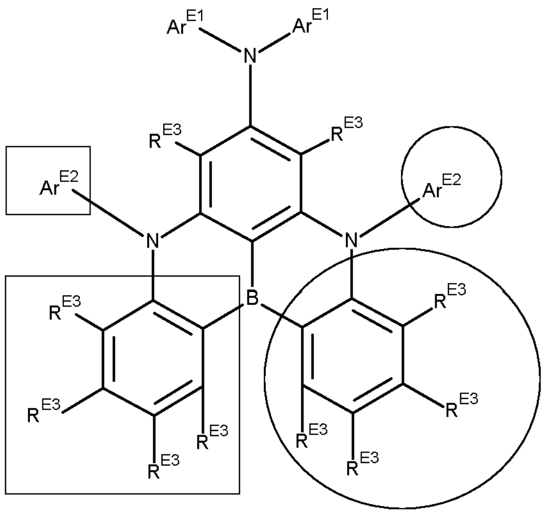

Formel (EM-1-1-1-1)

mit einem Kreis markierten Einheiten jeweils gleich gewählt, und die mit einem Rechteck markierten Einheiten sind ebenfalls jeweils gleich gewählt. Besonders bevorzugt sind alle vier markierten Einheiten gleich gewählt.

Bevorzugt sind die mit Kreis und Rechteck markierten Einheiten gleich oder verschieden, bevorzugt gleich, gewählt aus entsprechend substituiertem Benzol, Naphthalin, Fluoren, Dibenzofuran und Dibenzothiophen. Besonders bevorzugt ist entsprechend substituiertes Benzol.

Die Verbindung der Formel (EM-1 -1 -1 -1) lässt sich als Verbindung A-B enthaltend die zwei Teileinheiten A und B abbilden:

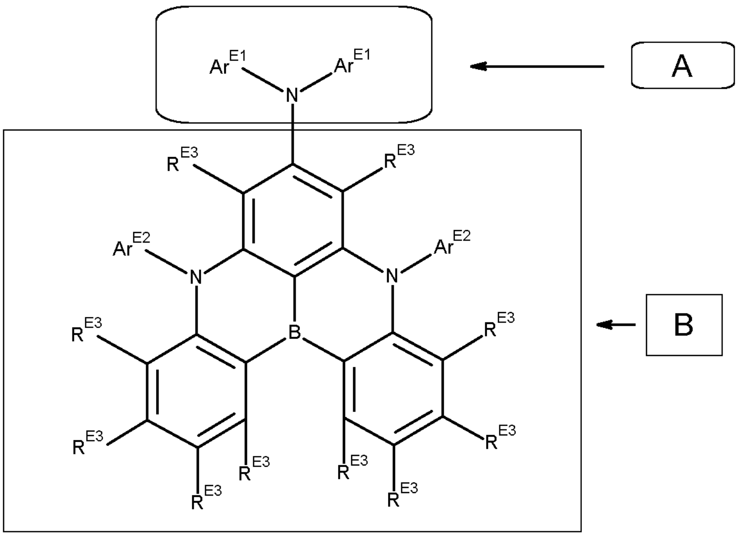

Bevorzugte Ausführungsformen der Einheit A sind die folgenden (mit "B" ist in den Formeln entsprechend die Einheit B bezeichnet):

| | | |
|---|---|---|
| 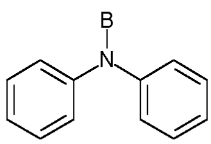 | 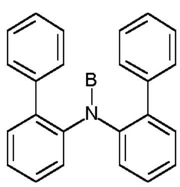 | 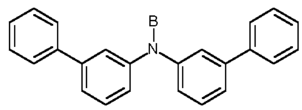 |

(fortgesetzt)

| A-1 | A-2 | A-3 |
|---|---|---|
| 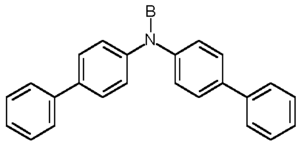 | 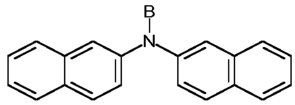 | 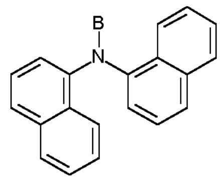 |
| A-4 | A-5 | A-6 |
| 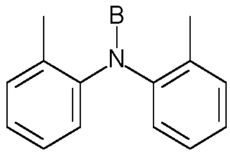 | 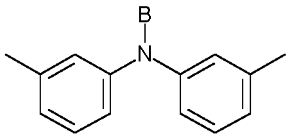 | 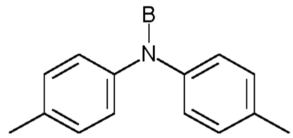 |
| A-7 | A-8 | A-9 |
| 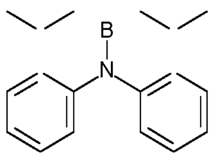 | 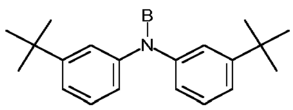 | 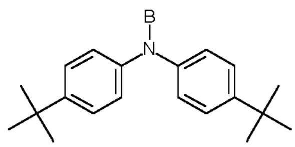 |
| A-10 | A-11 | A-12 |
| 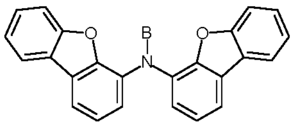 | 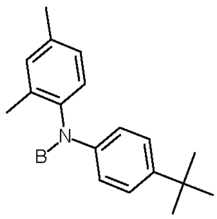 | 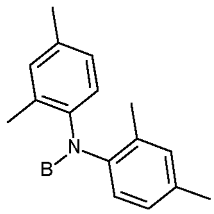 |
| A-13 | A-14 | A-15 |
| 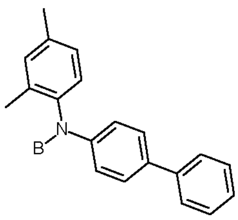 | 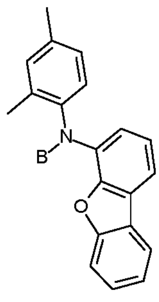 | 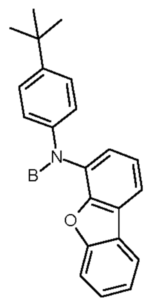 |
| A-16 | A-17 | A-18 |
| 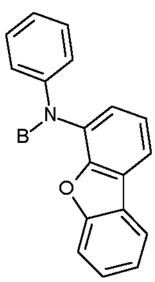 | 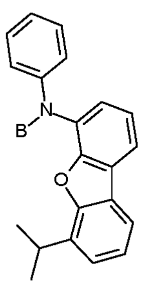 | 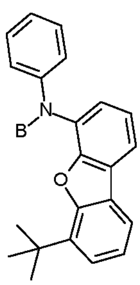 |
| A-19 | A-20 | A-21 |

(fortgesetzt)

| | | |
|---|---|---|
| 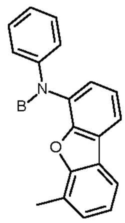 | 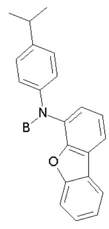 | 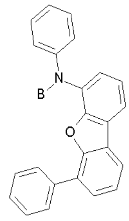 |
| A-22 | A-23 | A-24 |
| 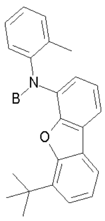 | 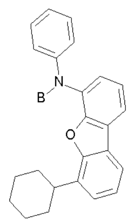 | 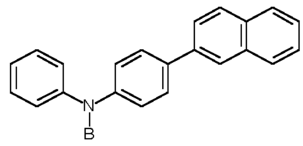 |
| A-25 | A-26 | A-27 |
| 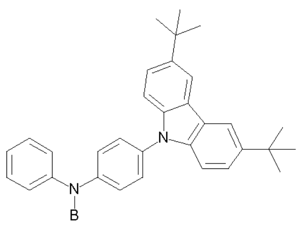 | B-$CH_3$ | B-$C(CH_3)_3$ |
| A-28 | A-29 | A-30 |

Bevorzugte Ausführungsformen der Einheit B sind die folgenden (mit "A" ist in den Formeln entsprechend die Einheit A bezeichnet):

| | | |
|---|---|---|
| 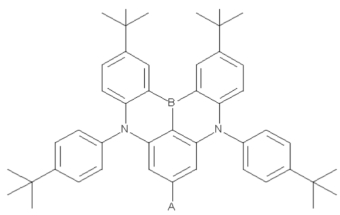 | 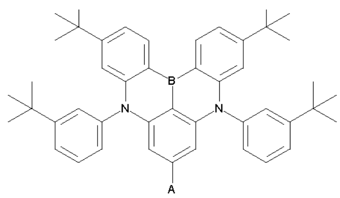 | 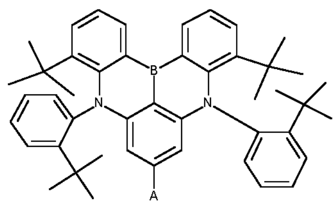 |
| B-1 | B-2 | B-3 |
| 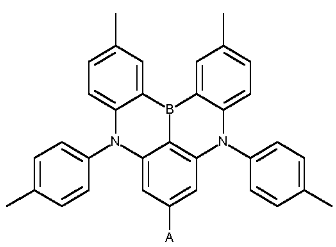 | 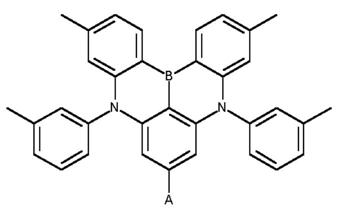 | 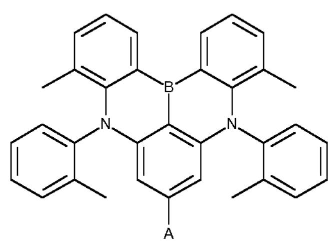 |
| B-4 | B-5 | B-6 |

(fortgesetzt)

| | | |
|---|---|---|
| 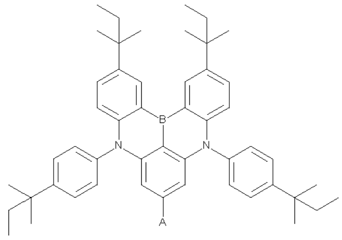 | 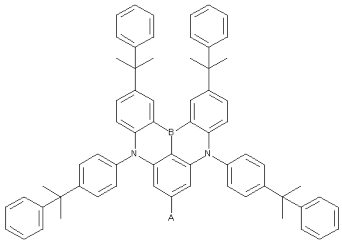 | 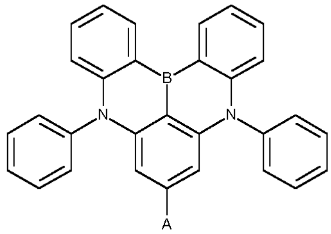 |
| B-7 | B-8 | B-9 |
| 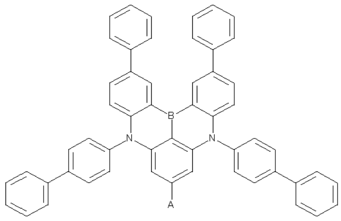 | 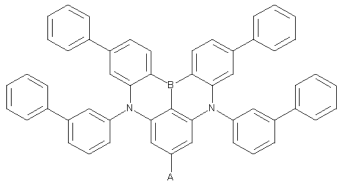 | 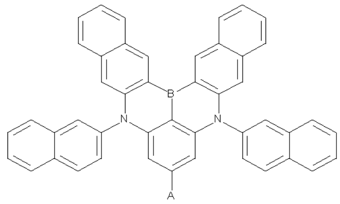 |
| B-10 | B-11 | B-12 |
| 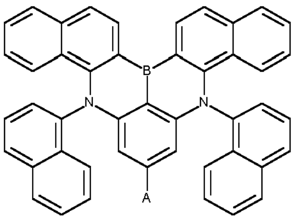 | 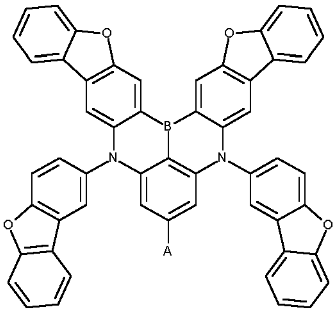 | 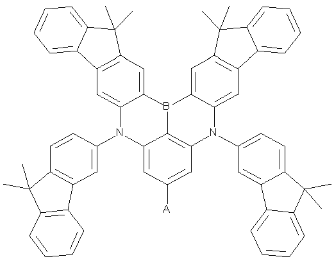 |
| B-13 | B-14 | B-15 |
| 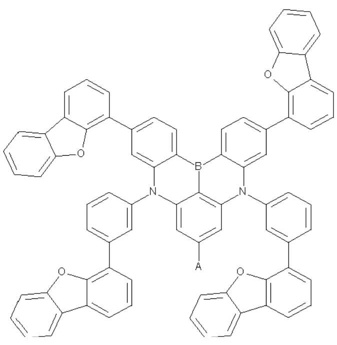 | 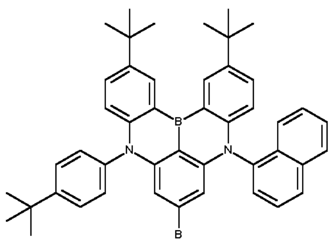 | 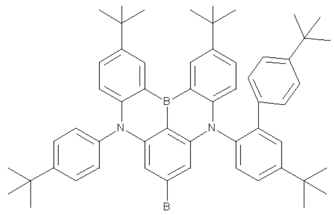 |
| B-16 | B-17 | B-18 |
| 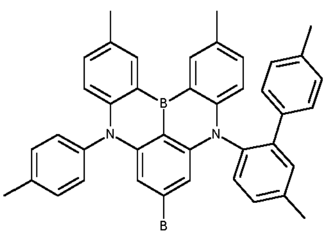 | 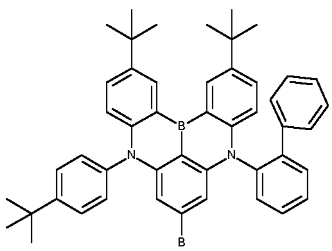 | 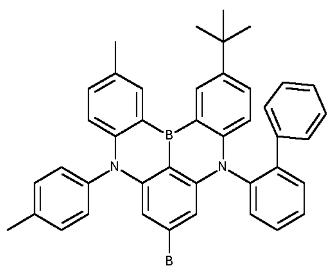 |
| B-19 | B-20 | B-21 |

(fortgesetzt)

| | | |
|---|---|---|
| 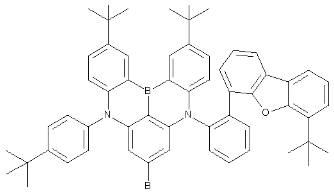 | | |
| B-22 | | |

Bevorzugte Ausführungsformen der Verbindungen der Formel (EM-1-1-1-1) sind damit Verbindungen der folgenden Formeln, in denen Teil A und Teil B der Formel wie folgt gewählt sind:

| Formel (EM-1-1-1-X) mit X= | Teil A | Teil B |
|---|---|---|
| 1 | A-1 | B-1 |
| 2 | A-1 | B-2 |
| 3 | A-1 | B-3 |
| 4 | A-1 | B-4 |
| 5 | A-1 | B-5 |
| 6 | A-1 | B-6 |
| 7 | A-1 | B-7 |
| 8 | A-1 | B-8 |
| 9 | A-1 | B-9 |
| 10 | A-1 | B-10 |
| 11 | A-1 | B-11 |
| 12 | A-1 | B-12 |
| 13 | A-1 | B-13 |
| 14 | A-1 | B-14 |
| 15 | A-1 | B-15 |
| 16 | A-1 | B-16 |
| 17 | A-1 | B-17 |
| 18 | A-1 | B-18 |
| 19 | A-1 | B-19 |
| 20 | A-1 | B-20 |
| 21 | A-1 | B-21 |
| 22 | A-1 | B-22 |
| 23 | A-2 | B-1 |
| 24 | A-2 | B-2 |
| 25 | A-2 | B-3 |
| 26 | A-2 | B-4 |
| 27 | A-2 | B-5 |
| 28 | A-2 | B-6 |
| 29 | A-2 | B-7 |

(fortgesetzt)

| Formel (EM-1-1-1-1-X) mit X= | Teil A | Teil B |
|---|---|---|
| 30 | A-2 | B-8 |
| 31 | A-2 | B-9 |
| 32 | A-2 | B-10 |
| 33 | A-2 | B-11 |
| 34 | A-2 | B-12 |
| 35 | A-2 | B-13 |
| 36 | A-2 | B-14 |
| 37 | A-2 | B-15 |
| 38 | A-2 | B-16 |
| 39 | A-2 | B-17 |
| 40 | A-2 | B-18 |
| 41 | A-2 | B-19 |
| 42 | A-2 | B-20 |
| 43 | A-2 | B-21 |
| 44 | A-2 | B-22 |
| 45 | A-3 | B-1 |
| 46 | A-3 | B-2 |
| 47 | A-3 | B-3 |
| 48 | A-3 | B-4 |
| 49 | A-3 | B-5 |
| 50 | A-3 | B-6 |
| 51 | A-3 | B-7 |
| 52 | A-3 | B-8 |
| 53 | A-3 | B-9 |
| 54 | A-3 | B-10 |
| 55 | A-3 | B-11 |
| 56 | A-3 | B-12 |
| 57 | A-3 | B-13 |
| 58 | A-3 | B-14 |
| 59 | A-3 | B-15 |
| 60 | A-3 | B-16 |
| 61 | A-3 | B-17 |
| 62 | A-3 | B-18 |
| 63 | A-3 | B-19 |
| 64 | A-3 | B-20 |
| 65 | A-3 | B-21 |
| 66 | A-3 | B-22 |
| 67 | A-4 | B-1 |

(fortgesetzt)

| Formel (EM-1-1-1-1-X) mit X= | Teil A | Teil B |
|---|---|---|
| 68 | A-4 | B-2 |
| 69 | A-4 | B-3 |
| 70 | A-4 | B-4 |
| 71 | A-4 | B-5 |
| 72 | A-4 | B-6 |
| 73 | A-4 | B-7 |
| 74 | A-4 | B-8 |
| 75 | A-4 | B-9 |
| 76 | A-4 | B-10 |
| 77 | A-4 | B-11 |
| 78 | A-4 | B-12 |
| 79 | A-4 | B-13 |
| 80 | A-4 | B-14 |
| 81 | A-4 | B-15 |
| 82 | A-4 | B-16 |
| 83 | A-4 | B-17 |
| 84 | A-4 | B-18 |
| 85 | A-4 | B-19 |
| 86 | A-4 | B-20 |
| 87 | A-4 | B-21 |
| 88 | A-4 | B-22 |
| 89 | A-5 | B-1 |
| 90 | A-5 | B-2 |
| 91 | A-5 | B-3 |
| 92 | A-5 | B-4 |
| 93 | A-5 | B-5 |
| 94 | A-5 | B-6 |
| 95 | A-5 | B-7 |
| 96 | A-5 | B-8 |
| 97 | A-5 | B-9 |
| 98 | A-5 | B-10 |
| 99 | A-5 | B-11 |
| 100 | A-5 | B-12 |
| 101 | A-5 | B-13 |
| 102 | A-5 | B-14 |
| 103 | A-5 | B-15 |
| 104 | A-5 | B-16 |
| 105 | A-5 | B-17 |

(fortgesetzt)

| Formel (EM-1-1-1-1-X) mit X= | Teil A | Teil B |
|---|---|---|
| 106 | A-5 | B-18 |
| 107 | A-5 | B-19 |
| 108 | A-5 | B-20 |
| 109 | A-5 | B-21 |
| 110 | A-5 | B-22 |
| 111 | A-6 | B-1 |
| 112 | A-6 | B-2 |
| 113 | A-6 | B-3 |
| 114 | A-6 | B-4 |
| 115 | A-6 | B-5 |
| 116 | A-6 | B-6 |
| 117 | A-6 | B-7 |
| 118 | A-6 | B-8 |
| 119 | A-6 | B-9 |
| 120 | A-6 | B-10 |
| 121 | A-6 | B-11 |
| 122 | A-6 | B-12 |
| 123 | A-6 | B-13 |
| 124 | A-6 | B-14 |
| 125 | A-6 | B-15 |
| 126 | A-6 | B-16 |
| 127 | A-6 | B-17 |
| 128 | A-6 | B-18 |
| 129 | A-6 | B-19 |
| 130 | A-6 | B-20 |
| 131 | A-6 | B-21 |
| 132 | A-6 | B-22 |
| 133 | A-7 | B-1 |
| 134 | A-7 | B-2 |
| 135 | A-7 | B-3 |
| 136 | A-7 | B-4 |
| 137 | A-7 | B-5 |
| 138 | A-7 | B-6 |
| 139 | A-7 | B-7 |
| 140 | A-7 | B-8 |
| 141 | A-7 | B-9 |
| 142 | A-7 | B-10 |
| 143 | A-7 | B-11 |

(fortgesetzt)

| Formel (EM-1-1-1-1-X) mit X= | Teil A | Teil B |
|---|---|---|
| 144 | A-7 | B-12 |
| 145 | A-7 | B-13 |
| 146 | A-7 | B-14 |
| 147 | A-7 | B-15 |
| 148 | A-7 | B-16 |
| 149 | A-7 | B-17 |
| 150 | A-7 | B-18 |
| 151 | A-7 | B-19 |
| 152 | A-7 | B-20 |
| 153 | A-7 | B-21 |
| 154 | A-7 | B-22 |
| 155 | A-8 | B-1 |
| 156 | A-8 | B-2 |
| 157 | A-8 | B-3 |
| 158 | A-8 | B-4 |
| 159 | A-8 | B-5 |
| 160 | A-8 | B-6 |
| 161 | A-8 | B-7 |
| 162 | A-8 | B-8 |
| 163 | A-8 | B-9 |
| 164 | A-8 | B-10 |
| 165 | A-8 | B-11 |
| 166 | A-8 | B-12 |
| 167 | A-8 | B-13 |
| 168 | A-8 | B-14 |
| 169 | A-8 | B-15 |
| 170 | A-8 | B-16 |
| 171 | A-8 | B-17 |
| 172 | A-8 | B-18 |
| 173 | A-8 | B-19 |
| 174 | A-8 | B-20 |
| 175 | A-8 | B-21 |
| 176 | A-8 | B-22 |
| 177 | A-9 | B-1 |
| 178 | A-9 | B-2 |
| 179 | A-9 | B-3 |
| 180 | A-9 | B-4 |
| 181 | A-9 | B-5 |

(fortgesetzt)

| Formel (EM-1-1-1-1-X) mit X= | Teil A | Teil B |
|---|---|---|
| 182 | A-9 | B-6 |
| 183 | A-9 | B-7 |
| 184 | A-9 | B-8 |
| 185 | A-9 | B-9 |
| 186 | A-9 | B-10 |
| 187 | A-9 | B-11 |
| 188 | A-9 | B-12 |
| 189 | A-9 | B-13 |
| 190 | A-9 | B-14 |
| 191 | A-9 | B-15 |
| 192 | A-9 | B-16 |
| 193 | A-9 | B-17 |
| 194 | A-9 | B-18 |
| 195 | A-9 | B-19 |
| 196 | A-9 | B-20 |
| 197 | A-9 | B-21 |
| 198 | A-9 | B-22 |
| 199 | A-10 | B-1 |
| 200 | A-10 | B-2 |
| 201 | A-10 | B-3 |
| 202 | A-10 | B-4 |
| 203 | A-10 | B-5 |
| 204 | A-10 | B-6 |
| 205 | A-10 | B-7 |
| 206 | A-10 | B-8 |
| 207 | A-10 | B-9 |
| 208 | A-10 | B-10 |
| 209 | A-10 | B-11 |
| 210 | A-10 | B-12 |
| 211 | A-10 | B-13 |
| 212 | A-10 | B-14 |
| 213 | A-10 | B-15 |
| 214 | A-10 | B-16 |
| 215 | A-10 | B-17 |
| 216 | A-10 | B-18 |
| 217 | A-10 | B-19 |
| 218 | A-10 | B-20 |
| 219 | A-10 | B-21 |

(fortgesetzt)

| Formel (EM-1-1-1-1-X) mit X= | Teil A | Teil B |
|---|---|---|
| 220 | A-10 | B-22 |
| 221 | A-11 | B-1 |
| 222 | A-11 | B-2 |
| 223 | A-11 | B-3 |
| 224 | A-11 | B-4 |
| 225 | A-11 | B-5 |
| 226 | A-11 | B-6 |
| 227 | A-11 | B-7 |
| 228 | A-11 | B-8 |
| 229 | A-11 | B-9 |
| 230 | A-11 | B-10 |
| 231 | A-11 | B-11 |
| 232 | A-11 | B-12 |
| 233 | A-11 | B-13 |
| 234 | A-11 | B-14 |
| 235 | A-11 | B-15 |
| 236 | A-11 | B-16 |
| 237 | A-11 | B-17 |
| 238 | A-11 | B-18 |
| 239 | A-11 | B-19 |
| 240 | A-11 | B-20 |
| 241 | A-11 | B-21 |
| 242 | A-11 | B-22 |
| 243 | A-12 | B-1 |
| 244 | A-12 | B-2 |
| 245 | A-12 | B-3 |
| 246 | A-12 | B-4 |
| 247 | A-12 | B-5 |
| 248 | A-12 | B-6 |
| 249 | A-12 | B-7 |
| 250 | A-12 | B-8 |
| 251 | A-12 | B-9 |
| 252 | A-12 | B-10 |
| 253 | A-12 | B-11 |
| 254 | A-12 | B-12 |
| 255 | A-12 | B-13 |
| 256 | A-12 | B-14 |
| 257 | A-12 | B-15 |

(fortgesetzt)

| Formel (EM-1-1-1-1-X) mit X= | Teil A | Teil B |
|---|---|---|
| 258 | A-12 | B-16 |
| 259 | A-12 | B-17 |
| 260 | A-12 | B-18 |
| 261 | A-12 | B-19 |
| 262 | A-12 | B-20 |
| 263 | A-12 | B-21 |
| 264 | A-12 | B-22 |
| 265 | A-13 | B-1 |
| 266 | A-13 | B-2 |
| 267 | A-13 | B-3 |
| 268 | A-13 | B-4 |
| 269 | A-13 | B-5 |
| 270 | A-13 | B-6 |
| 271 | A-13 | B-7 |
| 272 | A-13 | B-8 |
| 273 | A-13 | B-9 |
| 274 | A-13 | B-10 |
| 275 | A-13 | B-11 |
| 276 | A-13 | B-12 |
| 277 | A-13 | B-13 |
| 278 | A-13 | B-14 |
| 279 | A-13 | B-15 |
| 280 | A-13 | B-16 |
| 281 | A-13 | B-17 |
| 282 | A-13 | B-18 |
| 283 | A-13 | B-19 |
| 284 | A-13 | B-20 |
| 285 | A-13 | B-21 |
| 286 | A-13 | B-22 |
| 287 | A-14 | B-1 |
| 288 | A-14 | B-2 |
| 289 | A-14 | B-3 |
| 290 | A-14 | B-4 |
| 291 | A-14 | B-5 |
| 292 | A-14 | B-6 |
| 293 | A-14 | B-7 |
| 294 | A-14 | B-8 |
| 295 | A-14 | B-9 |

(fortgesetzt)

| Formel (EM-1-1-1-1-X) mit X= | Teil A | Teil B |
|---:|---|---|
| 296 | A-14 | B-10 |
| 297 | A-14 | B-11 |
| 298 | A-14 | B-12 |
| 299 | A-14 | B-13 |
| 300 | A-14 | B-14 |
| 301 | A-14 | B-15 |
| 302 | A-14 | B-16 |
| 303 | A-14 | B-17 |
| 304 | A-14 | B-18 |
| 305 | A-14 | B-19 |
| 306 | A-14 | B-20 |
| 307 | A-14 | B-21 |
| 308 | A-14 | B-22 |
| 309 | A-15 | B-1 |
| 310 | A-15 | B-2 |
| 311 | A-15 | B-3 |
| 312 | A-15 | B-4 |
| 313 | A-15 | B-5 |
| 314 | A-15 | B-6 |
| 315 | A-15 | B-7 |
| 316 | A-15 | B-8 |
| 317 | A-15 | B-9 |
| 318 | A-15 | B-10 |
| 319 | A-15 | B-11 |
| 320 | A-15 | B-12 |
| 321 | A-15 | B-13 |
| 322 | A-15 | B-14 |
| 323 | A-15 | B-15 |
| 324 | A-15 | B-16 |
| 325 | A-15 | B-17 |
| 326 | A-15 | B-18 |
| 327 | A-15 | B-19 |
| 328 | A-15 | B-20 |
| 329 | A-15 | B-21 |
| 330 | A-15 | B-22 |
| 331 | A-16 | B-1 |
| 332 | A-16 | B-2 |
| 333 | A-16 | B-3 |

(fortgesetzt)

| Formel (EM-1-1-1-1-X) mit X= | Teil A | Teil B |
|---|---|---|
| 334 | A-16 | B-4 |
| 335 | A-16 | B-5 |
| 336 | A-16 | B-6 |
| 337 | A-16 | B-7 |
| 338 | A-16 | B-8 |
| 339 | A-16 | B-9 |
| 340 | A-16 | B-10 |
| 341 | A-16 | B-11 |
| 342 | A-16 | B-12 |
| 343 | A-16 | B-13 |
| 344 | A-16 | B-14 |
| 345 | A-16 | B-15 |
| 346 | A-16 | B-16 |
| 347 | A-16 | B-17 |
| 348 | A-16 | B-18 |
| 349 | A-16 | B-19 |
| 350 | A-16 | B-20 |
| 351 | A-16 | B-21 |
| 352 | A-16 | B-22 |
| 353 | A-17 | B-1 |
| 354 | A-17 | B-2 |
| 355 | A-17 | B-3 |
| 356 | A-17 | B-4 |
| 357 | A-17 | B-5 |
| 358 | A-17 | B-6 |
| 359 | A-17 | B-7 |
| 360 | A-17 | B-8 |
| 361 | A-17 | B-9 |
| 362 | A-17 | B-10 |
| 363 | A-17 | B-11 |
| 364 | A-17 | B-12 |
| 365 | A-17 | B-13 |
| 366 | A-17 | B-14 |
| 367 | A-17 | B-15 |
| 368 | A-17 | B-16 |
| 369 | A-17 | B-17 |
| 370 | A-17 | B-18 |
| 371 | A-17 | B-19 |

(fortgesetzt)

| Formel (EM-1-1-1-1-X) mit X= | Teil A | Teil B |
|---|---|---|
| 372 | A-17 | B-20 |
| 373 | A-17 | B-21 |
| 374 | A-17 | B-22 |
| 375 | A-18 | B-1 |
| 376 | A-18 | B-2 |
| 377 | A-18 | B-3 |
| 378 | A-18 | B-4 |
| 379 | A-18 | B-5 |
| 380 | A-18 | B-6 |
| 381 | A-18 | B-7 |
| 382 | A-18 | B-8 |
| 383 | A-18 | B-9 |
| 384 | A-18 | B-10 |
| 385 | A-18 | B-11 |
| 386 | A-18 | B-12 |
| 387 | A-18 | B-13 |
| 388 | A-18 | B-14 |
| 389 | A-18 | B-15 |
| 390 | A-18 | B-16 |
| 391 | A-18 | B-17 |
| 392 | A-18 | B-18 |
| 393 | A-18 | B-19 |
| 394 | A-18 | B-20 |
| 395 | A-18 | B-21 |
| 396 | A-18 | B-22 |
| 397 | A-19 | B-1 |
| 398 | A-19 | B-2 |
| 399 | A-19 | B-3 |
| 400 | A-19 | B-4 |
| 401 | A-19 | B-5 |
| 402 | A-19 | B-6 |
| 403 | A-19 | B-7 |
| 404 | A-19 | B-8 |
| 405 | A-19 | B-9 |
| 406 | A-19 | B-10 |
| 407 | A-19 | B-11 |
| 408 | A-19 | B-12 |
| 409 | A-19 | B-13 |

(fortgesetzt)

| Formel (EM-1-1-1-1-X) mit X= | Teil A | Teil B |
|---|---|---|
| 410 | A-19 | B-14 |
| 411 | A-19 | B-15 |
| 412 | A-19 | B-16 |
| 413 | A-19 | B-17 |
| 414 | A-19 | B-18 |
| 415 | A-19 | B-19 |
| 416 | A-19 | B-20 |
| 417 | A-19 | B-21 |
| 418 | A-19 | B-22 |
| 419 | A-20 | B-1 |
| 420 | A-20 | B-2 |
| 421 | A-20 | B-3 |
| 422 | A-20 | B-4 |
| 423 | A-20 | B-5 |
| 424 | A-20 | B-6 |
| 425 | A-20 | B-7 |
| 426 | A-20 | B-8 |
| 427 | A-20 | B-9 |
| 428 | A-20 | B-10 |
| 429 | A-20 | B-11 |
| 430 | A-20 | B-12 |
| 431 | A-20 | B-13 |
| 432 | A-20 | B-14 |
| 433 | A-20 | B-15 |
| 434 | A-20 | B-16 |
| 435 | A-20 | B-17 |
| 436 | A-20 | B-18 |
| 437 | A-20 | B-19 |
| 438 | A-20 | B-20 |
| 439 | A-20 | B-21 |
| 440 | A-20 | B-22 |
| 441 | A-21 | B-1 |
| 442 | A-21 | B-2 |
| 443 | A-21 | B-3 |
| 444 | A-21 | B-4 |
| 445 | A-21 | B-5 |
| 446 | A-21 | B-6 |
| 447 | A-21 | B-7 |

(fortgesetzt)

| Formel (EM-1-1-1-1-X) mit X= | Teil A | Teil B |
|---|---|---|
| 448 | A-21 | B-8 |
| 449 | A-21 | B-9 |
| 450 | A-21 | B-10 |
| 451 | A-21 | B-11 |
| 452 | A-21 | B-12 |
| 453 | A-21 | B-13 |
| 454 | A-21 | B-14 |
| 455 | A-21 | B-15 |
| 456 | A-21 | B-16 |
| 457 | A-21 | B-17 |
| 458 | A-21 | B-18 |
| 459 | A-21 | B-19 |
| 460 | A-21 | B-20 |
| 461 | A-21 | B-21 |
| 462 | A-21 | B-22 |
| 463 | A-22 | B-1 |
| 464 | A-22 | B-2 |
| 465 | A-22 | B-3 |
| 466 | A-22 | B-4 |
| 467 | A-22 | B-5 |
| 468 | A-22 | B-6 |
| 469 | A-22 | B-7 |
| 470 | A-22 | B-8 |
| 471 | A-22 | B-9 |
| 472 | A-22 | B-10 |
| 473 | A-22 | B-11 |
| 474 | A-22 | B-12 |
| 475 | A-22 | B-13 |
| 476 | A-22 | B-14 |
| 477 | A-22 | B-15 |
| 478 | A-22 | B-16 |
| 479 | A-22 | B-17 |
| 480 | A-22 | B-18 |
| 481 | A-22 | B-19 |
| 482 | A-22 | B-20 |
| 483 | A-22 | B-21 |
| 484 | A-22 | B-22 |
| 485 | A-23 | B-1 |

(fortgesetzt)

| Formel (EM-1-1-1-1-X) mit X= | Teil A | Teil B |
|---|---|---|
| 486 | A-23 | B-2 |
| 487 | A-23 | B-3 |
| 488 | A-23 | B-4 |
| 489 | A-23 | B-5 |
| 490 | A-23 | B-6 |
| 491 | A-23 | B-7 |
| 492 | A-23 | B-8 |
| 493 | A-23 | B-9 |
| 494 | A-23 | B-10 |
| 495 | A-23 | B-11 |
| 496 | A-23 | B-12 |
| 497 | A-23 | B-13 |
| 498 | A-23 | B-14 |
| 499 | A-23 | B-15 |
| 500 | A-23 | B-16 |
| 501 | A-23 | B-17 |
| 502 | A-23 | B-18 |
| 503 | A-23 | B-19 |
| 504 | A-23 | B-20 |
| 505 | A-23 | B-21 |
| 506 | A-23 | B-22 |
| 507 | A-24 | B-1 |
| 508 | A-24 | B-2 |
| 509 | A-24 | B-3 |
| 510 | A-24 | B-4 |
| 511 | A-24 | B-5 |
| 512 | A-24 | B-6 |
| 513 | A-24 | B-7 |
| 514 | A-24 | B-8 |
| 515 | A-24 | B-9 |
| 516 | A-24 | B-10 |
| 517 | A-24 | B-11 |
| 518 | A-24 | B-12 |
| 519 | A-24 | B-13 |
| 520 | A-24 | B-14 |
| 521 | A-24 | B-15 |
| 522 | A-24 | B-16 |
| 523 | A-24 | B-17 |

(fortgesetzt)

| Formel (EM-1-1-1-1-X) mit X= | Teil A | Teil B |
|---:|---|---|
| 524 | A-24 | B-18 |
| 525 | A-24 | B-19 |
| 526 | A-24 | B-20 |
| 527 | A-24 | B-21 |
| 528 | A-24 | B-22 |
| 529 | A-25 | B-1 |
| 530 | A-25 | B-2 |
| 531 | A-25 | B-3 |
| 532 | A-25 | B-4 |
| 533 | A-25 | B-5 |
| 534 | A-25 | B-6 |
| 535 | A-25 | B-7 |
| 536 | A-25 | B-8 |
| 537 | A-25 | B-9 |
| 538 | A-25 | B-10 |
| 539 | A-25 | B-11 |
| 540 | A-25 | B-12 |
| 541 | A-25 | B-13 |
| 542 | A-25 | B-14 |
| 543 | A-25 | B-15 |
| 544 | A-25 | B-16 |
| 545 | A-25 | B-17 |
| 546 | A-25 | B-18 |
| 547 | A-25 | B-19 |
| 548 | A-25 | B-20 |
| 549 | A-25 | B-21 |
| 550 | A-25 | B-22 |
| 551 | A-26 | B-1 |
| 552 | A-26 | B-2 |
| 553 | A-26 | B-3 |
| 554 | A-26 | B-4 |
| 555 | A-26 | B-5 |
| 556 | A-26 | B-6 |
| 557 | A-26 | B-7 |
| 558 | A-26 | B-8 |
| 559 | A-26 | B-9 |
| 560 | A-26 | B-10 |
| 561 | A-26 | B-11 |

(fortgesetzt)

| Formel (EM-1-1-1-1-X) mit X= | Teil A | Teil B |
|---|---|---|
| 562 | A-26 | B-12 |
| 563 | A-26 | B-13 |
| 564 | A-26 | B-14 |
| 565 | A-26 | B-15 |
| 566 | A-26 | B-16 |
| 567 | A-26 | B-17 |
| 568 | A-26 | B-18 |
| 569 | A-26 | B-19 |
| 570 | A-26 | B-20 |
| 571 | A-26 | B-21 |
| 572 | A-26 | B-22 |
| 573 | A-27 | B-1 |
| 574 | A-27 | B-2 |
| 575 | A-27 | B-3 |
| 576 | A-27 | B-4 |
| 577 | A-27 | B-5 |
| 578 | A-27 | B-6 |
| 579 | A-27 | B-7 |
| 580 | A-27 | B-8 |
| 581 | A-27 | B-9 |
| 582 | A-27 | B-10 |
| 583 | A-27 | B-11 |
| 584 | A-27 | B-12 |
| 585 | A-27 | B-13 |
| 586 | A-27 | B-14 |
| 587 | A-27 | B-15 |
| 588 | A-27 | B-16 |
| 589 | A-27 | B-17 |
| 590 | A-27 | B-18 |
| 591 | A-27 | B-19 |
| 592 | A-27 | B-20 |
| 593 | A-27 | B-21 |
| 594 | A-27 | B-22 |
| 595 | A-28 | B-1 |
| 596 | A-28 | B-2 |
| 597 | A-28 | B-3 |
| 598 | A-28 | B-4 |
| 599 | A-28 | B-5 |

(fortgesetzt)

| Formel (EM-1-1-1-1-X) mit X= | Teil A | Teil B |
|---|---|---|
| 600 | A-28 | B-6 |
| 601 | A-28 | B-7 |
| 602 | A-28 | B-8 |
| 603 | A-28 | B-9 |
| 604 | A-28 | B-10 |
| 605 | A-28 | B-11 |
| 606 | A-28 | B-12 |
| 607 | A-28 | B-13 |
| 608 | A-28 | B-14 |
| 609 | A-28 | B-15 |
| 610 | A-28 | B-16 |
| 611 | A-28 | B-17 |
| 612 | A-28 | B-18 |
| 613 | A-28 | B-19 |
| 614 | A-28 | B-20 |
| 615 | A-28 | B-21 |
| 616 | A-28 | B-22 |
| 617 | A-29 | B-1 |
| 618 | A-29 | B-2 |
| 619 | A-29 | B-3 |
| 620 | A-29 | B-4 |
| 621 | A-29 | B-5 |
| 622 | A-29 | B-6 |
| 623 | A-29 | B-7 |
| 624 | A-29 | B-8 |
| 625 | A-29 | B-9 |
| 626 | A-29 | B-10 |
| 627 | A-29 | B-11 |
| 628 | A-29 | B-12 |
| 629 | A-29 | B-13 |
| 630 | A-29 | B-14 |
| 631 | A-29 | B-15 |
| 632 | A-29 | B-16 |
| 633 | A-29 | B-17 |
| 634 | A-29 | B-18 |
| 635 | A-29 | B-19 |
| 636 | A-29 | B-20 |
| 637 | A-29 | B-21 |

(fortgesetzt)

| Formel (EM-1-1-1-1-X) mit X= | Teil A | Teil B |
|---|---|---|
| 638 | A-29 | B-22 |
| 639 | A-30 | B-1 |
| 640 | A-30 | B-2 |
| 641 | A-30 | B-3 |
| 642 | A-30 | B-4 |
| 643 | A-30 | B-5 |
| 644 | A-30 | B-6 |
| 645 | A-30 | B-7 |
| 646 | A-30 | B-8 |
| 647 | A-30 | B-9 |
| 648 | A-30 | B-10 |
| 649 | A-30 | B-11 |
| 650 | A-30 | B-12 |
| 651 | A-30 | B-13 |
| 652 | A-30 | B-14 |
| 653 | A-30 | B-15 |
| 654 | A-30 | B-16 |
| 655 | A-30 | B-17 |
| 656 | A-30 | B-18 |
| 657 | A-30 | B-19 |
| 658 | A-30 | B-20 |
| 659 | A-30 | B-21 |
| 660 | A-30 | B-22 |

Bevorzugte Verbindungen gemäß Formel (EM-1) sind in der folgenden Tabelle gezeigt:

| | | |
|---|---|---|
| 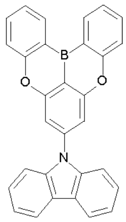 | 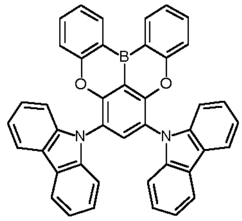 | 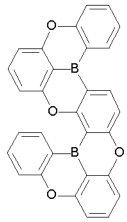 |
| 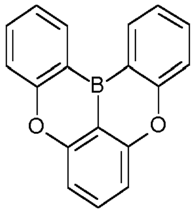 | 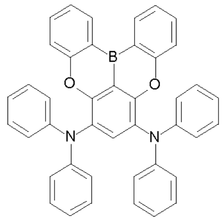 | 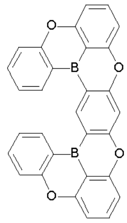 |
| 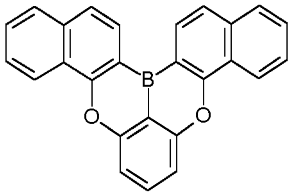 | 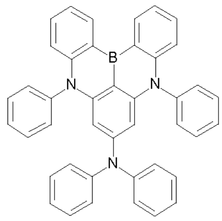 | 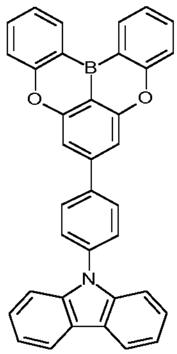 |
| 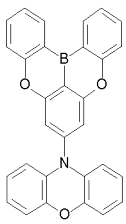 | 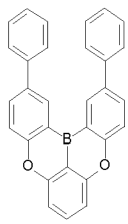 | 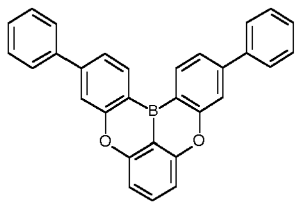 |
| 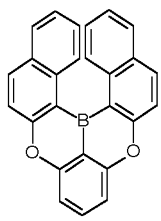 | 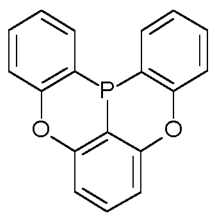 | 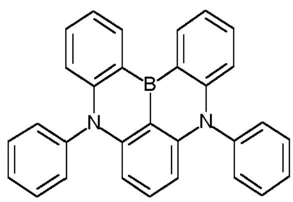 |

| | | |
|---|---|---|
| 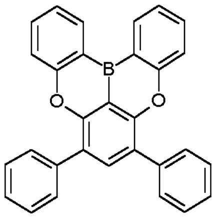 | 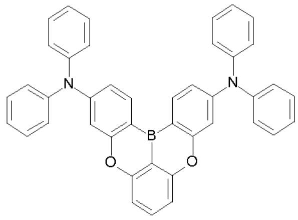 | 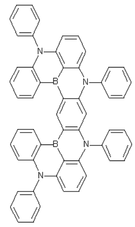 |
| 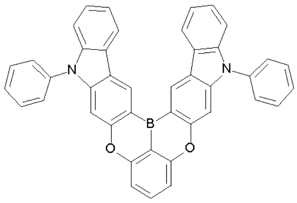 | 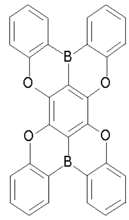 | 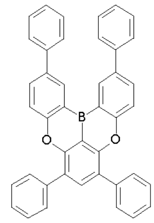 |
| 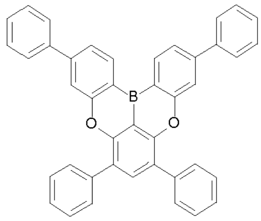 | 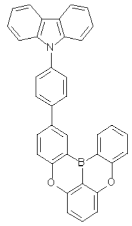 | 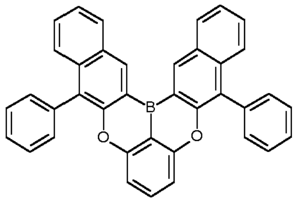 |
| 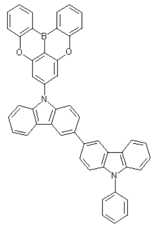 | 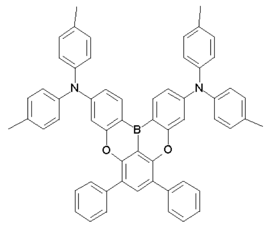 | 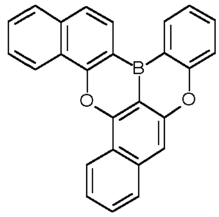 |
| 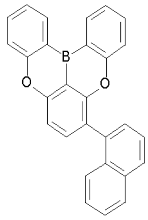 | 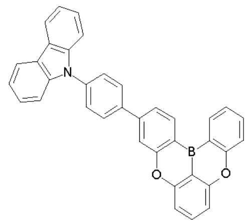 | 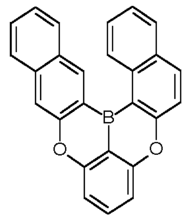 |
| 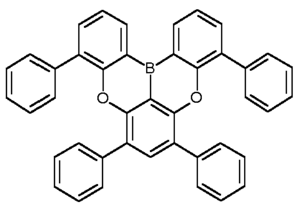 | 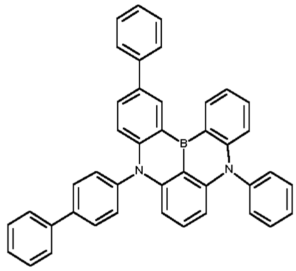 | 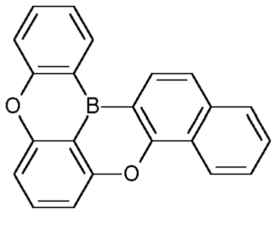 |
| 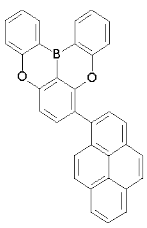 | 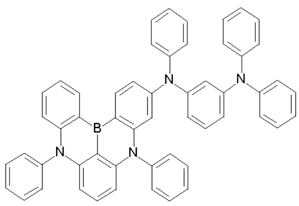 | 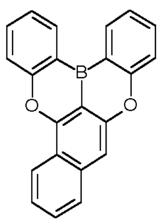 |

| | | |
|---|---|---|
| 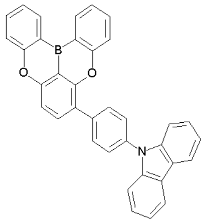 | 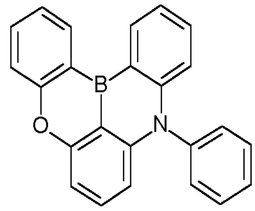 | 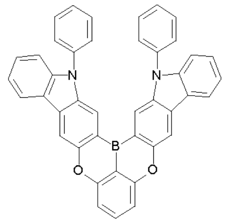 |
| 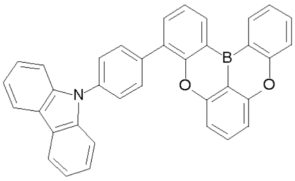 | 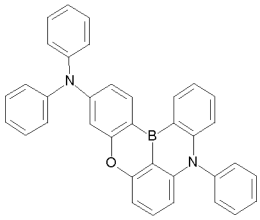 | 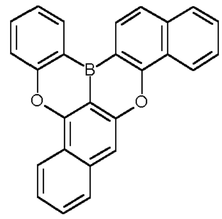 |
| 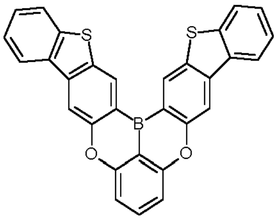 | 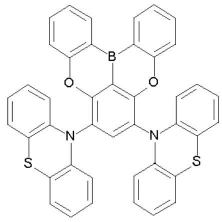 | 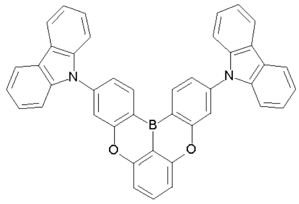 |
| 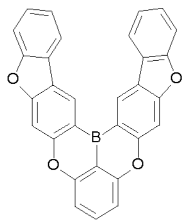 | 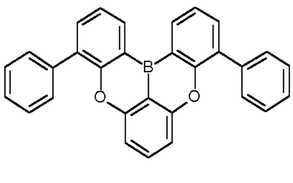 | 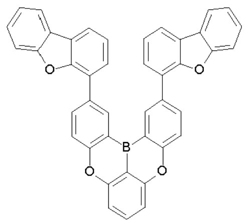 |
| 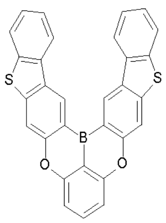 | 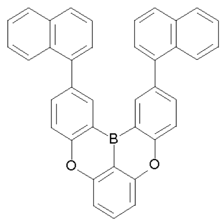 | 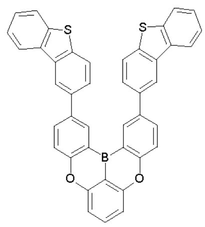 |
| 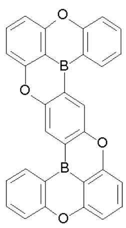 | 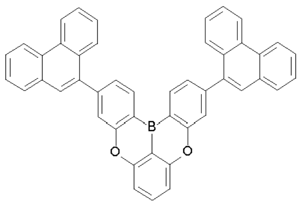 | 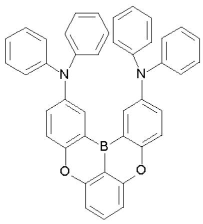 |
| 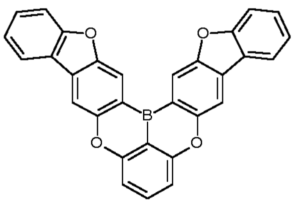 | 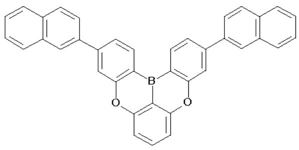 | 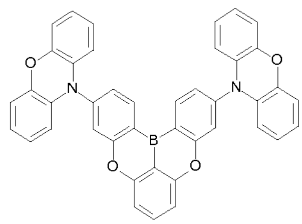 |

| | | |
|---|---|---|
| 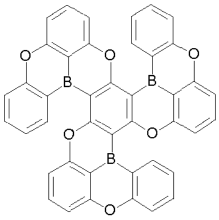 | 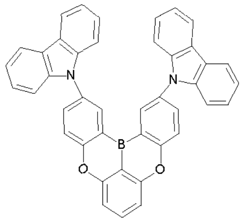 | 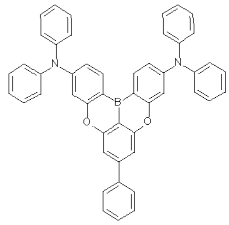 |
| 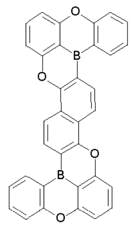 | 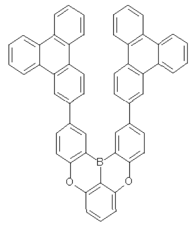 | 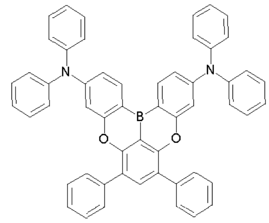 |
| 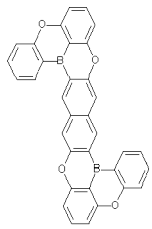 | 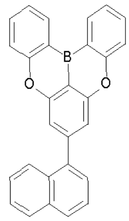 | 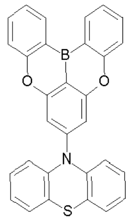 |
| 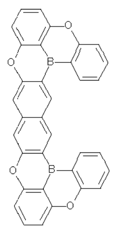 | 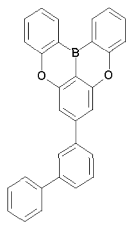 | 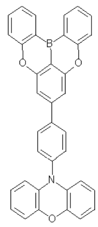 |
| 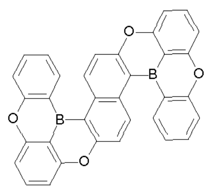 | 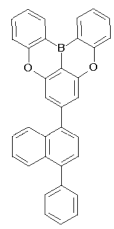 | 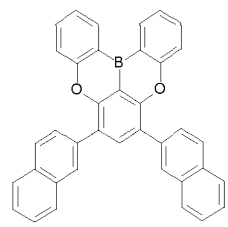 |
| 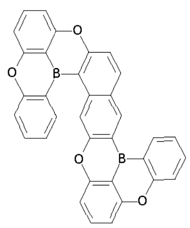 | 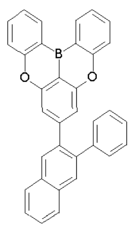 | 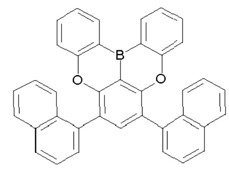 |
| 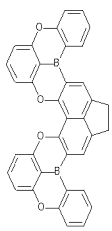 | 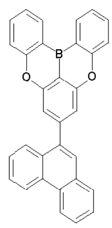 | 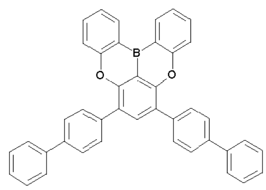 |

| | | |
|---|---|---|
| 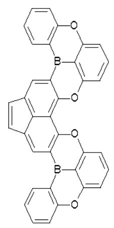 | 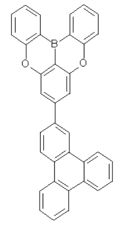 | 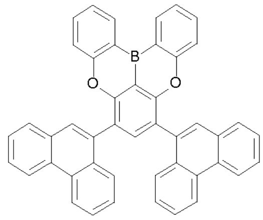 |
| 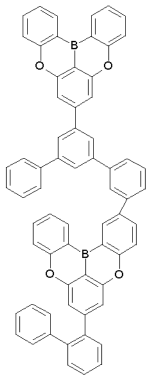 | 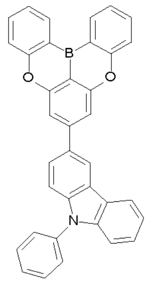 | 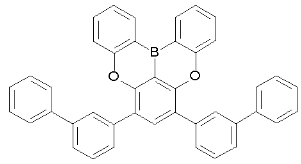 |
| 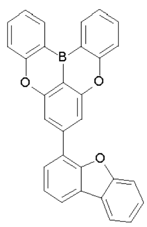 | 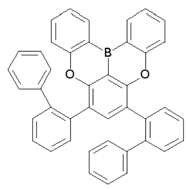 | 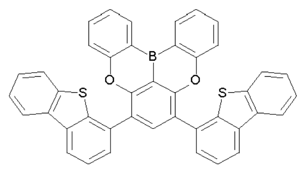 |
| 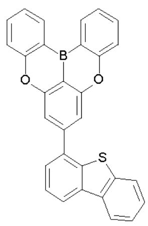 | 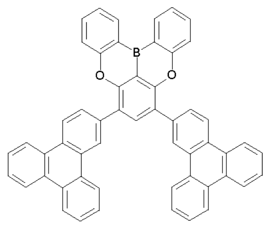 | 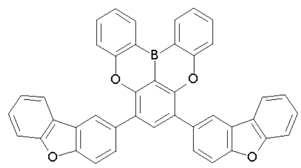 |
| 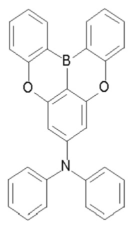 | 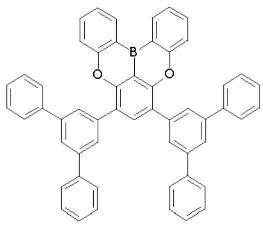 | 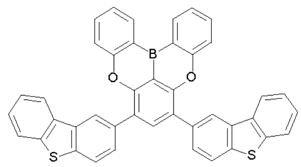 |
| 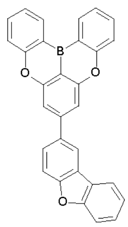 | 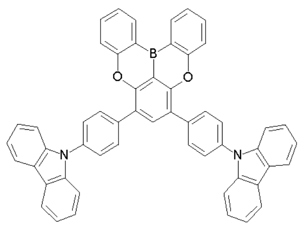 | 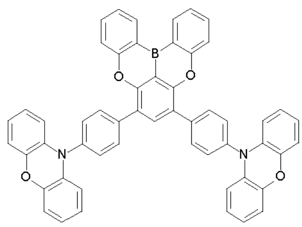 |

| | | |
|---|---|---|
| 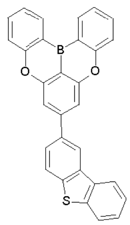 | 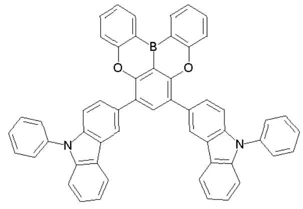 | 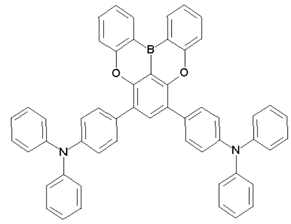 |
| 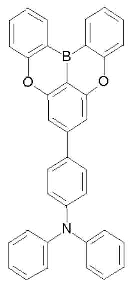 | 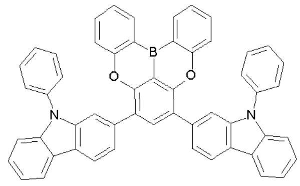 | 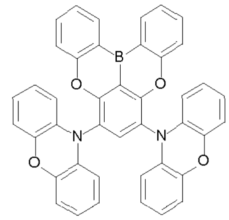 |
| 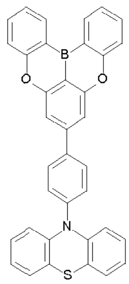 | 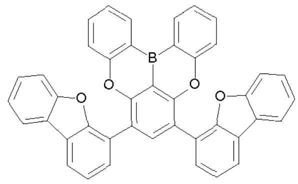 | 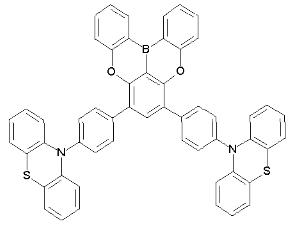 |
| 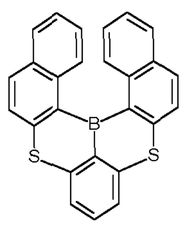 | 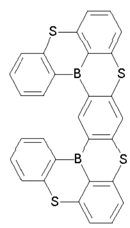 | 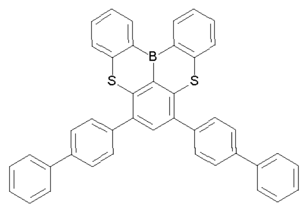 |
| 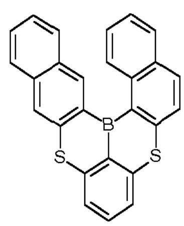 | 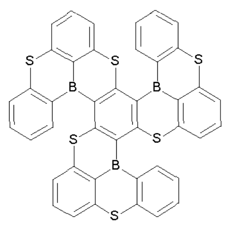 | 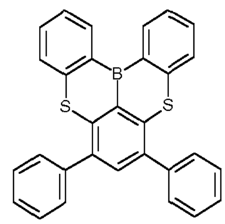 |
| 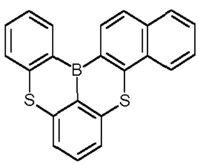 | 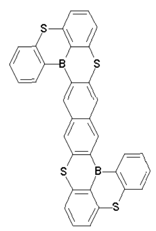 | 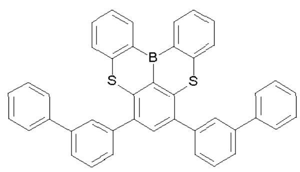 |

| | | |
|---|---|---|
| 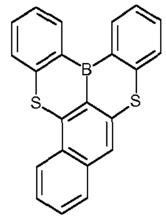 | 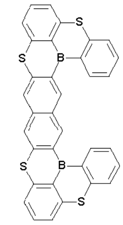 | 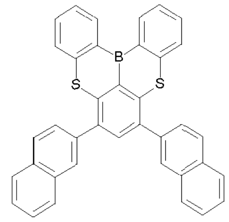 |
| 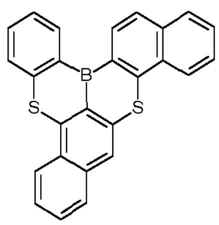 | 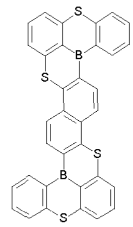 | 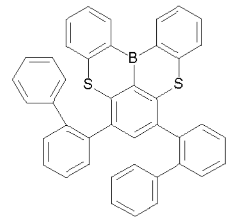 |
| 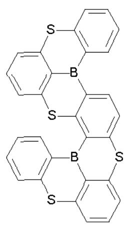 | 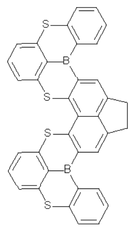 | 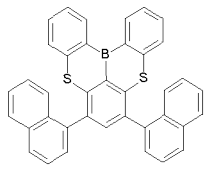 |
| 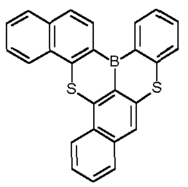 | 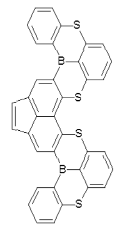 | 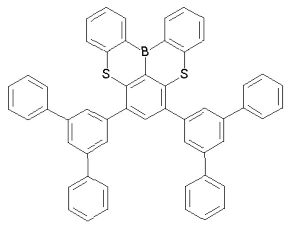 |
| 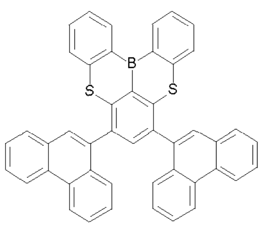 | 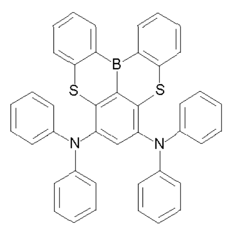 | 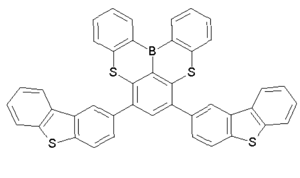 |
| 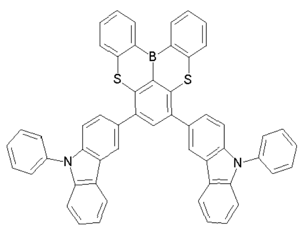 | 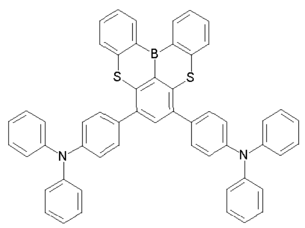 | 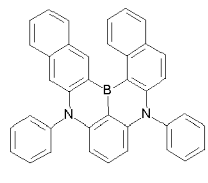 |
| 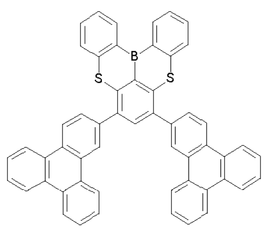 | 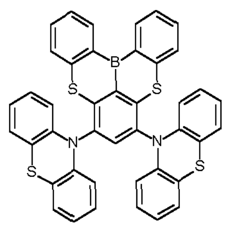 | 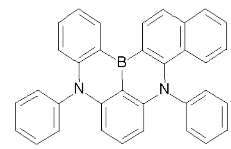 |

| | | |
|---|---|---|
| 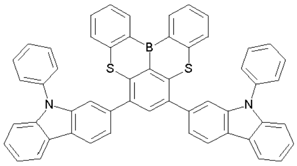 | 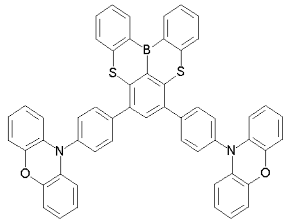 | 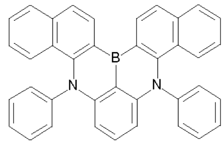 |
| 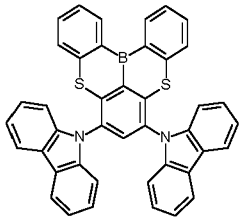 | 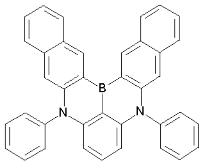 | 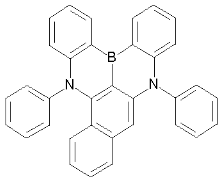 |
| 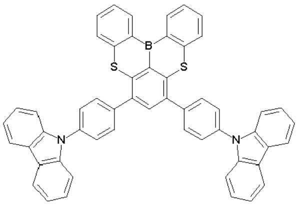 | 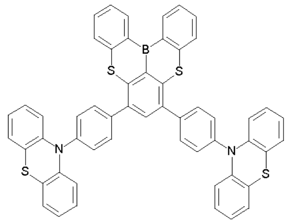 | 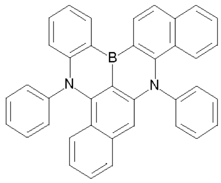 |
| 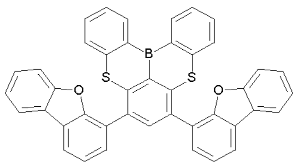 | 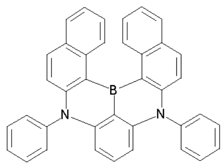 | 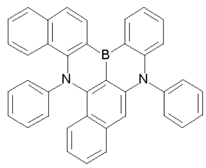 |
| 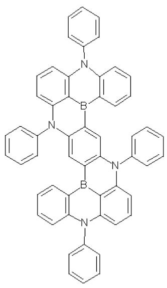 | 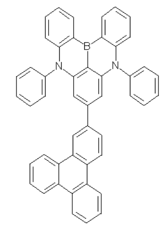 | 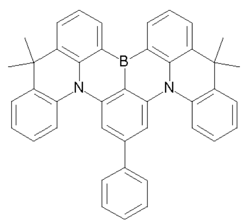 |
| 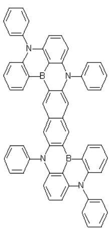 | 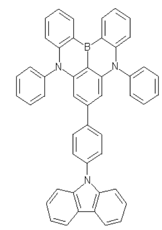 | 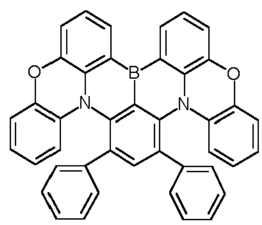 |
| 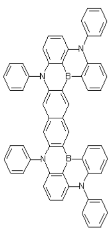 | 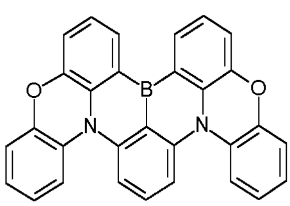 | 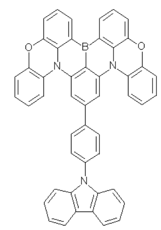 |

| | | |
|---|---|---|
| 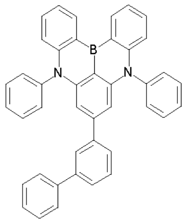 | 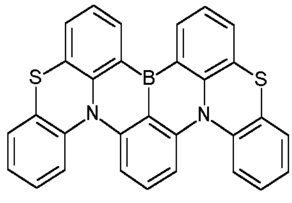 | 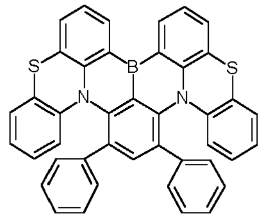 |
| 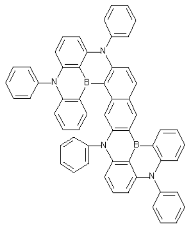 | 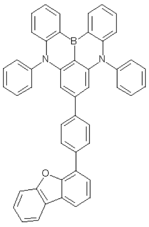 | 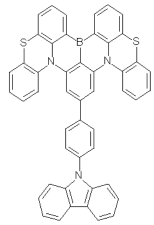 |
| 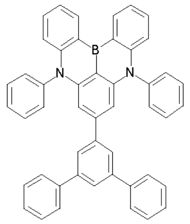 | 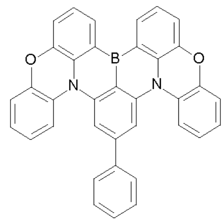 | 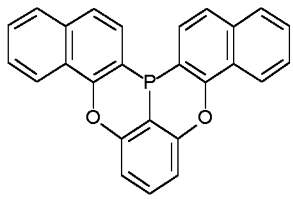 |
| 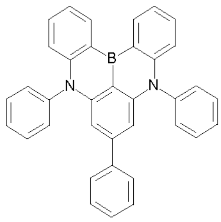 | 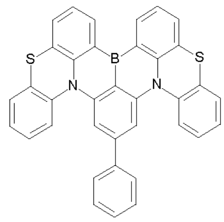 | 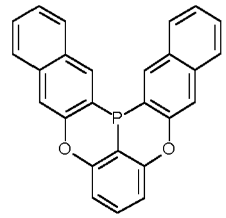 |
| 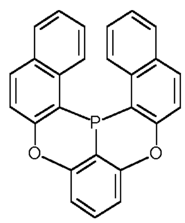 | 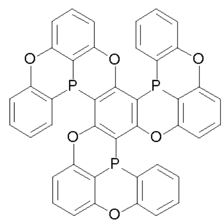 | 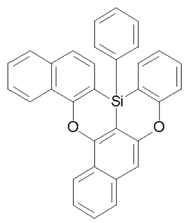 |
| 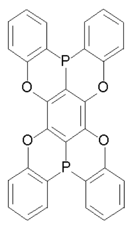 | 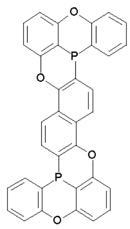 | 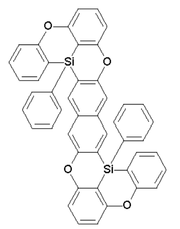 |
| 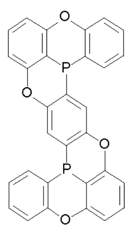 | 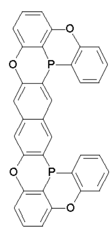 | 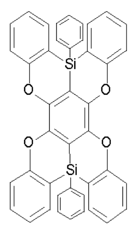 |

| | | |
|---|---|---|
| 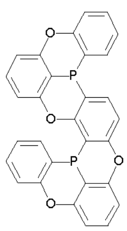 | 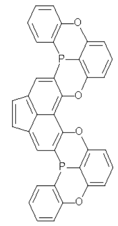 | 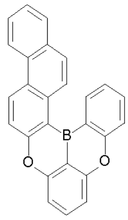 |
| 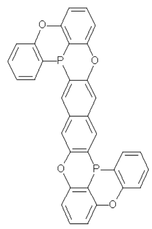 | 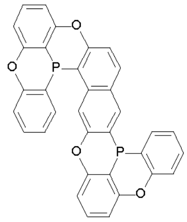 | 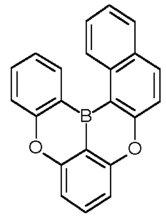 |
| 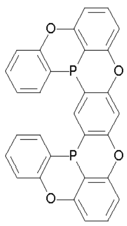 | 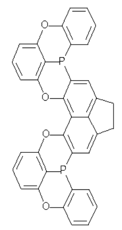 | 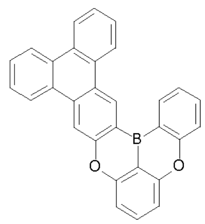 |
| 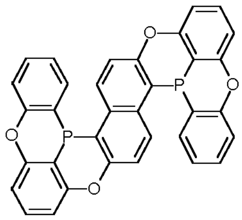 | 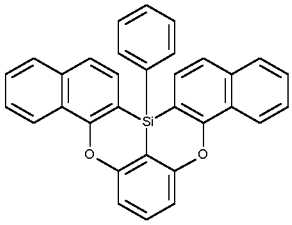 | 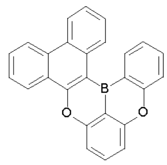 |
| 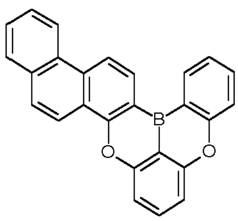 | 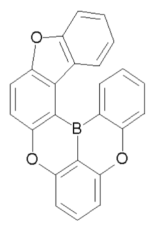 | 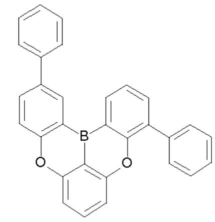 |
| 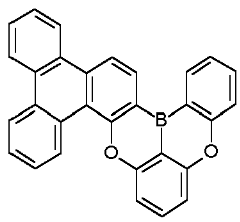 | 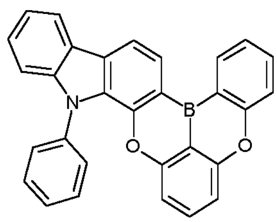 | 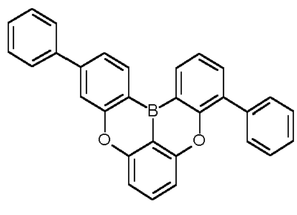 |
| 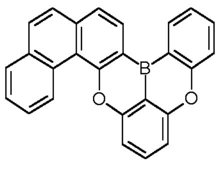 | 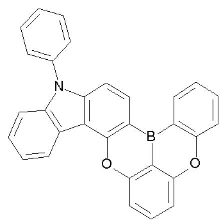 | 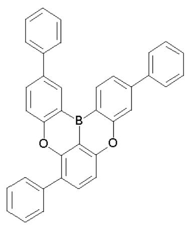 |

| | | |
|---|---|---|
| 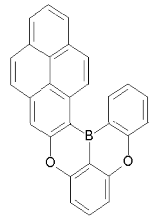 | 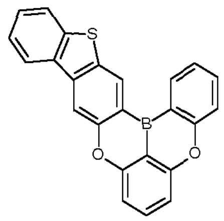 | 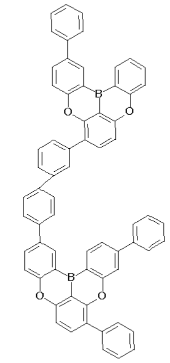 |
| 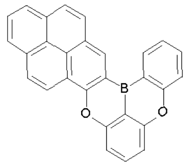 | 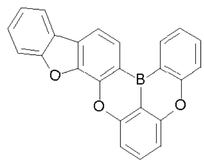 | 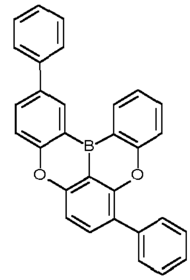 |
| 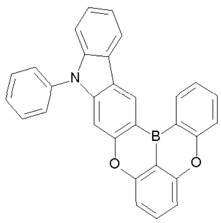 | 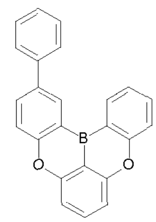 | 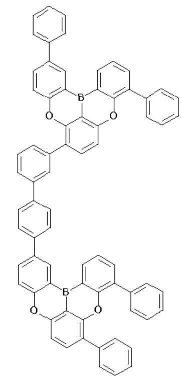 |
| 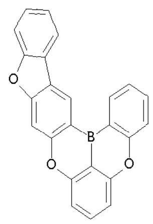 | 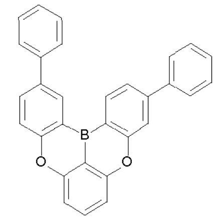 | 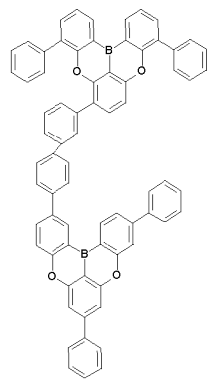 |
| 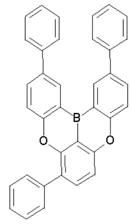 | 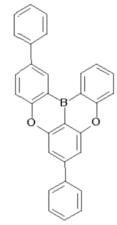 | 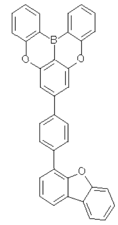 |

| | | |
|---|---|---|
| 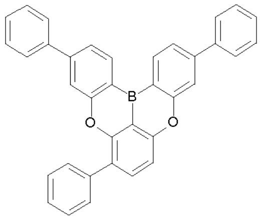 | 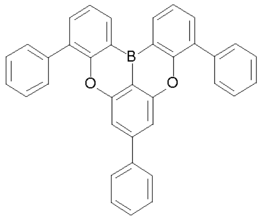 | 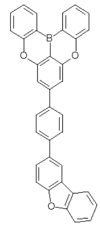 |
| 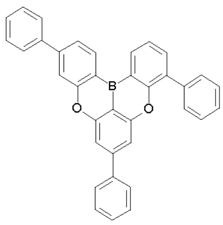 | 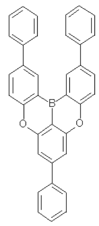 | 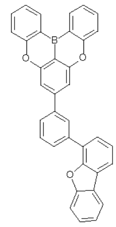 |
| 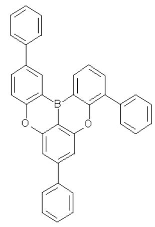 | 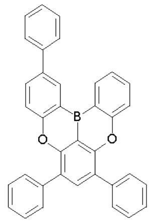 | 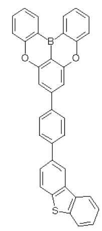 |
| 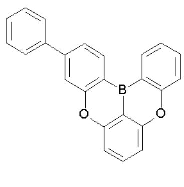 | 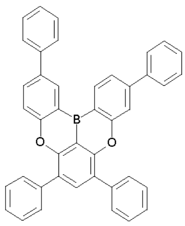 | 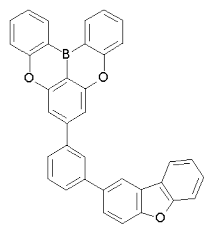 |
| 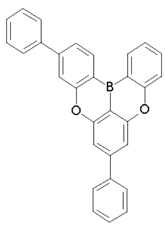 | 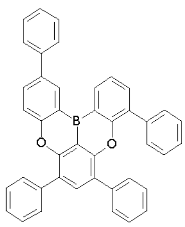 | 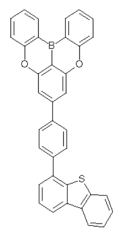 |
| 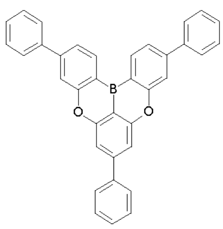 | 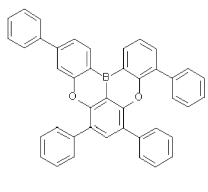 | 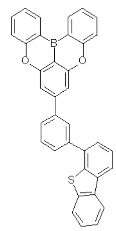 |
| 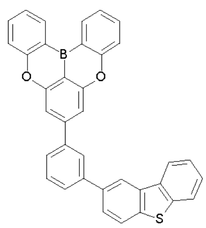 | 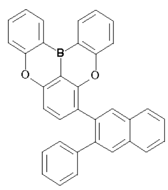 | 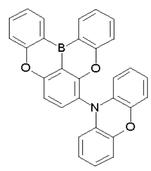 |

| | | |
|---|---|---|
| 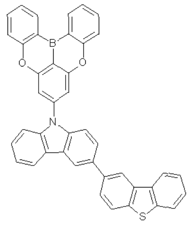 | 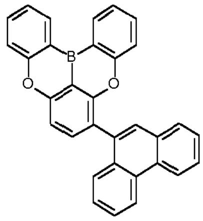 | 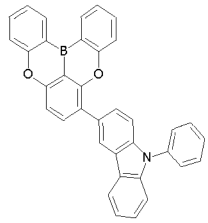 |
| 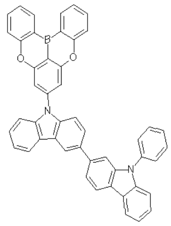 | 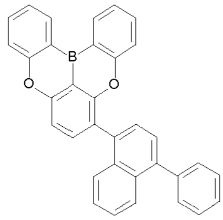 | 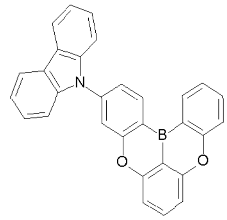 |
| 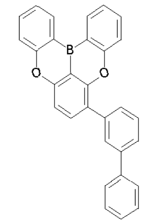 | 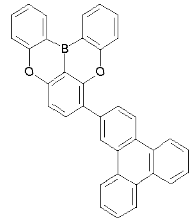 | 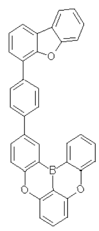 |
| 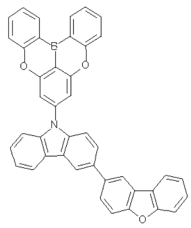 | 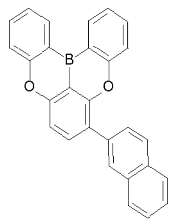 | 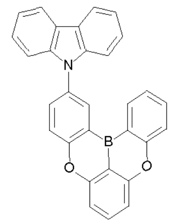 |
| 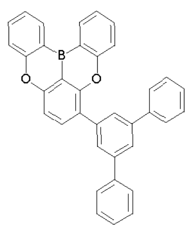 | 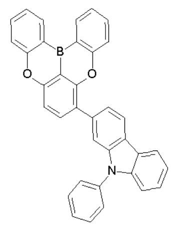 | 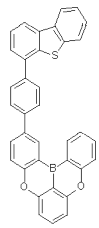 |
| 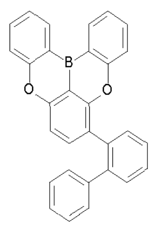 | 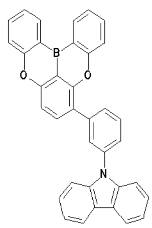 | 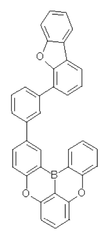 |
| 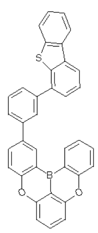 | 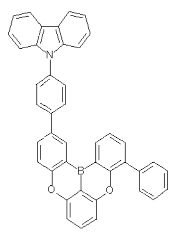 | 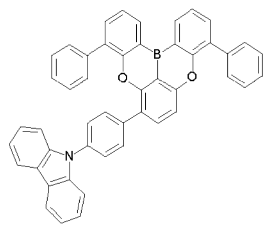 |

| | | |
|---|---|---|
| 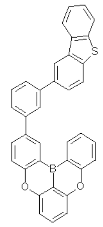 | 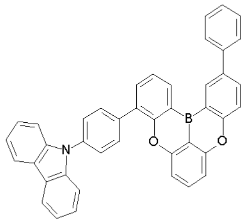 | 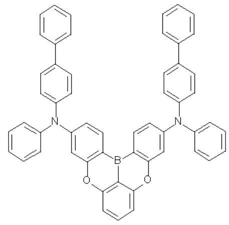 |
| 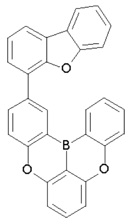 | 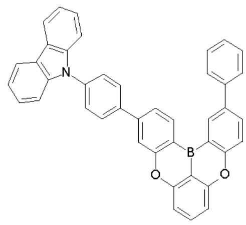 | 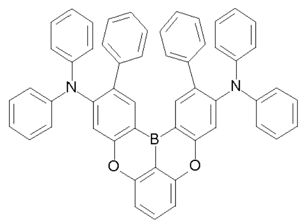 |
| 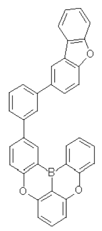 | 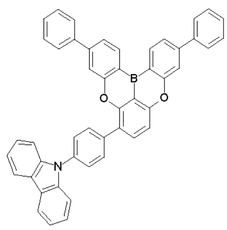 | 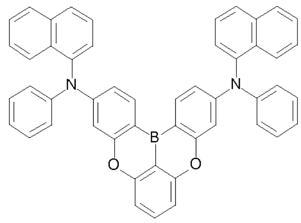 |
| 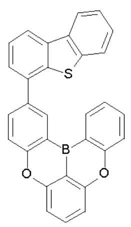 | 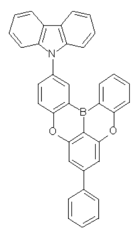 | 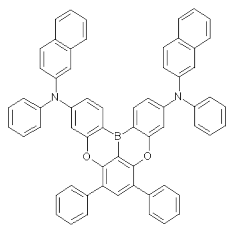 |
| 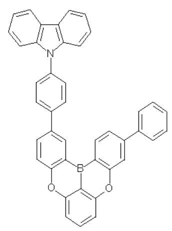 | 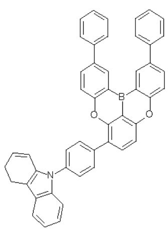 | 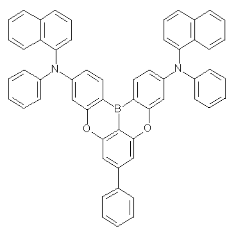 |
| 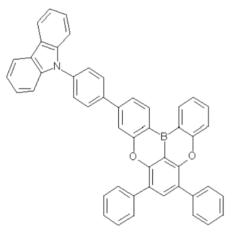 | 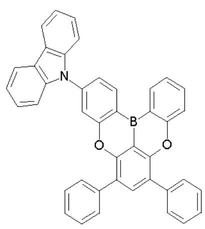 | 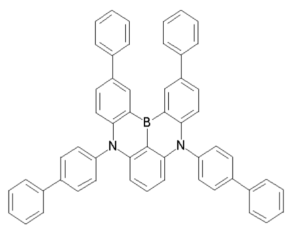 |
| 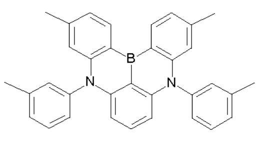 | 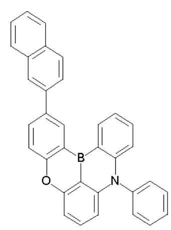 | 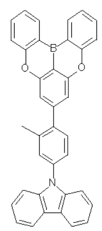 |

| | | |
|---|---|---|
| 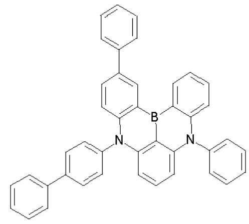 | 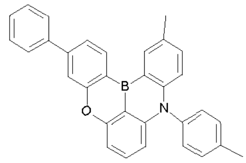 | 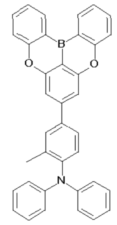 |
| 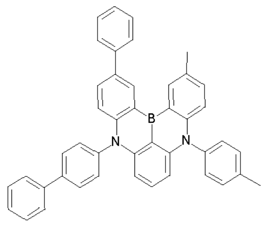 | 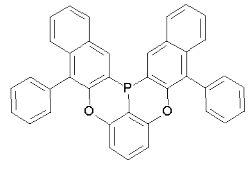 | 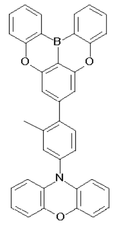 |
| 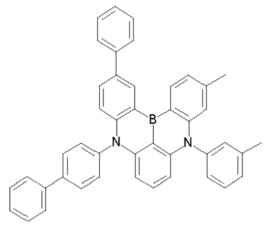 | 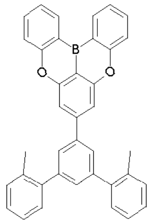 | 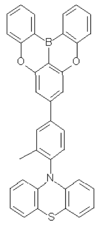 |
| 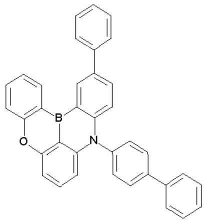 | 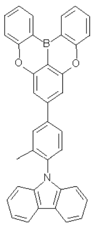 | 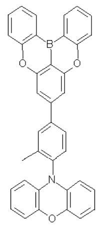 |
| 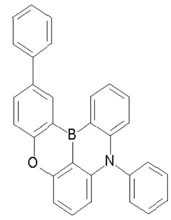 | 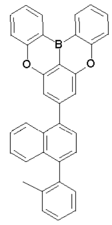 | 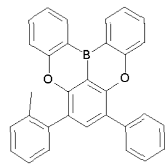 |
| 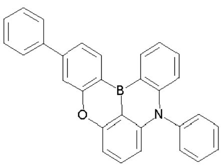 | 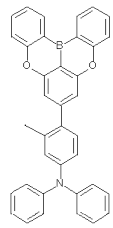 | 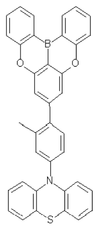 |
| 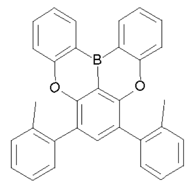 | 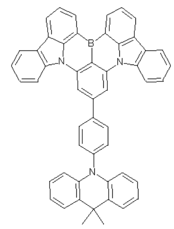 | 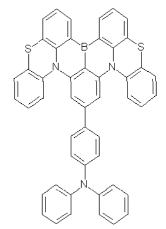 |

| | | |
|---|---|---|
| 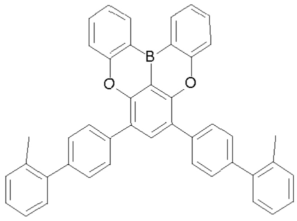 | 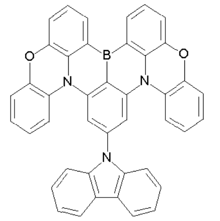 | 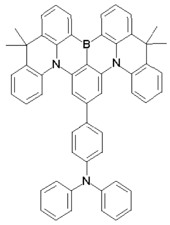 |
| 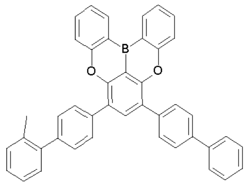 | 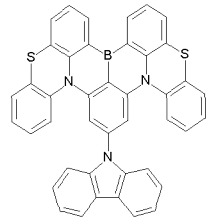 | 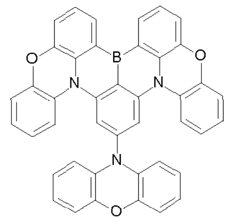 |
| 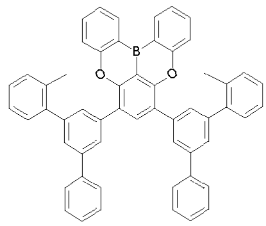 | 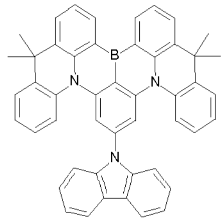 | 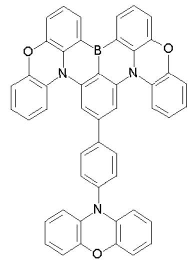 |
| 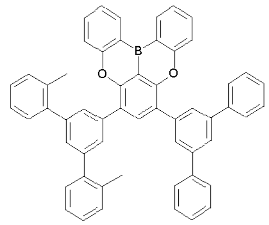 | 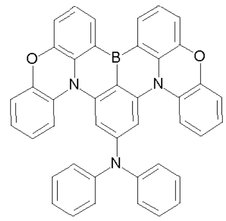 | 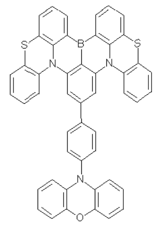 |
| 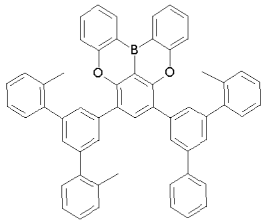 | 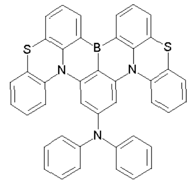 | 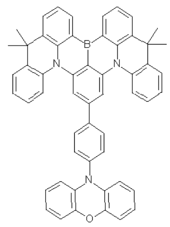 |
| 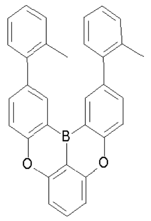 | 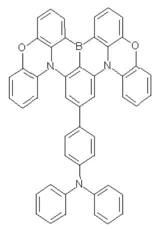 | 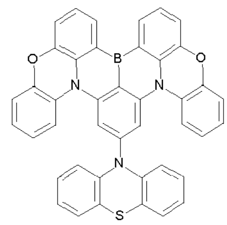 |
| 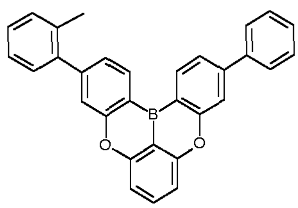 | 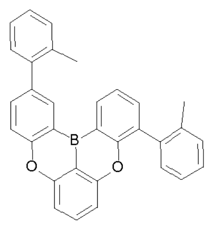 | 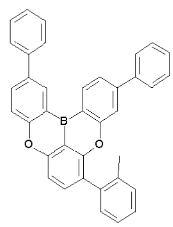 |

| | | |
|---|---|---|
| 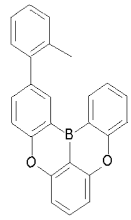 | 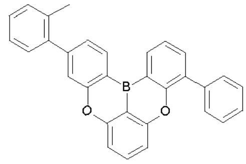 | 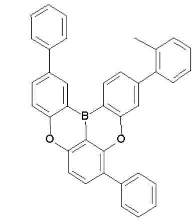 |
| 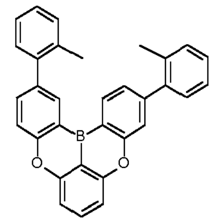 | 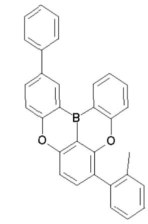 | 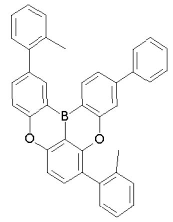 |
| 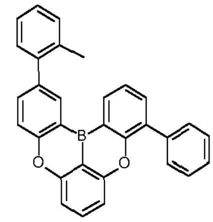 | 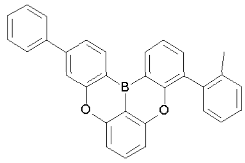 | 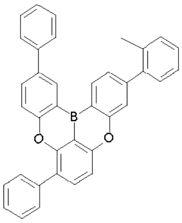 |
| 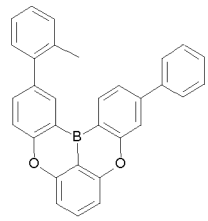 | 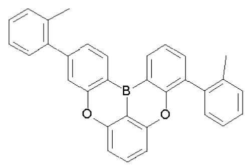 | 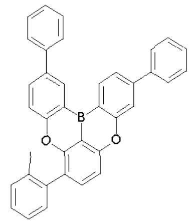 |
| 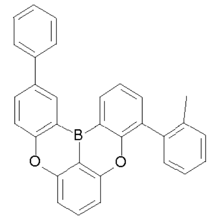 | 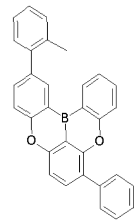 | 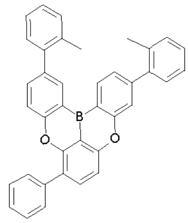 |
| 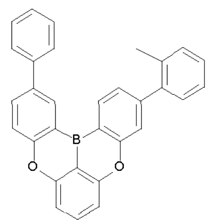 | 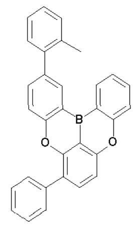 | 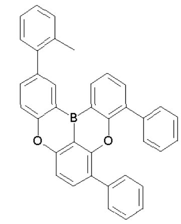 |
| 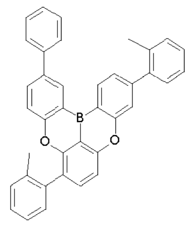 | 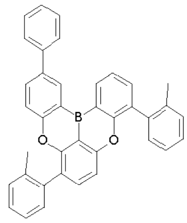 | 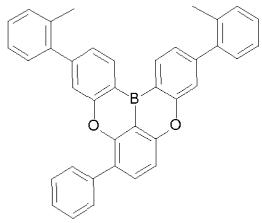 |

| | | |
|---|---|---|
| 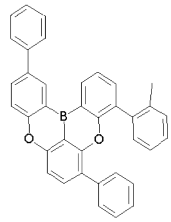 | 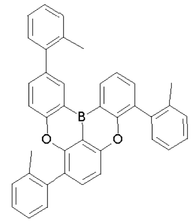 | 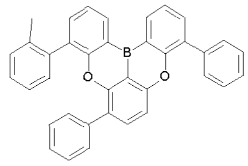 |
| 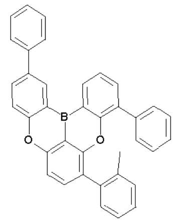 | 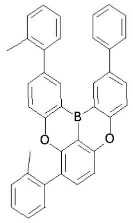 | 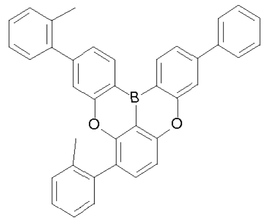 |
| 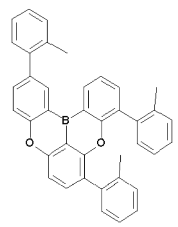 | 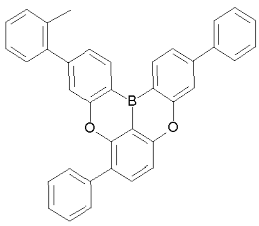 | 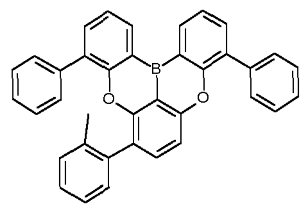 |
| 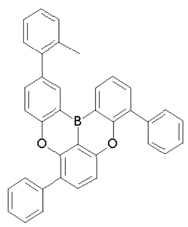 | 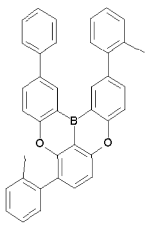 | 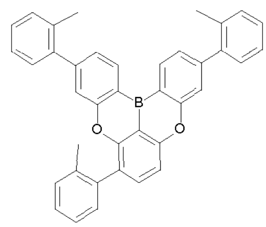 |
| 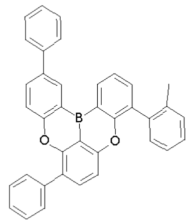 | 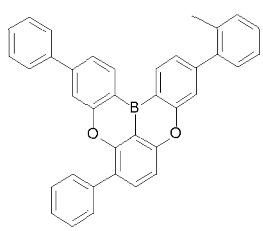 | 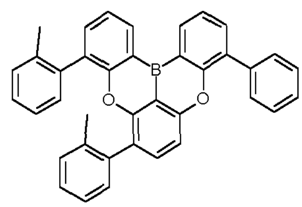 |
| 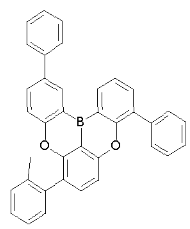 | 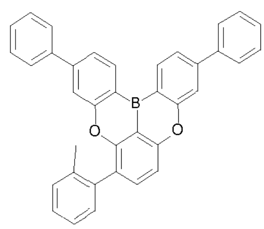 | 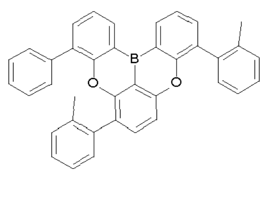 |
| 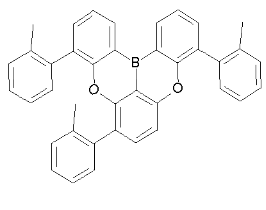 | 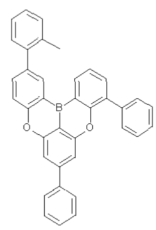 | 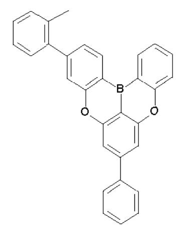 |

| | | |
|---|---|---|
| 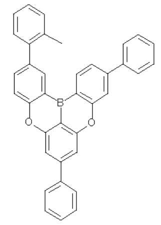 | 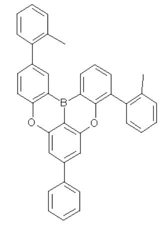 | 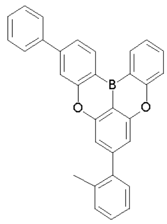 |
| 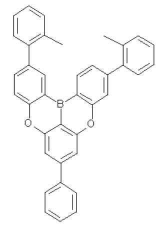 | 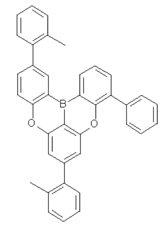 | 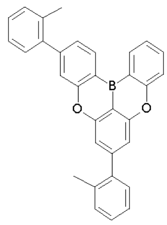 |
| 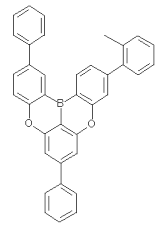 | 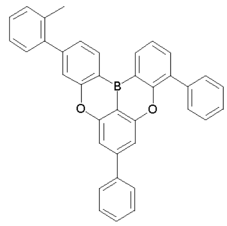 | 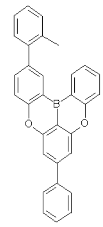 |
| 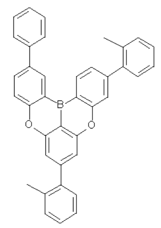 | 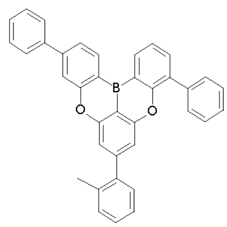 | 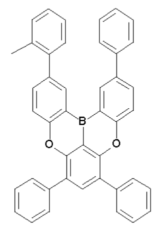 |
| 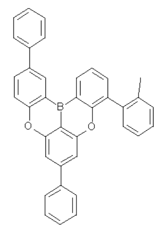 | 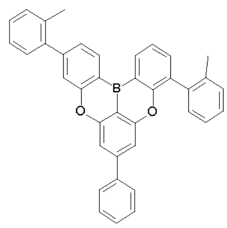 | 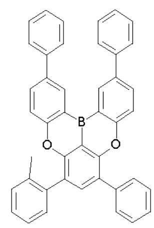 |
| 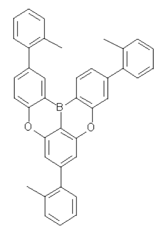 | 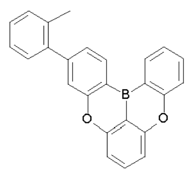 | 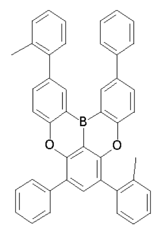 |
| 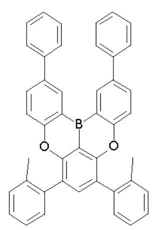 | 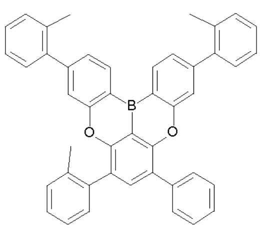 | 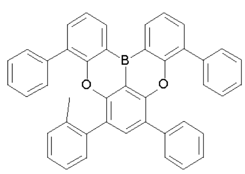 |

| | | |
|---|---|---|
| 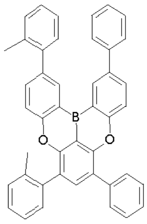 | 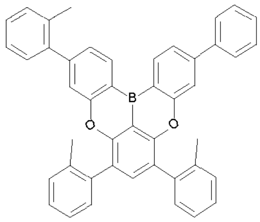 | 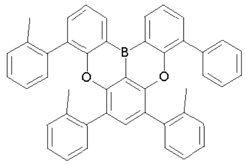 |
| 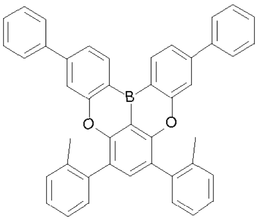 | 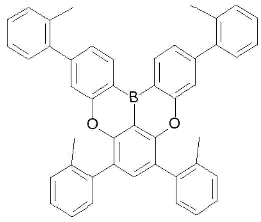 | 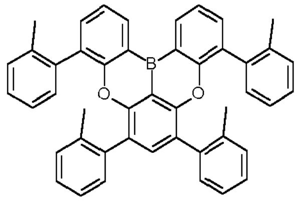 |
| 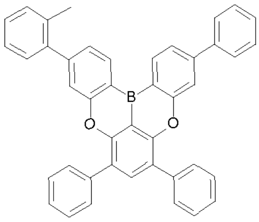 | 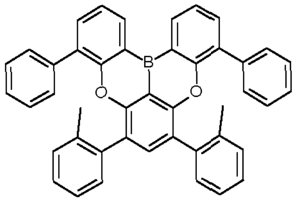 | 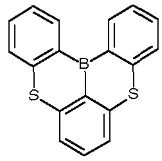 |
| 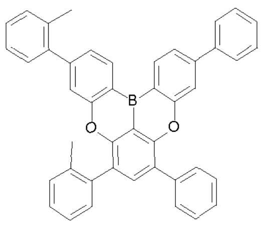 | 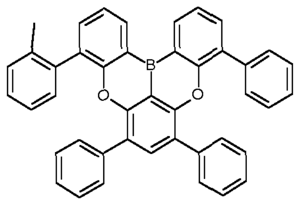 | 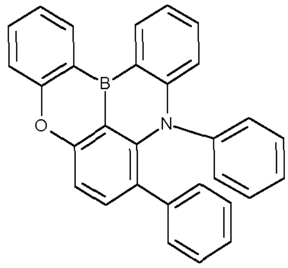 |
| 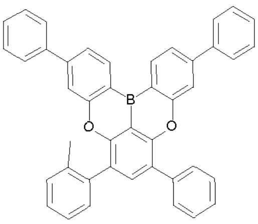 | 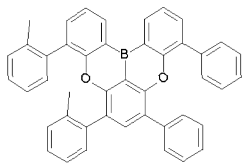 | 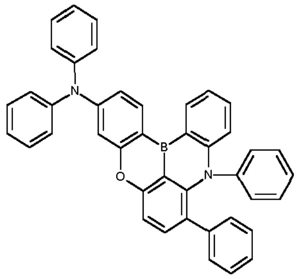 |
| 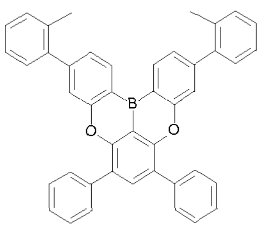 | 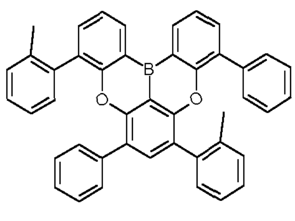 | 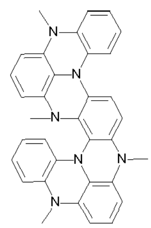 |

| | | |
|---|---|---|
| 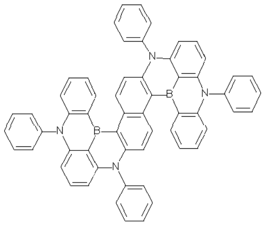 | 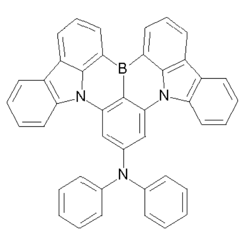 | 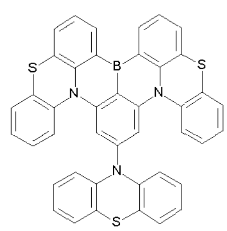 |
| 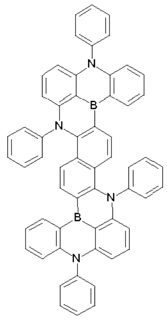 | 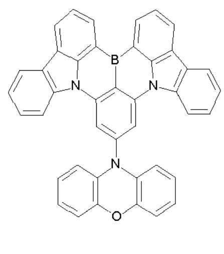 | 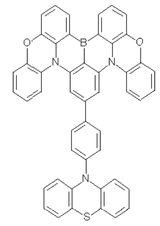 |
| 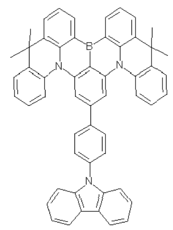 | 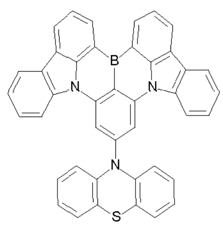 | 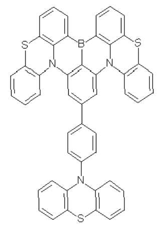 |
| 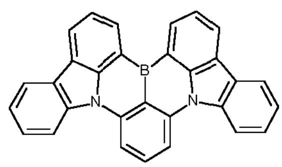 | 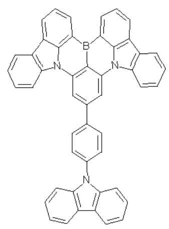 | 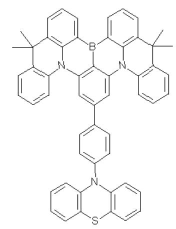 |
| 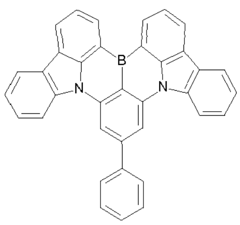 | 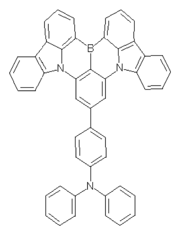 | 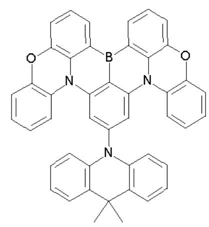 |
| 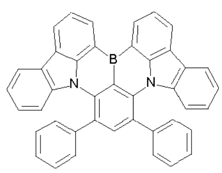 | 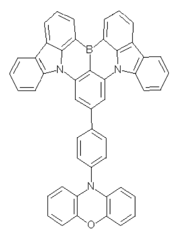 | 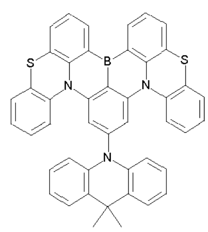 |

| | | |
|---|---|---|
| 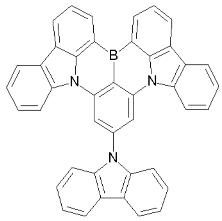 | 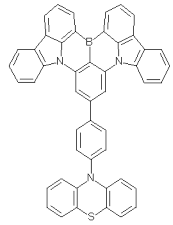 | 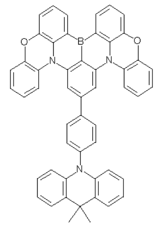 |
| 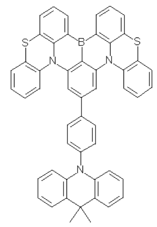 | 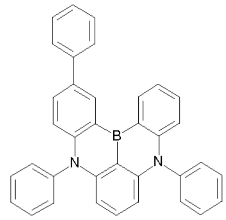 | 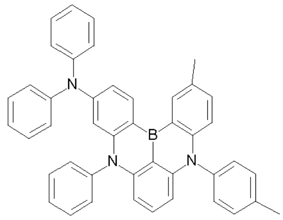 |
| 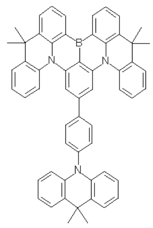 | 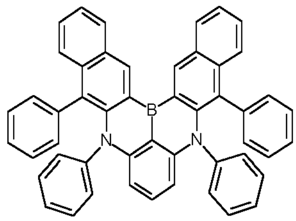 | 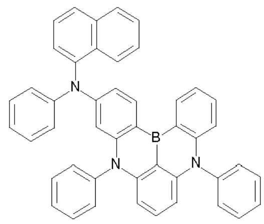 |
| 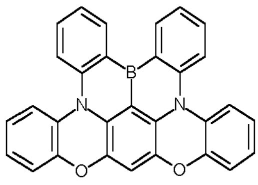 | 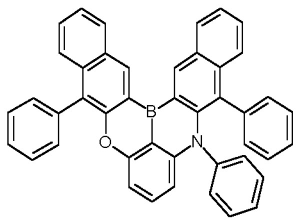 | 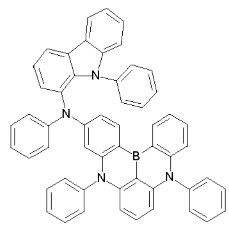 |
| 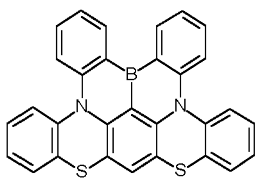 | 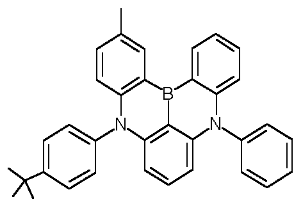 | 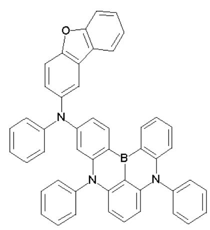 |
| 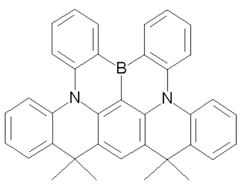 | 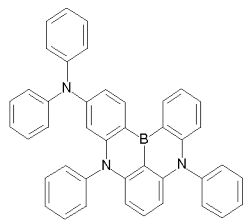 | 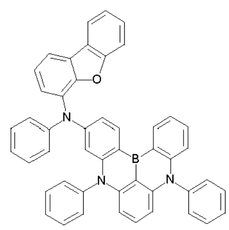 |
| 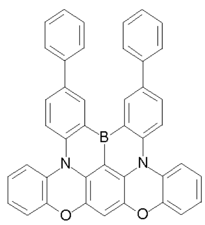 | 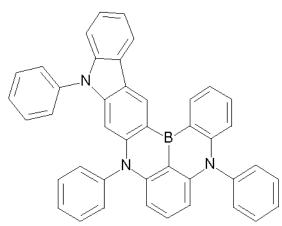 | 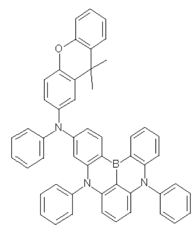 |

| | | |
|---|---|---|
| 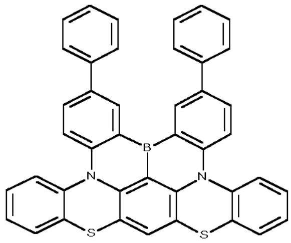 | 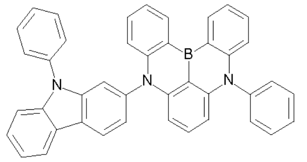 | 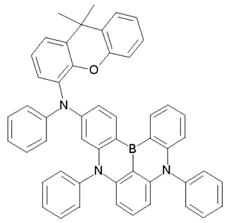 |
| 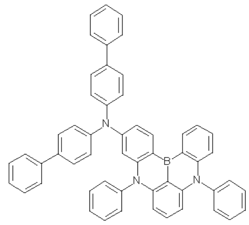 | 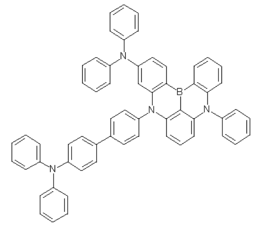 | 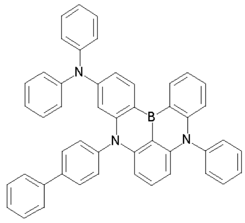 |
| 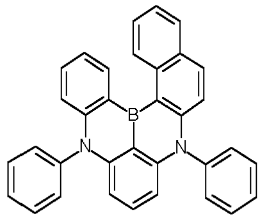 | 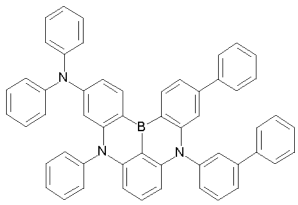 | 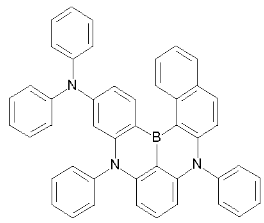 |
| 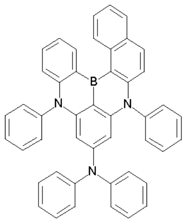 | 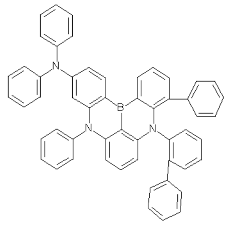 | 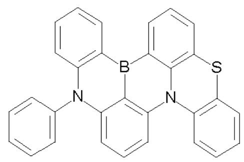 |
| 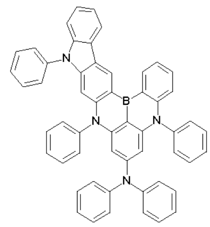 | 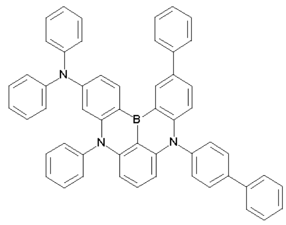 | 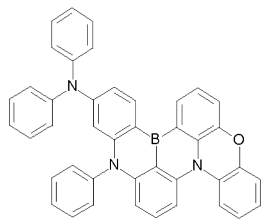 |
| 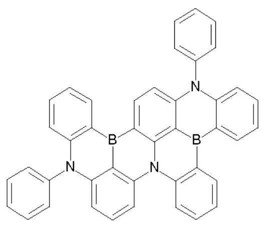 | 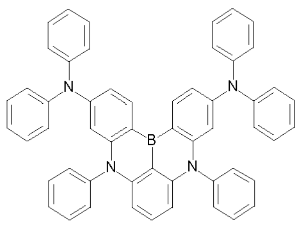 | 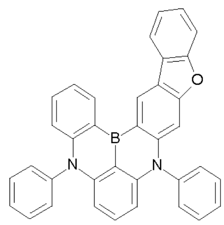 |
| 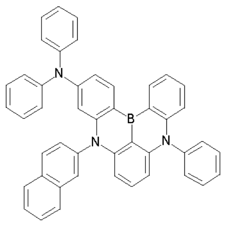 | 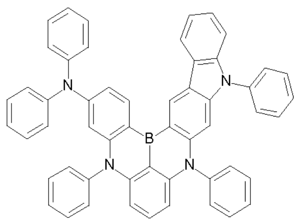 | 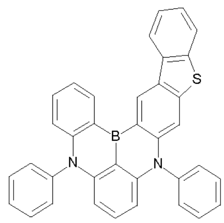 |

| | | |
|---|---|---|
| 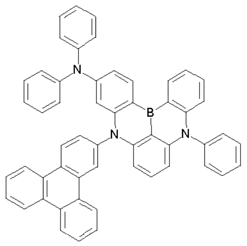 | 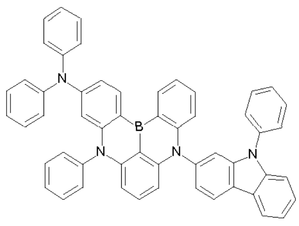 | 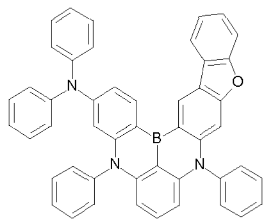 |
| 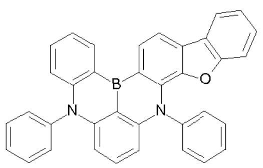 | 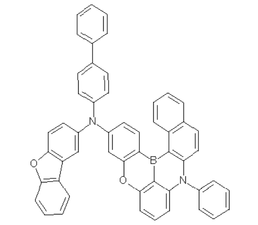 | 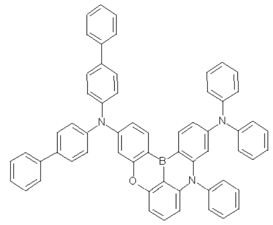 |
| 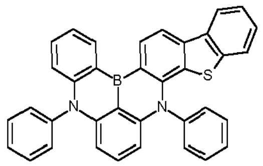 | 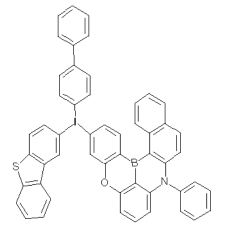 | 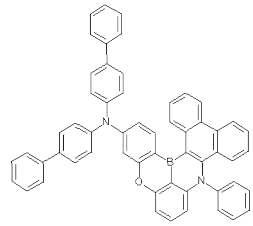 |
| 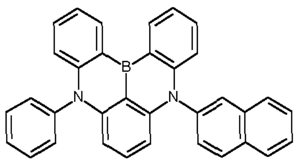 | 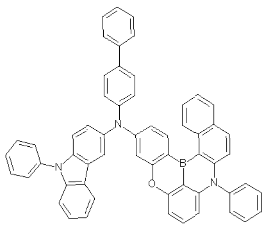 | 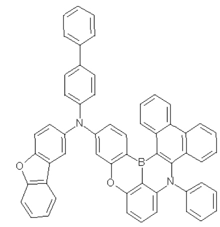 |
| 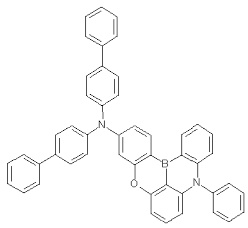 | 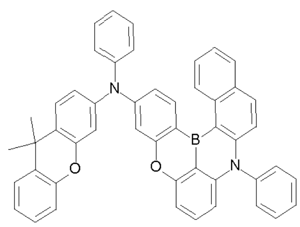 | 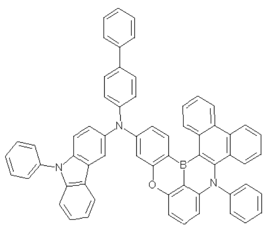 |
| 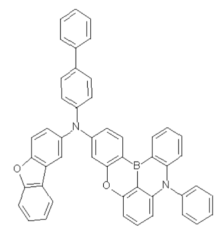 | 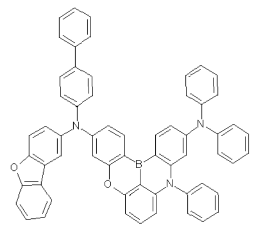 | 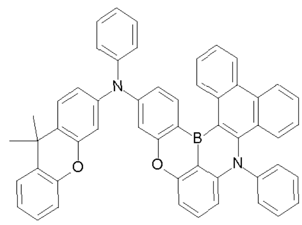 |
| 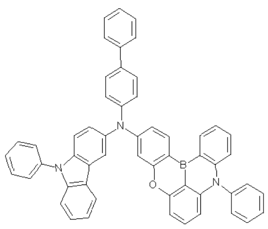 | 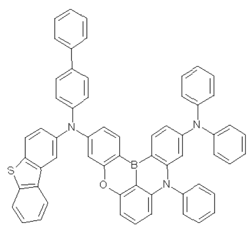 | 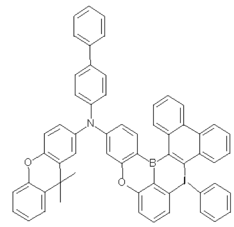 |

| | | |
|---|---|---|
| 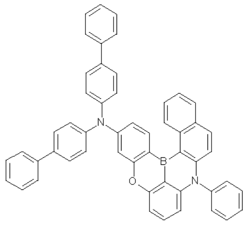 | 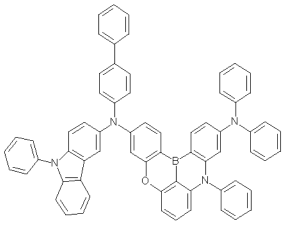 | 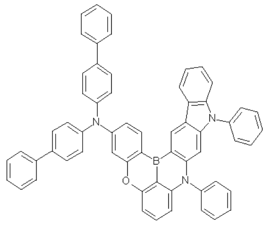 |
| 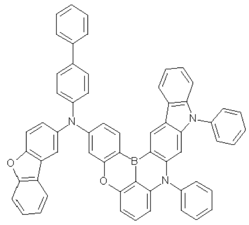 | 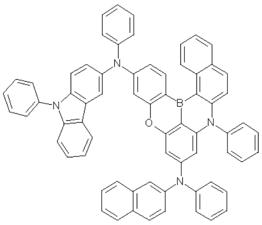 | 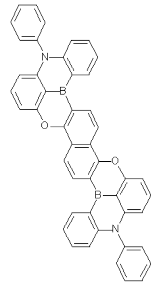 |
| 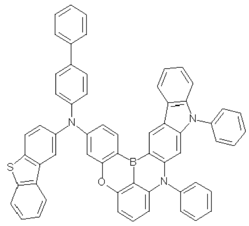 | 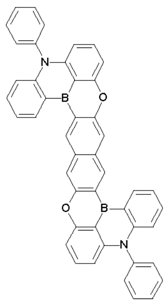 | 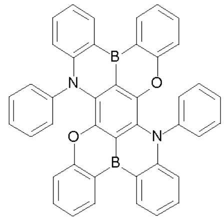 |
| 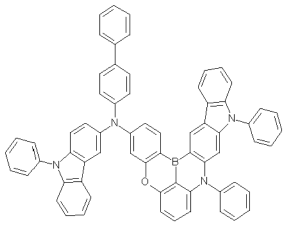 | 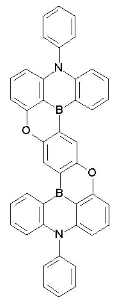 | 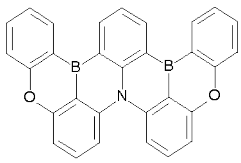 |
| 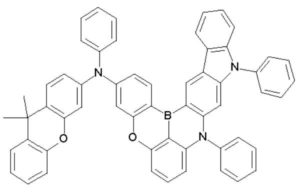 | 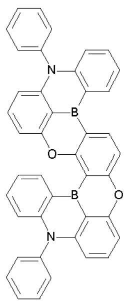 | 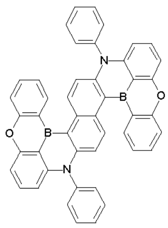 |
| 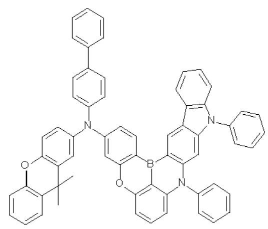 | 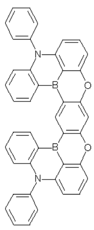 | 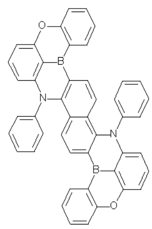 |

| | | |
|---|---|---|
| 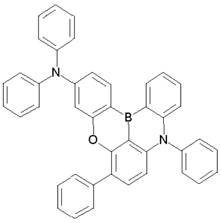 | 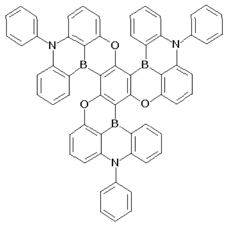 | 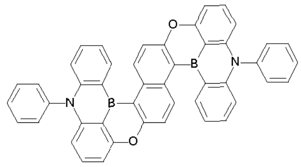 |
| 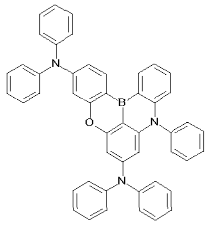 | 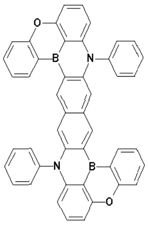 | 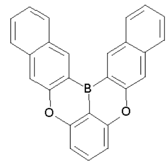 |
| 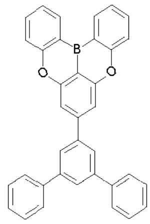 | 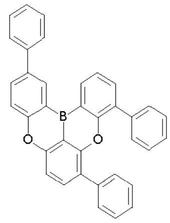 | 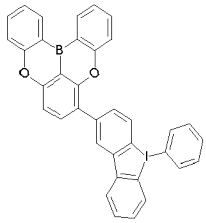 |
| 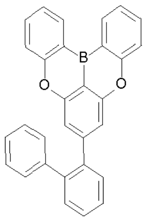 | 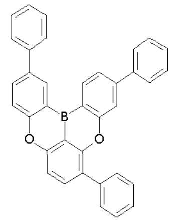 | 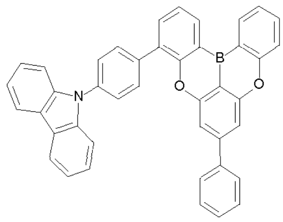 |
| 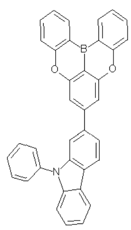 | 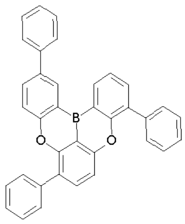 | 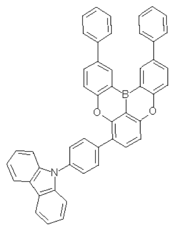 |
| 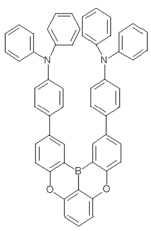 | 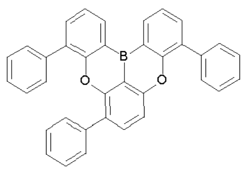 | 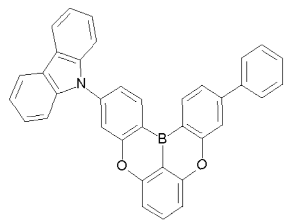 |
| 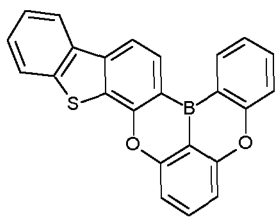 | 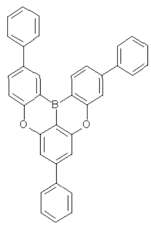 | 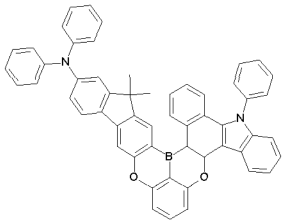 |

| | | |
|---|---|---|
| 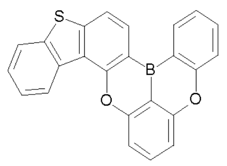 | 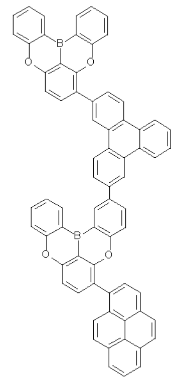 | 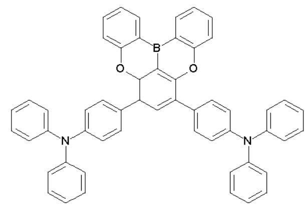 |
| 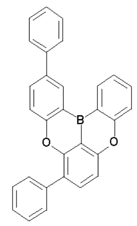 | 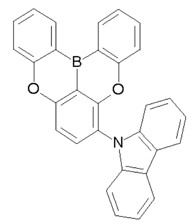 | 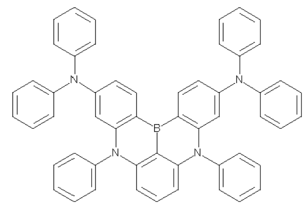 |
| 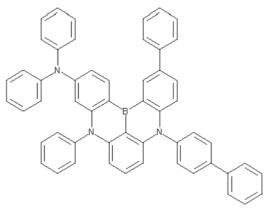 | 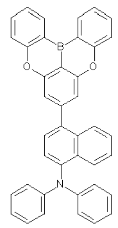 | 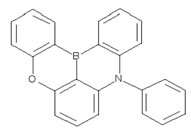 |
| 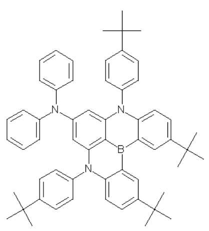 | 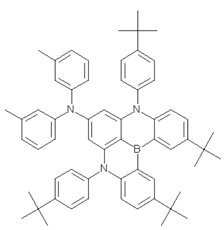 | 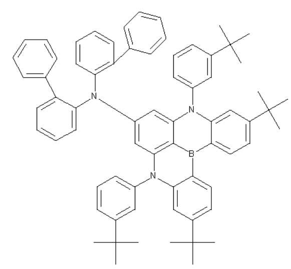 |
| 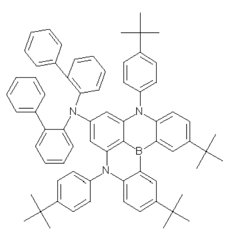 | 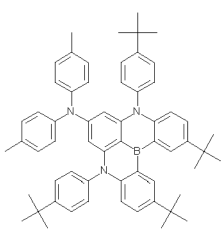 | 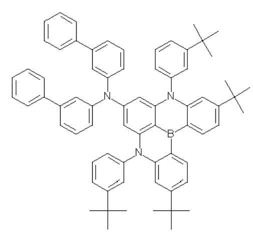 |
| 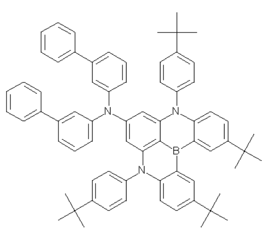 | 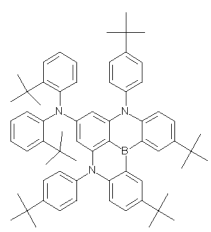 | 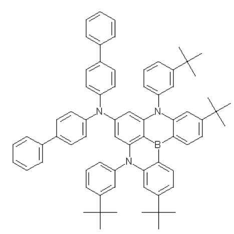 |

| | | |
|---|---|---|
| 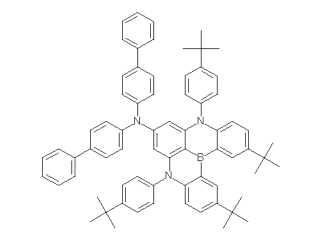 | 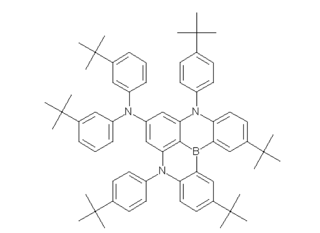 | 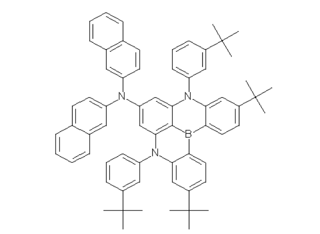 |
| 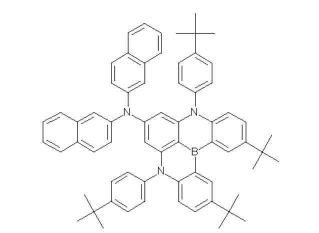 | 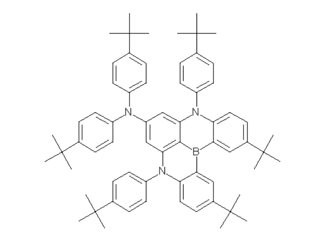 | 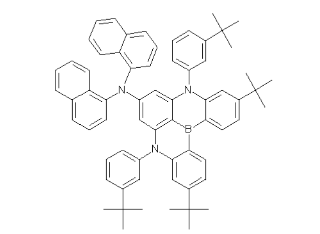 |
| 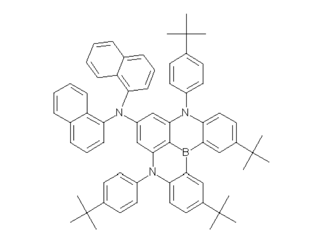 | 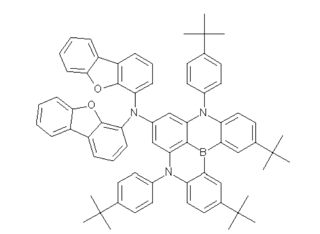 | 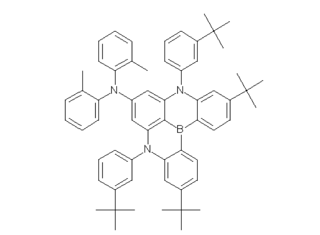 |
| 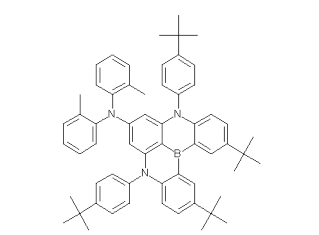 | 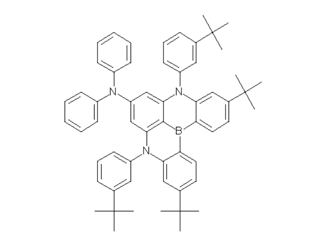 | 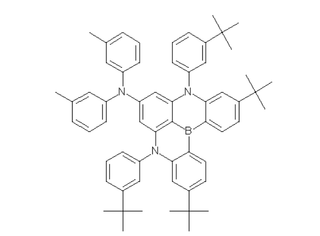 |
| 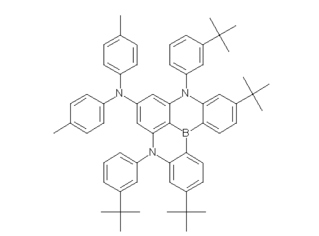 | 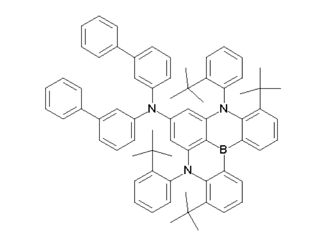 | 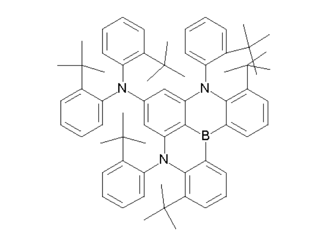 |
| 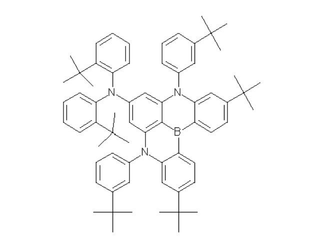 | 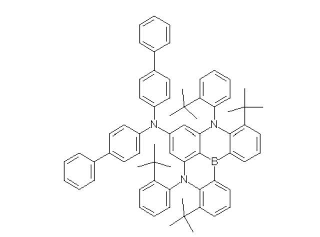 | 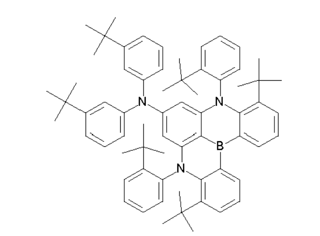 |
| 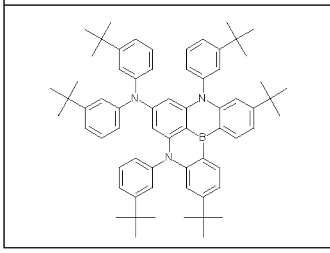 | 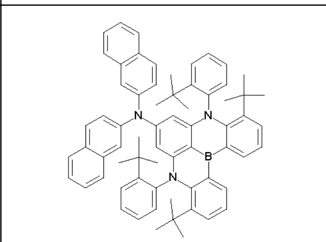 | 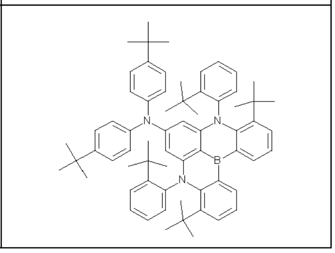 |

| | | |
|---|---|---|
| 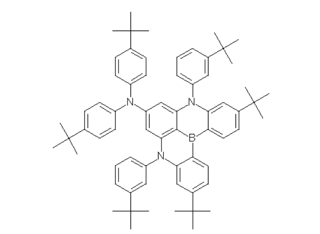 | 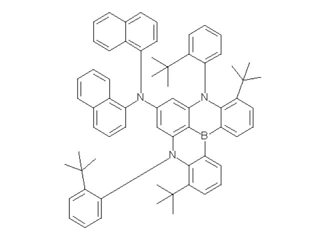 | 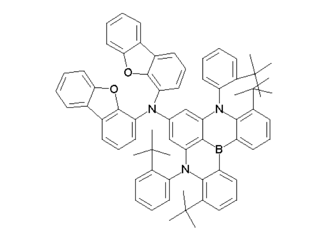 |
| 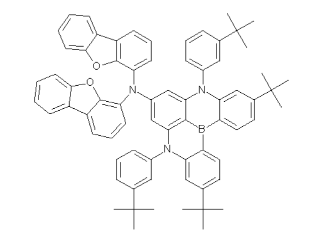 | 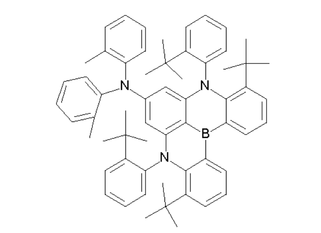 | 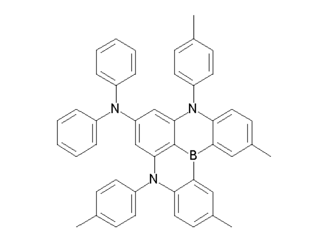 |
| 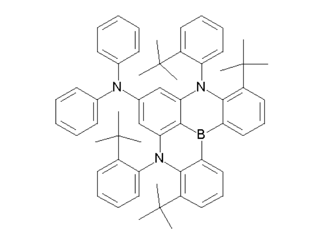 | 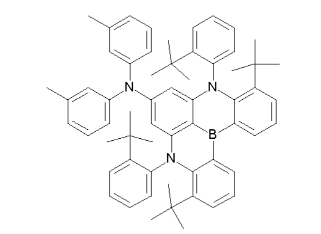 | 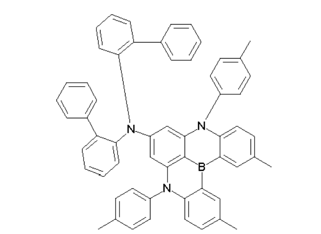 |
| 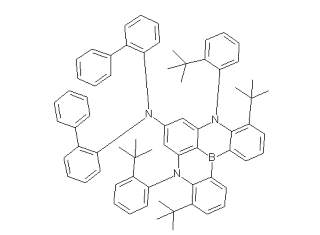 | 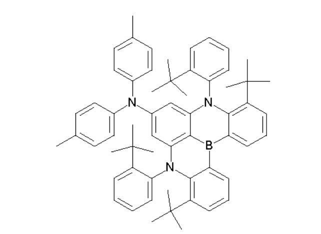 | 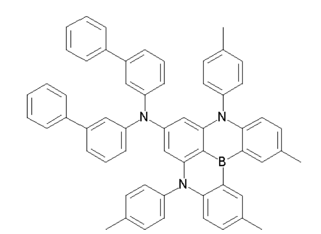 |
| 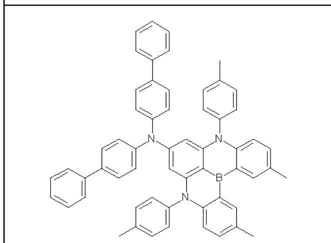 | 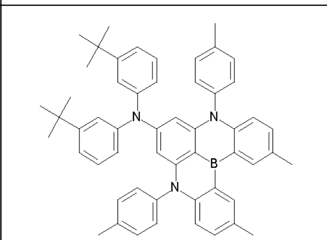 | 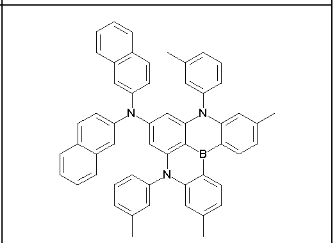 |
| 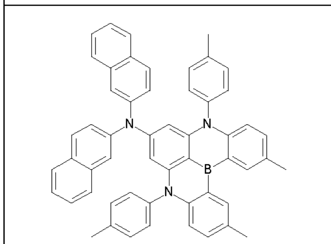 | 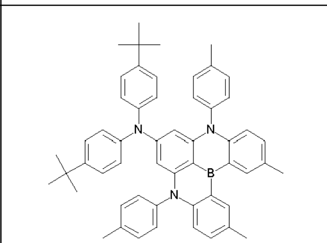 | 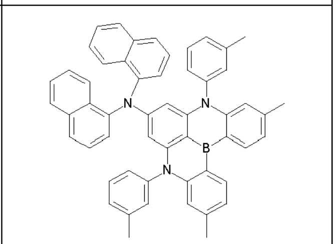 |
| 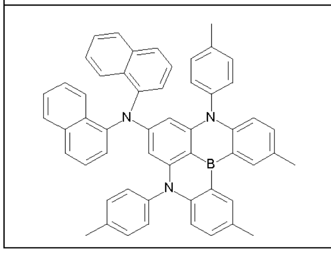 | 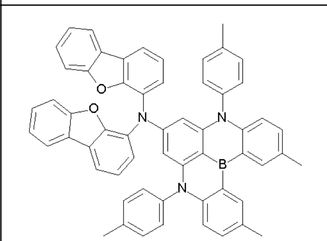 | 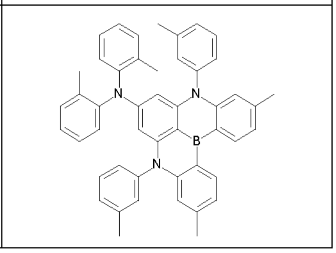 |

| | | |
|---|---|---|
| 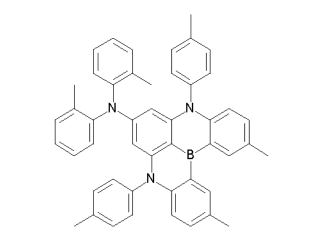 | 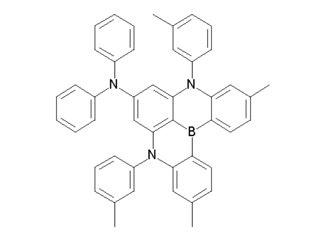 | 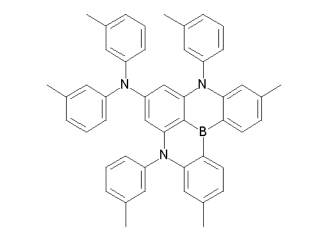 |
| 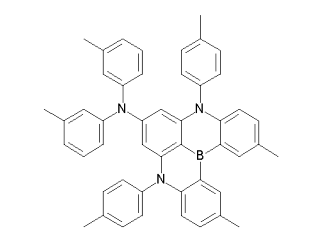 | 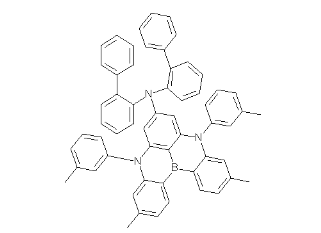 | 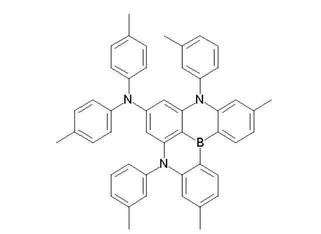 |
| 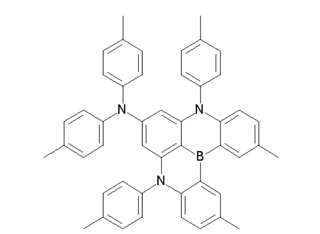 | 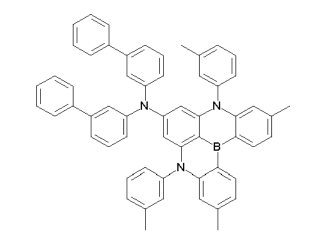 | 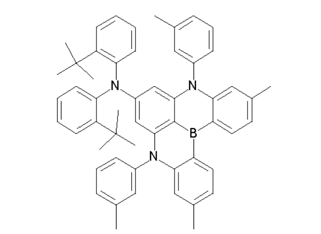 |
| 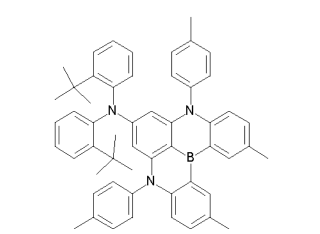 | 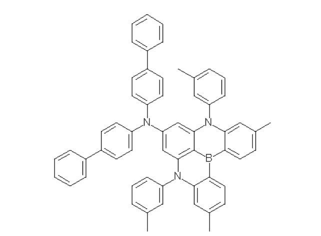 | 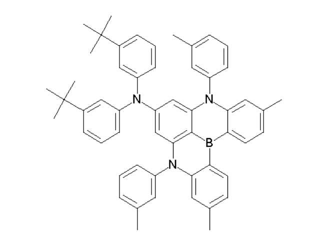 |
| 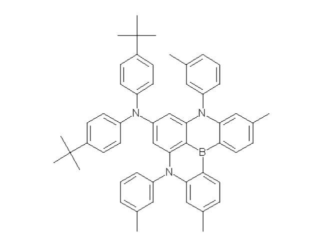 | 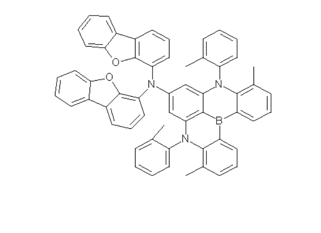 | 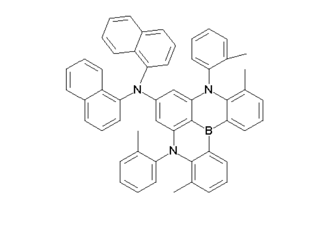 |
| 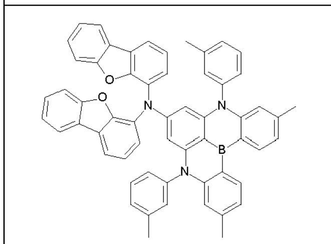 | 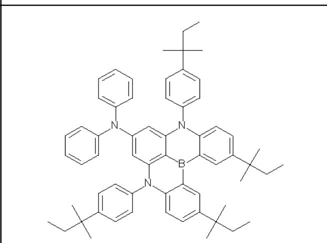 | 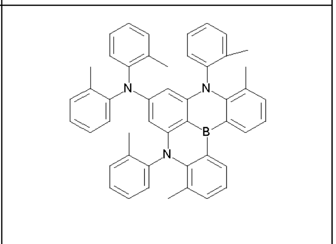 |
| 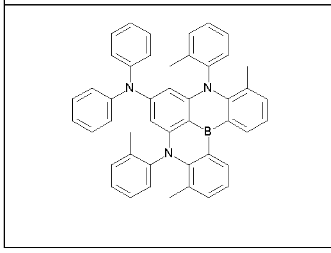 | 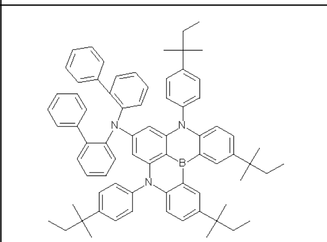 | 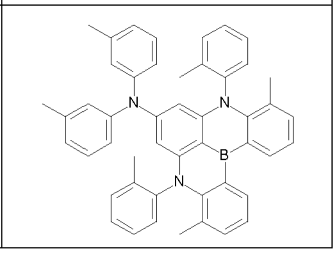 |

| | | |
|---|---|---|
| 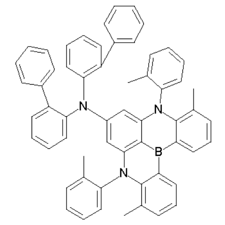 | 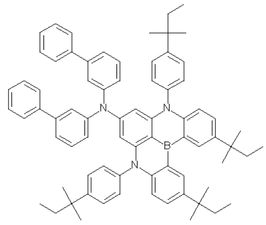 | 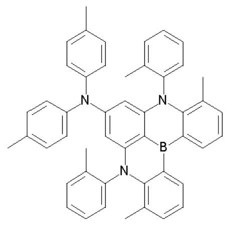 |
| 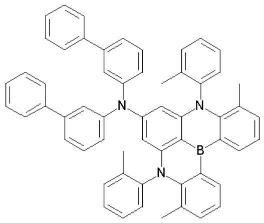 | 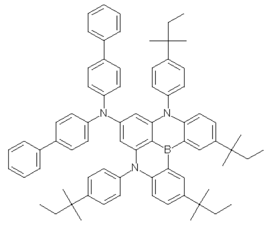 | 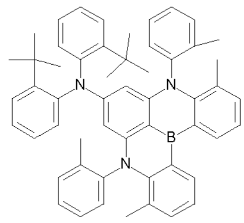 |
| 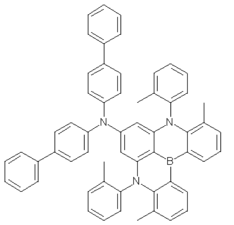 | 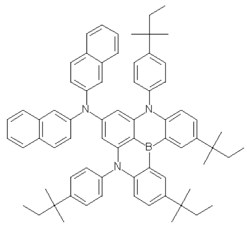 | 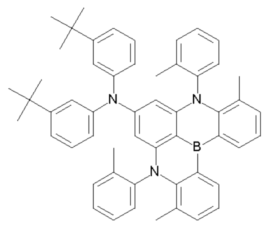 |
| 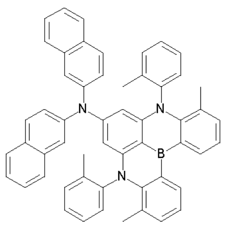 | 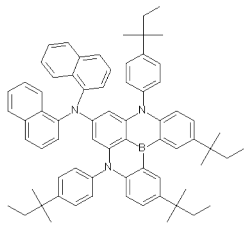 | 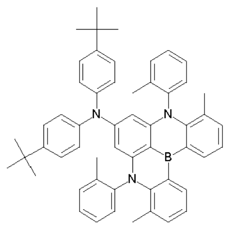 |
| 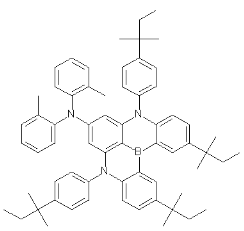 | 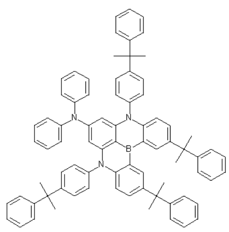 | 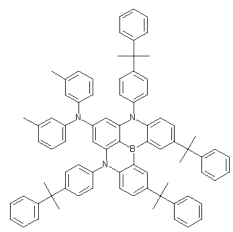 |
| 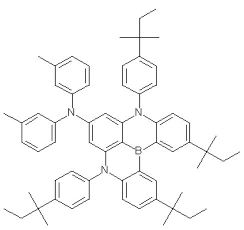 | 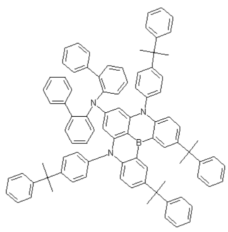 | 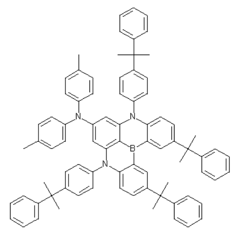 |
| 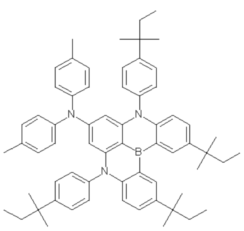 | 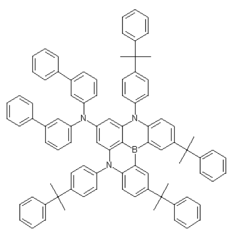 | 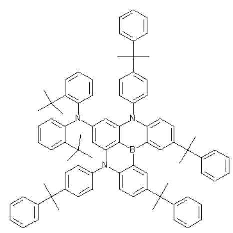 |

| | | |
|---|---|---|
| 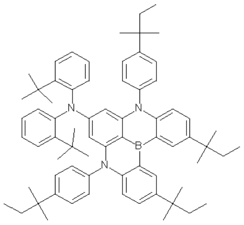 | 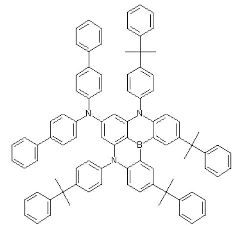 | 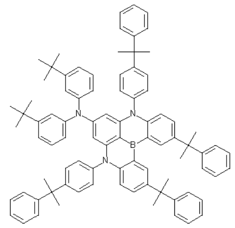 |
| 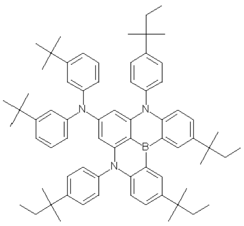 | 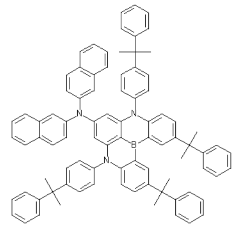 | 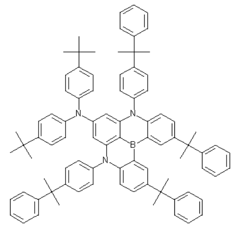 |
| 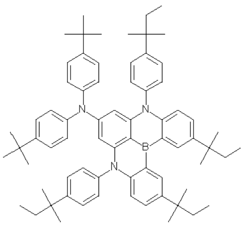 | 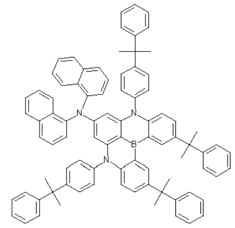 | 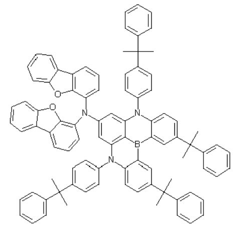 |
| 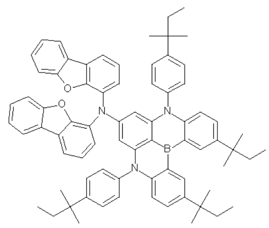 | 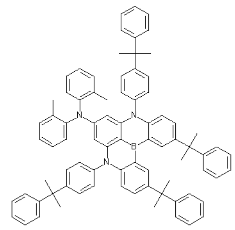 | 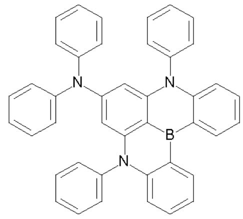 |
| 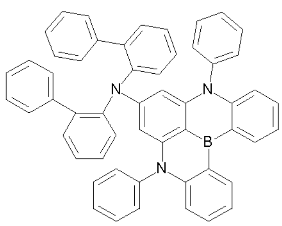 | 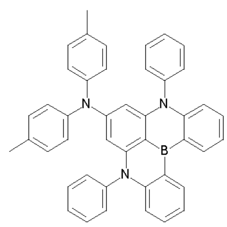 | 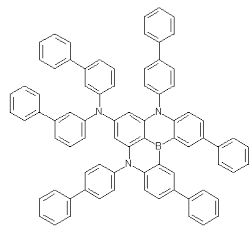 |
| 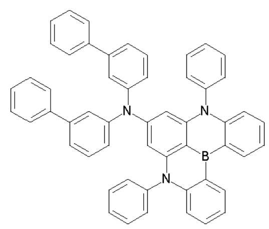 | 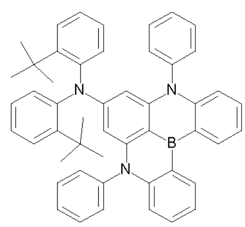 | 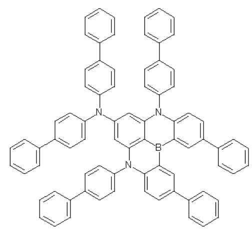 |
| 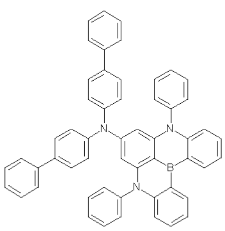 | 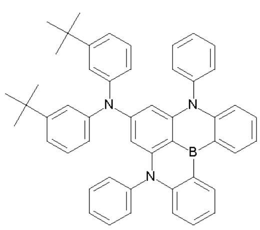 | 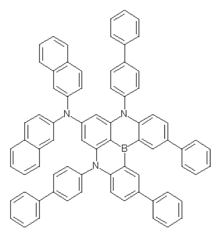 |

| | | |
|---|---|---|
| 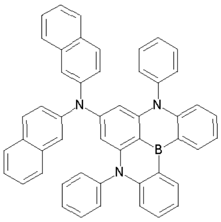 | 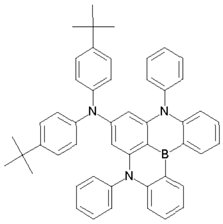 | 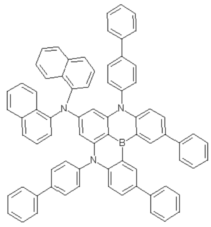 |
| 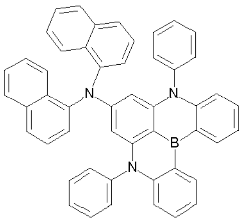 | 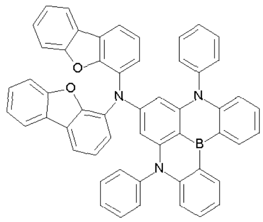 | 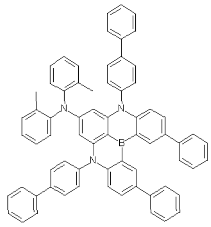 |
| 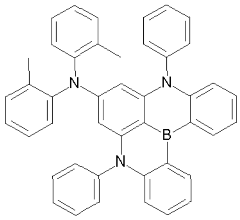 | 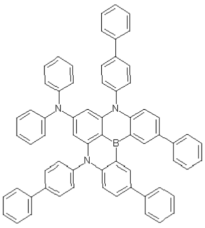 | 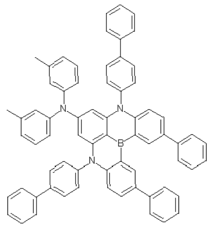 |
| 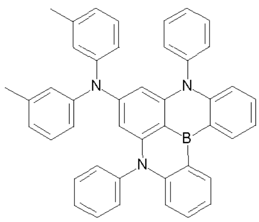 | 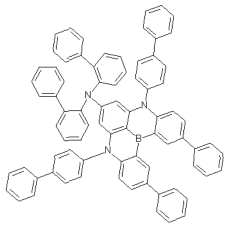 | 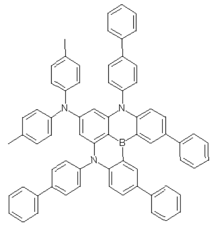 |
| 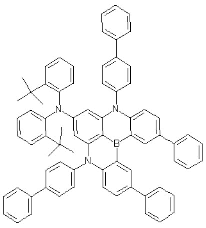 | 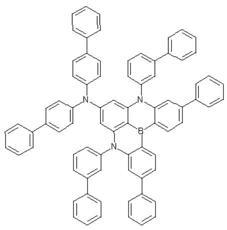 | 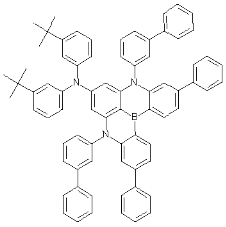 |
| 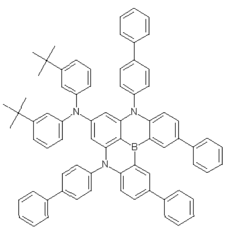 | 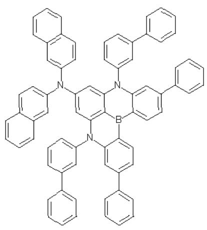 | 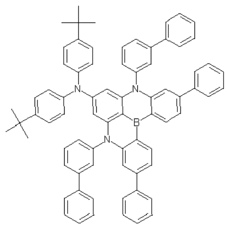 |
| 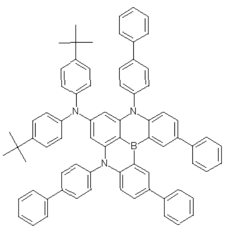 | 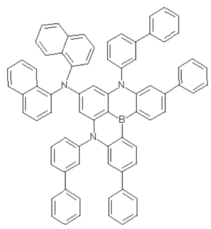 | 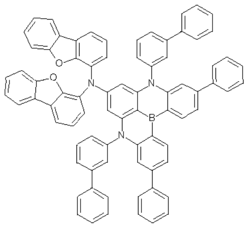 |

| | | |
|---|---|---|
| 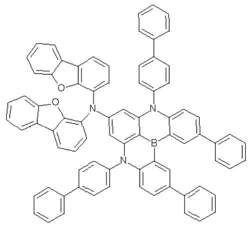 | 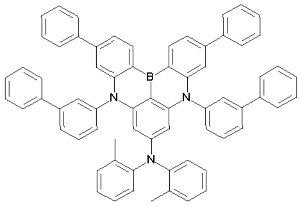 | 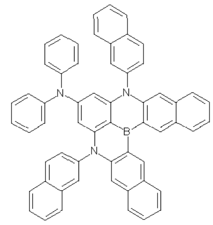 |
| 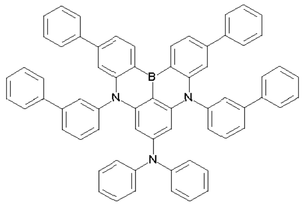 | 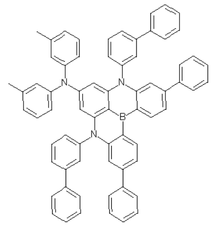 | 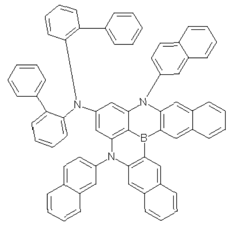 |
| 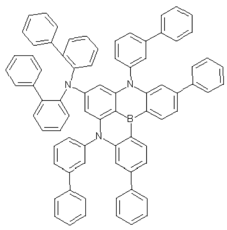 | 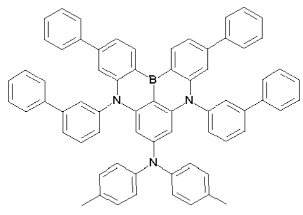 | 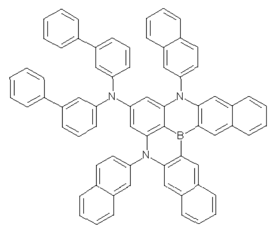 |
| 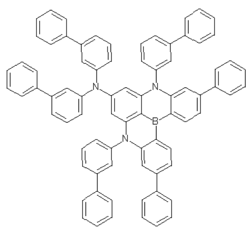 | 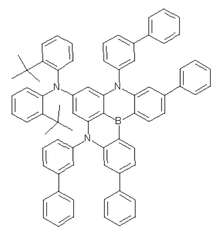 | 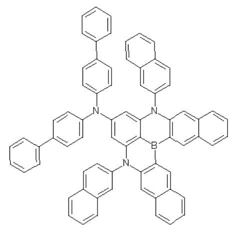 |
| 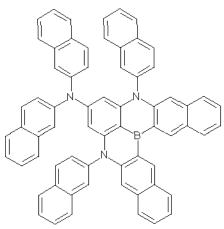 | 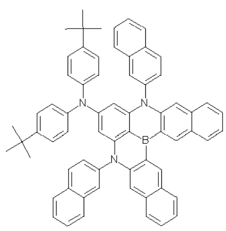 | 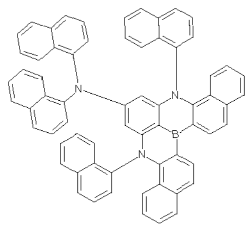 |
| 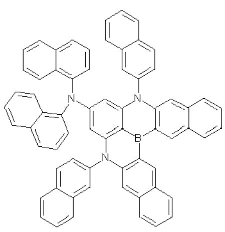 | 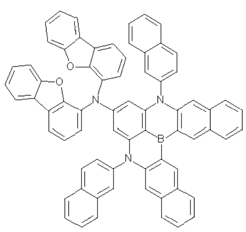 | 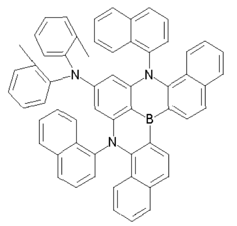 |
| 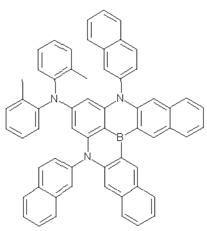 | 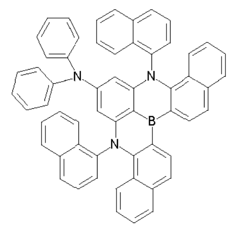 | 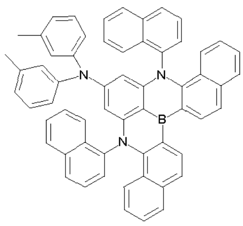 |

| | | |
|---|---|---|
| 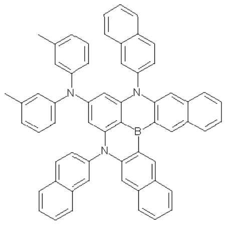 | 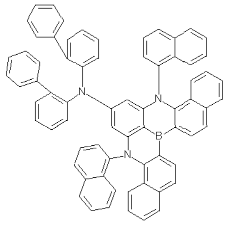 | 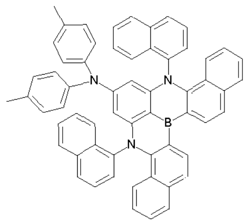 |
| 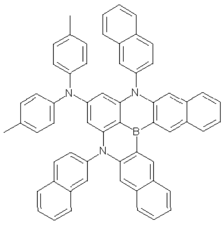 | 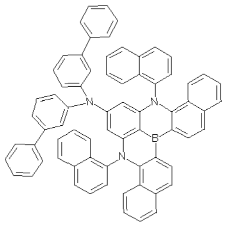 | 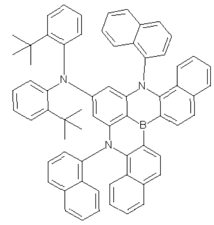 |
| 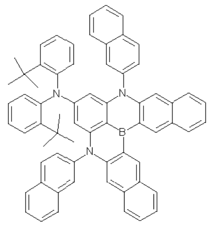 | 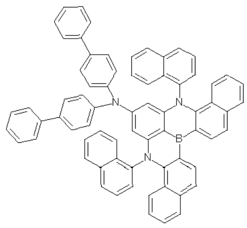 | 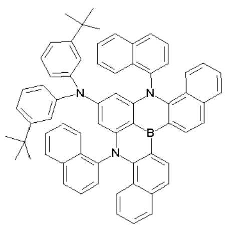 |
| 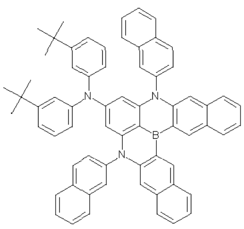 | 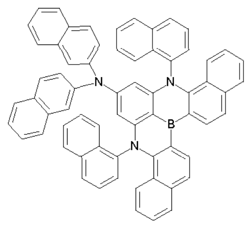 | 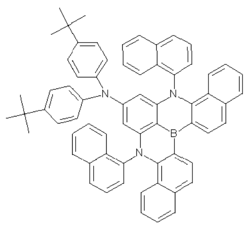 |
| 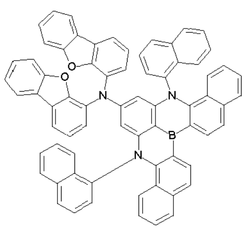 | 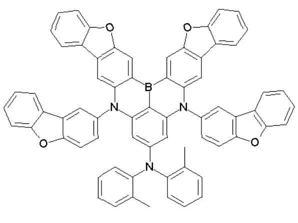 | 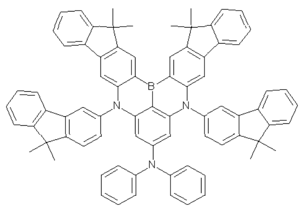 |
| 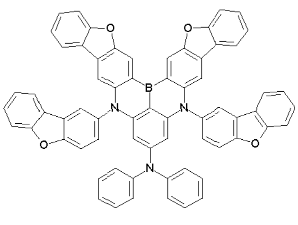 | 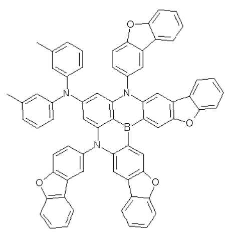 | 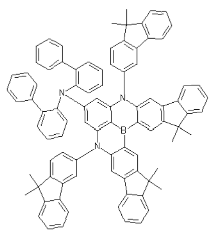 |
| 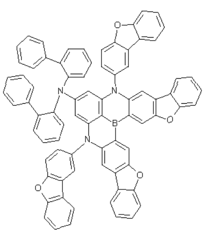 | 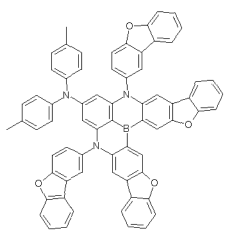 | 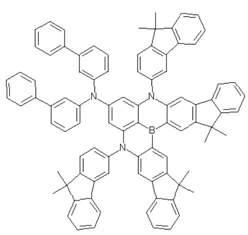 |

| | | |
|---|---|---|
| 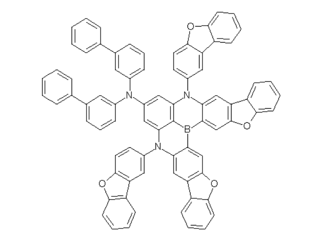 | 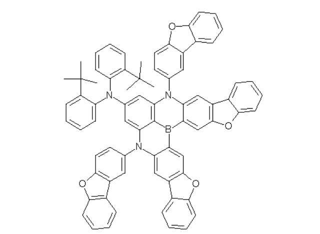 | 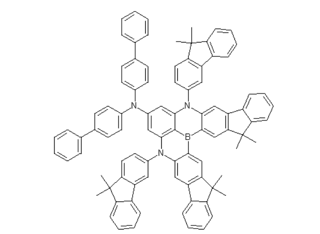 |
| 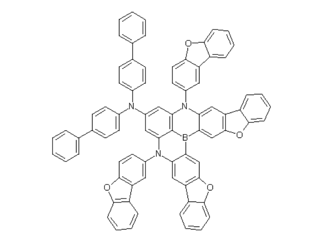 | 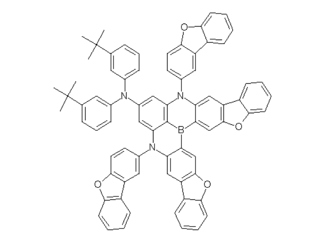 | 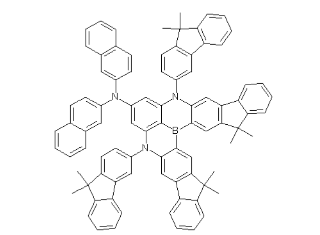 |
| 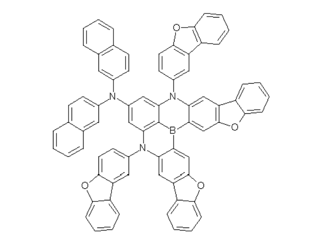 | 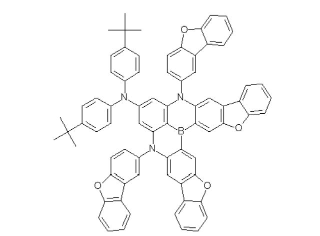 | 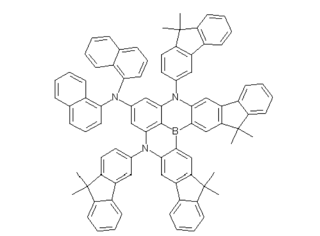 |
| 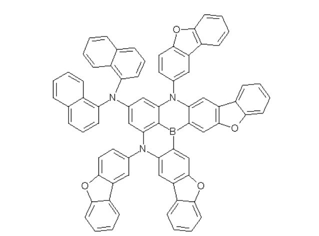 | 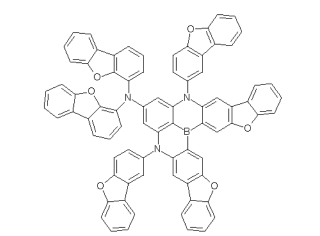 | 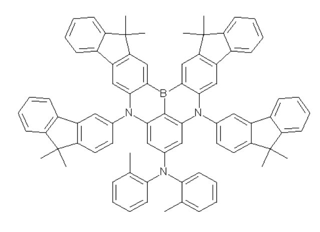 |
| 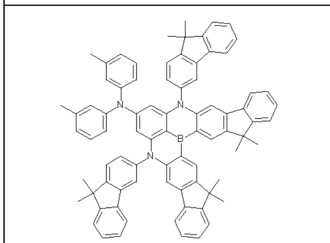 | 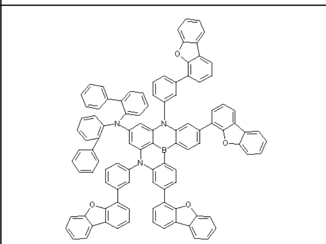 | 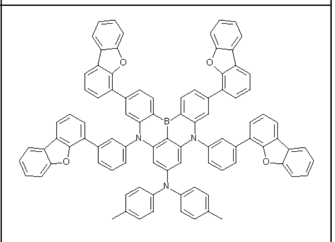 |
| 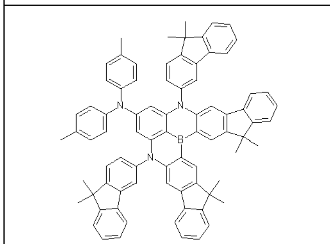 | 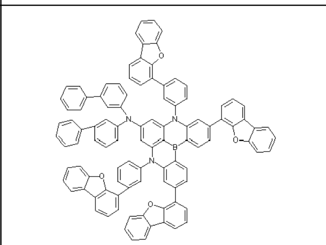 | 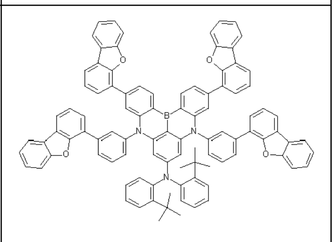 |
| 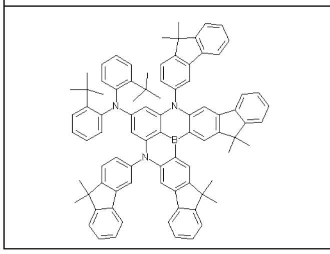 | 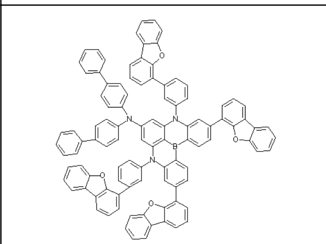 | 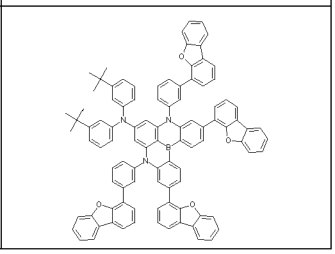 |

| | | |
|---|---|---|
| 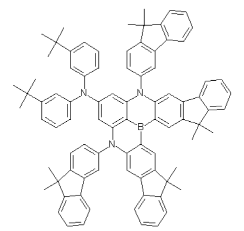 | 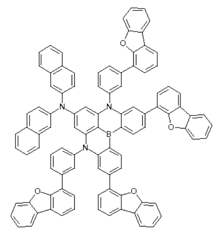 | 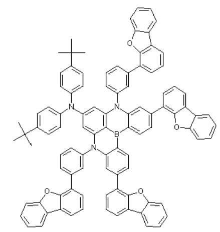 |
| 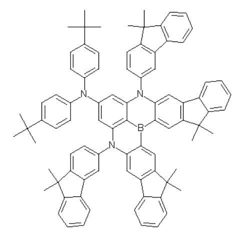 | 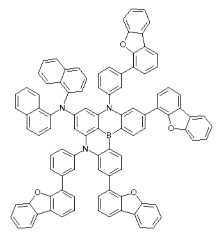 | 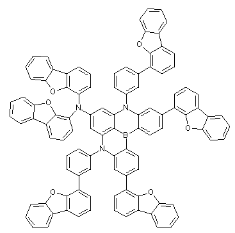 |
| 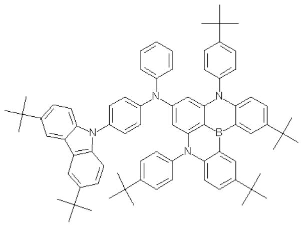 | 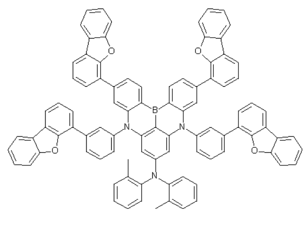 | 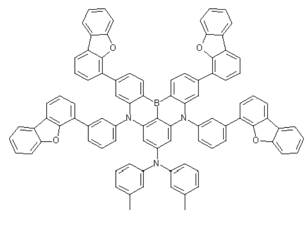 |
| 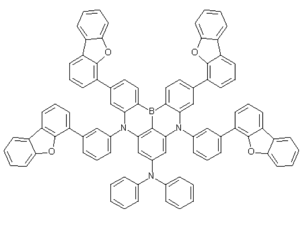 | 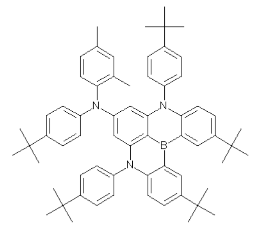 | 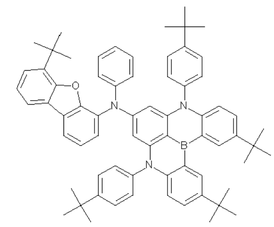 |
| 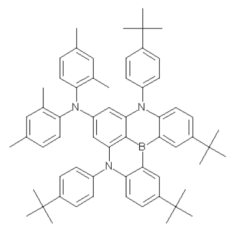 | 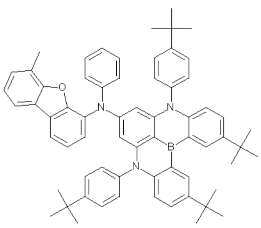 | 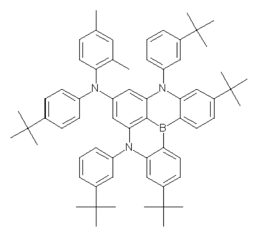 |
| 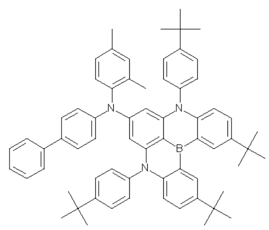 | 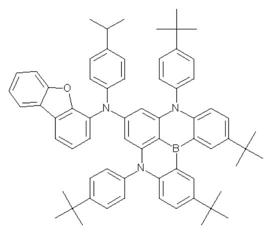 | 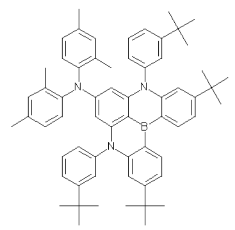 |
| 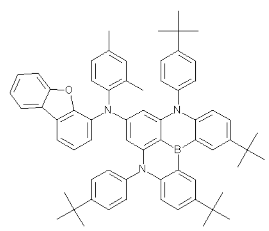 | 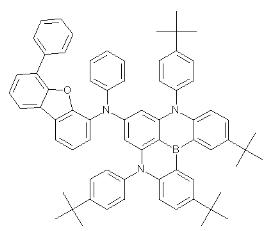 | 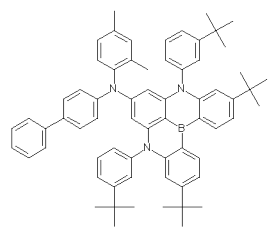 |

| | | |
|---|---|---|
| 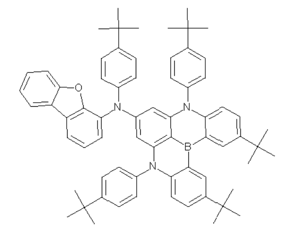 | 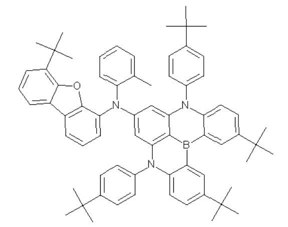 | 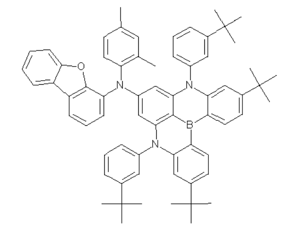 |
| 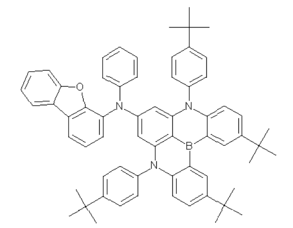 | 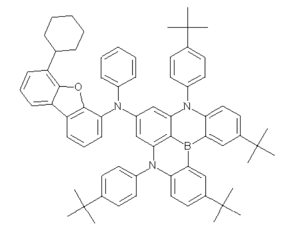 | 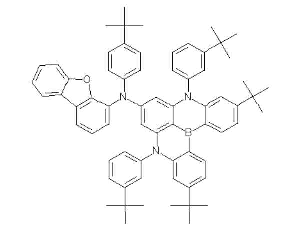 |
| 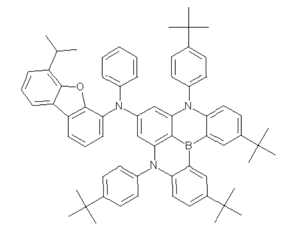 | 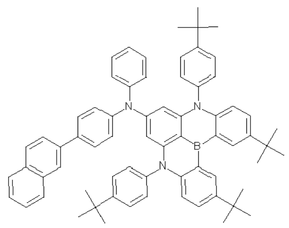 | 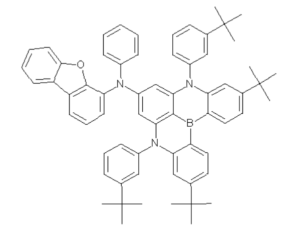 |
| 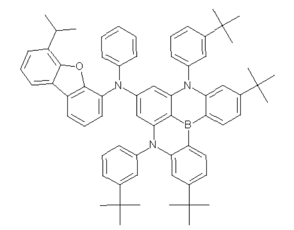 | 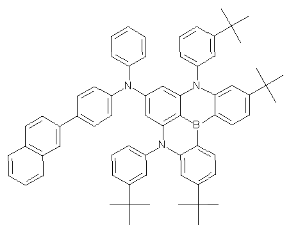 | 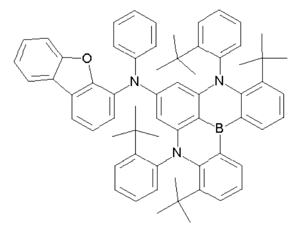 |
| 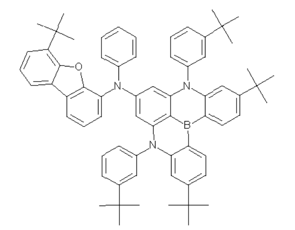 | 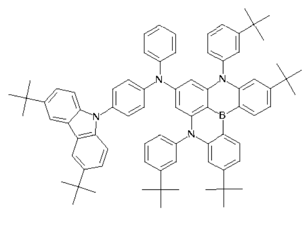 | 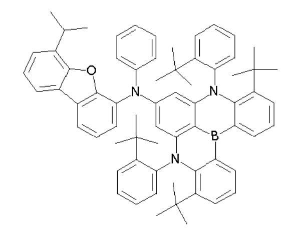 |
| 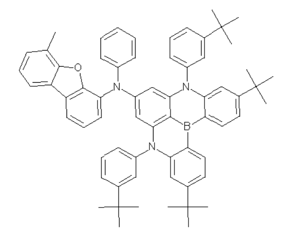 | 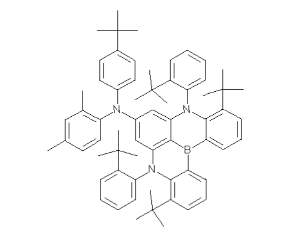 | 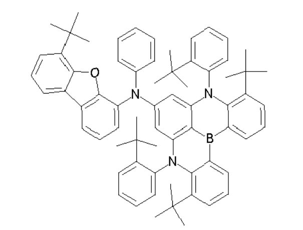 |
| 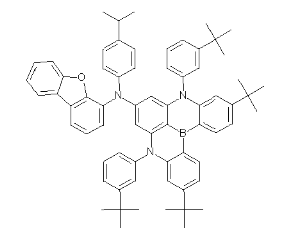 | 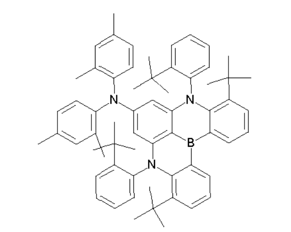 | 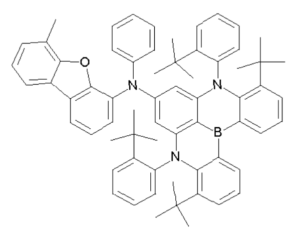 |

| | | |
|---|---|---|
| 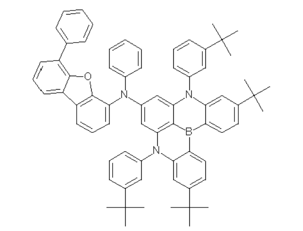 | 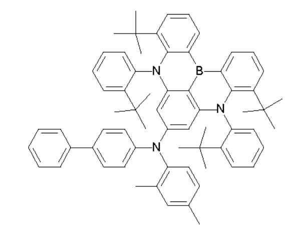 | 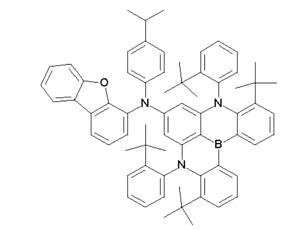 |
| 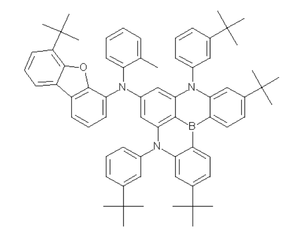 | 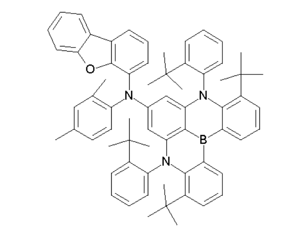 | 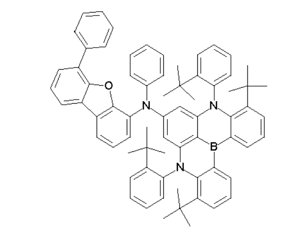 |
| 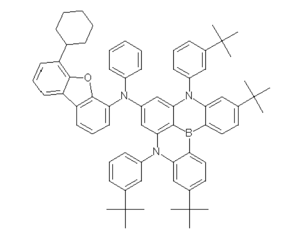 | 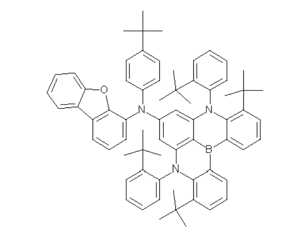 | 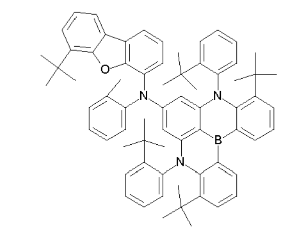 |
| 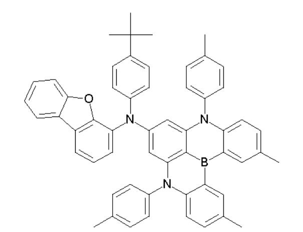 | 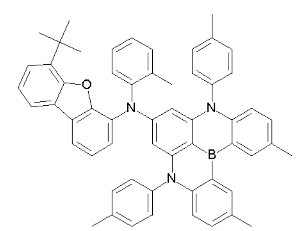 | 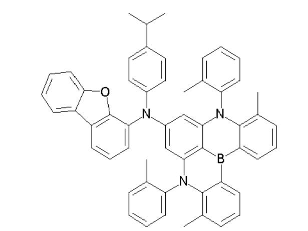 |
| 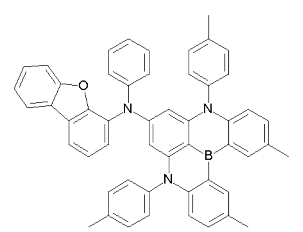 | 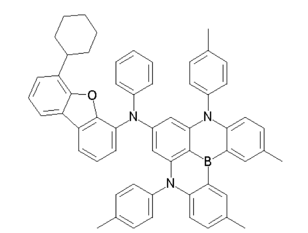 | 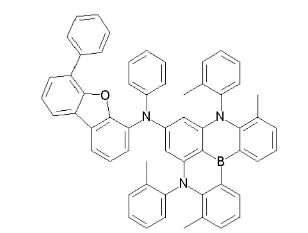 |
| 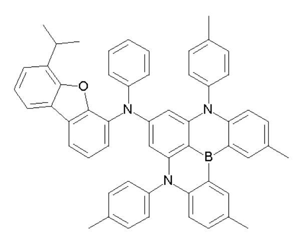 | 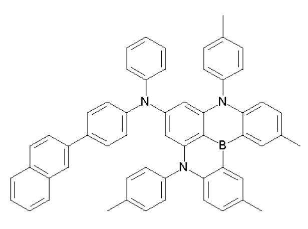 | 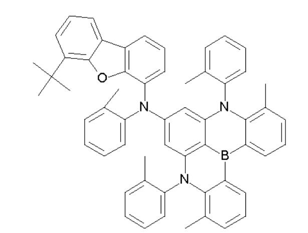 |
| 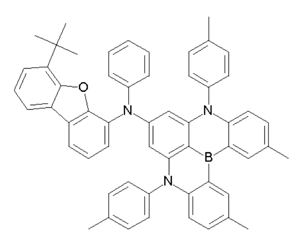 | 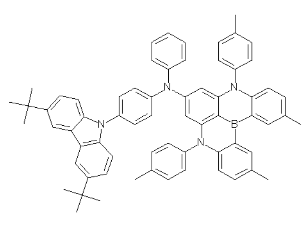 | 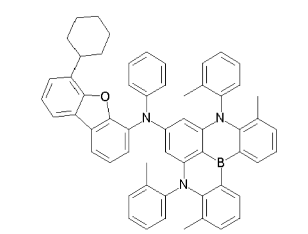 |

| | | |
|---|---|---|
| 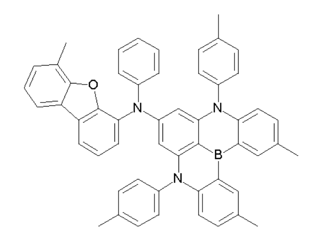 | 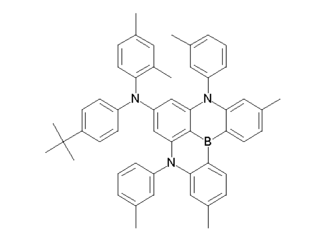 | 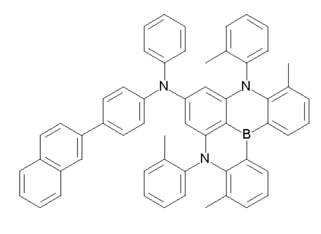 |
| 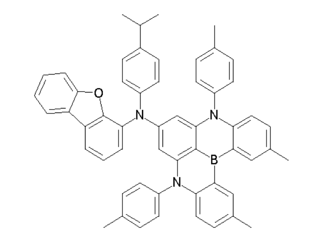 | 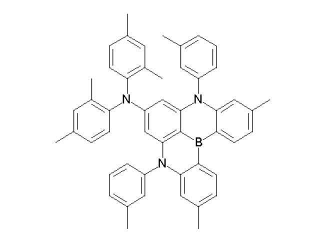 | 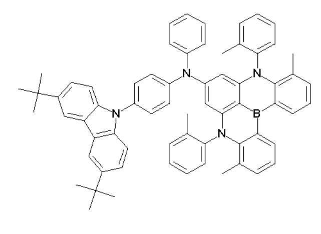 |
| 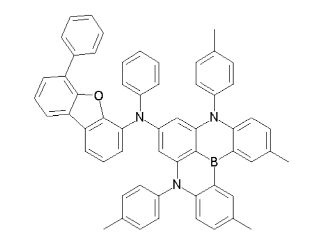 | 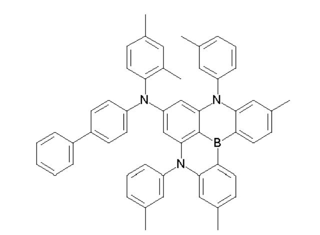 | 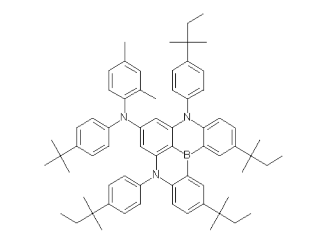 |
| 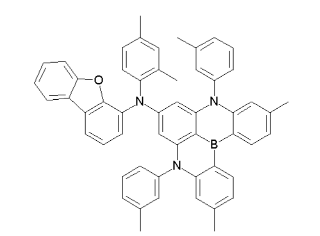 | 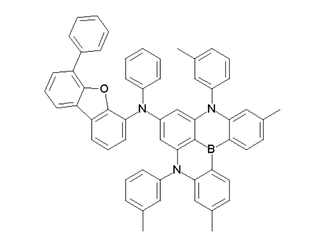 | 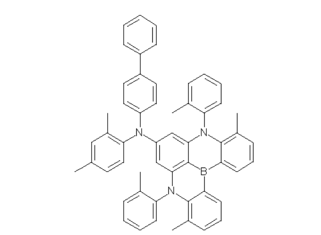 |
| 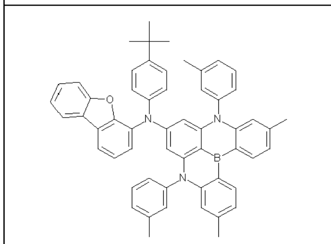 | 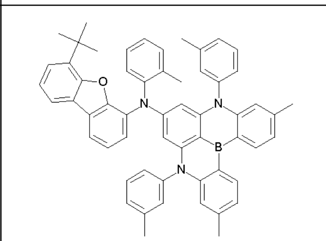 | 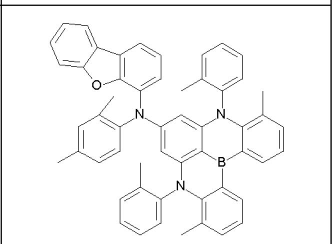 |
| 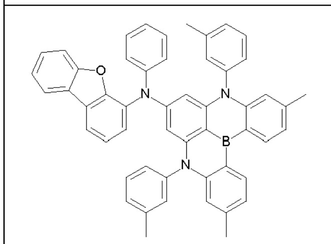 | 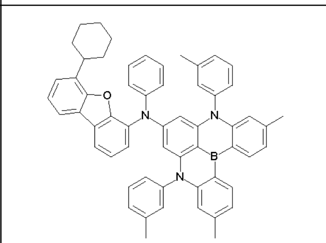 | 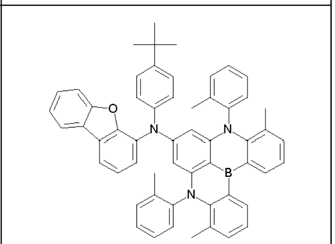 |
| 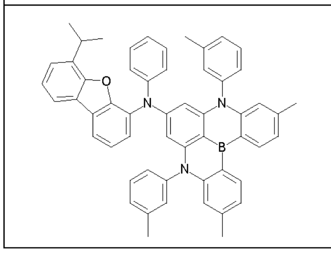 | 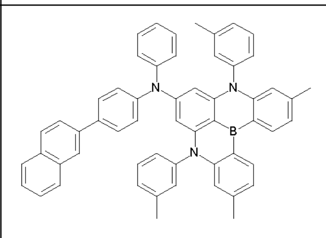 | 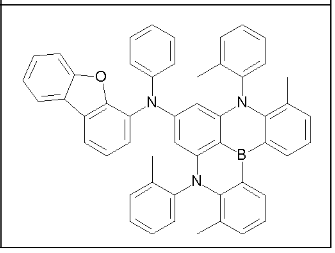 |

| | | |
|---|---|---|
| 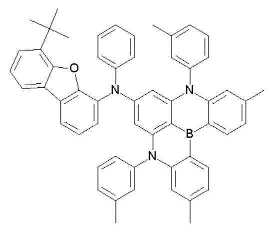 | 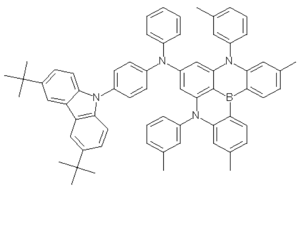 | 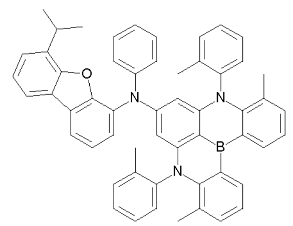 |
| 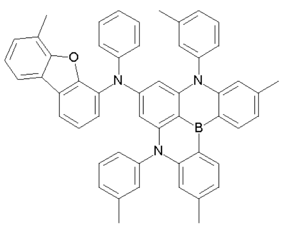 | 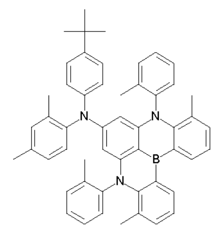 | 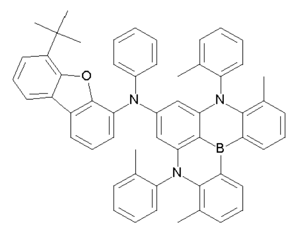 |
| 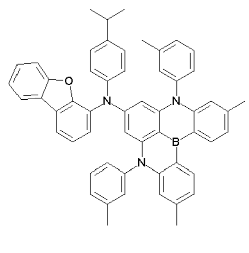 | 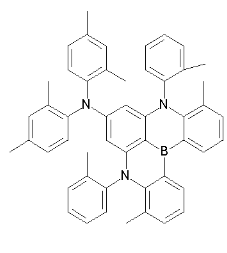 | 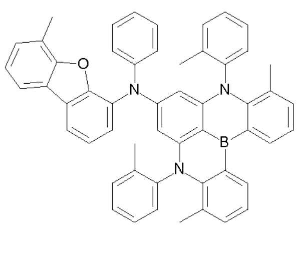 |
| 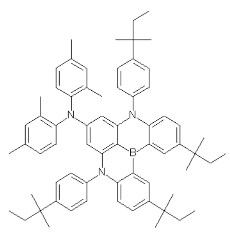 | 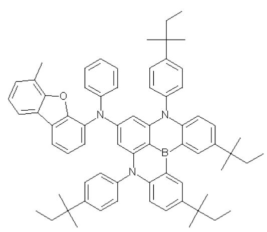 | 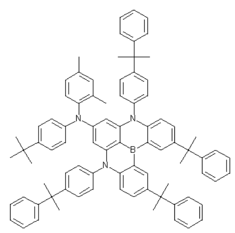 |
| 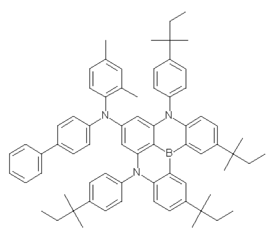 | 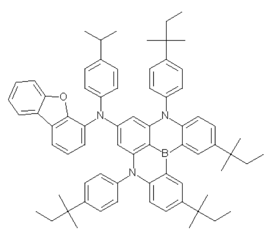 | 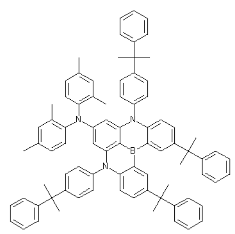 |
| 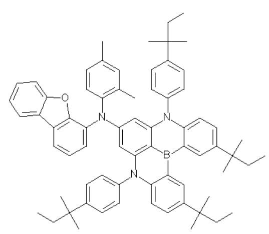 | 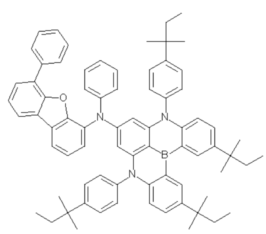 | 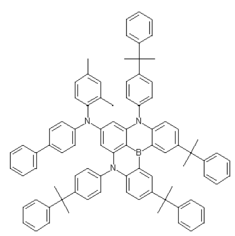 |
| 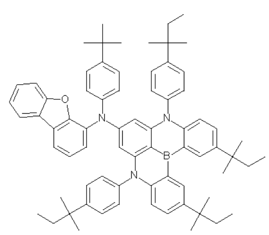 | 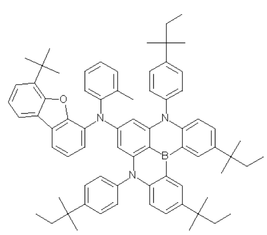 | 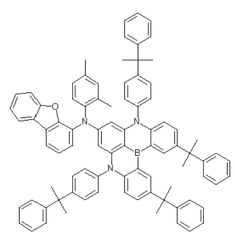 |

| | | |
|---|---|---|
| 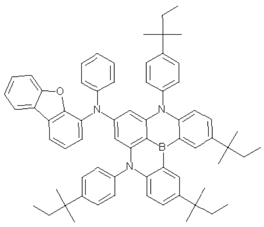 | 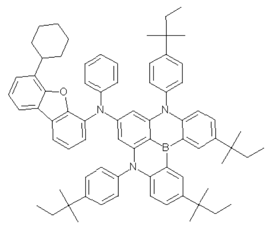 | 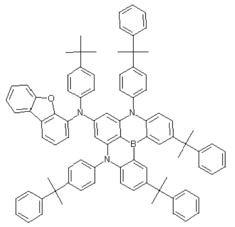 |
| 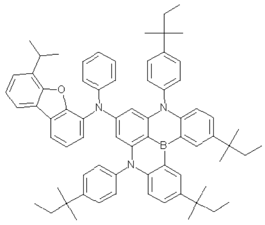 | 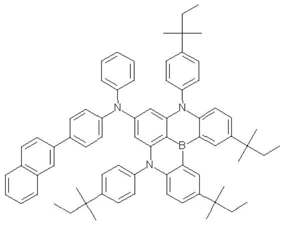 | 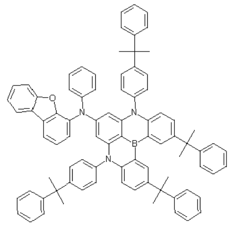 |
| 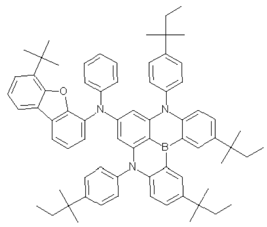 | 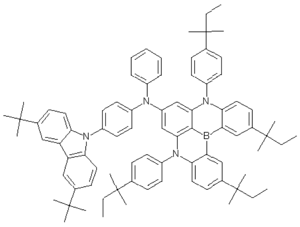 | 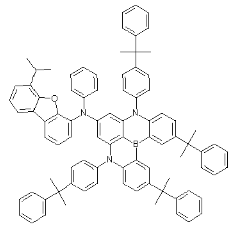 |
| 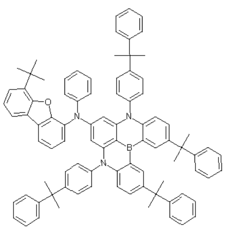 | 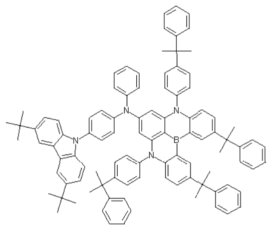 | 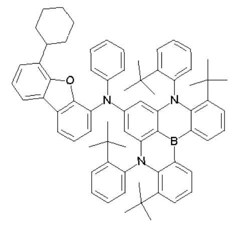 |
| 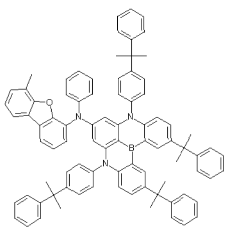 | 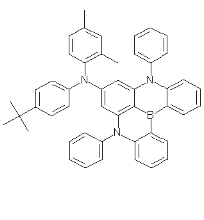 | 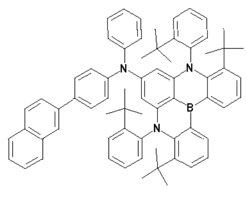 |
| 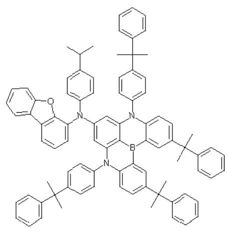 | 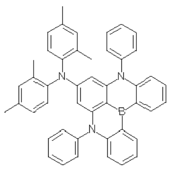 | 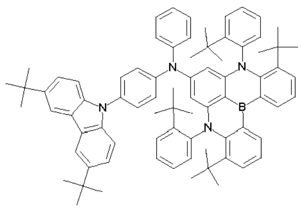 |
| 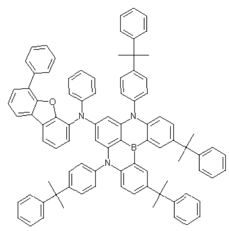 | 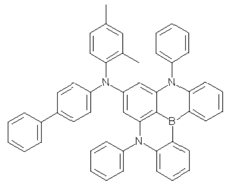 | 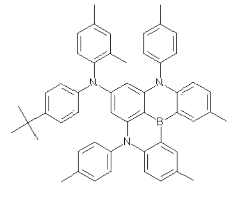 |

| | | |
|---|---|---|
| 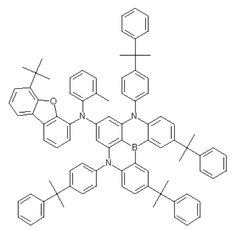 | 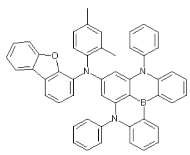 | 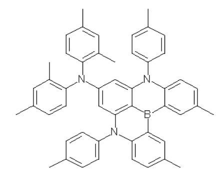 |
| 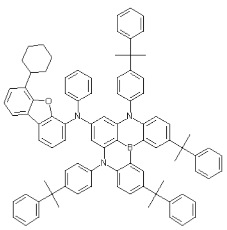 | 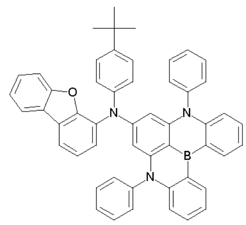 | 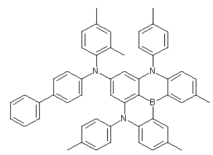 |
| 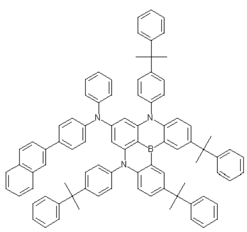 | 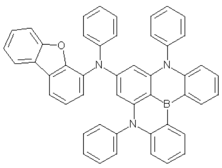 | 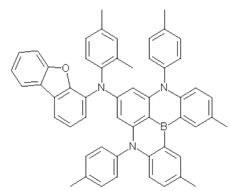 |
| 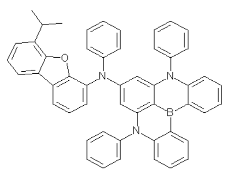 | 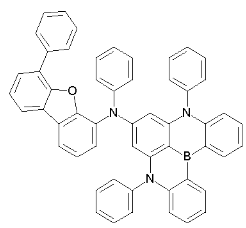 | 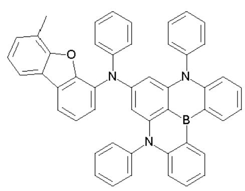 |
| 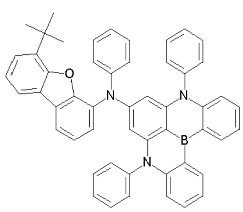 | 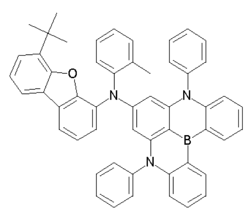 | 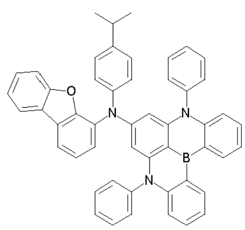 |
| 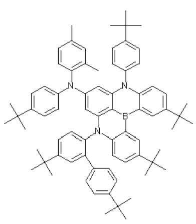 | 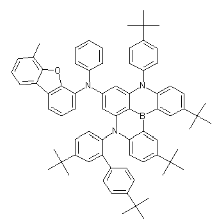 | 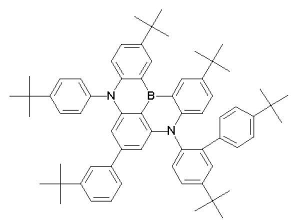 |
| 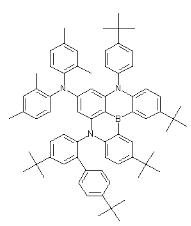 | 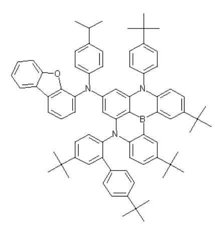 | 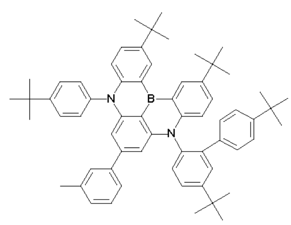 |

| | | |
|---|---|---|
| 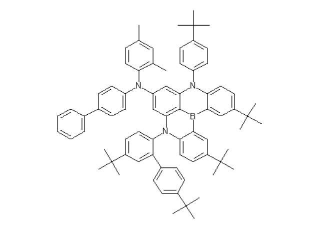 | 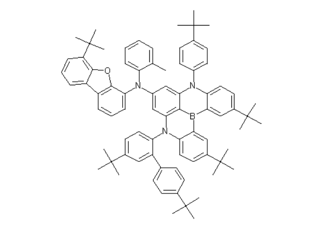 | 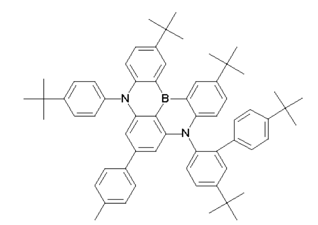 |
| 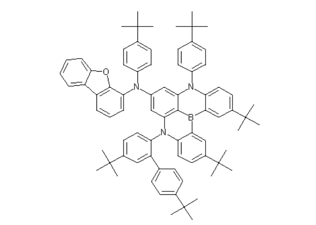 | 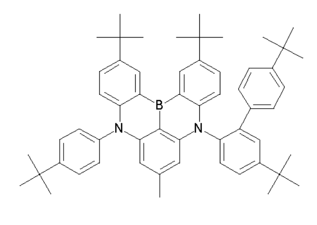 | 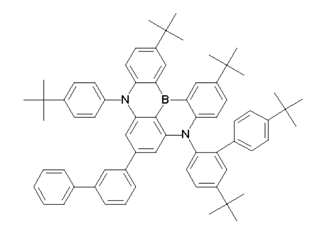 |
| 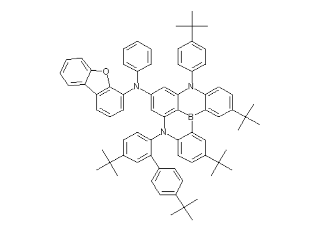 | 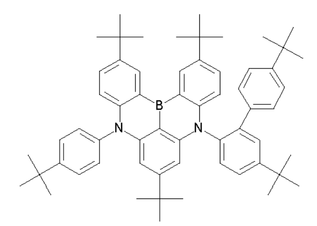 | 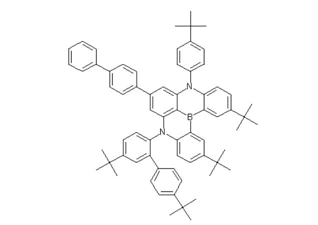 |
| 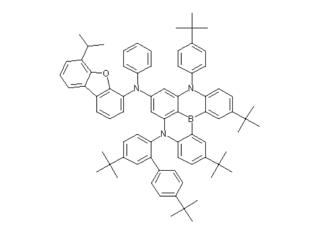 | 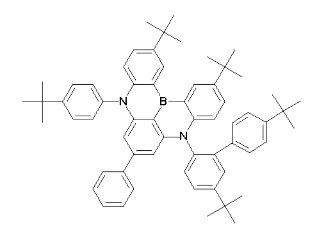 | 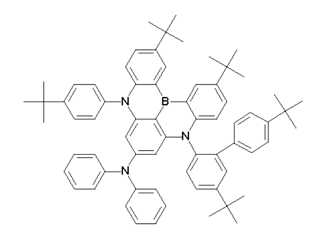 |
| 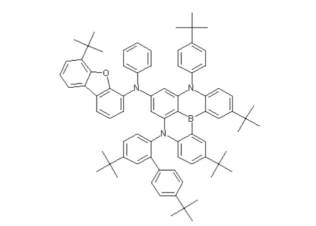 | 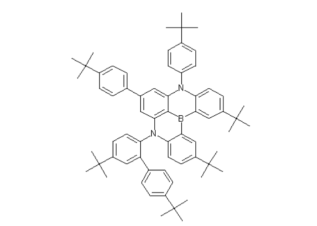 | 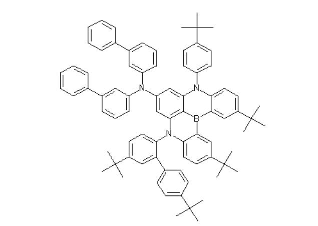 |
| 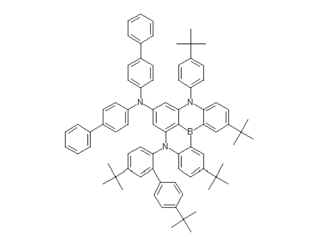 | 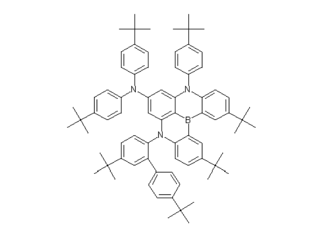 | 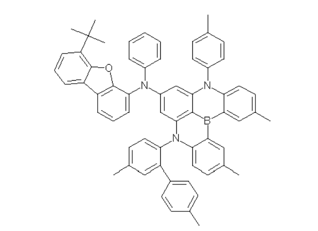 |
| 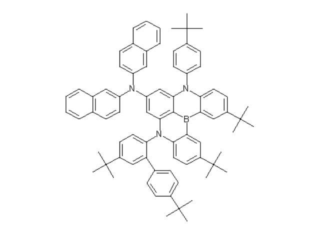 | 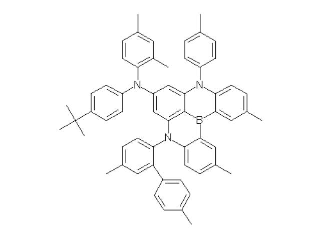 | 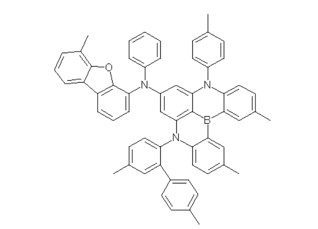 |

| | | |
|---|---|---|
| 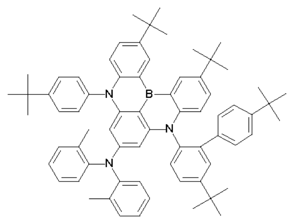 | 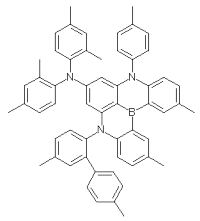 | 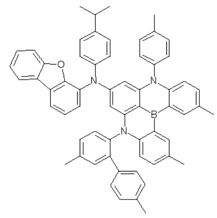 |
| 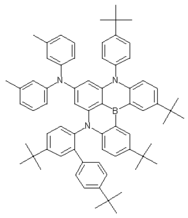 | 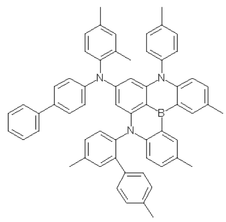 | 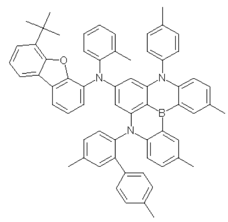 |
| 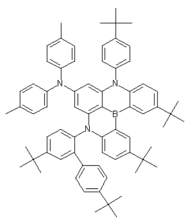 | 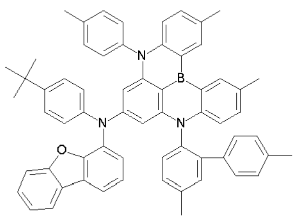 | 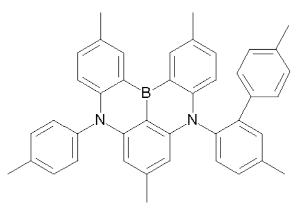 |
| 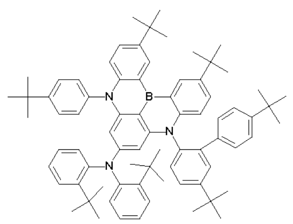 | 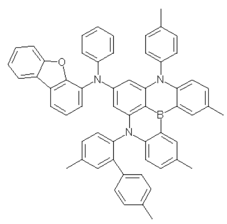 | 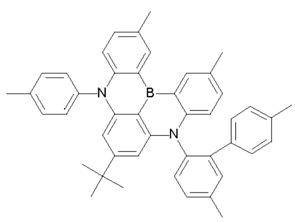 |
| 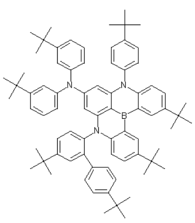 | 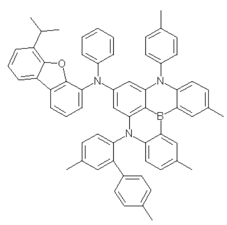 | 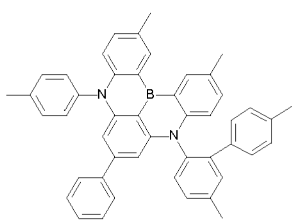 |
| 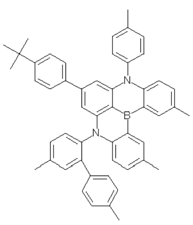 | 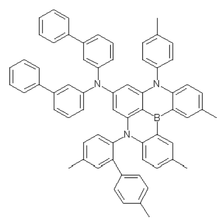 | 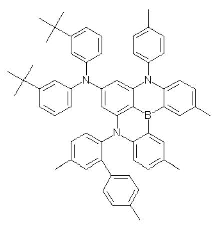 |
| 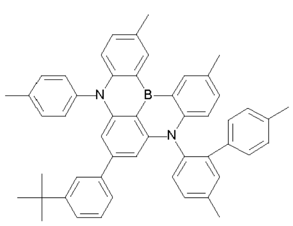 | 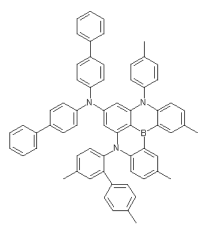 | 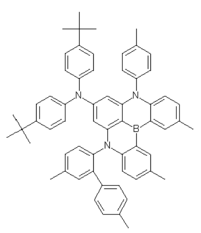 |

| | | |
|---|---|---|
| 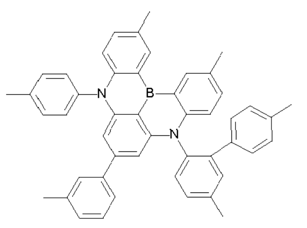 | 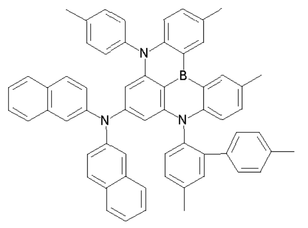 | 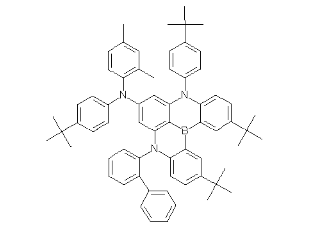 |
| 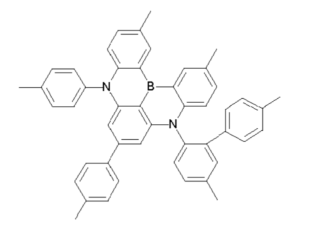 | 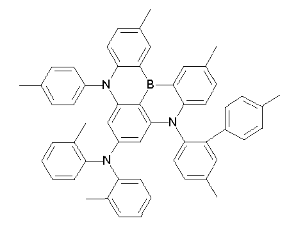 | 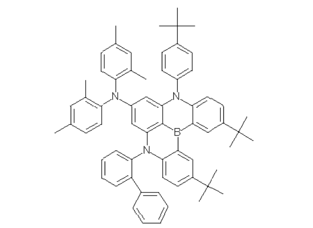 |
| 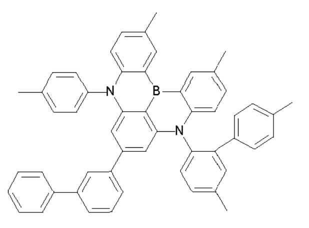 | 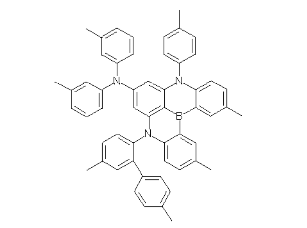 | 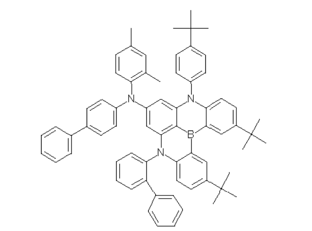 |
| 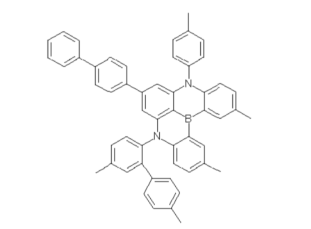 | 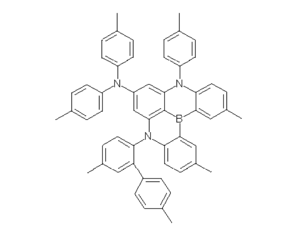 | 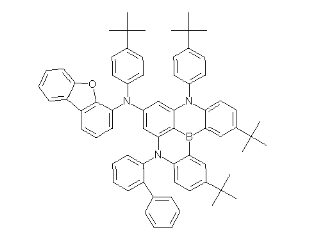 |
| 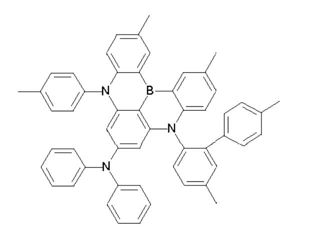 | 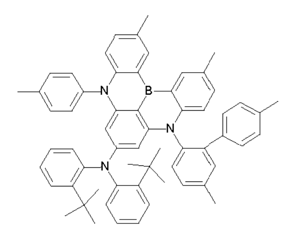 | 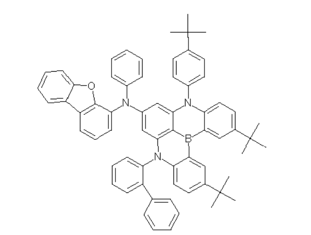 |
| 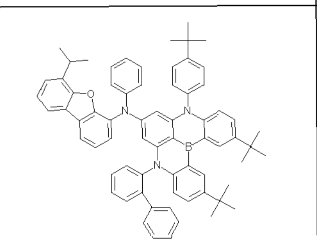 | 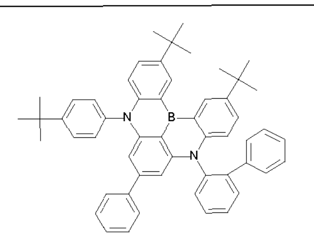 | 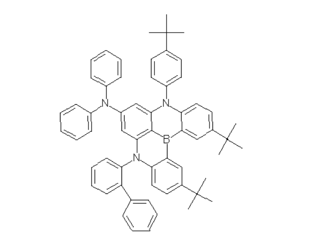 |
| 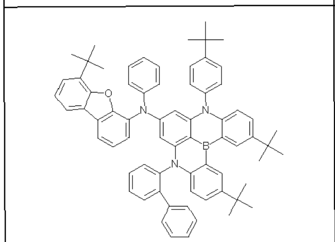 | 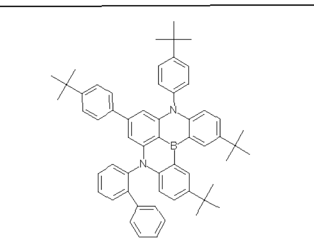 | 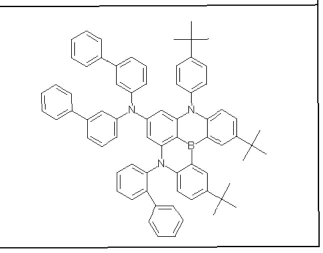 |

| | | |
|---|---|---|
| 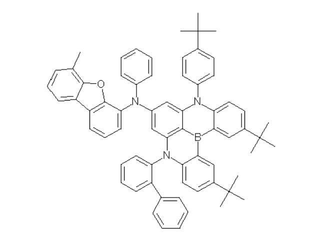 | 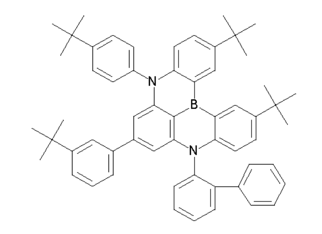 | 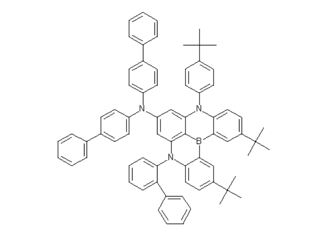 |
| 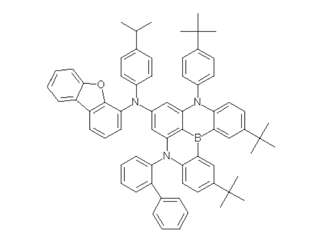 | 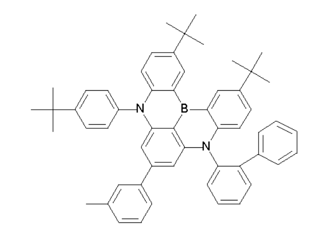 | 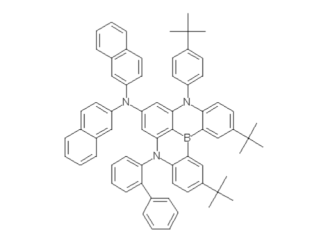 |
| 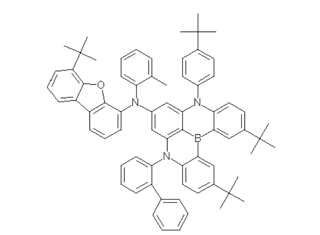 | 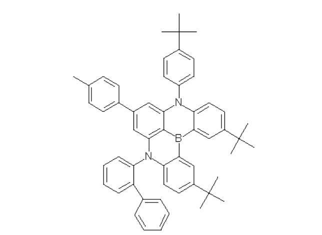 | 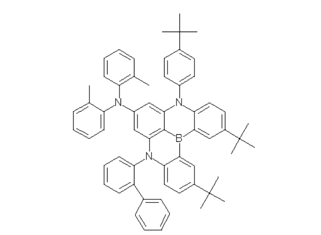 |
| 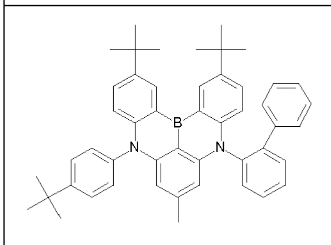 | 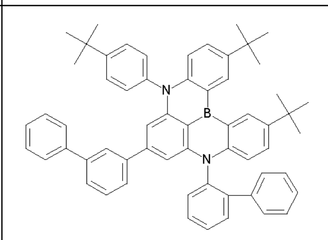 | 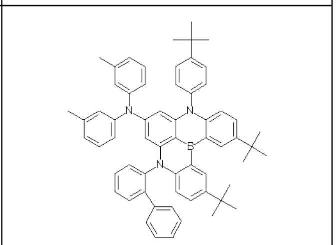 |
| 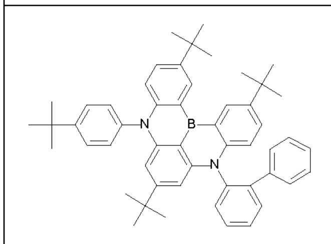 | 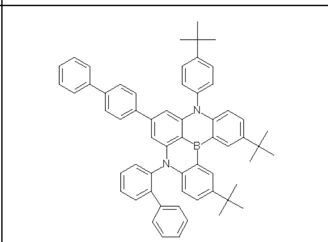 | 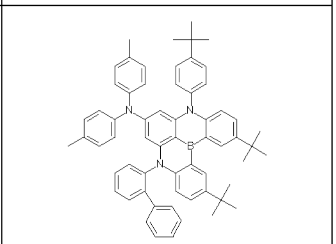 |
| 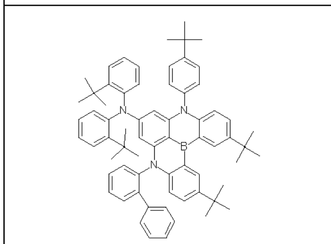 | 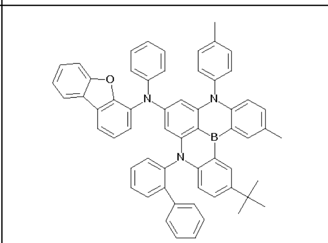 | 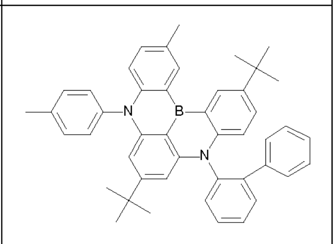 |
| 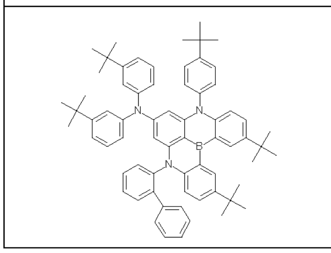 | 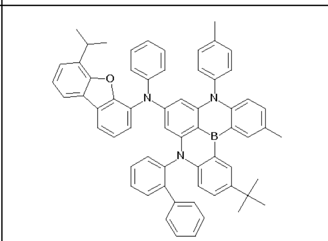 | 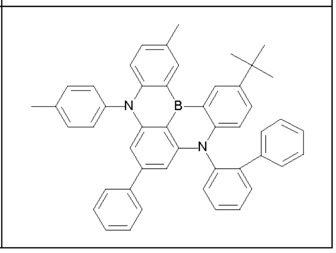 |

| | | |
|---|---|---|
| 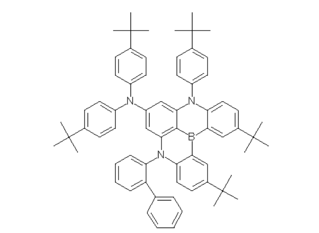 | 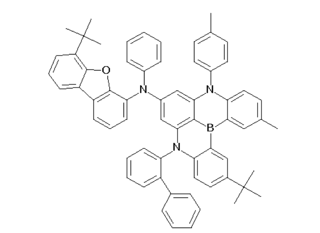 | 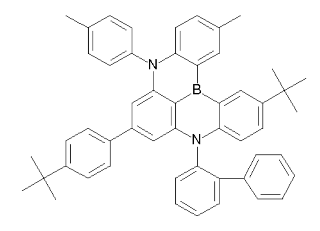 |
| 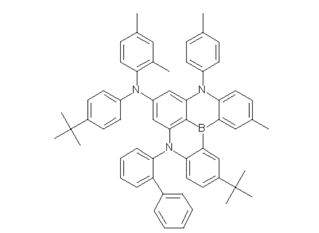 | 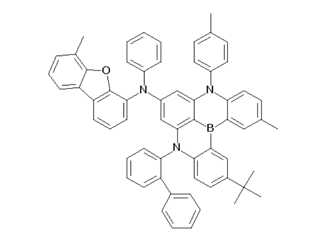 | 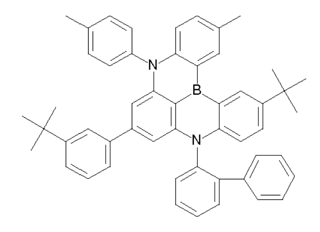 |
| 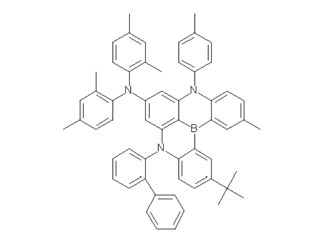 | 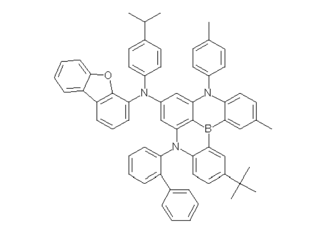 | 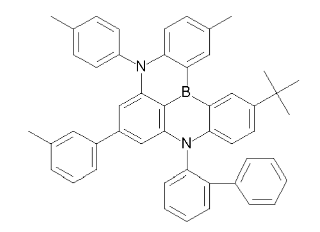 |
| 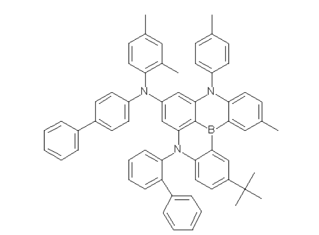 | 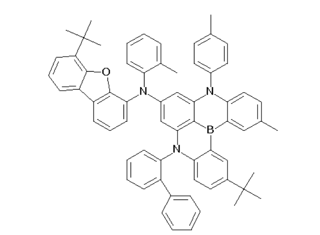 | 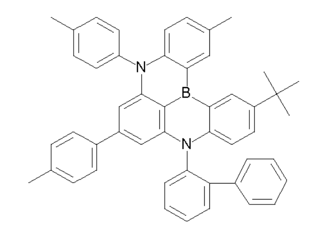 |
| 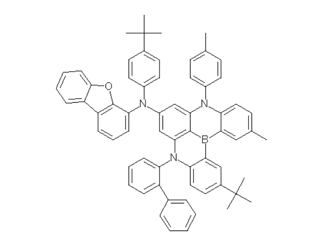 | 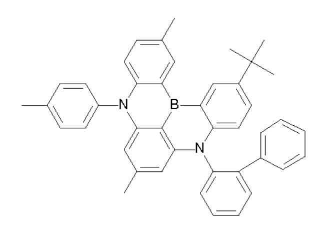 | 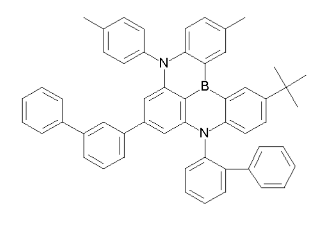 |
| 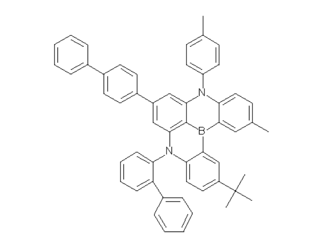 | 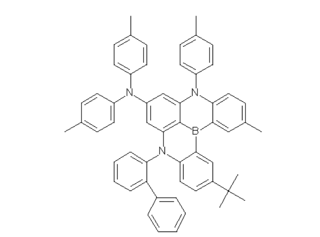 | 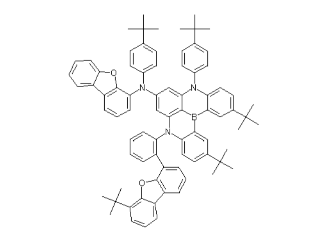 |
| 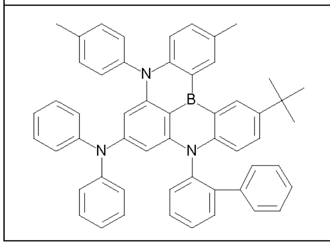 | 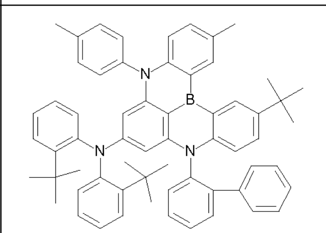 | 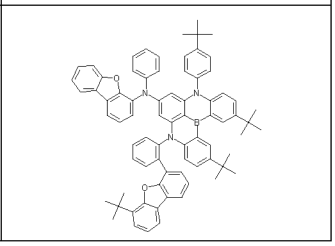 |

| | | |
|---|---|---|
| 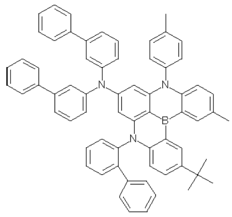 | 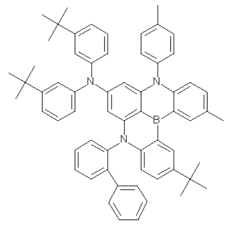 | 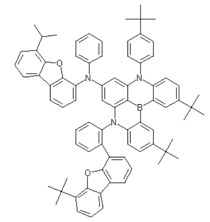 |
| 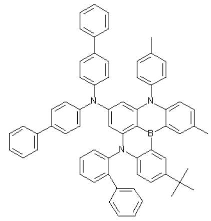 | 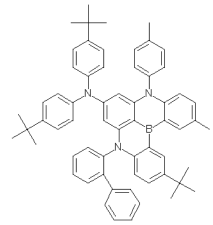 | 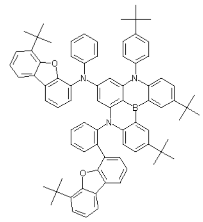 |
| 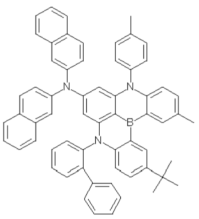 | 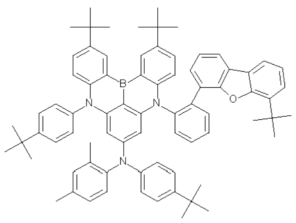 | 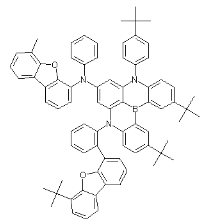 |
| 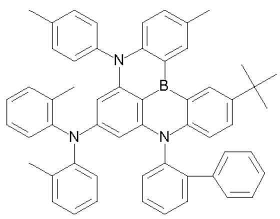 | 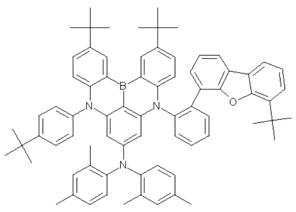 | 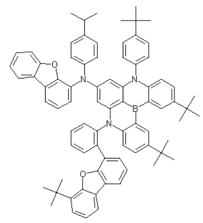 |
| 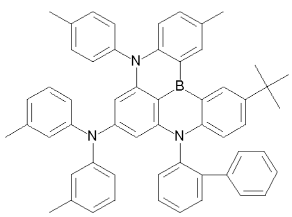 | 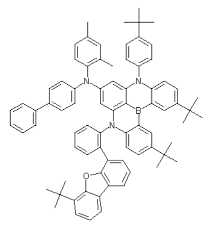 | 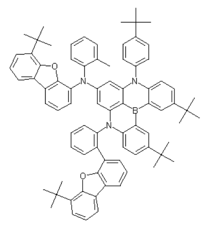 |
| 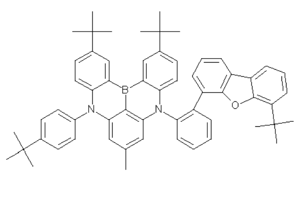 | 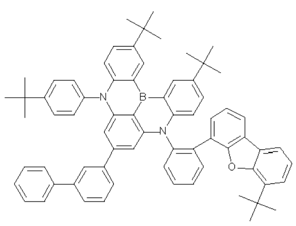 | 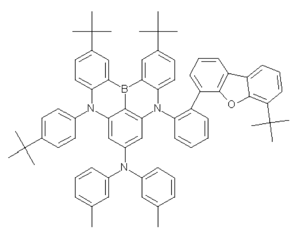 |
| 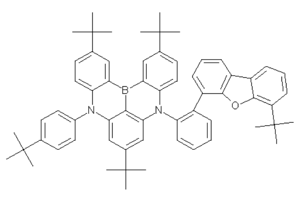 | 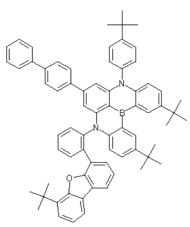 | 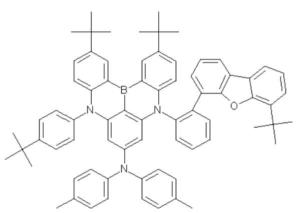 |

| | | |
|---|---|---|
| 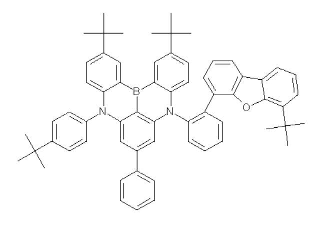 | 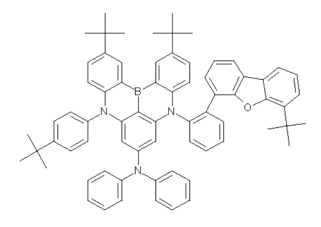 | 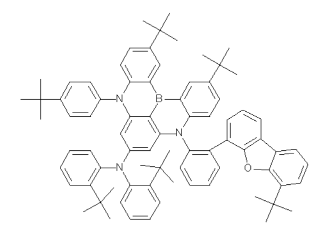 |
| 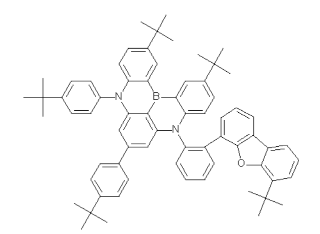 | 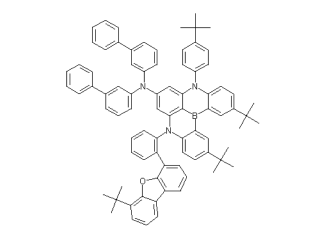 | 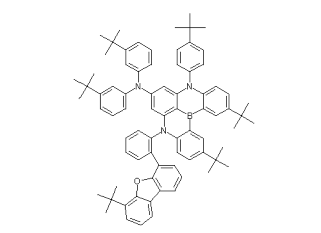 |
| 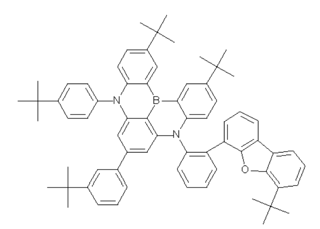 | 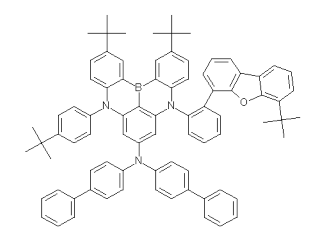 | 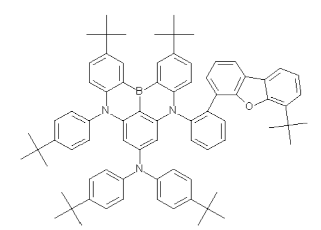 |
| 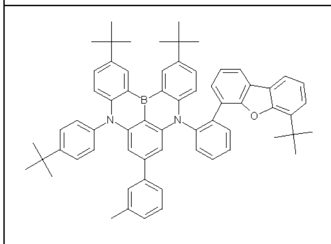 | 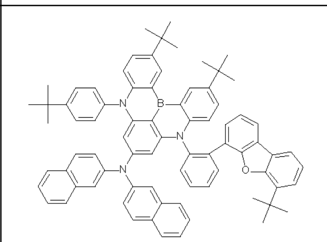 | 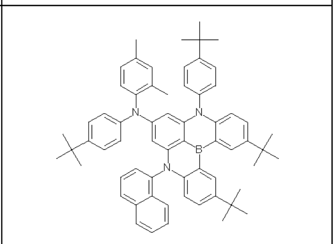 |
| 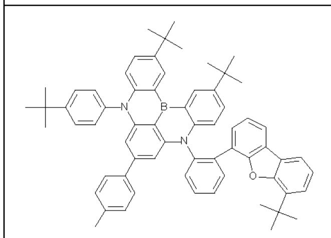 | 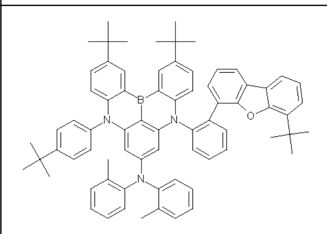 | 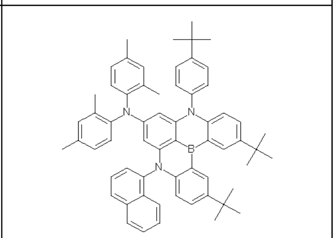 |
| 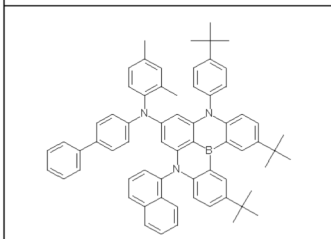 | 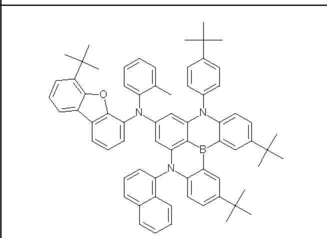 | 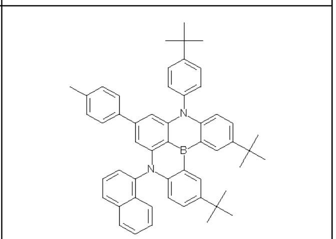 |
| 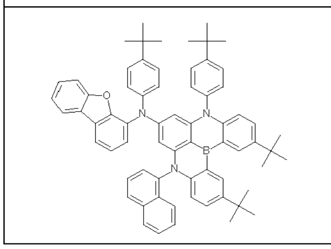 | 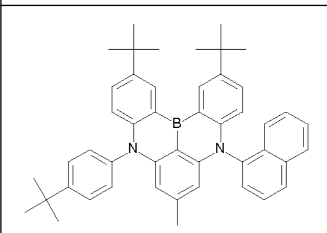 | 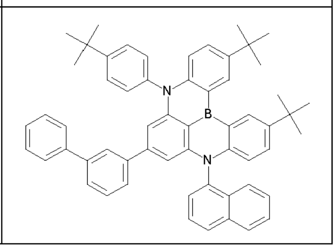 |

| | | |
|---|---|---|
| 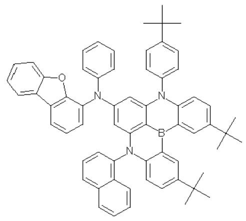 | 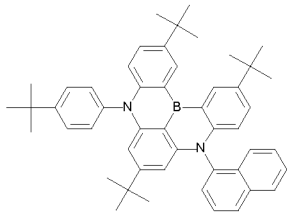 | 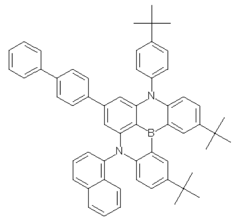 |
| 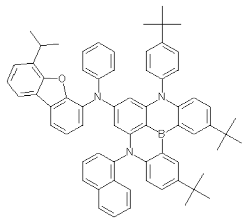 | 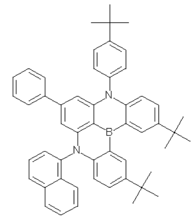 | 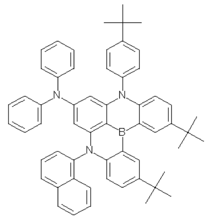 |
| 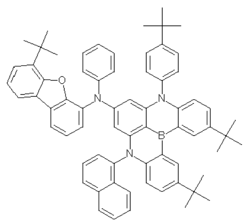 | 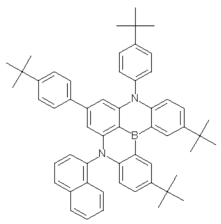 | 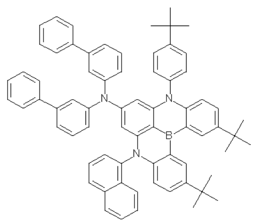 |
| 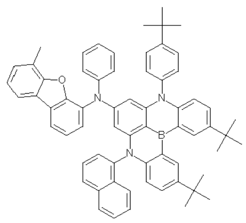 | 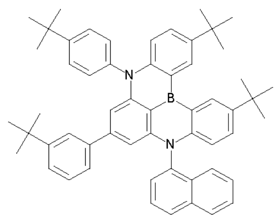 | 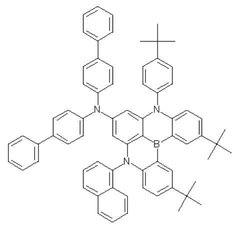 |
| 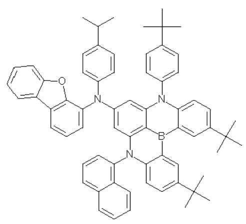 | 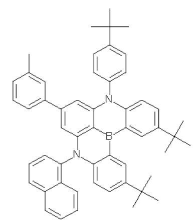 | 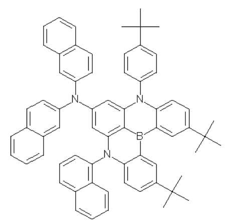 |
| 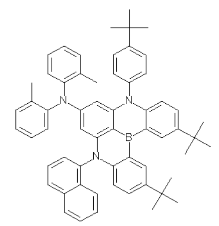 | 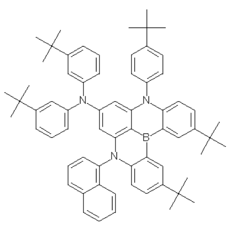 | 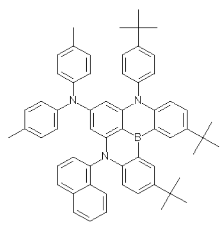 |
| 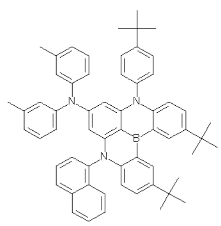 | 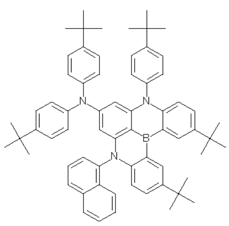 | 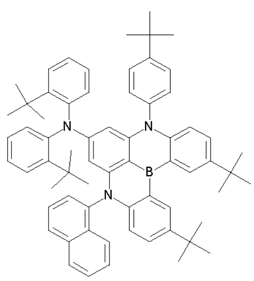 |

Bevorzugt ist A in der Verbindung der Formel (E-1) gleich

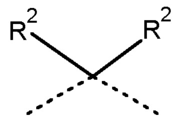

oder

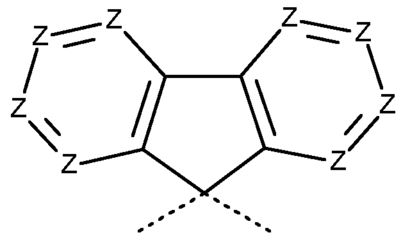

,

wobei die gestrichelten Bindungen die

Bindungen von A zum Rest der Formel kennzeichnen. Besonders bevorzugt ist A gleich

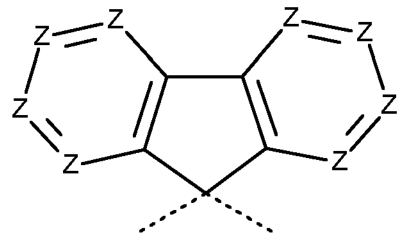

,

wobei die gestrichelten Bindungen die Bindungen von A zum Rest der Formel kennzeichnen.

Bevorzugt ist Z gleich $CR^1$, wenn keine Gruppe

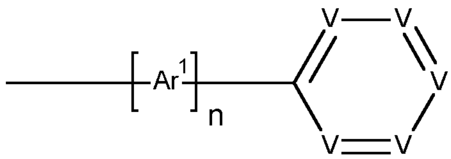

daran gebunden ist.

Bevorzugt sind zwei oder drei Gruppen V im Ring in Formel (E-1) gleich N, und die restlichen Gruppen V sind gleich $CR^4$. Besonders bevorzugt sind drei Gruppen V im Ring in Formel (E-1) gleich N, und die restlichen Gruppen V sind gleich $CR^4$. Weiterhin ist es bevorzugt, dass Gruppen V, die gleich N sind, im Ring nicht benachbart zueinander sind. Unter "benachbart zueinander im Ring" wird dabei verstanden, dass die betreffenden Gruppen V aneinander gebunden sind.

Bevorzugte Gruppen

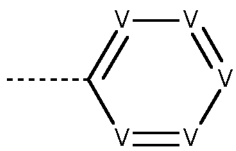

sind die folgenden Gruppen

| | |
|---|---|
| 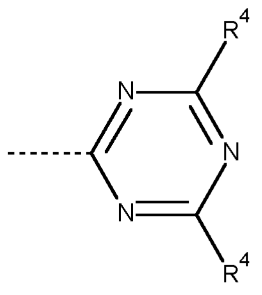 | 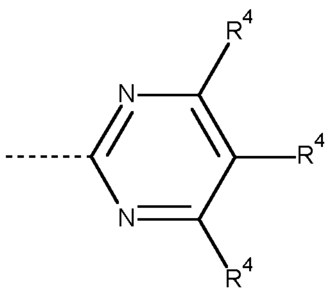 |
| Formel (H-1) | Formel (H-2) |
| 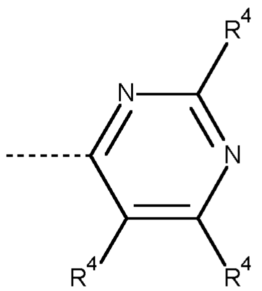 | 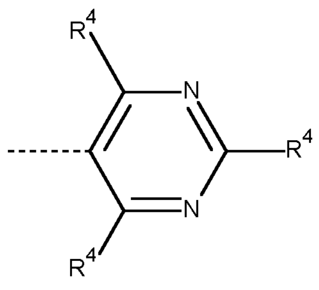 |
| Formel (H-3) | Formel (H-4), |

wobei die gestrichelte Linie die Bindung an den Rest der Formel darstellt. Bevorzugt ist dabei $R^4$ gewählt aus H, aromatischen Ringsystemen mit 6 bis 40 aromatischen Ringatomen, die mit Resten $R^5$ substituiert sind, und heteroaromatischen Ringsystemen mit 5 bis 40 aromatischen Ringatomen, die mit Resten $R^5$ substituiert sind; besonders bevorzugt aus H und aromatischen Ringsystemen mit 6 bis 40 aromatischen Ringatomen, die mit Resten $R^5$ substituiert sind, ganz besonders bevorzugt aus H und Phenyl, das mit Resten $R^5$ substituiert ist.

Besonders bevorzugt unter den Formeln (H-1) bis (H-4) sind die Formeln (H-1) bis (H-3). Ganz besonders bevorzugt ist die Formel (H-1).

Bevorzugte Ausführungsformen der Formeln (H-2) und (H-3) sind im Folgenden gezeigt:

| | |
|---|---|
| 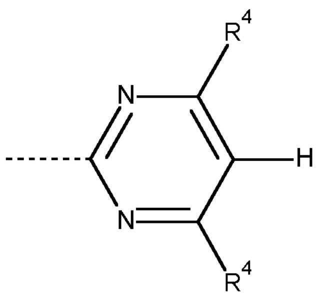 | 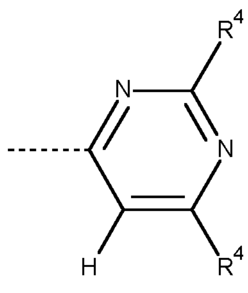 |
| Formel (H-2-1) | Formel (H-3-1), |

wobei die gestrichelte Linie die Bindung an den Rest der Formel darstellt. Bevorzugt ist dabei $R^4$ gewählt aus aromatischen Ringsystemen mit 6 bis 40 aromatischen Ringatomen, die mit Resten $R^5$ substituiert sind, und aus heteroaromatischen Ringsystemen mit 5 bis 40 aromatischen Ringatomen, die mit Resten $R^5$ substituiert sind; besonders bevorzugt aus aromatischen Ringsystemen mit 6 bis 40 aromatischen Ringatomen, die mit Resten $R^5$ substituiert sind; ganz besonders bevorzugt aus Phenyl, das mit Resten $R^5$ substituiert ist.

$Ar^1$ ist bevorzugt gleich oder verschieden gewählt aus divalenten Gruppen abgeleitet von Benzol, Biphenyl, Terphenyl, Naphthalin, Fluoren, Indenofluoren, Indenocarbazol, Spirobifluoren, Dibenzofuran, Dibenzothiophen und Carbazol, die jeweils mit einem oder mehreren Resten $R^3$ substituiert sein können. Ganz besonders bevorzugt ist $Ar^1$ eine divalente Gruppe abgeleitet von Benzol, das jeweils mit einem oder mehreren Resten $R^3$ substituiert sein kann.

Gemäß einer bevorzugten Ausführungsform ist Index n gleich 0. Gemäß einer alternativen bevorzugten Ausführungsform ist Index n gleich 1, 2 oder 3, bevorzugt gleich 1 oder 2, besonders bevorzugt gleich 1.

Bevorzugte Gruppen $-(Ar^1)_n-$ entsprechen den folgenden Formeln:

| | | |
|---|---|---|
| 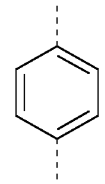 | 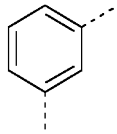 | 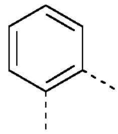 |
| $Ar^1$-1 | $Ar^1$-2 | $Ar^1$-3 |
| 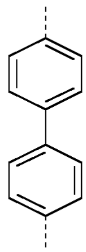 | 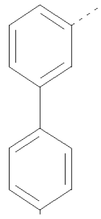 | 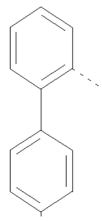 |
| $Ar^1$-4 | $Ar^1$-5 | $Ar^1$-6 |
| 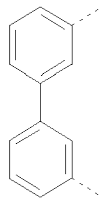 | 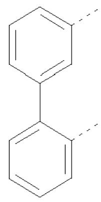 | 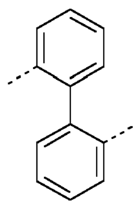 |
| $Ar^1$-7 | $Ar^1$-8 | $Ar^1$-9 |
| 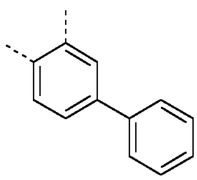 | 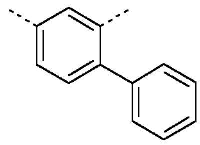 | 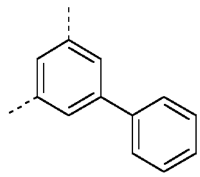 |
| $Ar^1$-10 | $Ar^1$-11 | $Ar^1$-12 |
| 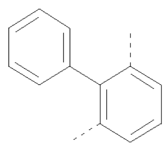 | 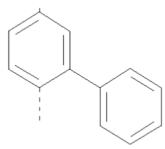 | 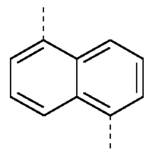 |
| $Ar^1$-13 | $Ar^1$-14 | $Ar^1$-15 |
| 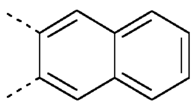 | 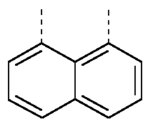 | 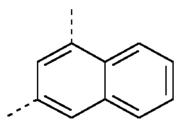 |
| $Ar^1$-16 | $Ar^1$-17 | $Ar^1$-18 |
| 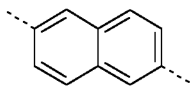 | 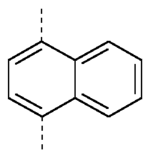 | 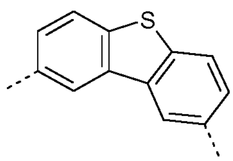 |

(fortgesetzt)

| $Ar^1$-19 | $Ar^1$-20 | $Ar^1$-21 |
|---|---|---|
| 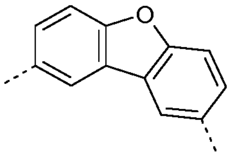 | 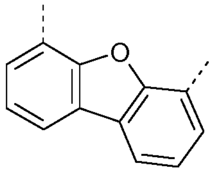 | 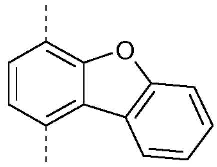 |
| $Ar^1$-22 | $Ar^1$-23 | $Ar^1$-24 |
| 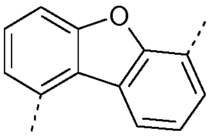 | 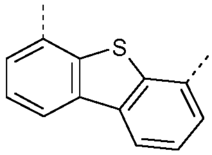 | 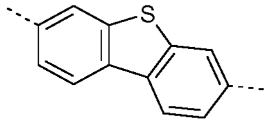 |
| $Ar^1$-25 | $Ar^1$-26 | $Ar^1$-27 |
| 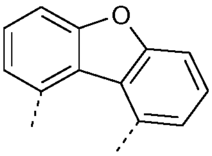 | 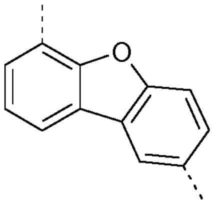 | 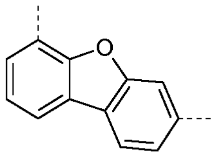 |
| $Ar^1$-28 | $Ar^1$-29 | $Ar^1$-30 |
| 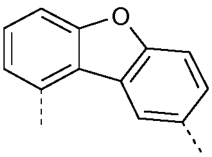 | 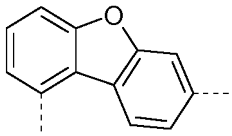 | 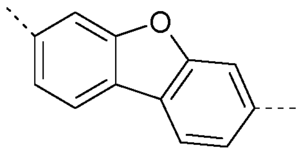 |
| $Ar^1$-31 | $Ar^1$-32 | $Ar^1$-33 |
| 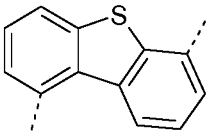 | 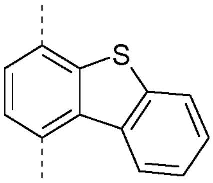 | 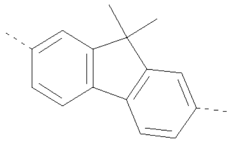 |
| $Ar^1$-34 | $Ar^1$-35 | $Ar^1$-36 |
| 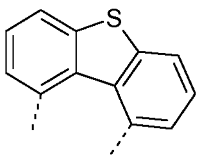 | 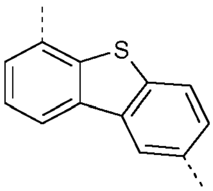 | 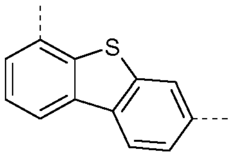 |
| $Ar^1$-37 | $Ar^1$-38 | $Ar^1$-39 |

(fortgesetzt)

| | | |
|---|---|---|
| 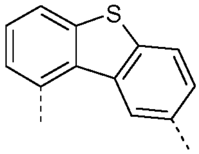 | 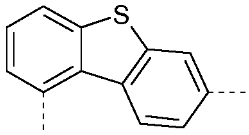 | 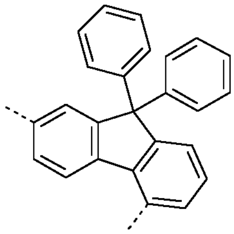 |
| $Ar^1$-40 | $Ar^1$-41 | $Ar^1$-42 |
| 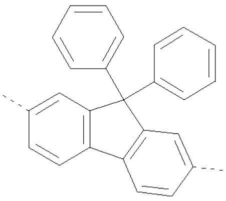 | 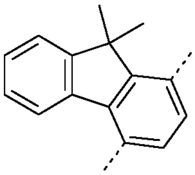 | 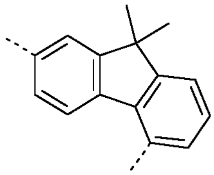 |
| $Ar^1$-43 | $Ar^1$-44 | $Ar^1$-45 |
| 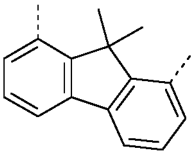 | 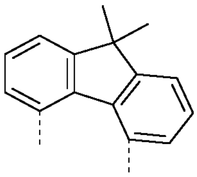 | 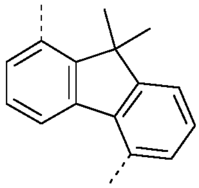 |
| $Ar^1$-46 | $Ar^1$-47 | $Ar^1$-48 |
| 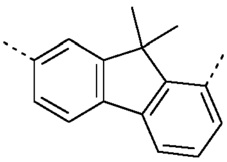 | 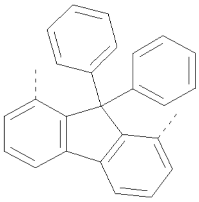 | 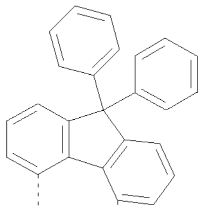 |
| $Ar^1$-49 | $Ar^1$-50 | $Ar^1$-51 |
| 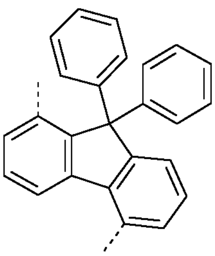 | 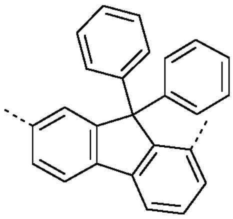 | 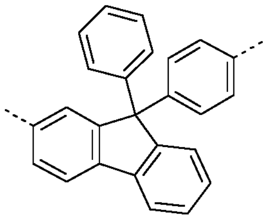 |
| $Ar^1$-52 | $Ar^1$-53 | $Ar^1$-54 |
| 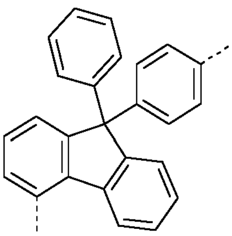 | 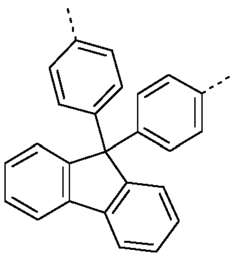 | 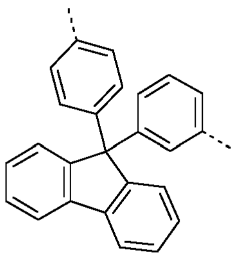 |
| $Ar^1$-55 | $Ar^1$-56 | $Ar^1$-57 |

(fortgesetzt)

| | | |
|---|---|---|
| 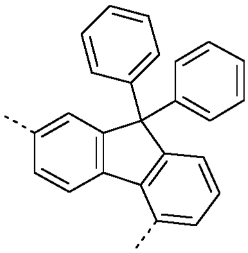 | 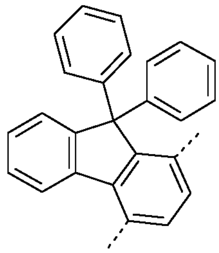 | 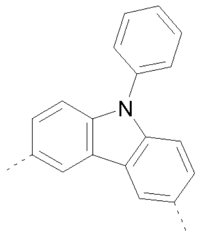 |
| $Ar^1$-58 | $Ar^1$-59 | $Ar^1$-60 |
| 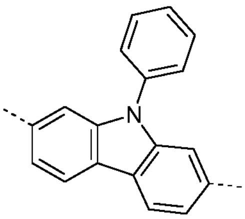 | 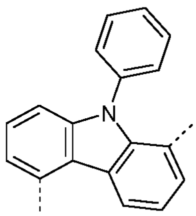 | 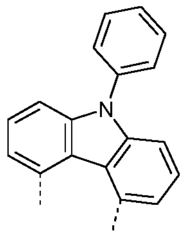 |
| $Ar^1$-61 | $Ar^1$-62 | $Ar^1$-63 |
| 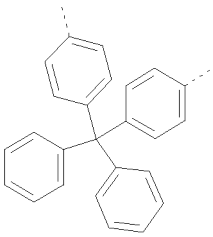 | 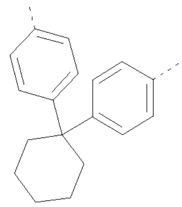 | 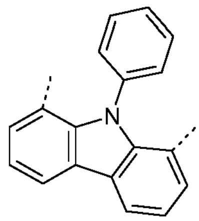 |
| $Ar^1$-64 | $Ar^1$-65 | $Ar^1$-66 |
| 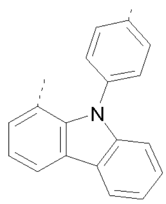 | 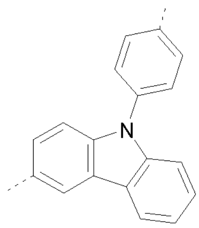 | 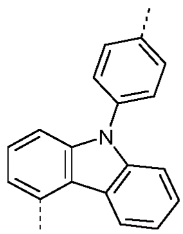 |
| $Ar^1$-67 | $Ar^1$-68 | $Ar^1$-69 |
| 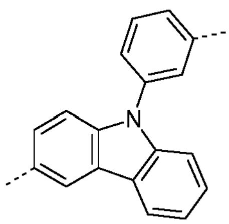 | 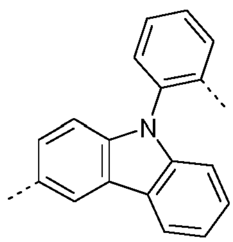 | 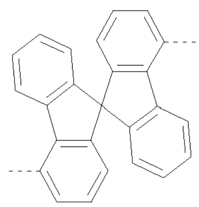 |
| $Ar^1$-70 | $Ar^1$-71 | $Ar^1$-72 |

(fortgesetzt)

| | | |
|---|---|---|
| 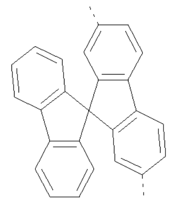 | 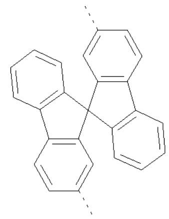 | 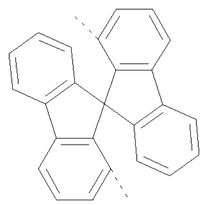 |
| $Ar^1$-73 | $Ar^1$-74 | $Ar^1$-75 |

wobei die gestrichelten Linien die Bindungen an den Rest der Formel darstellen.

Bevorzugt ist $R^1$ bei jedem Auftreten gleich oder verschieden gewählt aus H, D, F, CN, $Si(R^5)_3$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^5$ substituiert sind; und wobei in den genannten Alkyl- oder Alkoxygruppen eine oder mehrere $CH_2$-Gruppen durch -C=C-, $-R^5C=CR^5-$, $Si(R^5)_2$, C=O, $C=NR^5$, $-NR^5-$, -O-, - S-, -C(=O)O- oder $-C(=O)NR^5-$ ersetzt sein können. Besonders bevorzugt ist $R^1$ bei jedem Auftreten gleich oder verschieden gewählt aus H, F, aromatischen Ringsystemen mit 6 bis 40 aromatischen Ringatomen, und heteroaromatischen Ringsystemen mit 5 bis 40 aromatischen Ringatomen; wobei die aromatischen Ringsysteme und die heteroaromatischen Ringsysteme jeweils mit Resten $R^5$ substituiert sind. Ganz besonders bevorzugt ist $R^1$ gleich H.

Bevorzugt ist $R^2$ bei jedem Auftreten gleich oder verschieden gewählt aus H, D, F, CN, $Si(R^5)_3$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^5$ substituiert sind; und wobei in den genannten Alkyl- oder Alkoxygruppen eine oder mehrere $CH_2$-Gruppen durch -C=C-, $-R^5C=CR^5-$, $Si(R^5)_2$, C=O, $C=NR^5$, $-NR^5-$, -O-, - S-, -C(=O)O- oder $-C(=O)NR^5-$ ersetzt sein können. Besonders bevorzugt ist $R^2$ bei jedem Auftreten gleich oder verschieden gewählt aus geradkettigen Alkylgruppen mit 1 bis 20 C-Atomen, verzweigten Alkylgruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkylgruppen, die genannten aromatischen Ringsysteme und die genannten heteroaromatischen Ringsysteme jeweils mit Resten $R^5$ substituiert sind. Ganz besonders bevorzugt ist $R^2$ bei jedem Auftreten gleich oder verschieden, bevorzugt gleich, gewählt aus Alkylgruppen mit 1 bis 10 Atomen, bevorzugt Methyl, und aromatischen Ringsystemen mit 6 bis 40 aromatischen Ringatomen, bevorzugt Phenyl.

Bevorzugt ist $R^3$ bei jedem Auftreten gleich oder verschieden gewählt aus H, D, F, CN, $Si(R^5)_3$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^5$ substituiert sind; und wobei in den genannten Alkyl- oder Alkoxygruppen eine oder mehrere $CH_2$-Gruppen durch -C=C-, $-R^5C=CR^5-$, $Si(R^5)_2$, C=O, $C=NR^5$, $-NR^5-$, -O-, - S-, -C(=O)O- oder $-C(=O)NR^5-$ ersetzt sein können.

Bevorzugt ist $R^4$ bei jedem Auftreten gleich oder verschieden gewählt aus H, D, F, CN, $Si(R^5)_3$, geradkettigen Alkylgruppen mit 1 bis 20 C-Atomen, verzweigten oder cyclischen Alkylgruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkylgruppen, die genannten aromatischen Ringsysteme und die genannten heteroaromatischen Ringsysteme jeweils mit Resten $R^5$ substituiert sind. Besonders bevorzugt ist $R^4$ bei jedem Auftreten gleich oder verschieden gewählt aus H und aromatischen Ringsystemen mit 6 bis 40 aromatischen Ringatomen, die mit Resten $R^5$ substituiert sind. Ganz besonders bevorzugt ist $R^4$ bei jedem Auftreten gleich oder verschieden gewählt aus H und Phenyl, das mit Resten $R^5$ substituiert ist.

Bevorzugt ist $R^5$ bei jedem Auftreten gleich oder verschieden gewählt aus H, D, F, CN, $Si(R^6)_3$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^6$ substituiert sind; und wobei in den genannten Alkyl- oder Alkoxygruppen eine oder mehrere $CH_2$-Gruppen durch $-C\equiv C-$, $-R^6C=CR^6-$, $Si(R^6)^2$, C=O,

C=NR$^6$, -NR$^6$-, -O-, - S-, -C(=O)O- oder -C(=O)NR$^6$- ersetzt sein können.

Die Verbindung der Formel (E-1) entspricht bevorzugt einer der folgenden Formeln:

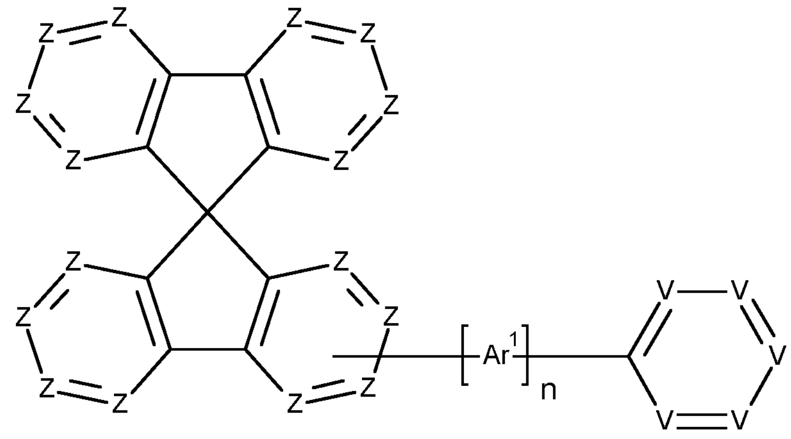

Formel (E-1-1)

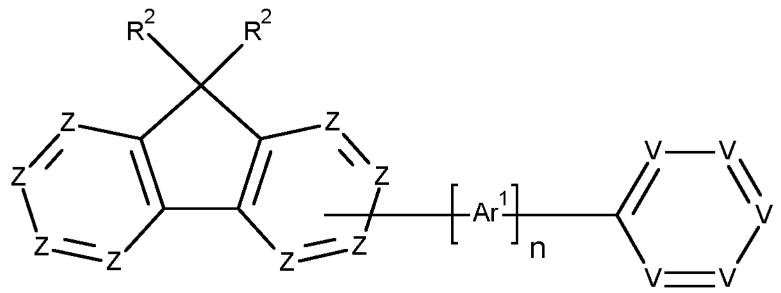

Formel (E-1-2),

wobei die auftretenden Symbole und Indices definiert sind wie oben und bevorzugt ihren oben angegebenen bevorzugten Ausführungsformen entsprechen. Insbesondere ist es für die Formeln bevorzugt, dass Z gleich CR$^1$ ist, wenn keine Gruppe

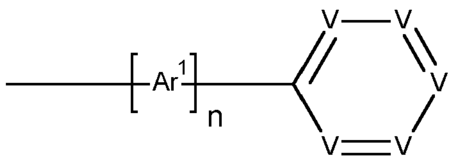

daran gebunden ist.

Formeln (E-1-1) und (E-1-2) können den folgenden Ausführungsformen entsprechen:

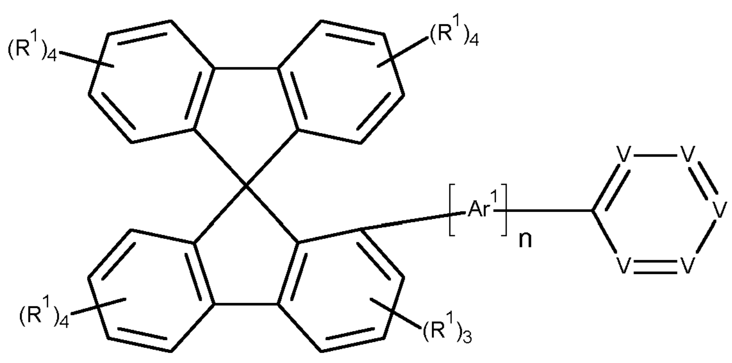

(fortgesetzt)

| Formel (E-1-1-1) |
|---|
| 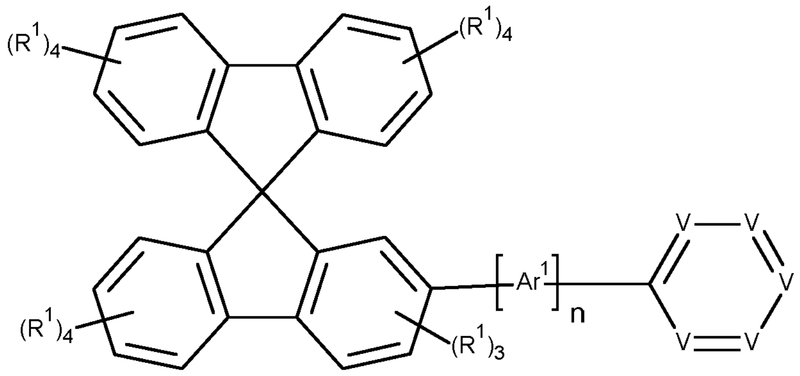 |
| Formel (E-1-1-2) |
| 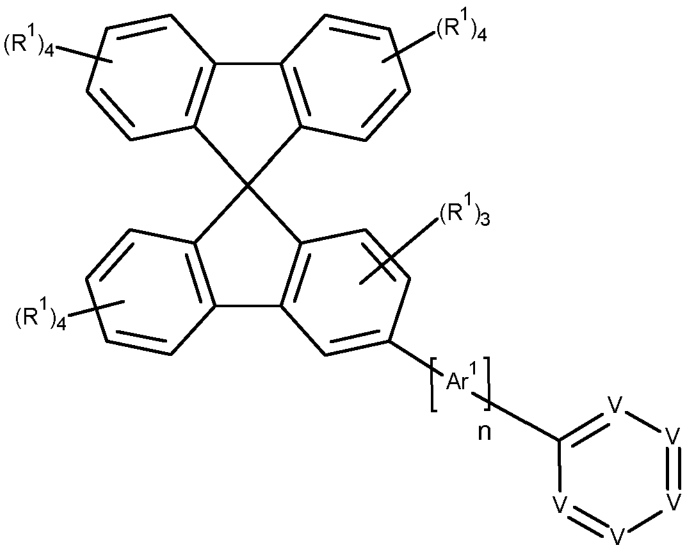 |
| Formel (E-1-1-3) |
| 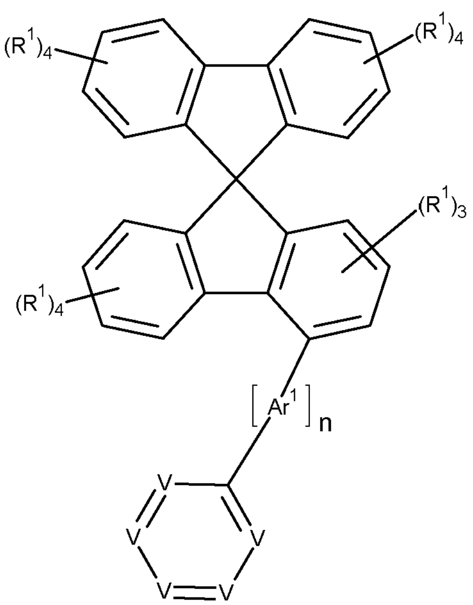 |

(fortgesetzt)

| Formel (E-1-1-4) |
|---|
| 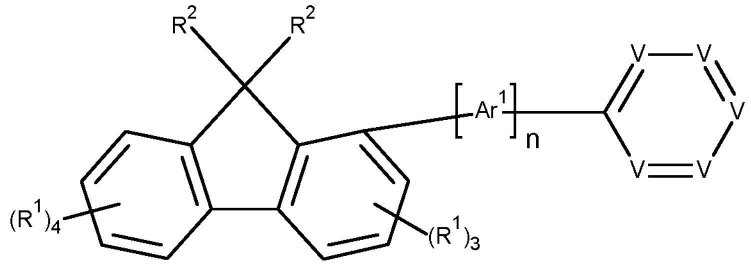 |
| Formel (E-1-2-1) |
| 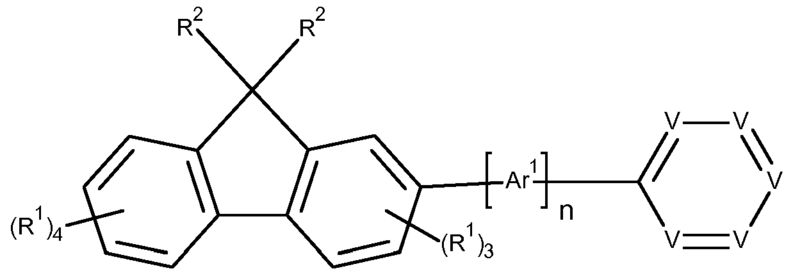 |
| Formel (E-1-2-2) |
| 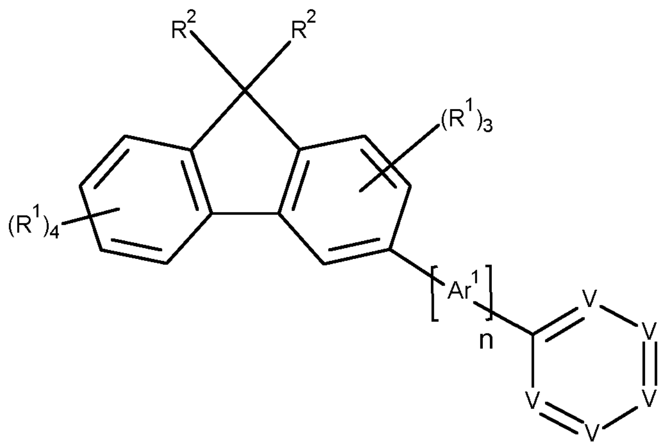 |
| Formel (E-1-2-3) |

(fortgesetzt)

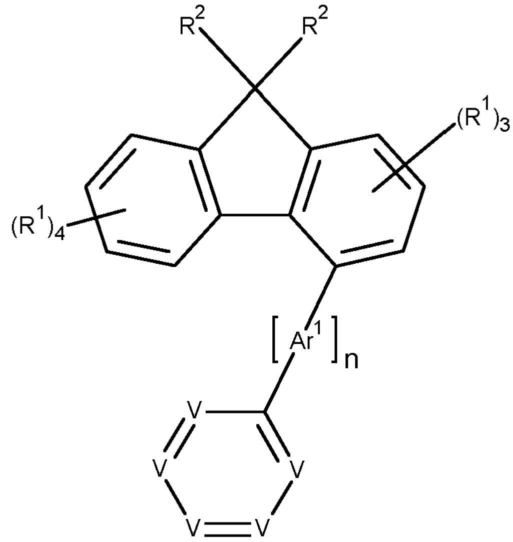

Formel (E-1-2-4)

wobei die auftretenden Symbole und Indices definiert sind wie oben und bevorzugt ihren oben angegebenen bevorzugten Ausführungsformen entsprechen. Mit der Darstellung -$(R^1)_3$ bzw. -$(R^1)_4$ ist dabei gemeint, dass drei bzw. vier Gruppen $R^1$ am betreffenden Benzolring vorliegen, d.h. eine Gruppe $R^1$ an jeder freien Position am betreffenden Benzolring. Bevorzugt gelten für die Formeln die oben genannten bevorzugten Ausführungsformen der Gruppen V, $Ar^1$, $R^1$ und $R^2$, und von Index n. Insbesondere ist es für die Formeln bevorzugt, dass

- zwei oder drei nicht benachbarte Gruppen V gleich N sind, und die restlichen Gruppen V gleich $CR^4$ sind;
- Index n gleich 0 oder 1 ist;
- $Ar^1$ gewählt ist aus divalenten Gruppen abgeleitet von Benzol, Biphenyl, Terphenyl, Naphthalin, Fluoren, Indenofluoren, Indenocarbazol, Spirobifluoren, Dibenzofuran, Dibenzothiophen und Carbazol, die jeweils mit einem oder mehreren Resten $R^3$ substituiert sein können;
- $R^1$ bei jedem Auftreten gleich oder verschieden gewählt ist aus H, F, aromatischen Ringsystemen mit 6 bis 40 aromatischen Ringatomen, und heteroaromatischen Ringsystemen mit 5 bis 40 aromatischen Ringatomen; wobei die aromatischen Ringsysteme und die heteroaromatischen Ringsysteme jeweils mit Resten $R^5$ substituiert sind;
- $R^2$ bei jedem Auftreten gleich oder verschieden gewählt ist aus geradkettigen Alkylgruppen mit 1 bis 20 C-Atomen, verzweigten Alkylgruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkylgruppen, die genannten aromatischen Ringsysteme und die genannten heteroaromatischen Ringsysteme jeweils mit Resten $R^5$ substituiert sind.

Unter den Formeln sind die Formeln (E-1-1-1) bis (E-1-1-4) bevorzugt. Weiterhin sind unter den Formeln die Formeln (E-1-1-2), (E-1-1-4), (E-1-2-2) und (E-1-2-4) bevorzugt, insbesondere die Formeln (E-1-1-2) und (E-1-1-4).

Bevorzugte Ausführungsformen der Formeln (E-1-1-1) bis (E-1-1-4) und (E-1-2-1) bis (E-1-2-4) entsprechen den folgenden Formeln:

| |
|---|
| 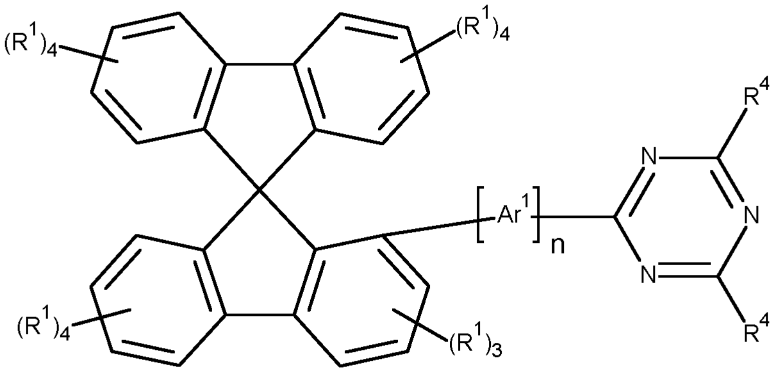 |
| Formel (E-1-1-1-1) |
| 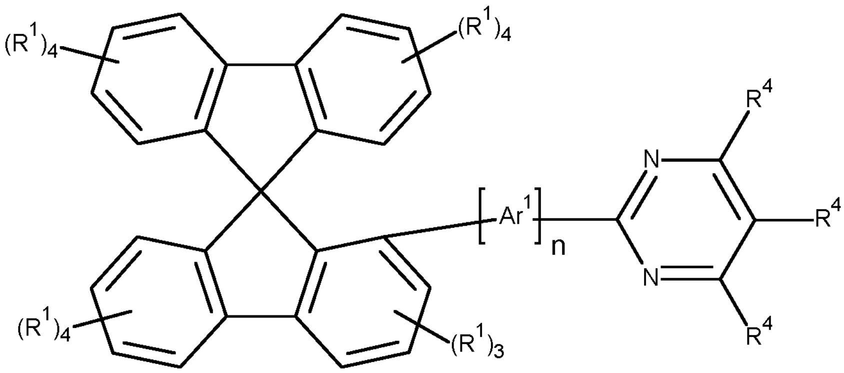 |
| Formel (E-1-1-1-2) |
| 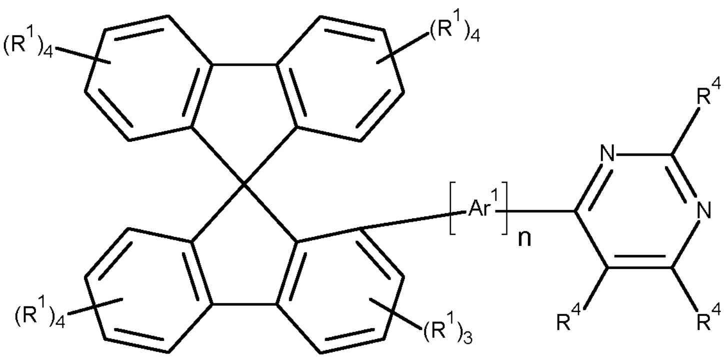 |
| Formel (E-1-1-1-3) |
| 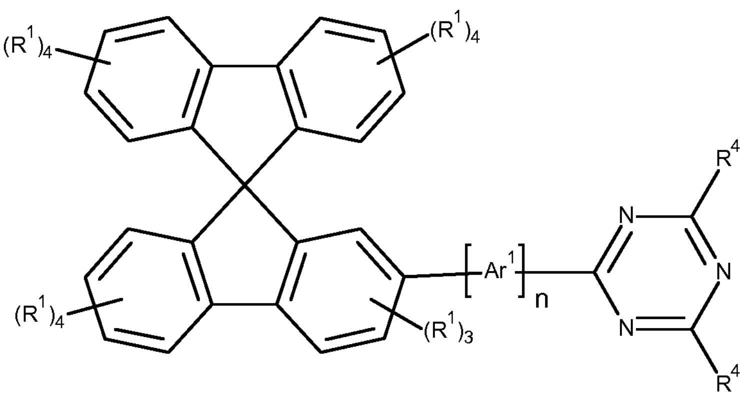 |
| Formel (E-1-1-2-1) |

(fortgesetzt)

| |
|---|
| 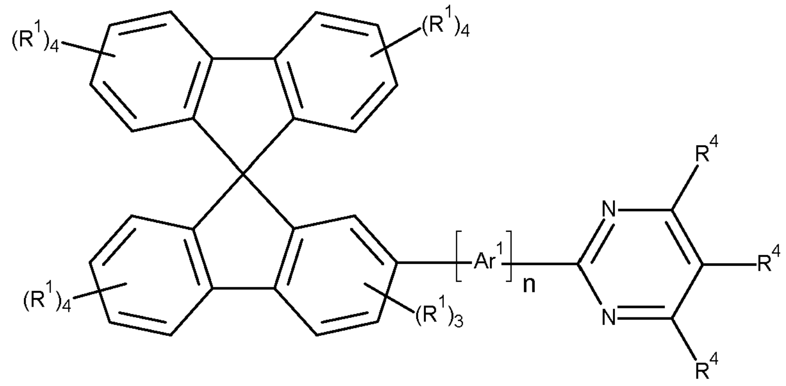 |
| Formel (E-1-1-2-2) |
| 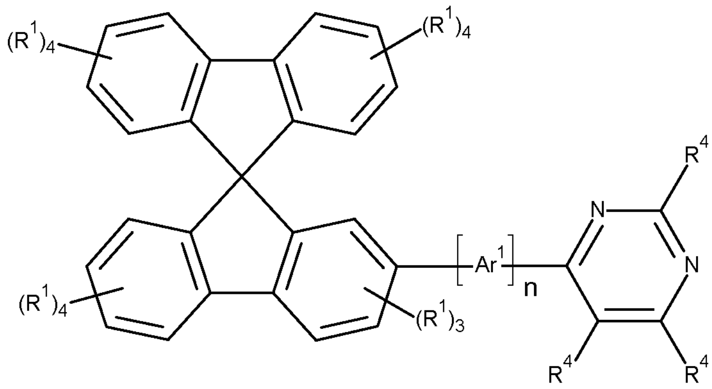 |
| Formel (E-1-1-2-3) |
| 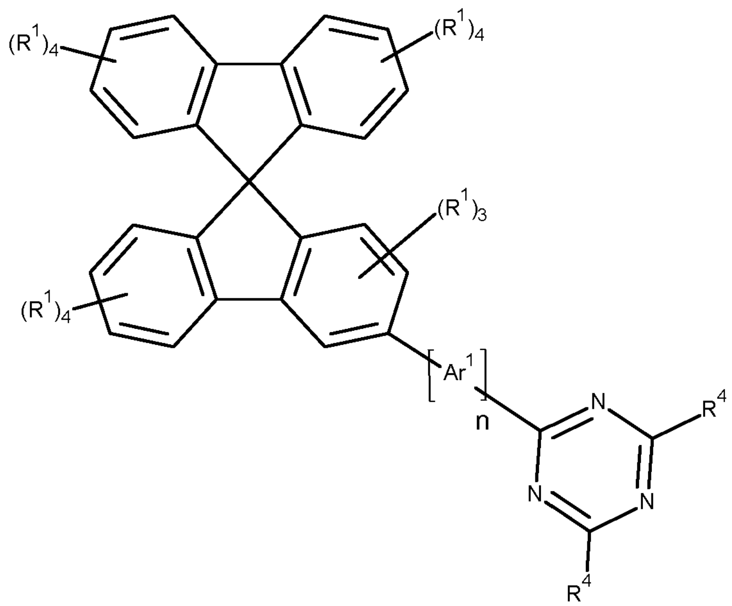 |
| Formel (E-1-1-3-1) |

(fortgesetzt)

| |
|---|
| 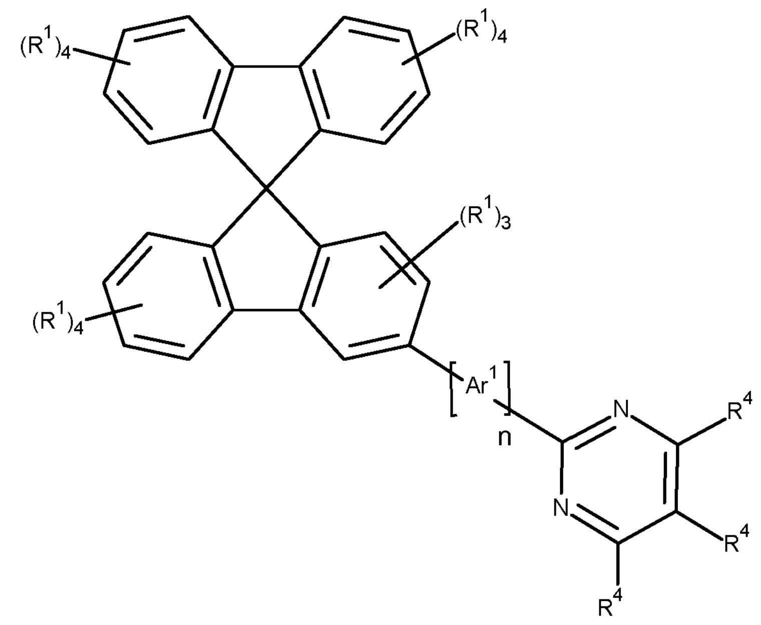 |
| Formel (E-1-1-3-2) |
| 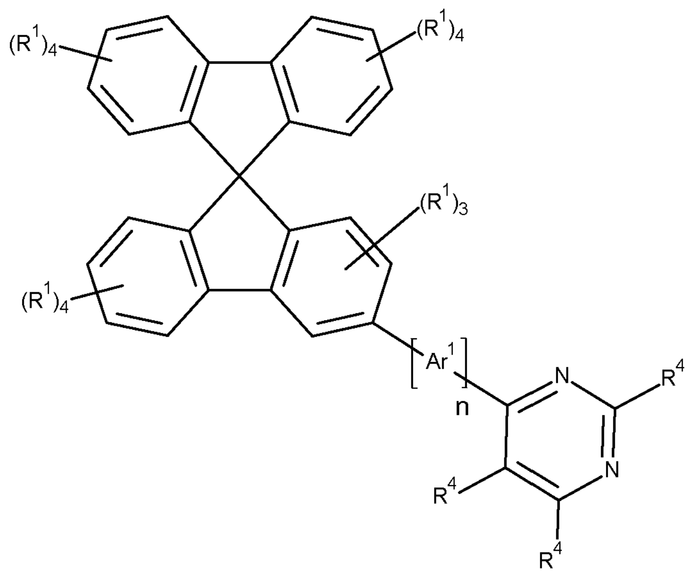 |
| Formel (E-1-1-3-3) |

(fortgesetzt)

| |
|---|
| 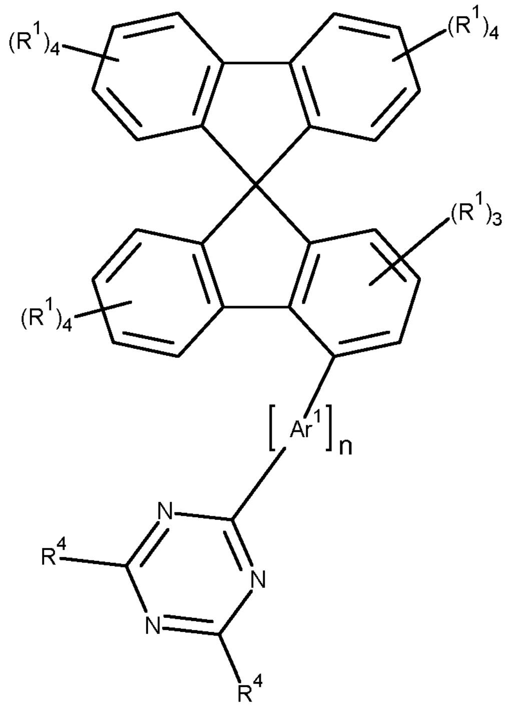 |
| Formel (E-1-1-4-1) |
| 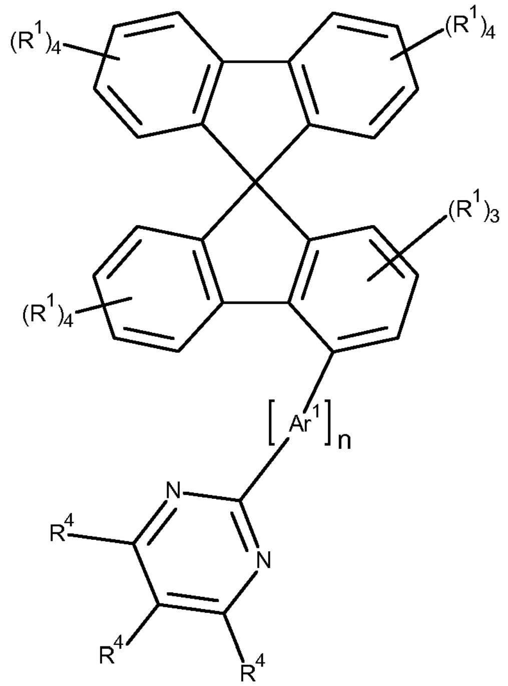 |
| Formel (E-1-1-4-2) |

(fortgesetzt)

| |
|---|
| 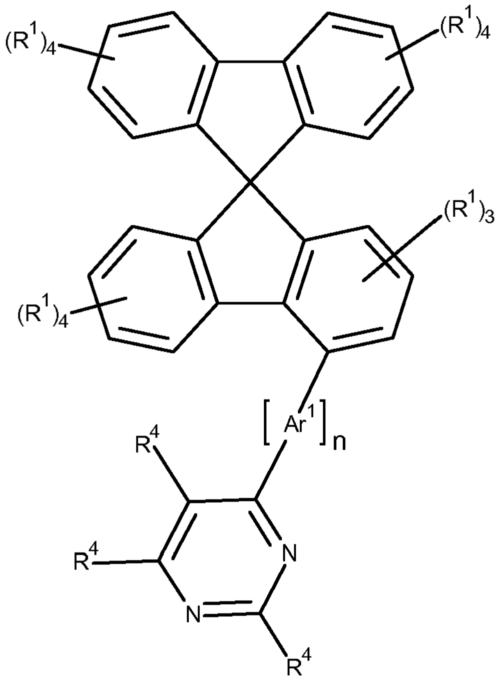 |
| Formel (E-1-1-4-3) |
| 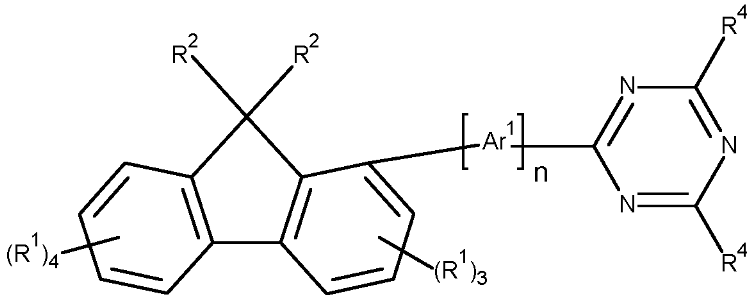 |
| Formel (E-1-2-1-1) |
| 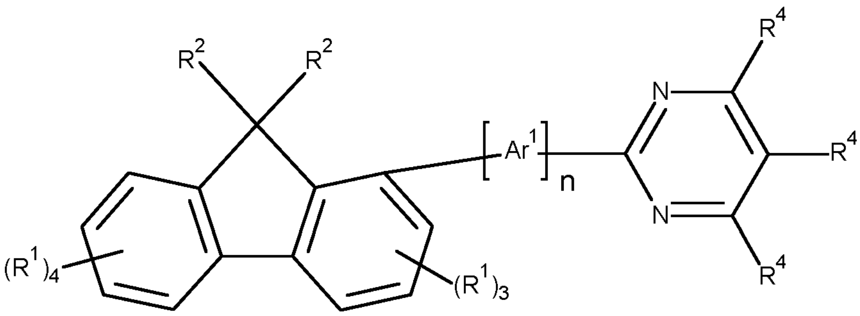 |
| Formel (E-1-2-1-2) |

(fortgesetzt)

| |
|---|
| 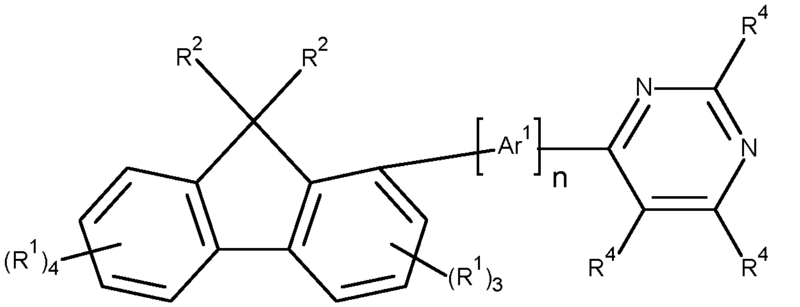 |
| Formel (E-1-2-1-3) |
| 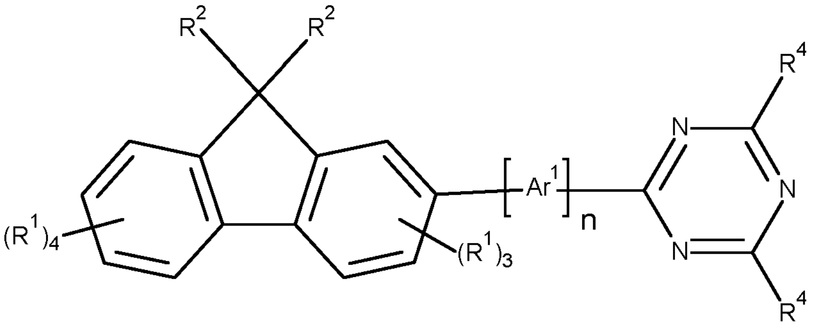 |
| Formel (E-1-2-2-1) |
| 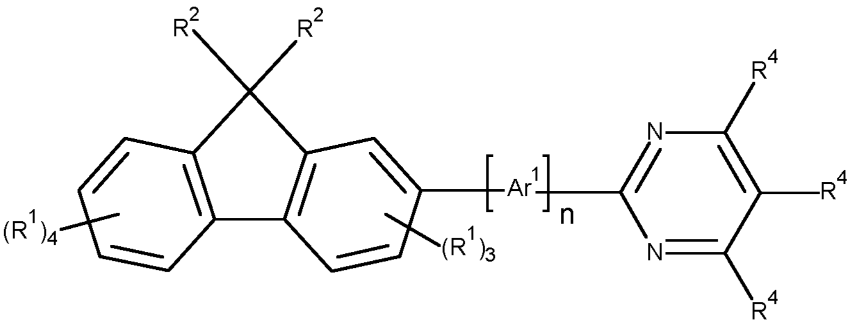 |
| Formel (E-1-2-2-2) |
| 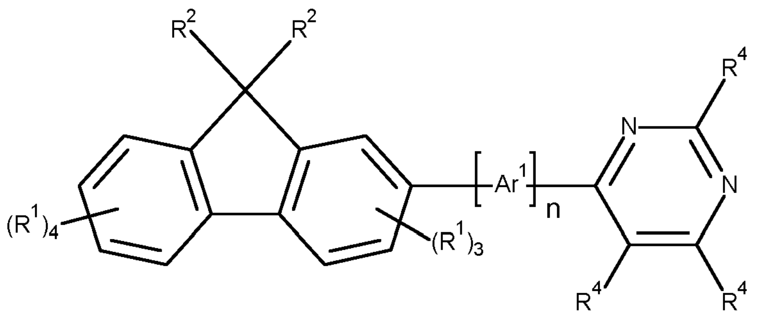 |
| Formel (E-1-2-2-3) |

(fortgesetzt)

| |
|---|
| 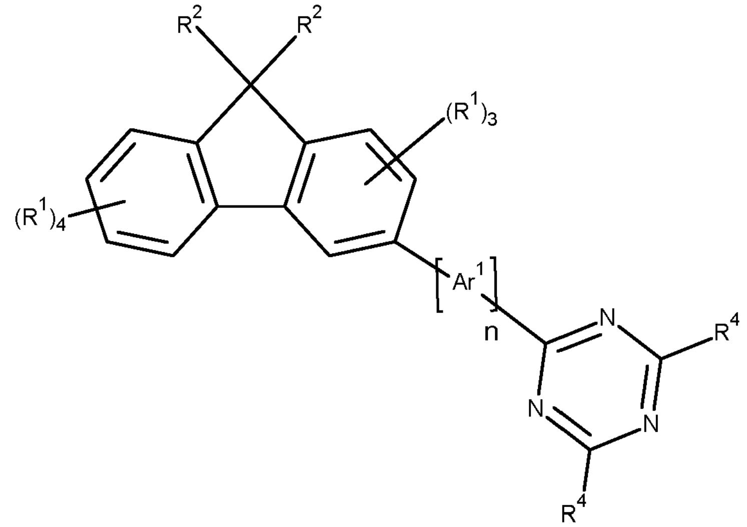 |
| Formel (E-1-2-3-1) |
| 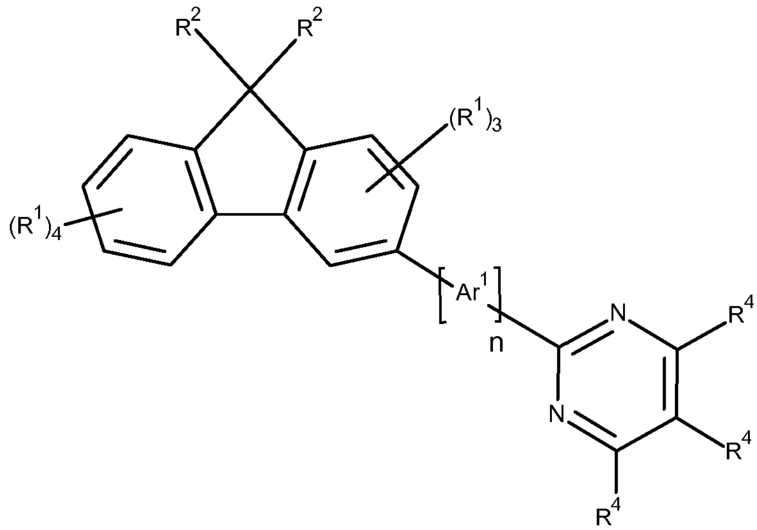 |
| Formel (E-1-2-3-2) |
| 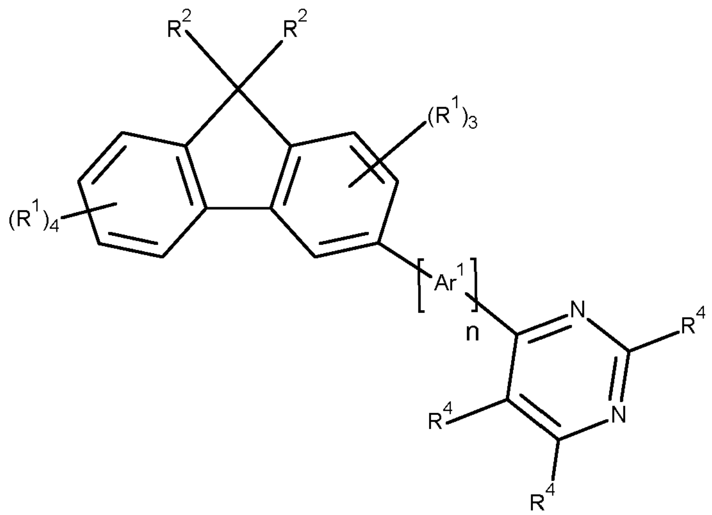 |

(fortgesetzt)

| Formel (E-1-2-3-3) |
|---|
| 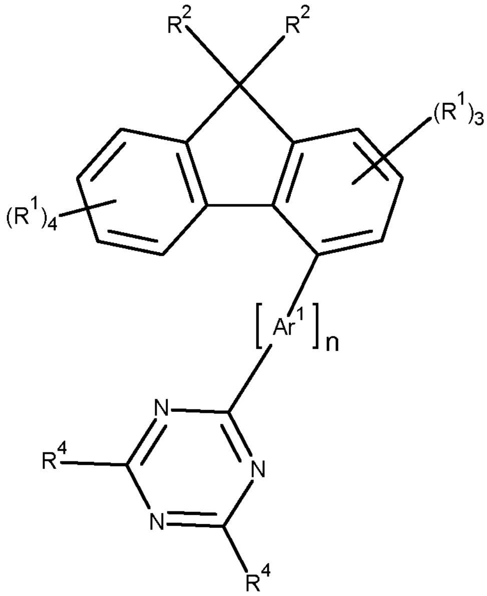 |
| Formel (E-1-2-4-1) |
| 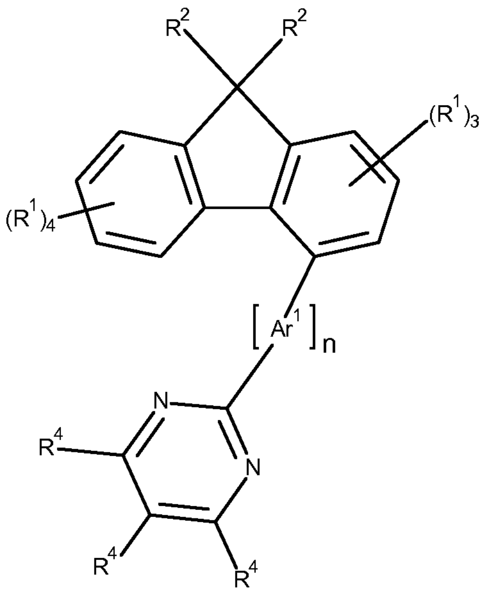 |
| Formel (E-1-2-4-2) |

(fortgesetzt)

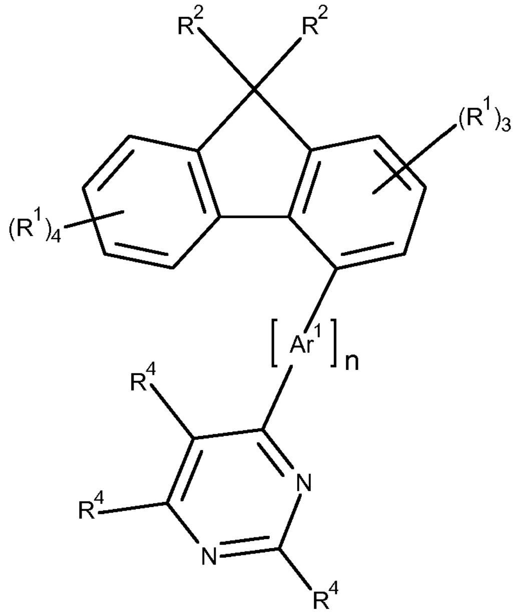

Formel (E-1-2-4-3),

wobei die auftretenden Symbole und Indices definiert sind wie oben und bevorzugt ihren oben angegebenen bevorzugten Ausführungsformen entsprechen. Mit der Darstellung -$(R^1)_3$ bzw. -$(R^1)_4$ ist dabei gemeint, dass drei bzw. vier Gruppen $R^1$ am betreffenden Benzolring vorliegen, d.h. eine Gruppe $R^1$ an jeder freien Position am betreffenden Benzolring. Bevorzugt gelten für die Formeln die oben genannten bevorzugten Ausführungsformen der Gruppen $Ar^1$, $R^1$, $R^2$, $R^4$, und von Index n.

Insbesondere ist es für die Formeln bevorzugt, dass

- Index n gleich 0 oder 1 ist;
- $Ar^1$ gewählt ist aus divalenten Gruppen abgeleitet von Benzol, Biphenyl, Terphenyl, Naphthalin, Fluoren, Indenofluoren, Indenocarbazol, Spirobifluoren, Dibenzofuran, Dibenzothiophen und Carbazol, die jeweils mit einem oder mehreren Resten $R^3$ substituiert sein können;
- $R^1$ bei jedem Auftreten gleich oder verschieden gewählt ist aus H, F, aromatischen Ringsystemen mit 6 bis 40 aromatischen Ringatomen, und heteroaromatischen Ringsystemen mit 5 bis 40 aromatischen Ringatomen; wobei die aromatischen Ringsysteme und die heteroaromatischen Ringsysteme jeweils mit Resten $R^5$ substituiert sind;
- $R^2$ bei jedem Auftreten gleich oder verschieden gewählt ist aus geradkettigen Alkylgruppen mit 1 bis 20 C-Atomen, verzweigten Alkylgruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkylgruppen, die genannten aromatischen Ringsysteme und die genannten heteroaromatischen Ringsysteme jeweils mit Resten $R^5$ substituiert sind;
- $R^4$ bei jedem Auftreten gleich oder verschieden gewählt ist aus H und aromatischen Ringsystemen mit 6 bis 40 aromatischen Ringatomen, die mit Resten $R^5$ substituiert sind.

Unter den Formeln sind die Formeln (E-1-1-1-1) bis (E-1-1-4-3) bevorzugt. Weiterhin sind unter den Formeln die Formeln (E-1-1-2-1), (E-1-1-2-2), (E-1-1-2-3), (E-1-1-4-1), (E-1-1-4-2), (E-1-1-4-3), (E-1-2-2-1), (E-1-2-2-2), (E-1-2-2-3), (E-1-2-4-1), (E-1-2-4-2) und (E-1-2-4-3) bevorzugt, insbesondere die Formeln (E-1-1-2-1), (E-1-1-2-2), (E-1-1-2-3), (E-1-1-4-1), (E-1-1-4-2) und (E-1-1-4-3), am stärksten die Formeln (E-1-1-2-1) und (E-1-1-4-1).

Bevorzugte Verbindungen gemäß Formel (E-1) sind in der folgenden Tabelle gezeigt:

| | | |
|---|---|---|
| 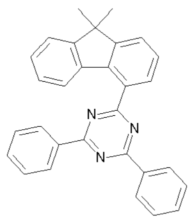 | 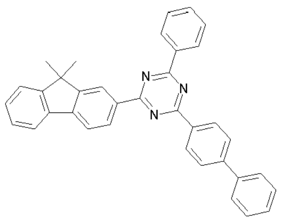 | 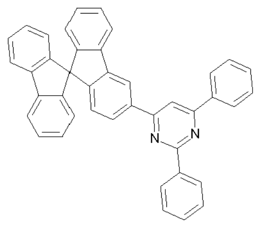 |

| | | |
|---|---|---|
| 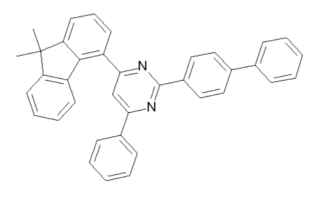 | 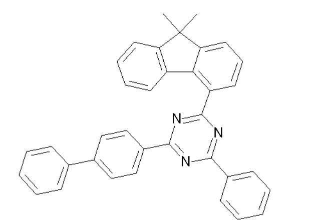 | 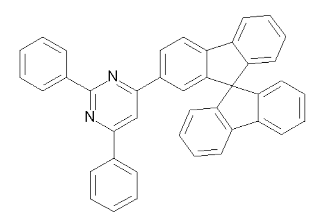 |
| 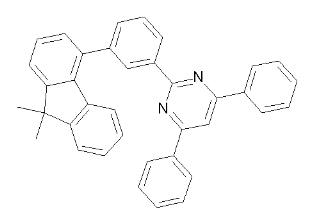 | 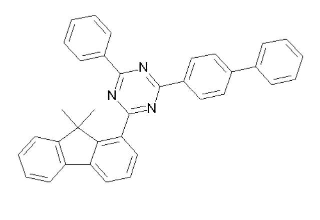 | 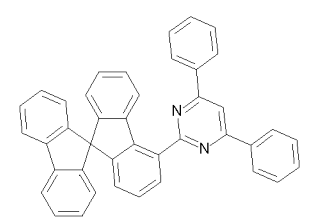 |
| 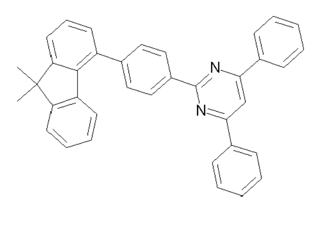 | 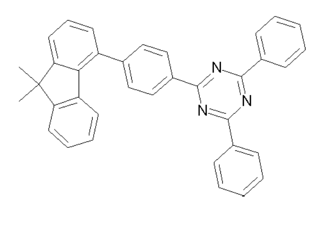 | 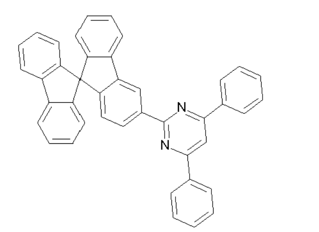 |
| 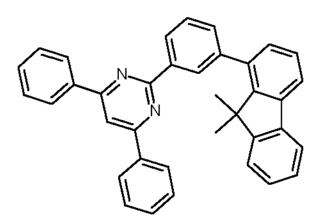 | 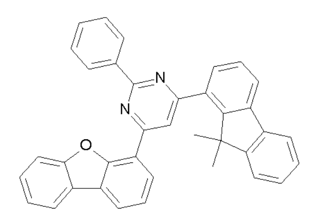 | 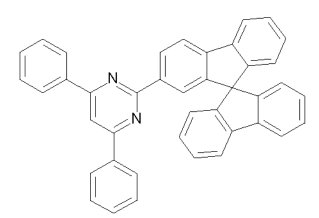 |
| 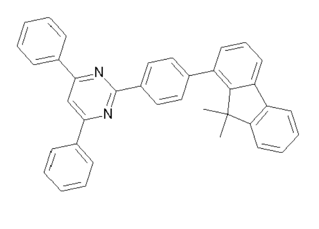 | 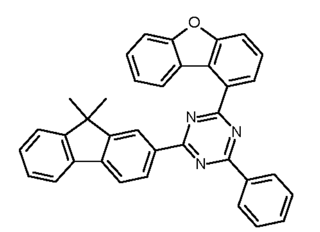 | 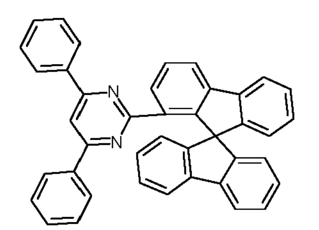 |
| 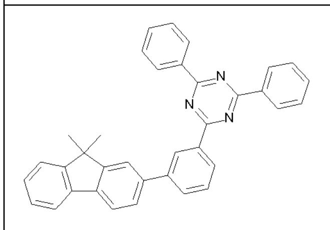 | 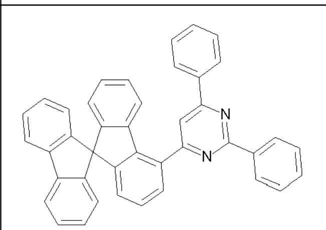 | 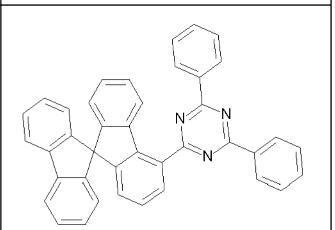 |
| 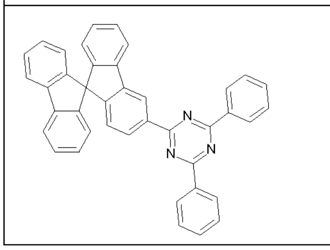 | 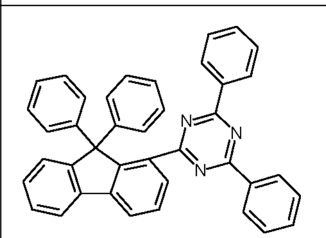 | 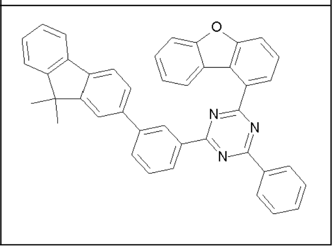 |

| | | |
|---|---|---|
| 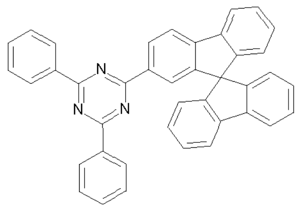 | 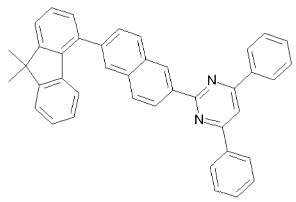 | 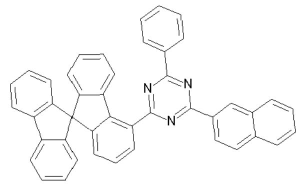 |
| 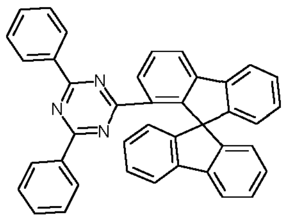 | 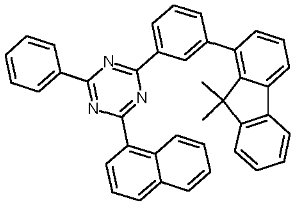 | 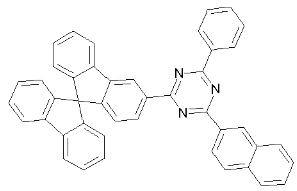 |
| 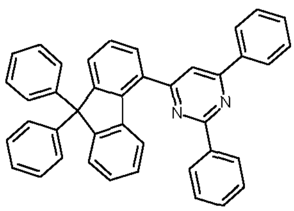 | 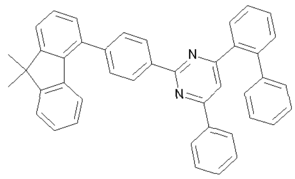 | 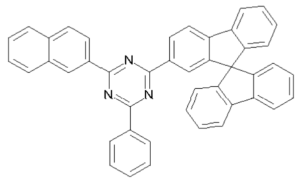 |
| 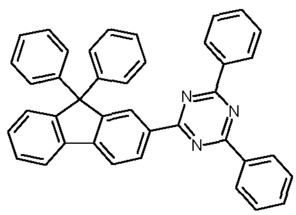 | 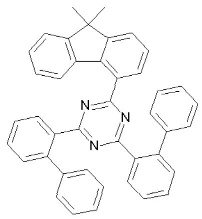 | 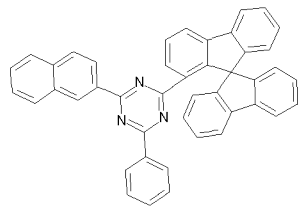 |
| 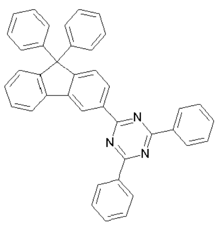 | 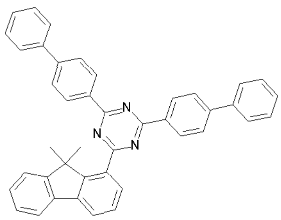 | 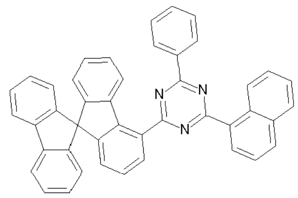 |
| 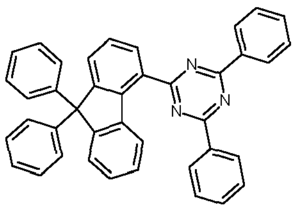 | 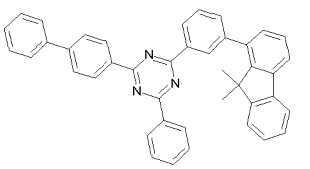 | 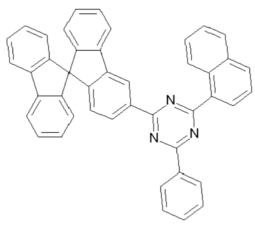 |
| 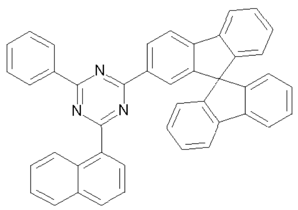 | 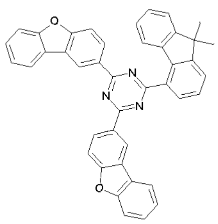 | 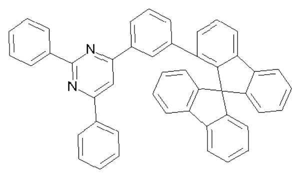 |

| | | |
|---|---|---|
| 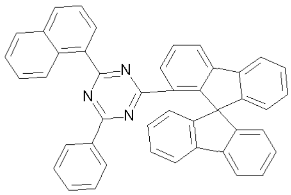 | 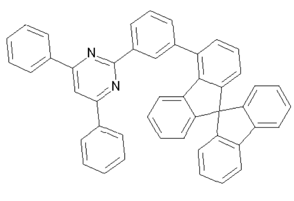 | 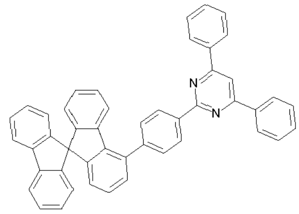 |
| 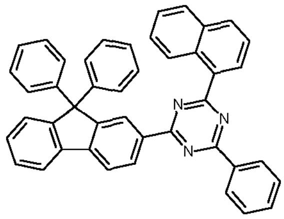 | 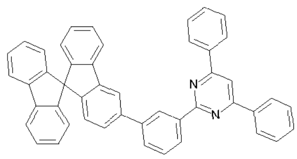 | 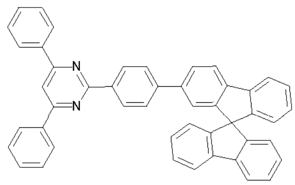 |
| 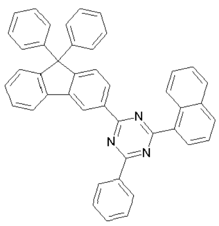 | 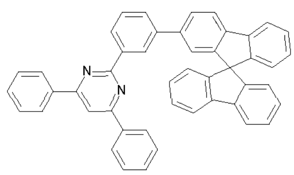 | 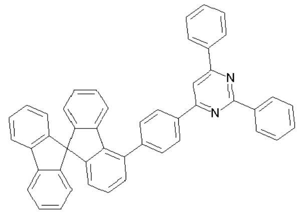 |
| 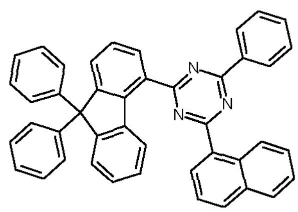 | 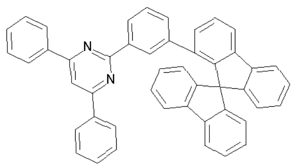 | 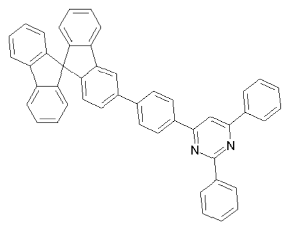 |
| 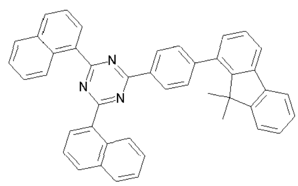 | 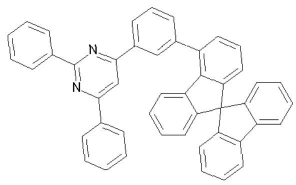 | 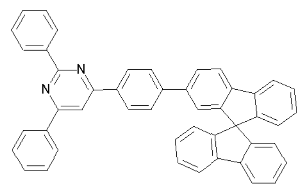 |
| 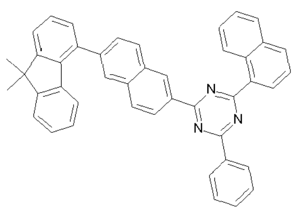 | 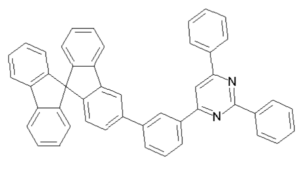 | 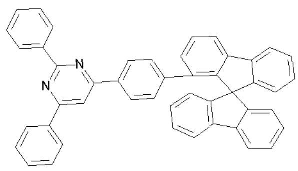 |
| 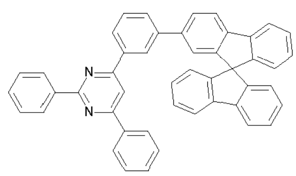 | 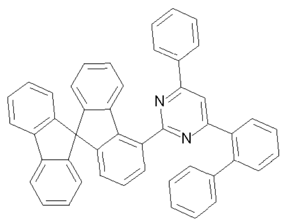 | 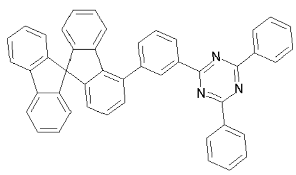 |

| | | |
|---|---|---|
| 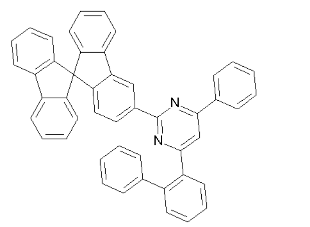 | 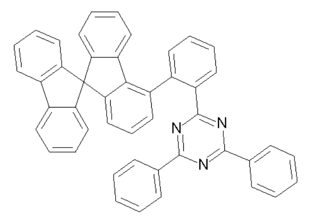 | 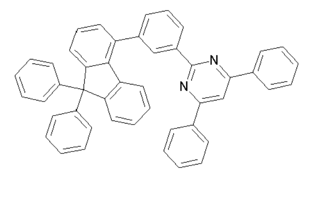 |
| 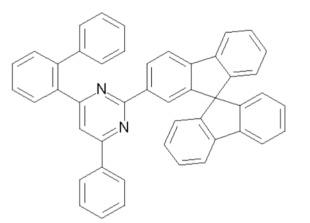 | 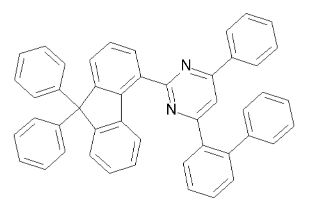 | 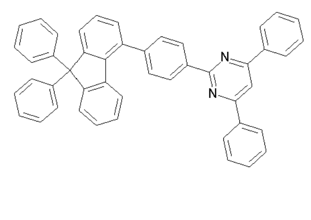 |
| 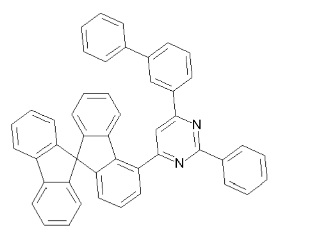 | 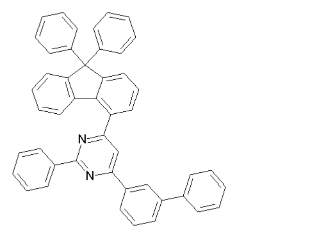 | 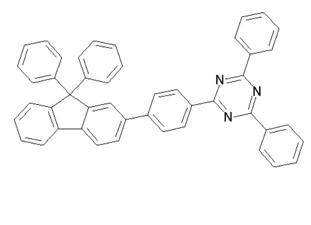 |
| 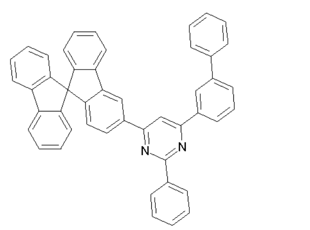 | 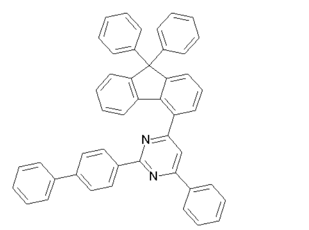 | 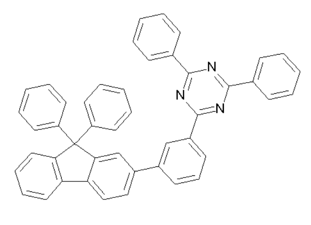 |
| 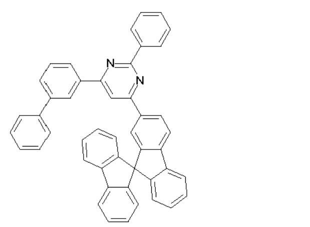 | 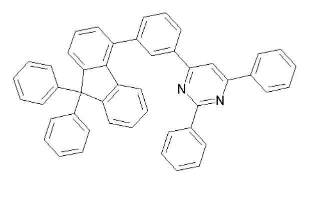 | 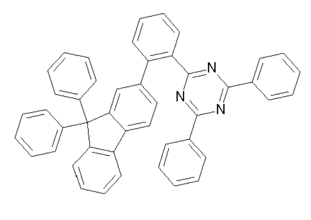 |
| 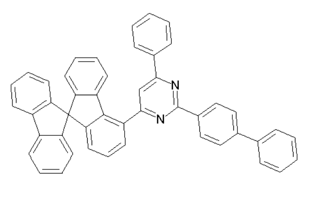 | 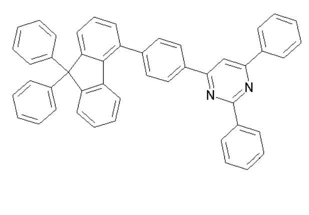 | 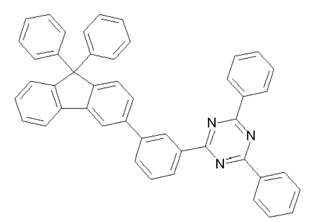 |
| 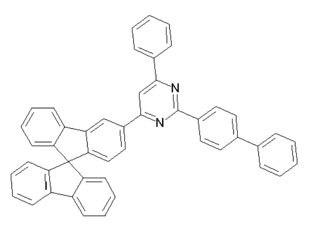 | 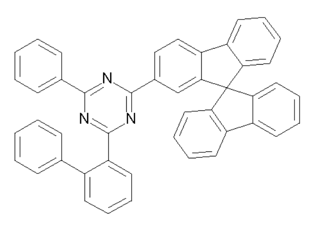 | 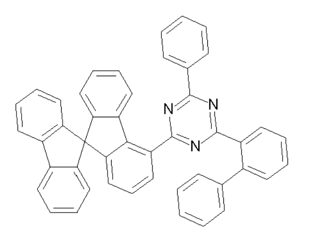 |

| | | |
|---|---|---|
| 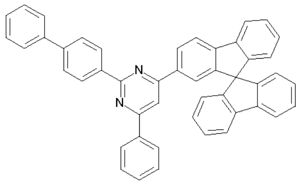 | 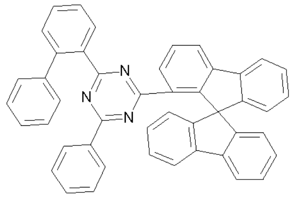 | 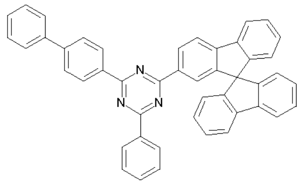 |
| 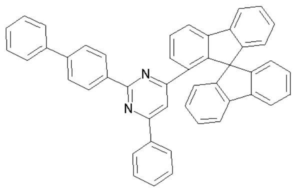 | 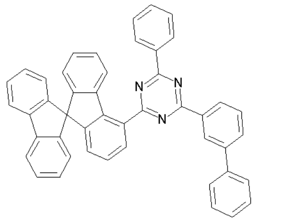 | 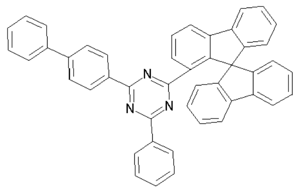 |
| 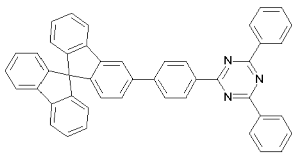 | 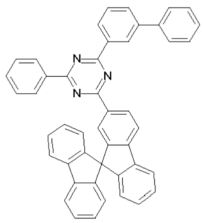 | 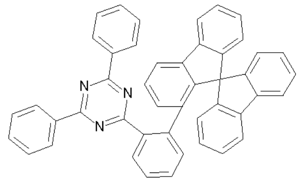 |
| 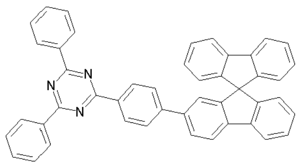 | 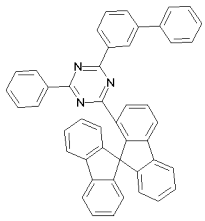 | 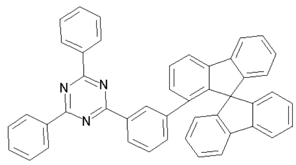 |
| 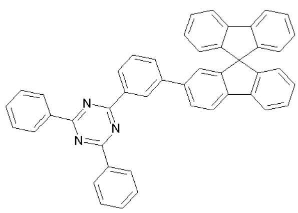 | 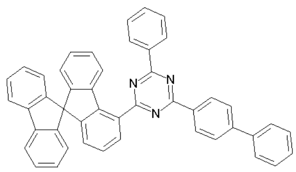 | 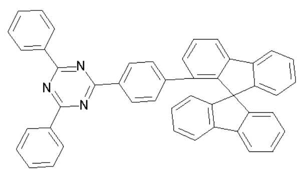 |
| 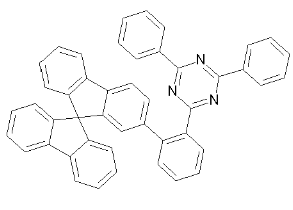 | 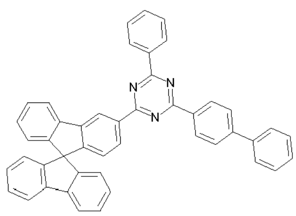 | 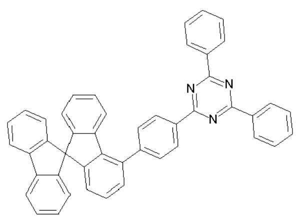 |
| 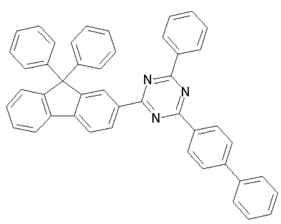 | 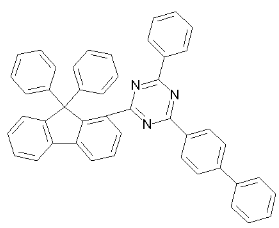 | 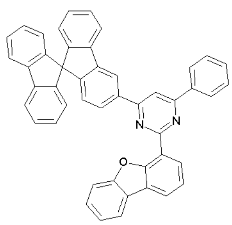 |

| | | |
|---|---|---|
| 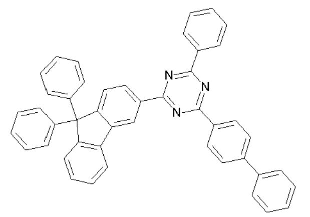 | 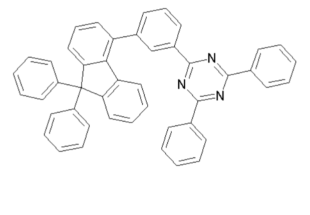 | 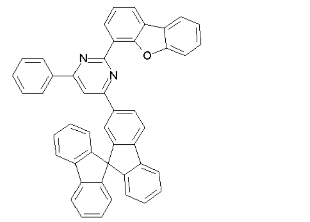 |
| 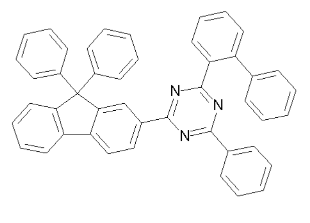 | 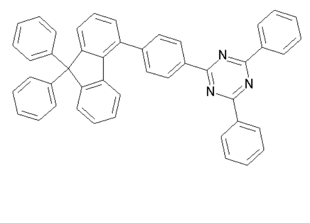 | 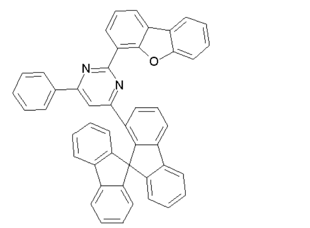 |
| 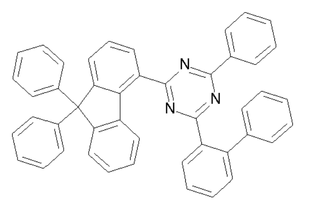 | 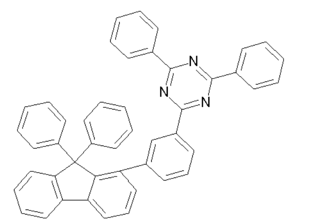 | 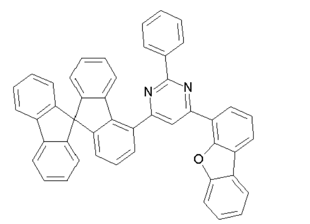 |
| 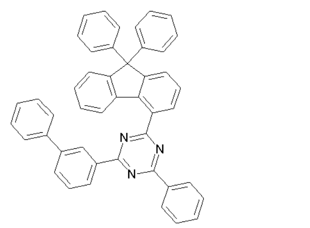 | 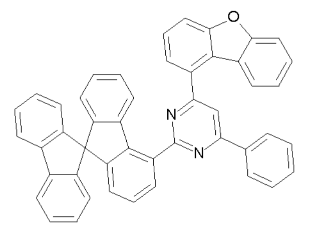 | 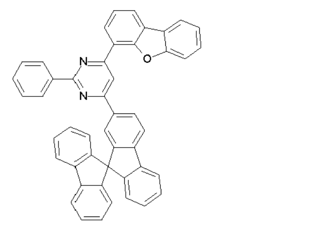 |
| 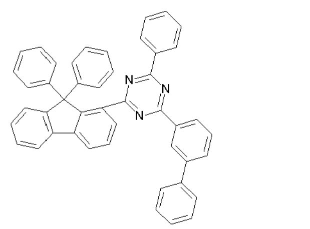 | 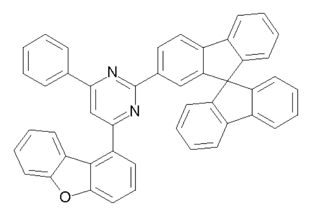 | 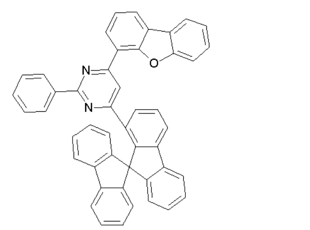 |
| 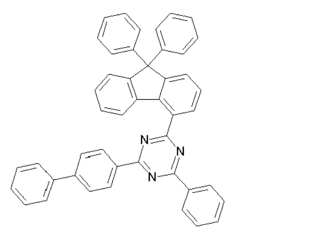 | 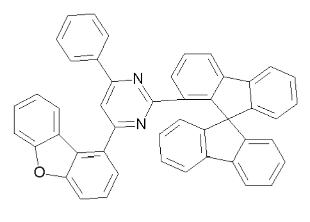 | 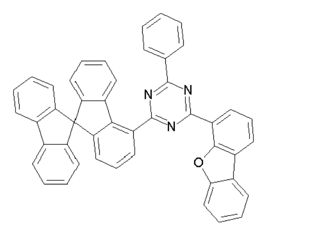 |
| 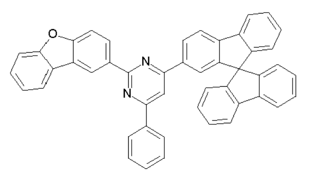 | 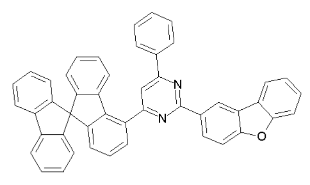 | 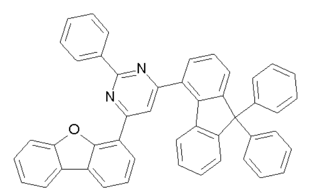 |

| | | |
|---|---|---|
| 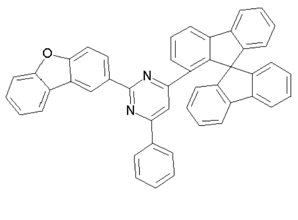 | 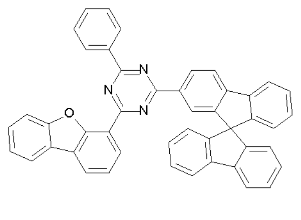 | 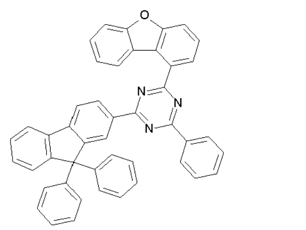 |
| 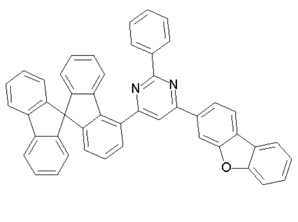 | 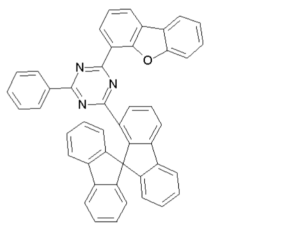 | 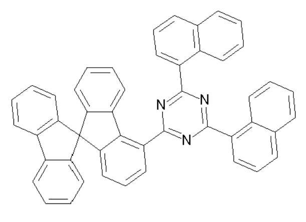 |
| 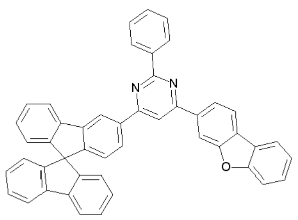 | 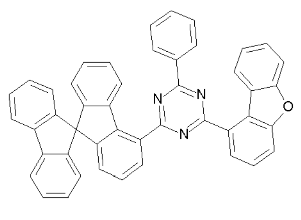 | 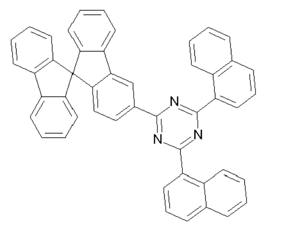 |
| 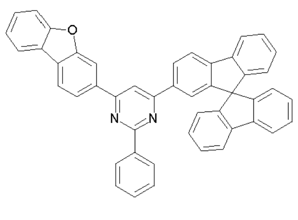 | 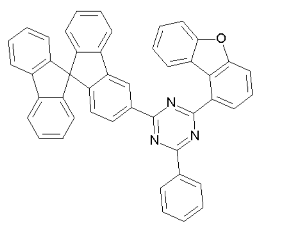 | 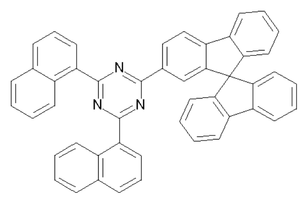 |
| 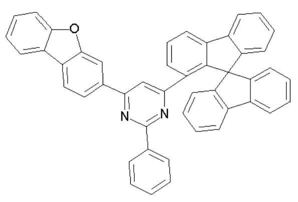 | 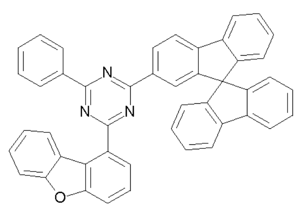 | 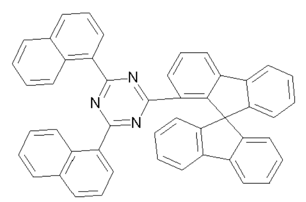 |
| 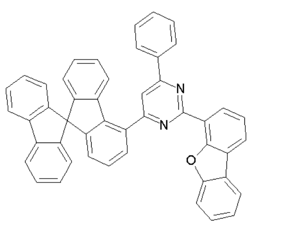 | 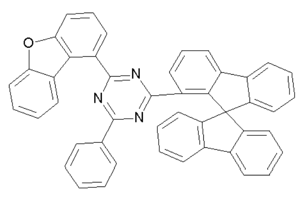 | 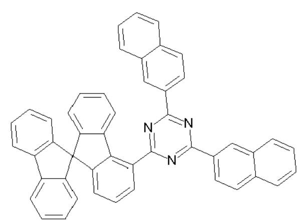 |
| 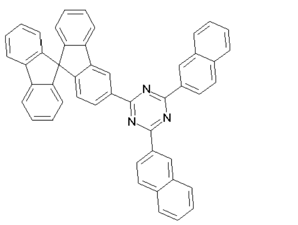 | 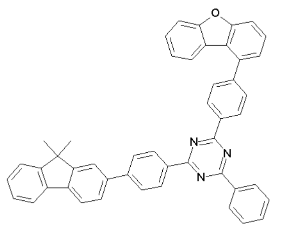 | 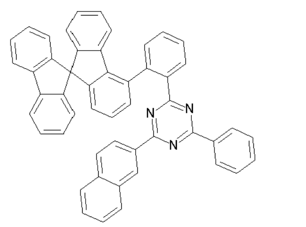 |

| | | |
|---|---|---|
| 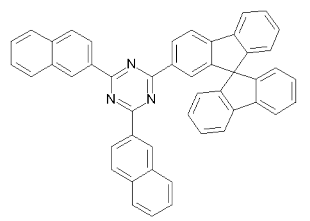 | 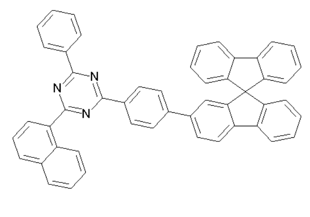 | 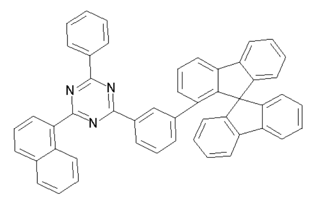 |
| 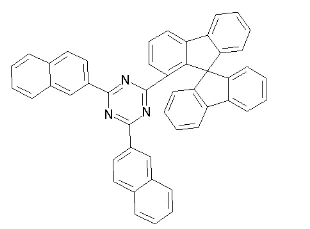 | 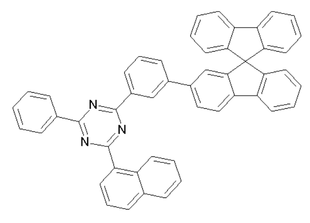 | 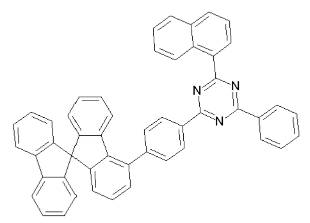 |
| 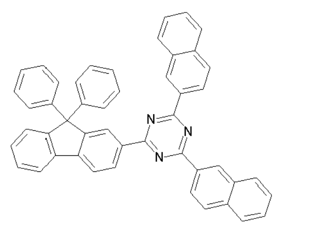 | 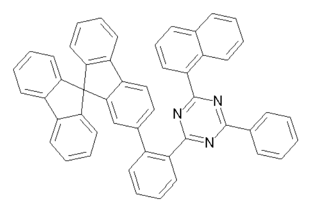 | 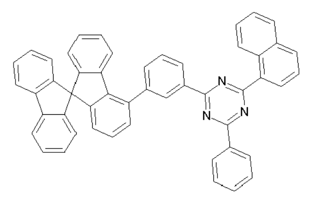 |
| 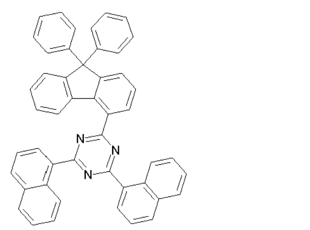 | 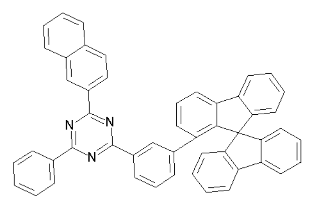 | 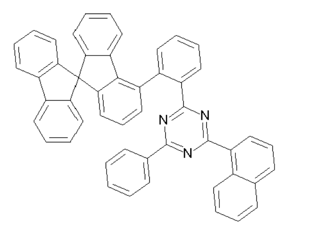 |
| 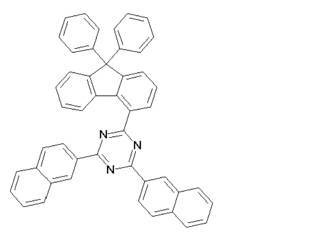 | 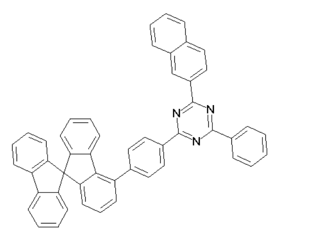 | 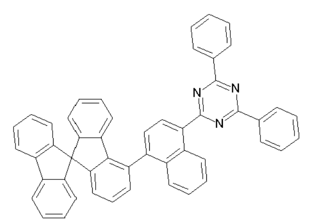 |
| 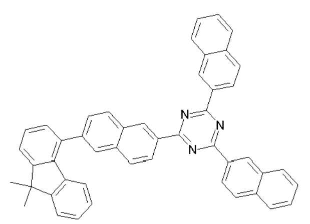 | 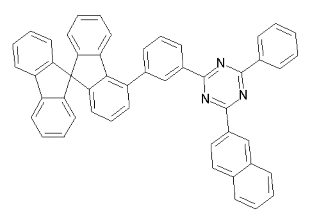 | 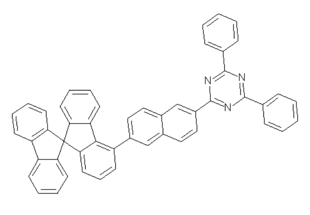 |
| 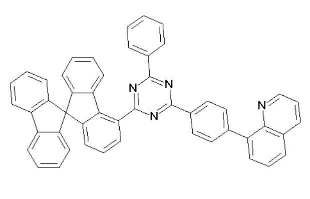 | 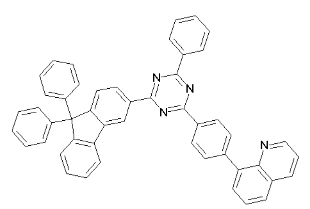 | 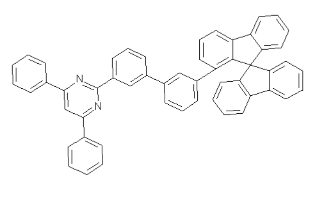 |

| | | |
|---|---|---|
| 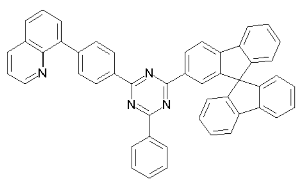 | 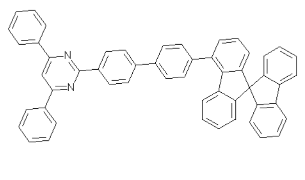 | 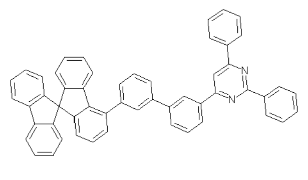 |
| 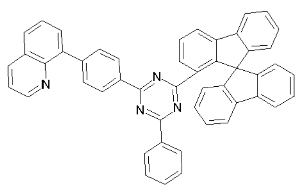 | 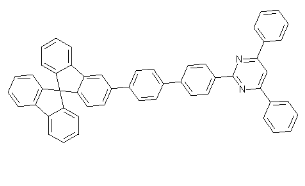 | 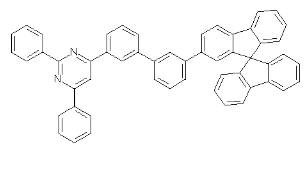 |
| 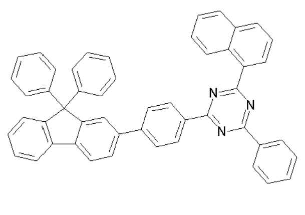 | 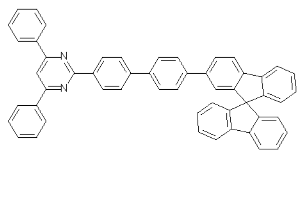 | 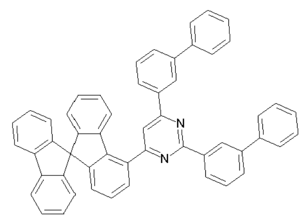 |
| 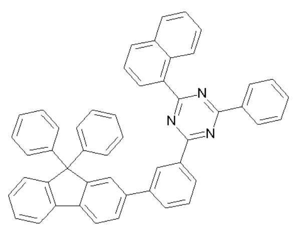 | 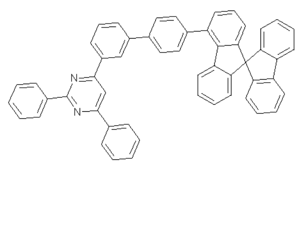 | 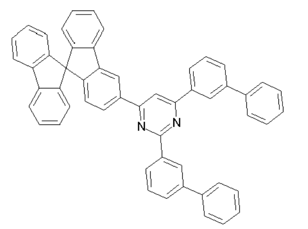 |
| 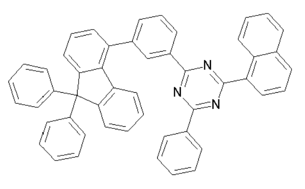 | 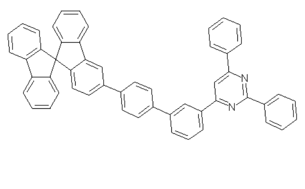 | 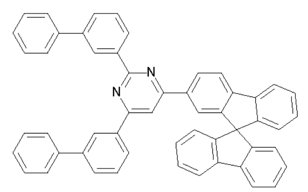 |
| 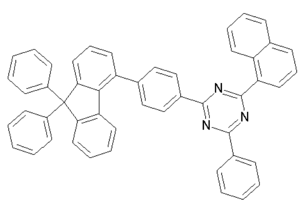 | 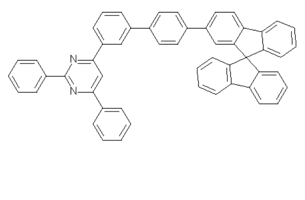 | 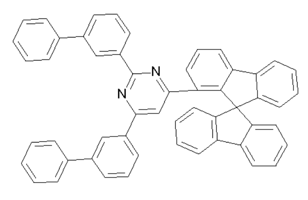 |
| 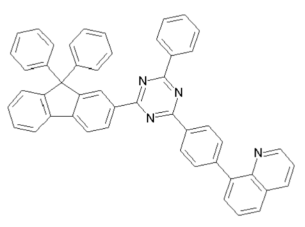 | 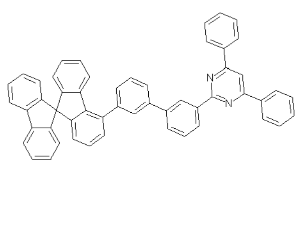 | 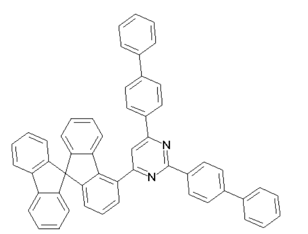 |

| | | |
|---|---|---|
| 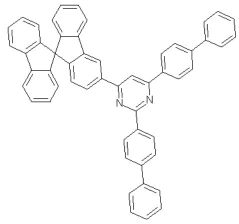 | 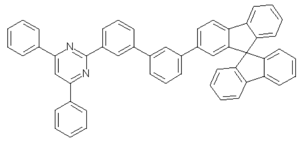 | 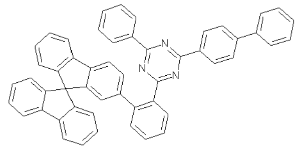 |
| 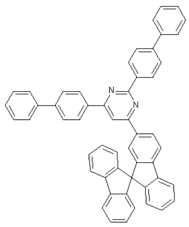 | 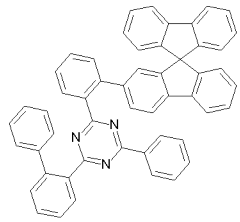 | 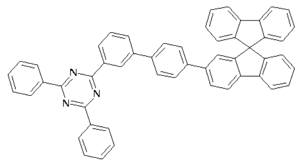 |
| 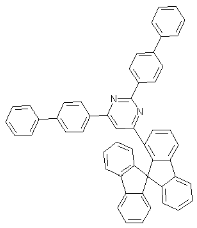 | 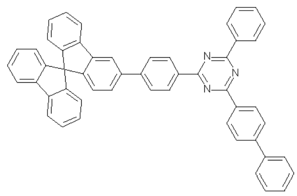 | 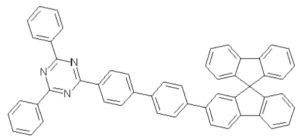 |
| 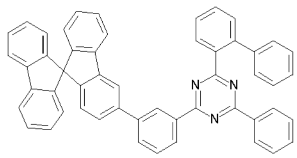 | 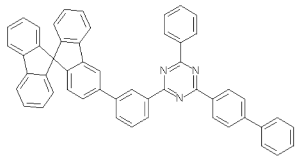 | 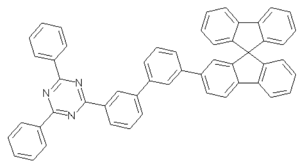 |
| 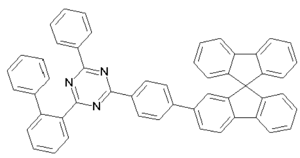 | 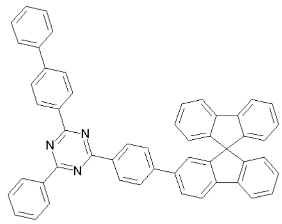 | 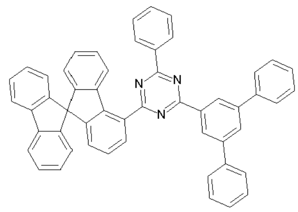 |
| 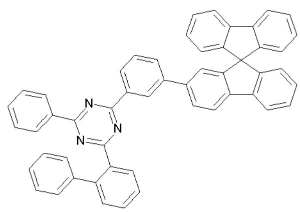 | 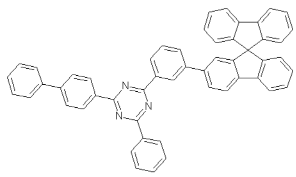 | 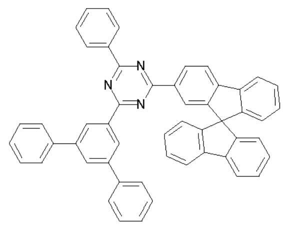 |
| 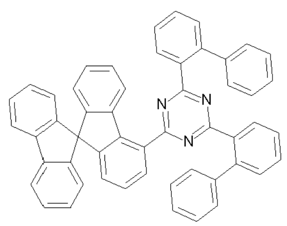 | 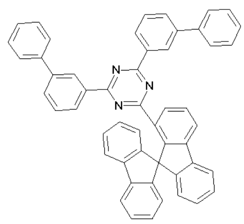 | 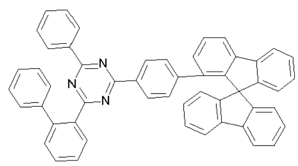 |

| | | |
|---|---|---|
| 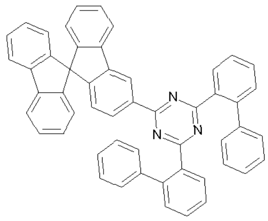 | 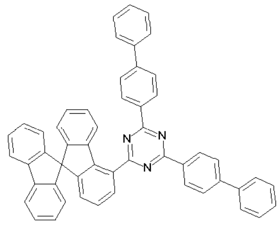 | 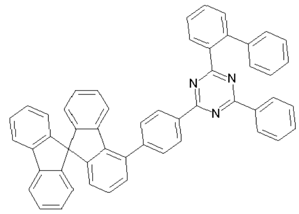 |
| 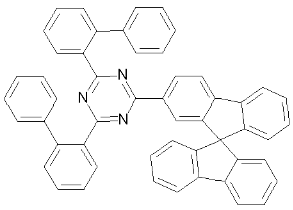 | 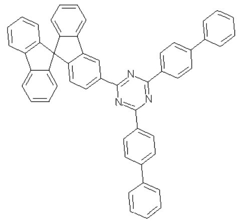 | 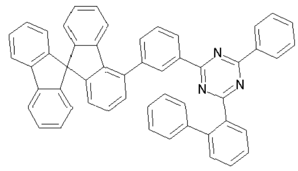 |
| 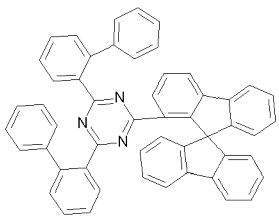 | 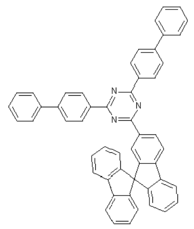 | 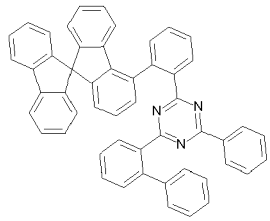 |
| 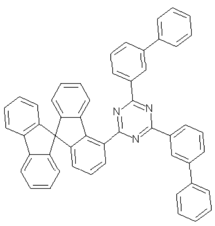 | 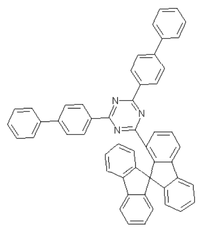 | 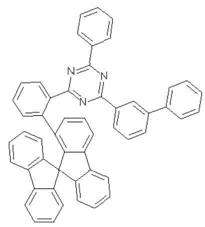 |
| 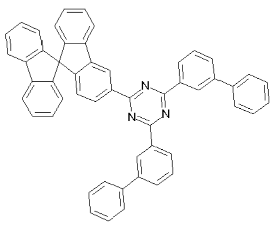 | 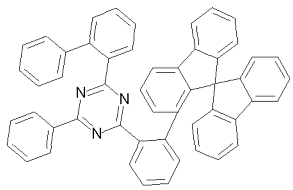 | 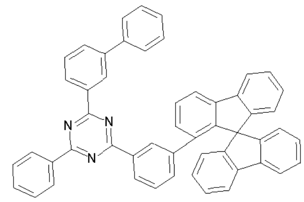 |
| 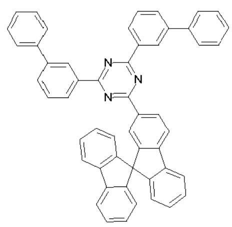 | 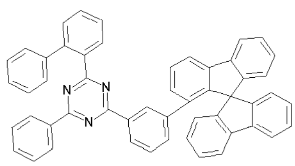 | 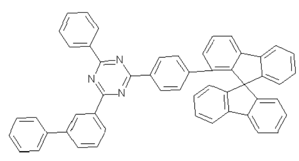 |
| 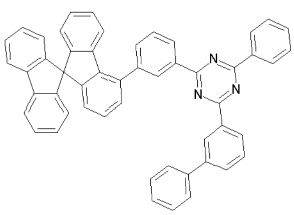 | 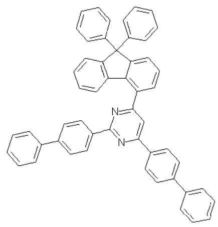 | 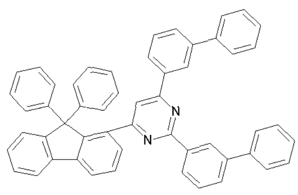 |

| | | |
|---|---|---|
| 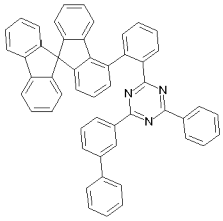 | 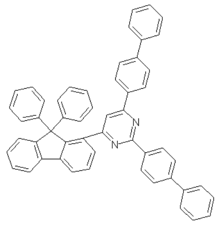 | 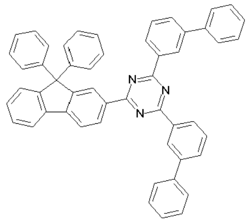 |
| 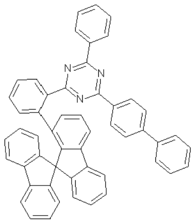 | 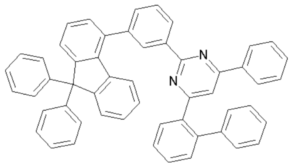 | 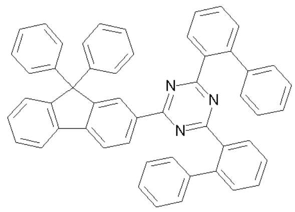 |
| 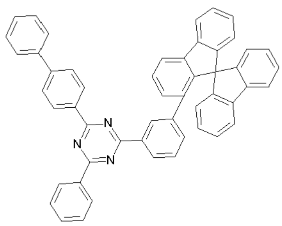 | 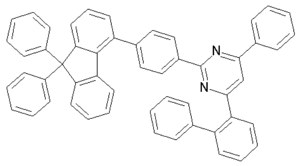 | 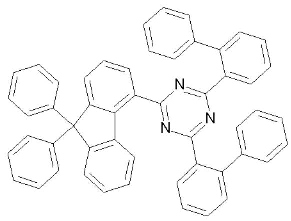 |
| 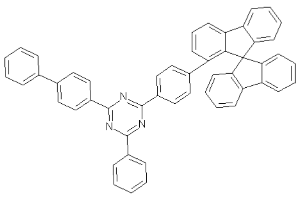 | 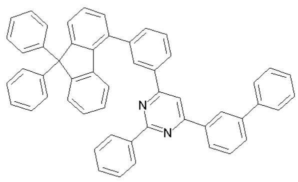 | 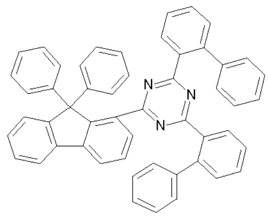 |
| 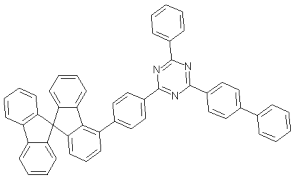 | 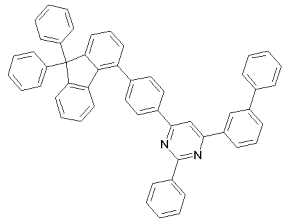 | 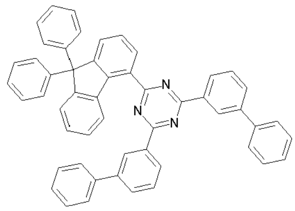 |
| 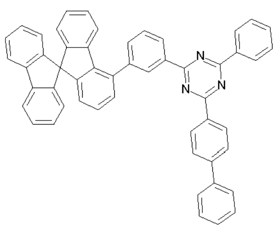 | 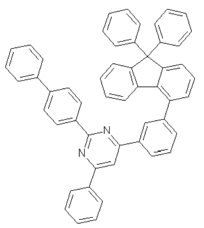 | 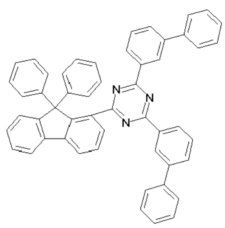 |
| 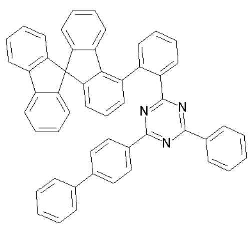 | 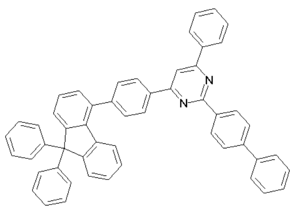 | 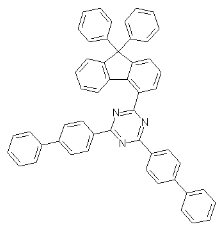 |

| | | |
|---|---|---|
| 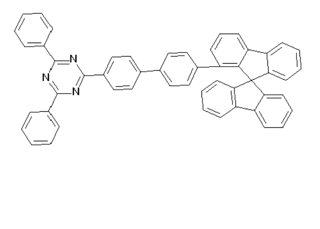 | 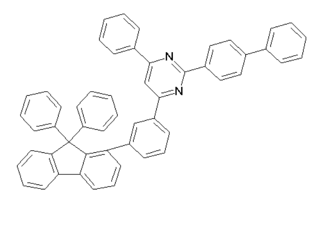 | 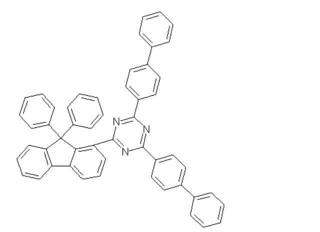 |
| 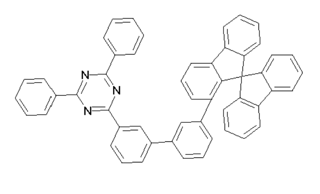 | 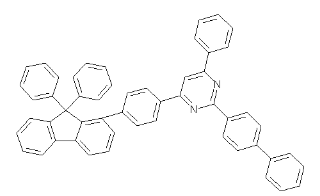 | 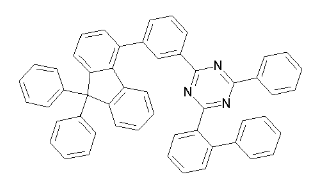 |
| 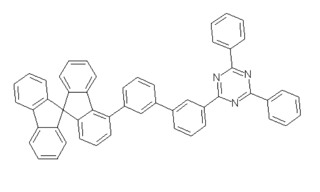 | 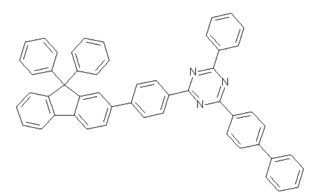 | 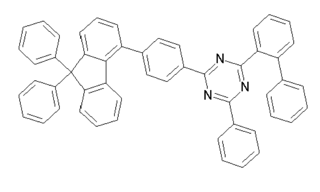 |
| 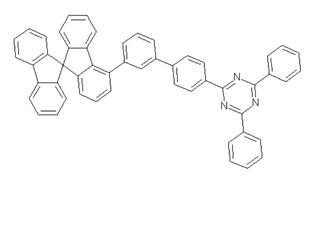 | 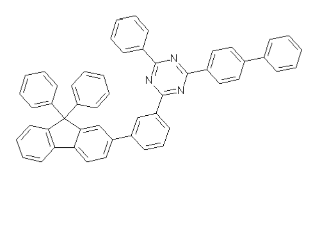 | 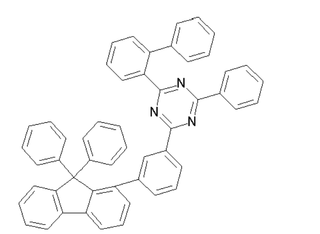 |
| 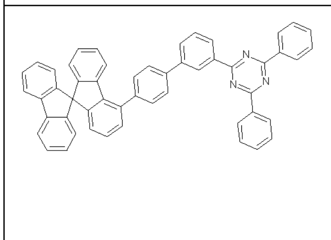 | 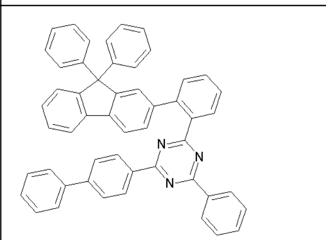 | 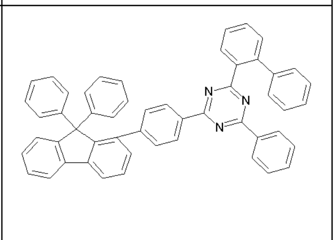 |
| 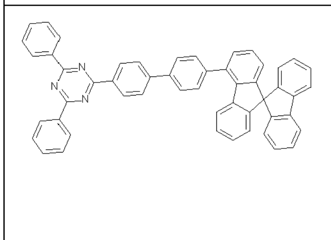 | 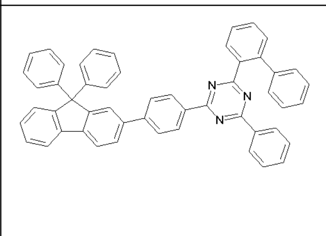 | 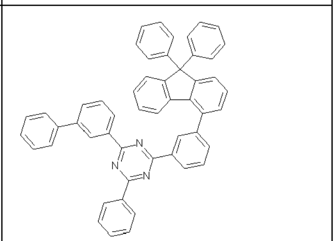 |
| 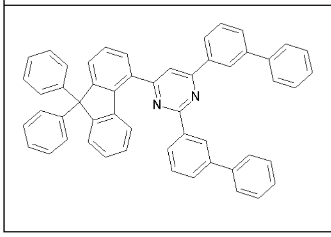 | 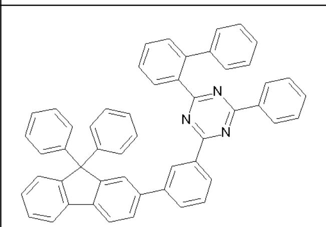 | 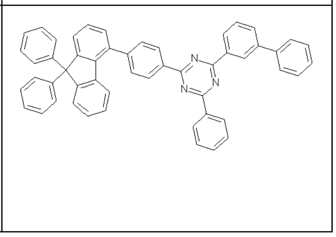 |

| | | |
|---|---|---|
| 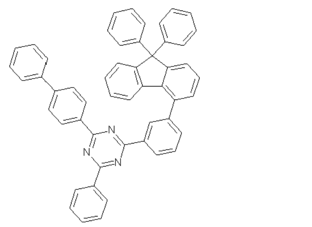 | 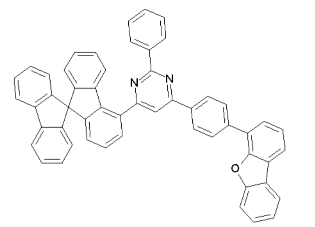 | 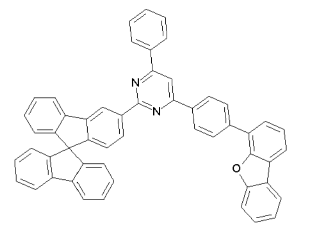 |
| 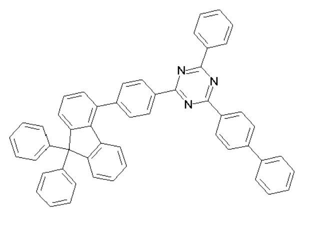 | 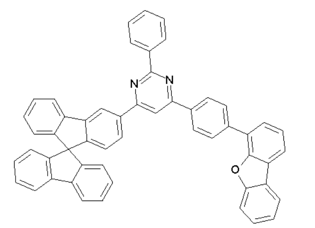 | 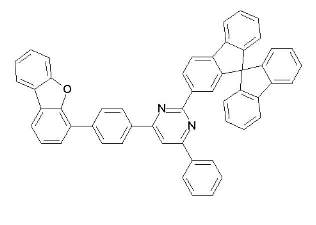 |
| 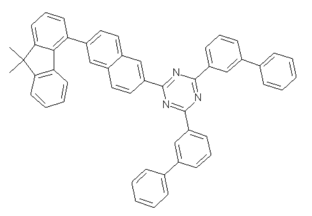 | 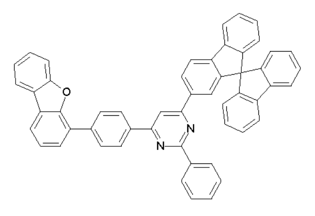 | 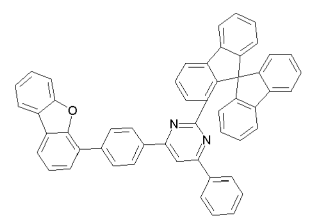 |
| 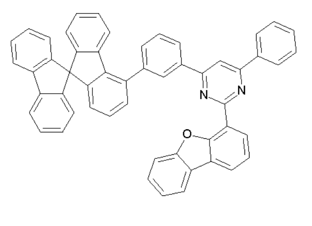 | 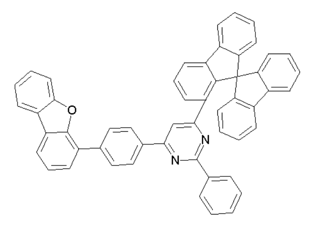 | 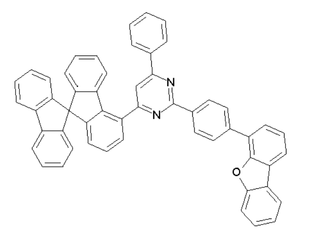 |
| 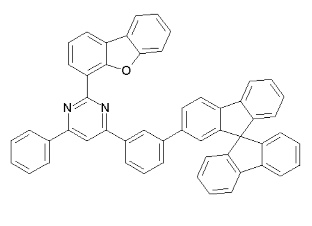 | 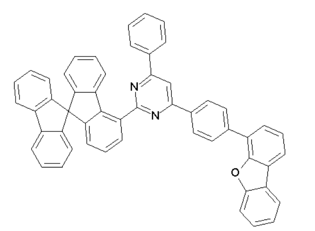 | 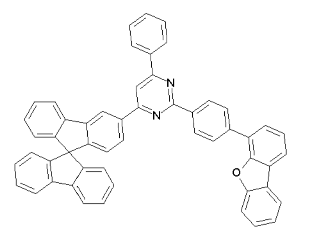 |
| 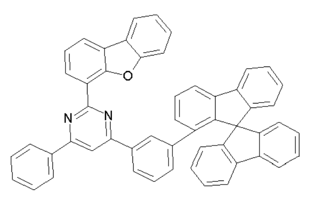 | 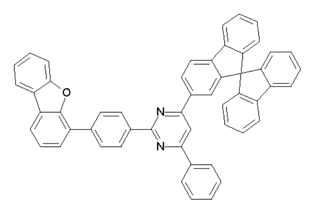 | 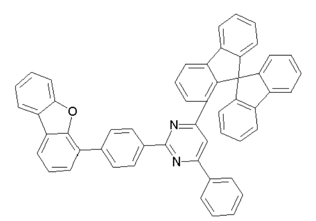 |
| 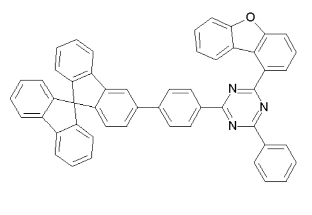 | 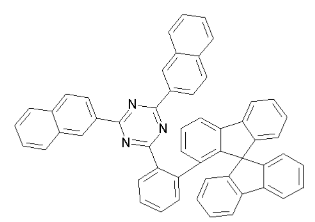 | 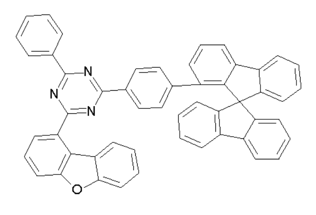 |

| | | |
|---|---|---|
| 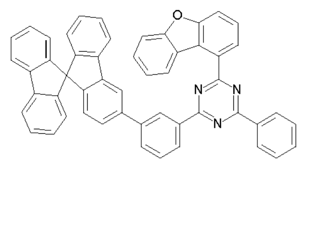 | 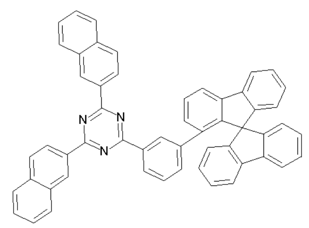 | 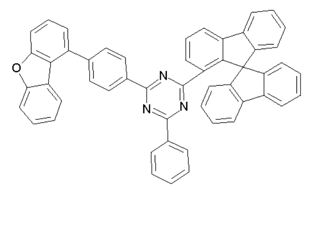 |
| 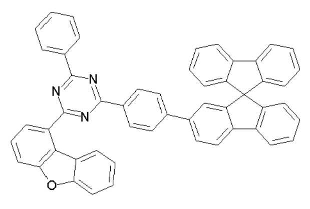 | 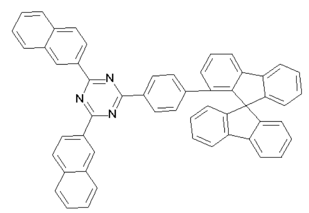 | 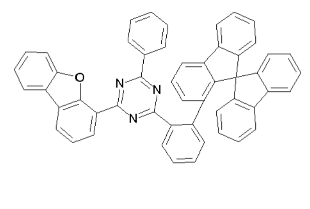 |
| 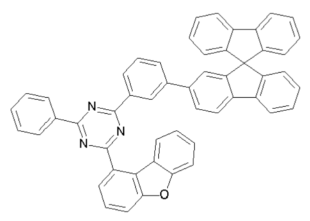 | 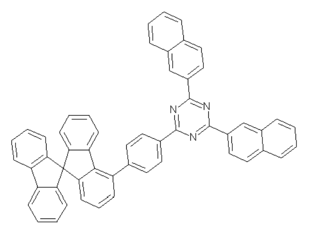 | 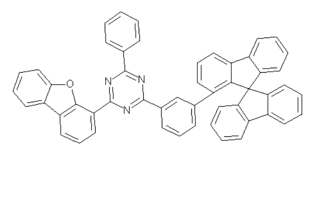 |
| 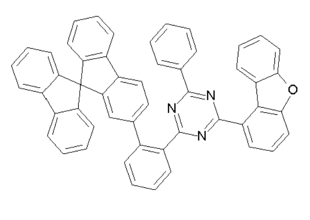 | 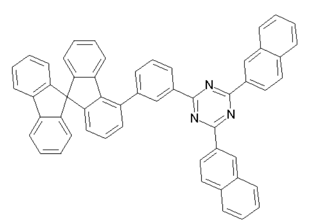 | 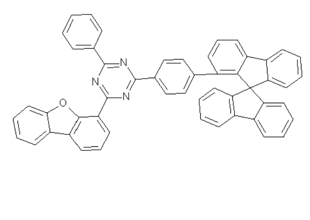 |
| 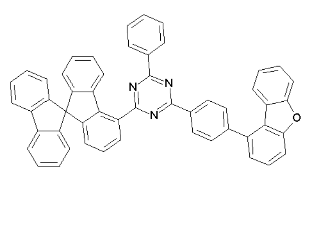 | 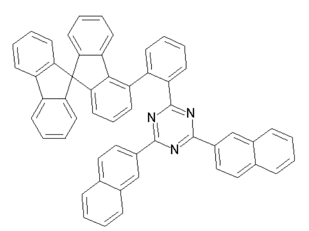 | 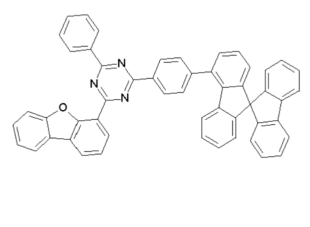 |
| 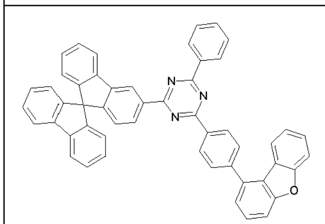 | 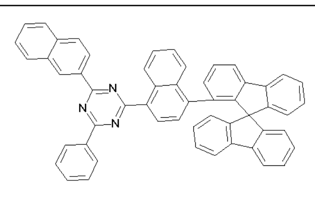 | 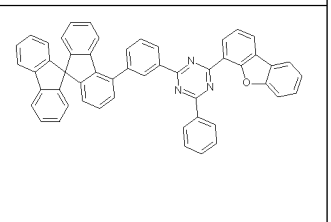 |
| 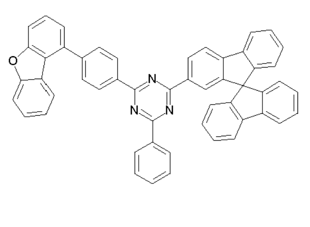 | 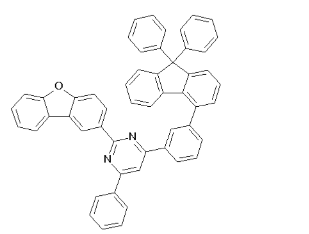 | 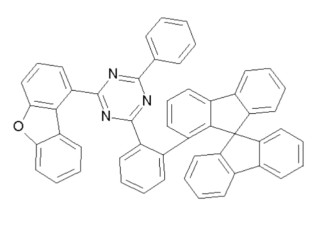 |

| | | |
|---|---|---|
| 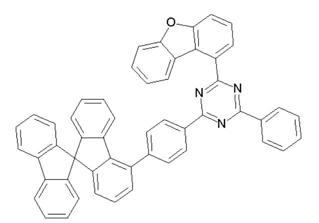 | 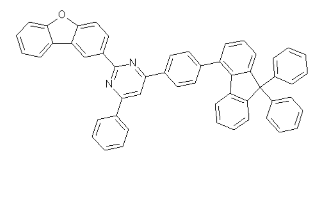 | 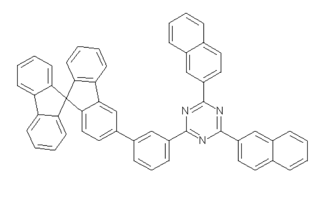 |
| 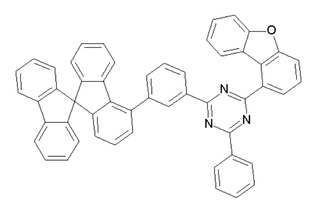 | 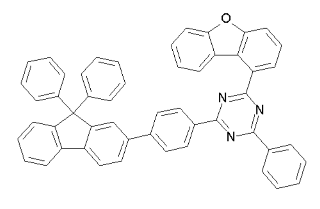 | 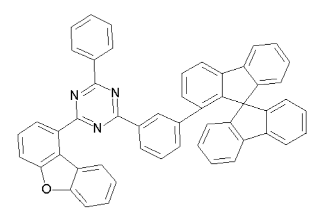 |
| 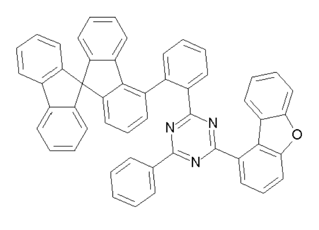 | 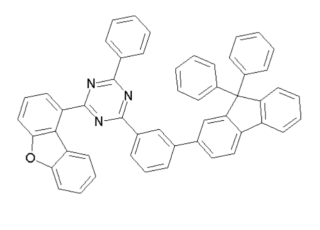 | 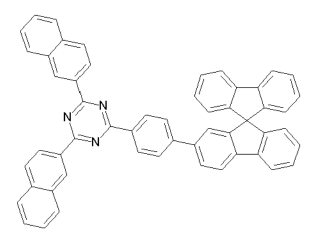 |
| 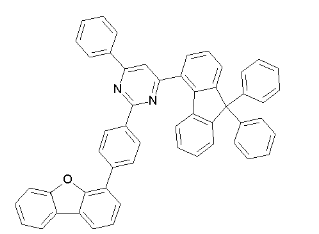 | 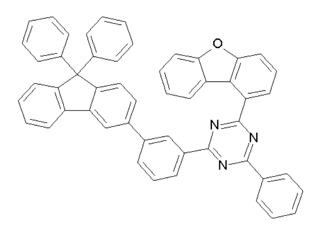 | 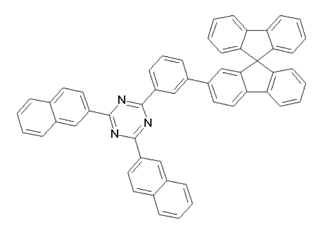 |
| 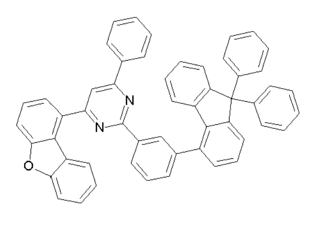 | 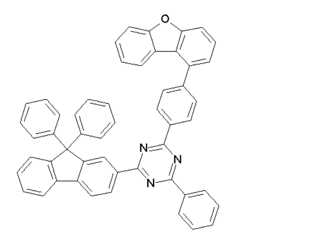 | 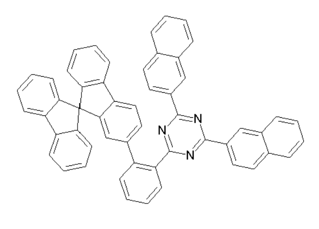 |
| 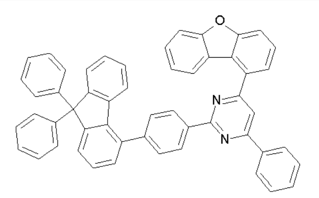 | 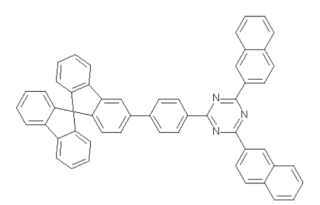 | 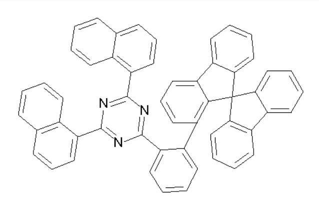 |
| 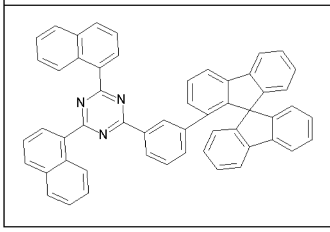 | 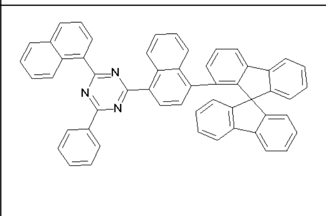 | 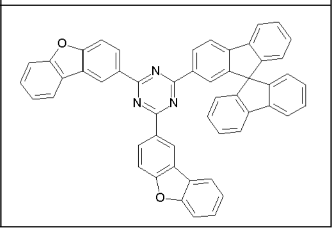 |

| | | |
|---|---|---|
| 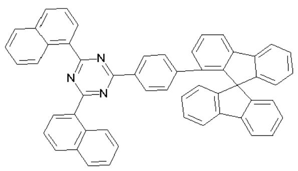 | 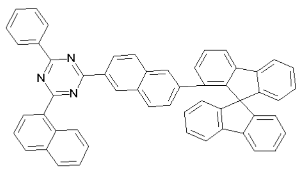 | 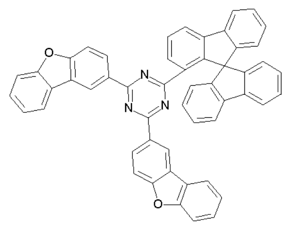 |
| 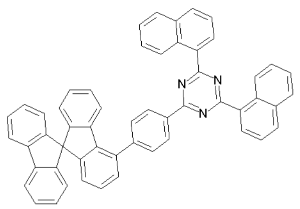 | 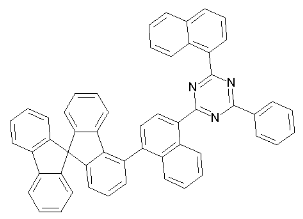 | 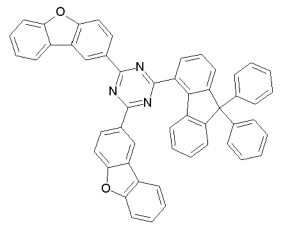 |
| 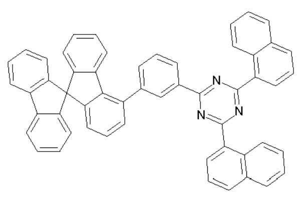 | 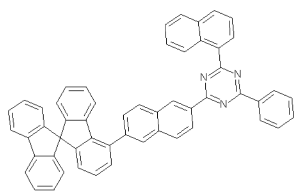 | 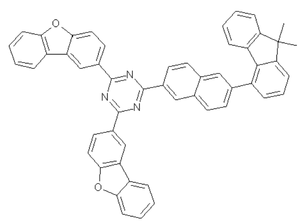 |
| 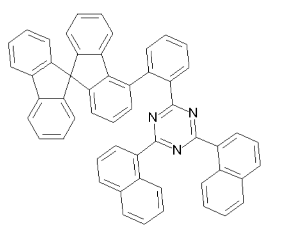 | 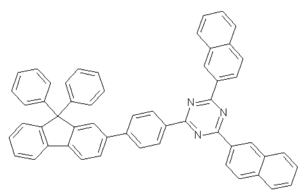 | 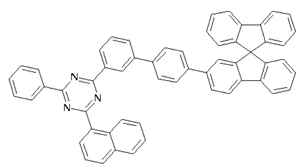 |
| 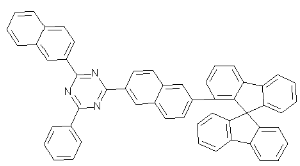 | 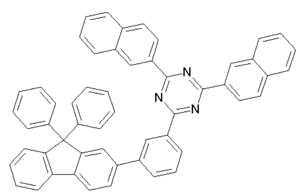 | 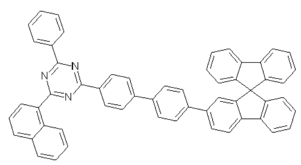 |
| 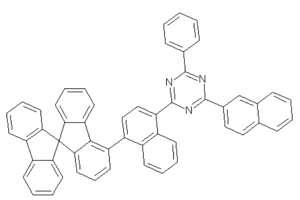 | 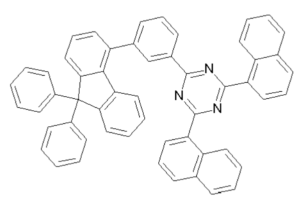 | 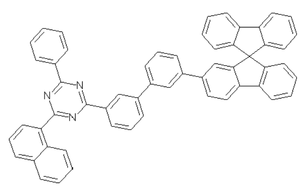 |
| 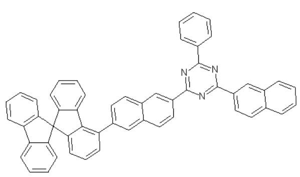 | 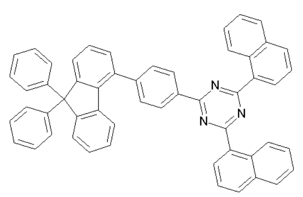 | 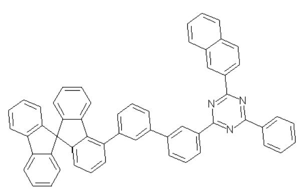 |

| | | |
|---|---|---|
| 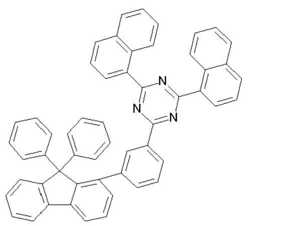 | 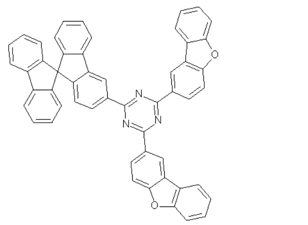 | 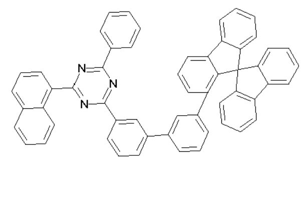 |
| 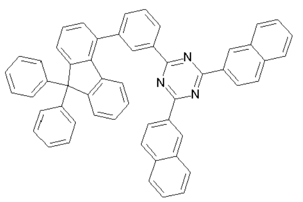 | 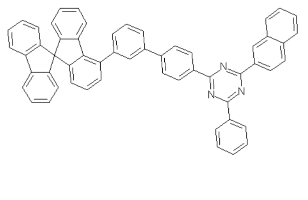 | 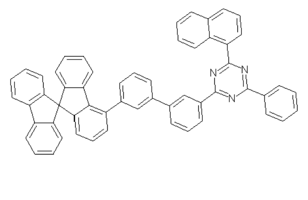 |
| 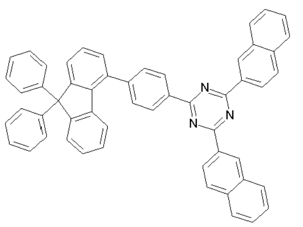 | 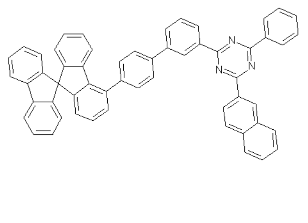 | 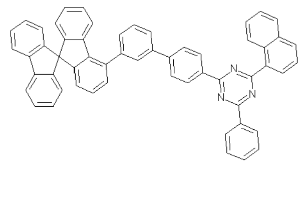 |
| 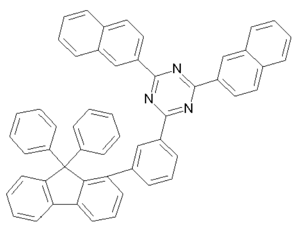 | 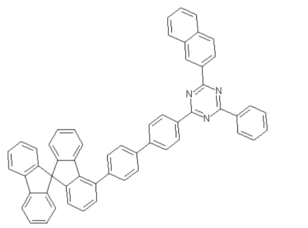 | 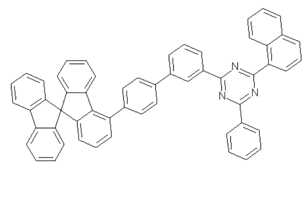 |
| 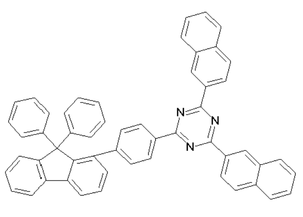 | 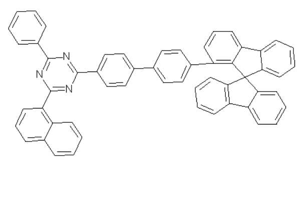 | 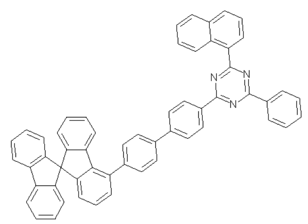 |
| 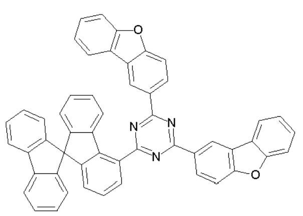 | 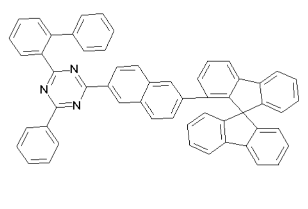 | 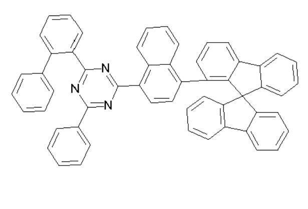 |
| 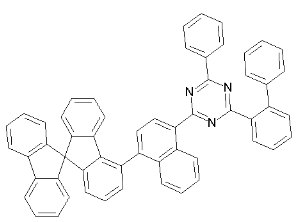 | 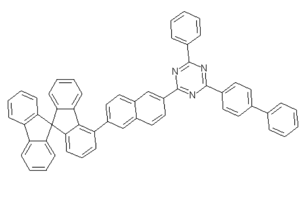 | 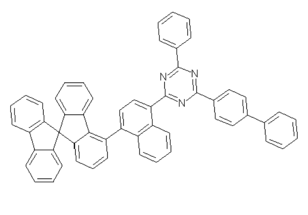 |

| | | |
|---|---|---|
| 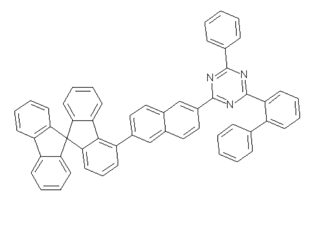 | 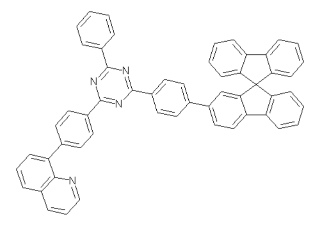 | 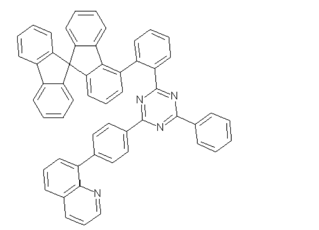 |
| 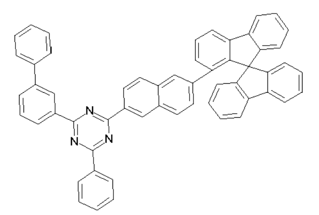 | 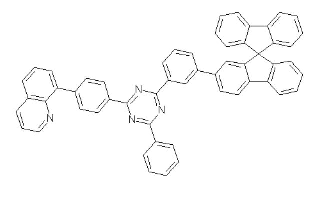 | 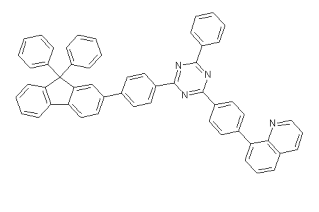 |
| 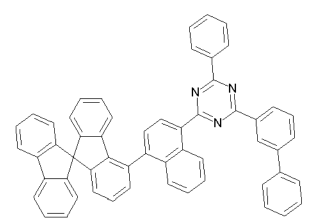 | 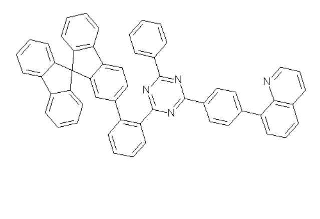 | 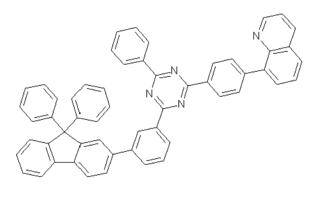 |
| 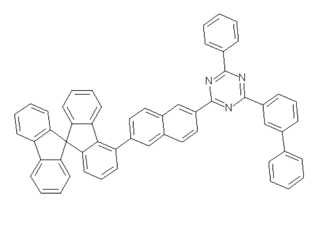 | 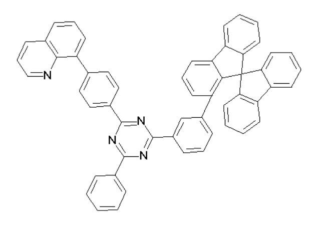 | 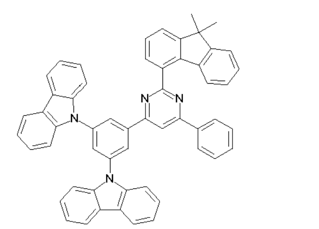 |
| 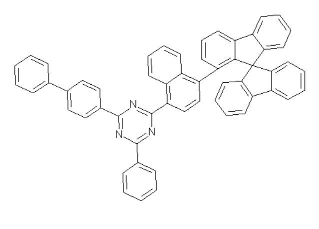 | 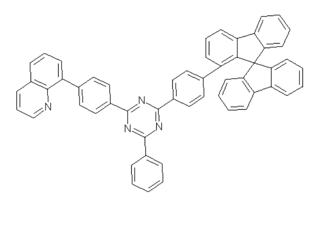 | 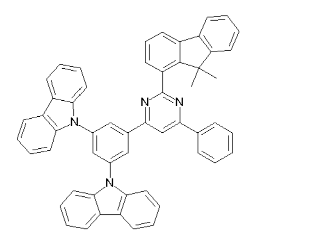 |
| 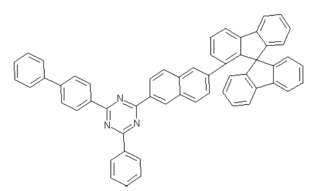 | 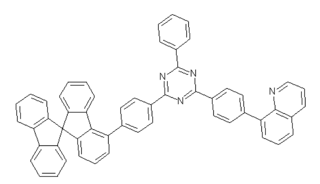 | 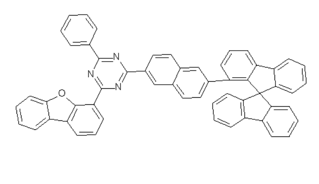 |
| 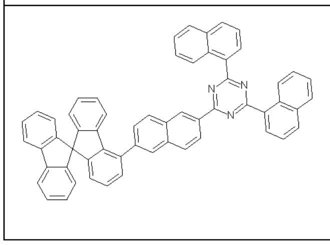 | 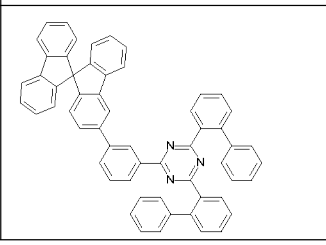 | 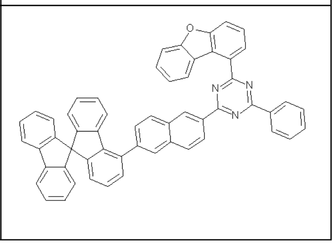 |

| | | |
|---|---|---|
| 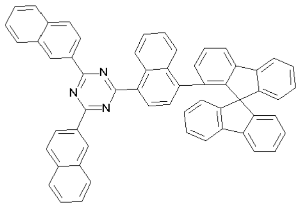 | 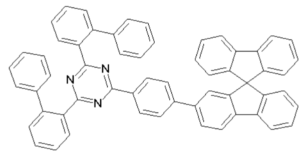 | 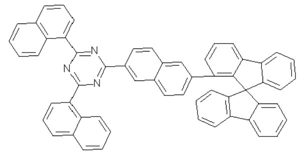 |
| 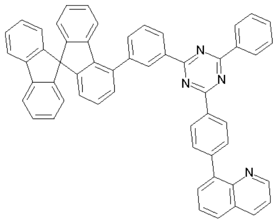 | 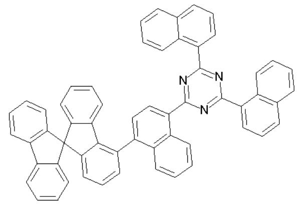 | 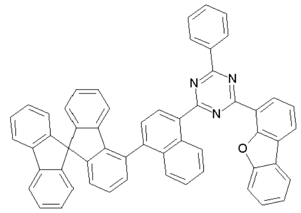 |
| 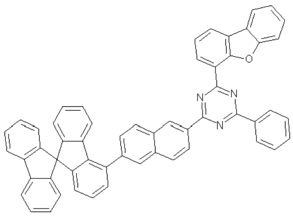 | 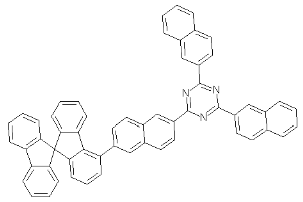 | 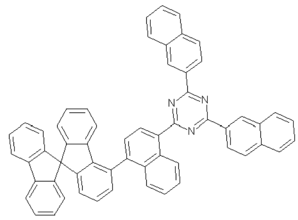 |
| 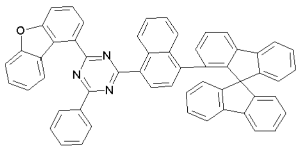 | 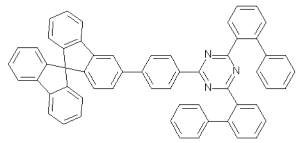 | 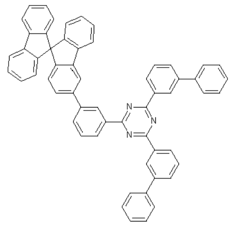 |
| 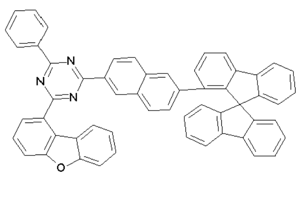 | 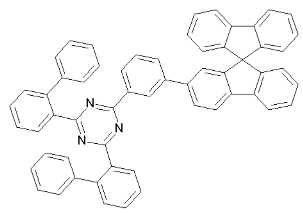 | 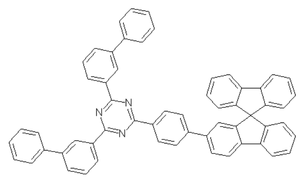 |
| 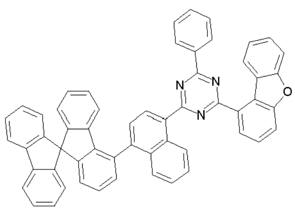 | 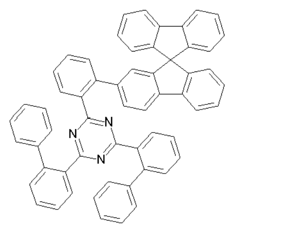 | 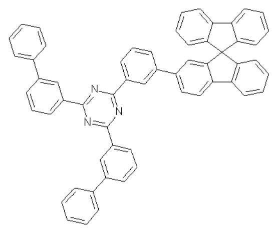 |
| 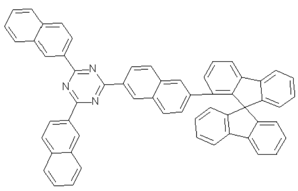 | 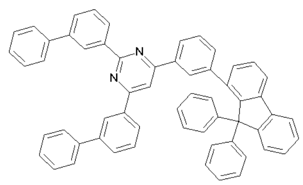 | 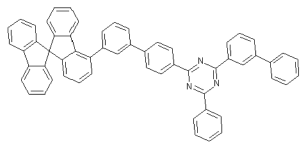 |

| | | |
|---|---|---|
| 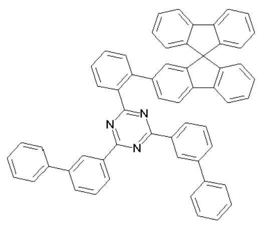 | 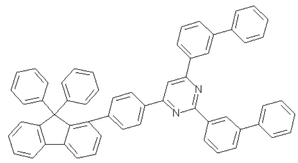 | 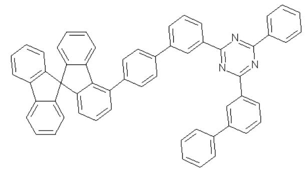 |
| 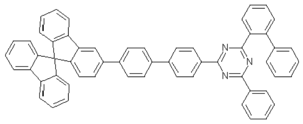 | 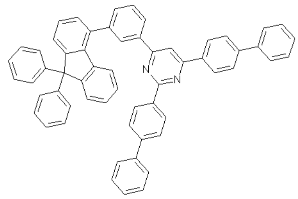 | 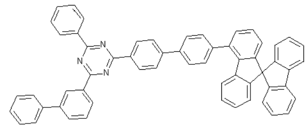 |
| 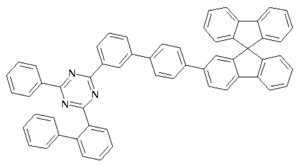 | 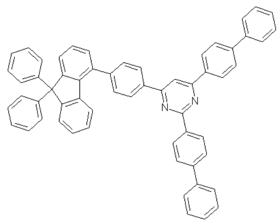 | 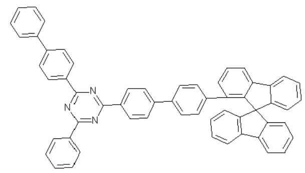 |
| 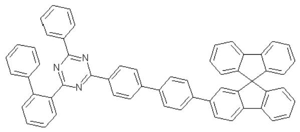 | 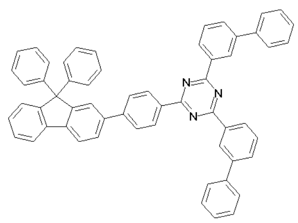 | 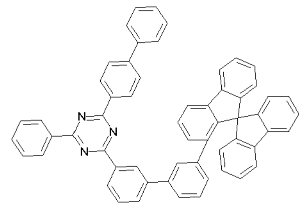 |
| 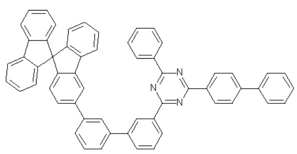 | 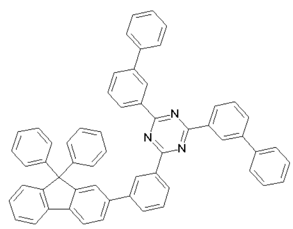 | 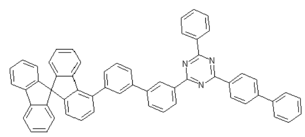 |
| 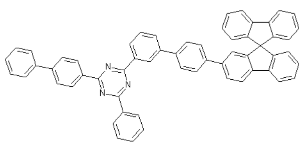 | 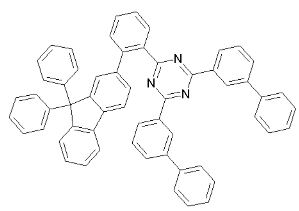 | 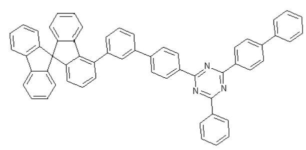 |
| 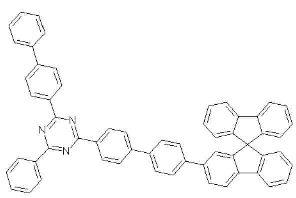 | 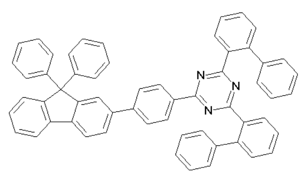 | 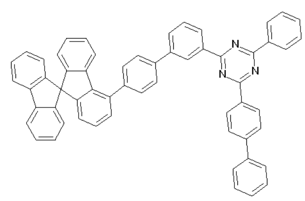 |

| | | |
|---|---|---|
| 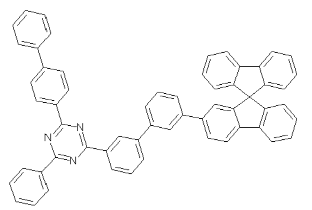 | 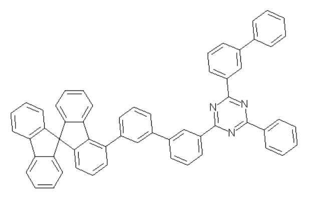 | 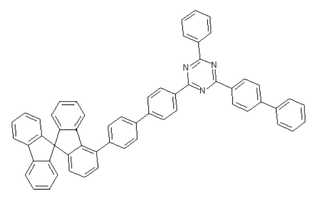 |
| 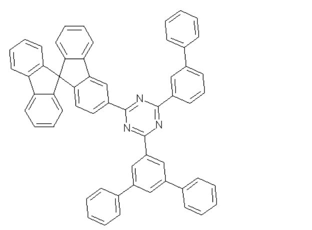 | 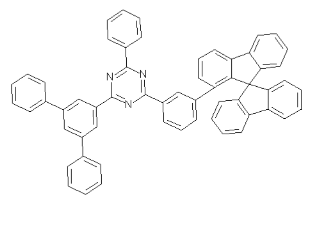 | 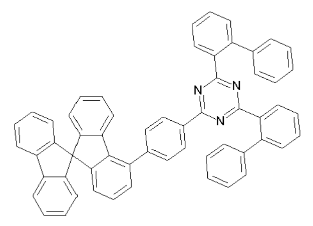 |
| 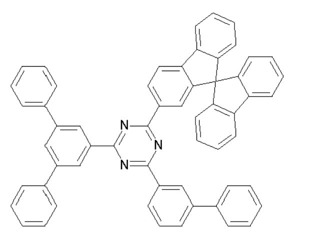 | 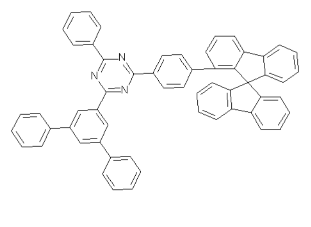 | 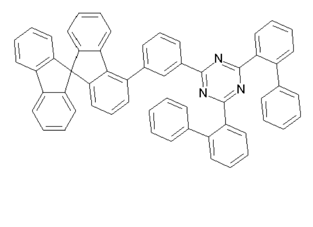 |
| 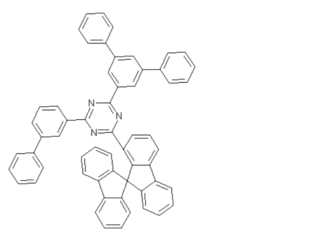 | 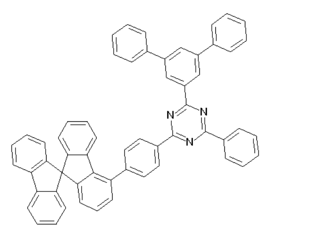 | 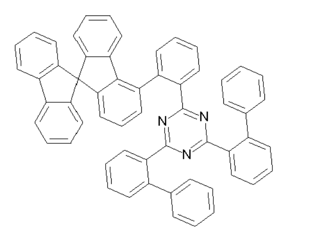 |
| 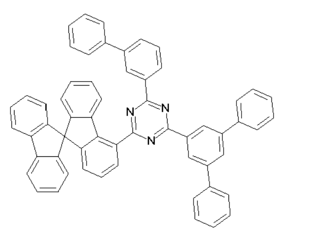 | 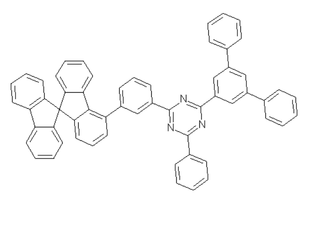 | 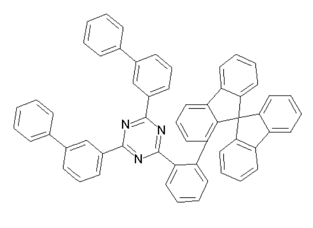 |
| 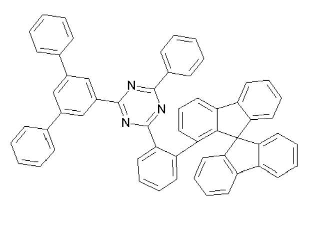 | 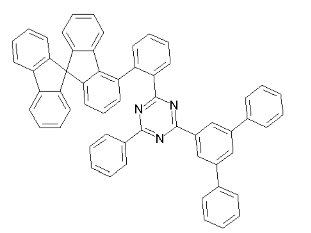 | 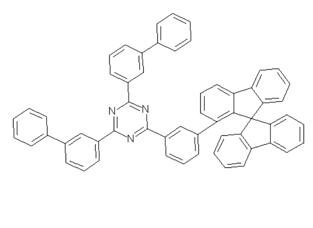 |
| 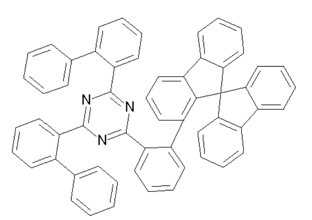 | 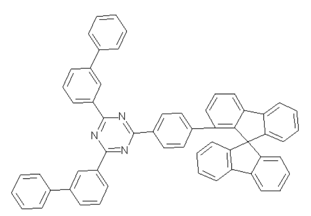 | 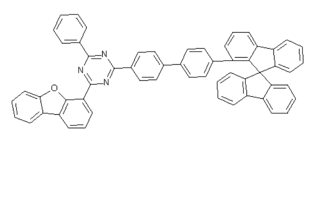 |

| | | |
|---|---|---|
| 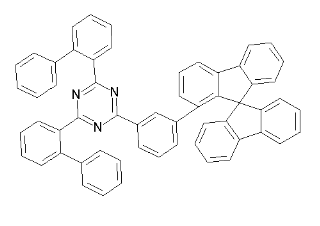 | 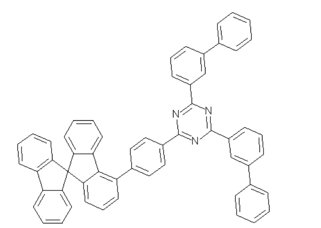 | 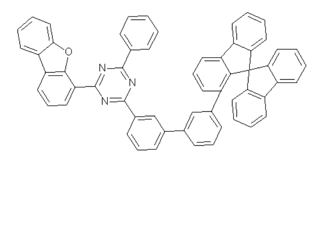 |
| 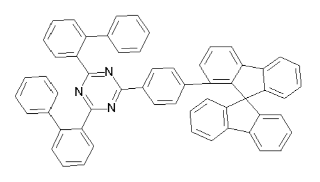 | 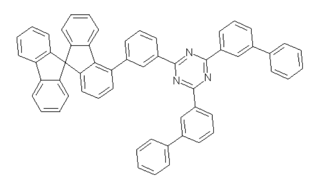 | 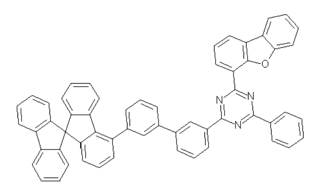 |
| 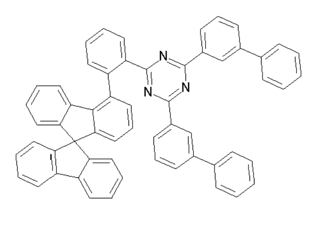 | 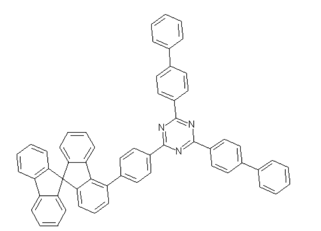 | 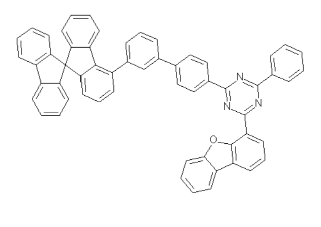 |
| 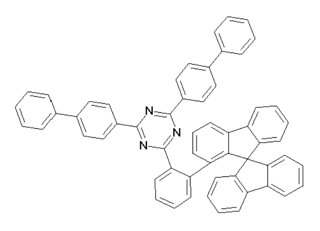 | 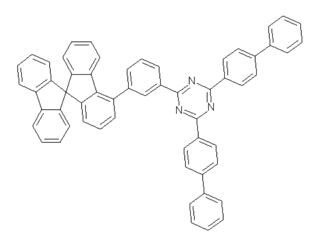 | 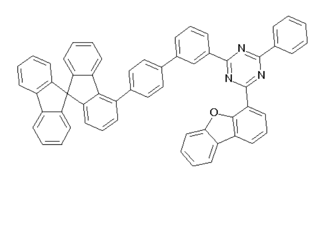 |
| 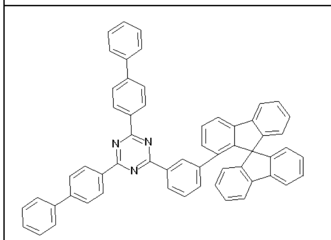 | 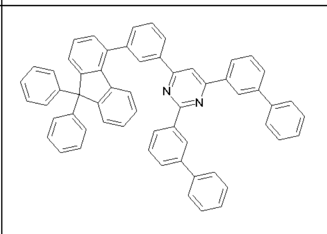 | 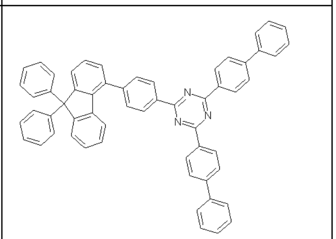 |
| 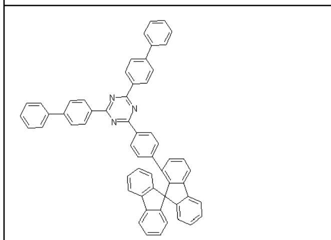 | 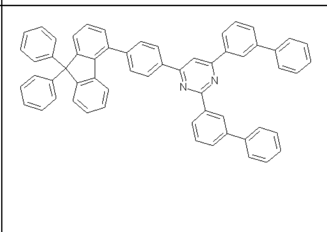 | 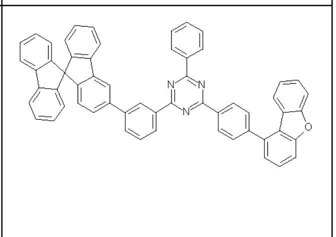 |
| 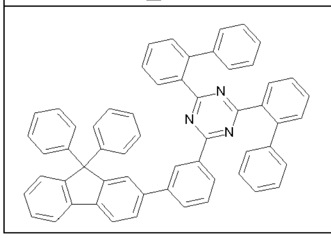 | 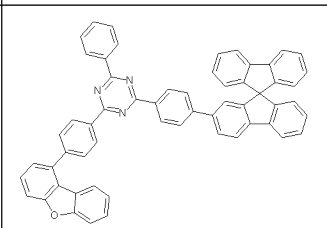 | 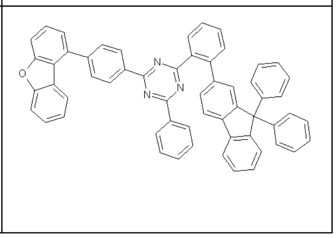 |

| | | |
|---|---|---|
| 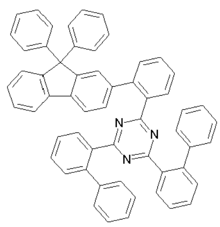 | 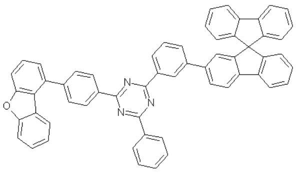 | 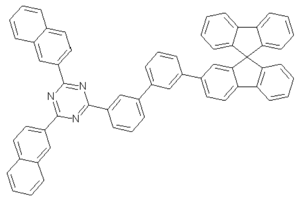 |
| 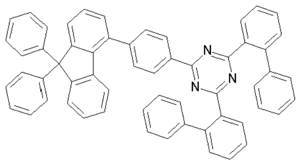 | 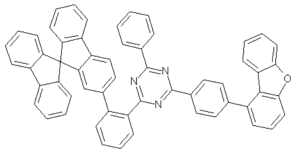 | 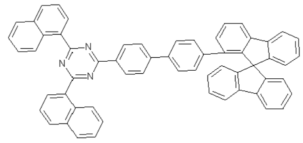 |
| 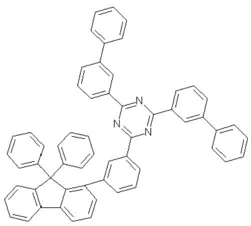 | 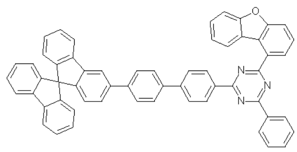 | 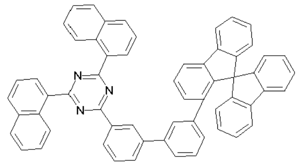 |
| 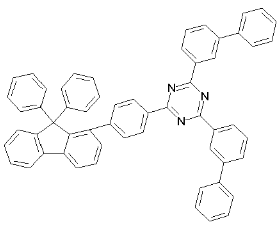 | 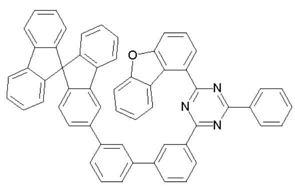 | 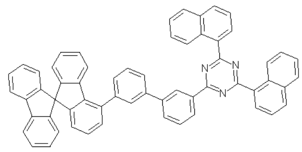 |
| 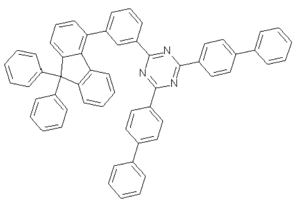 | 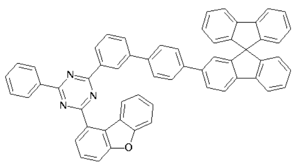 | 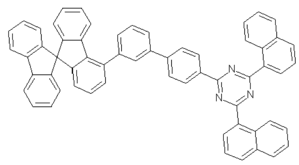 |
| 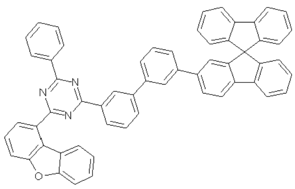 | 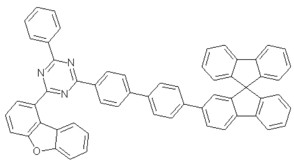 | 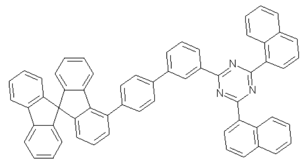 |
| 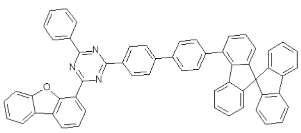 | 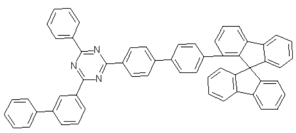 | 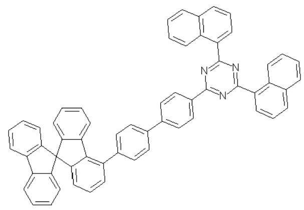 |

| | | |
|---|---|---|
| 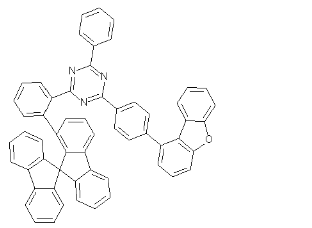 | 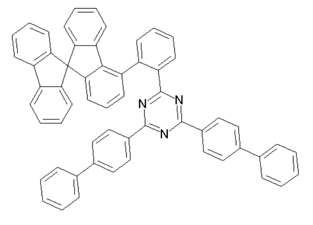 | 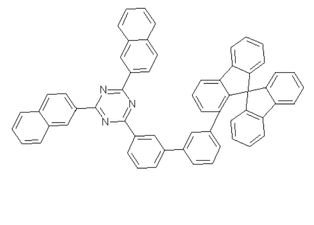 |
| 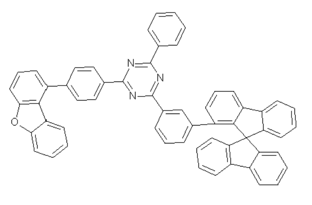 | 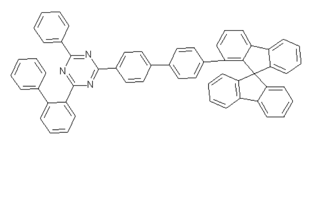 | 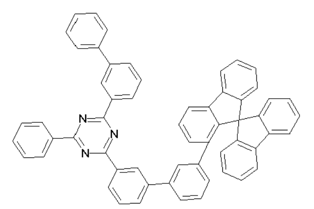 |
| 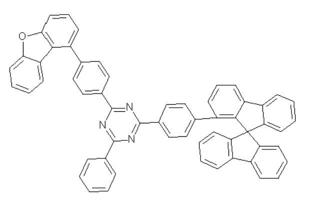 | 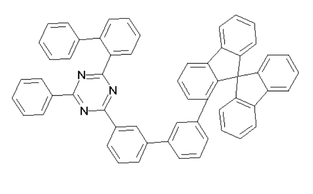 | 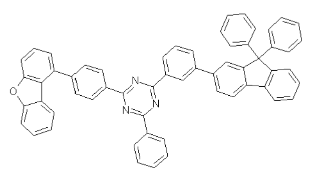 |
| 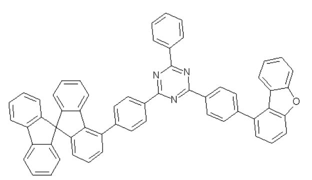 | 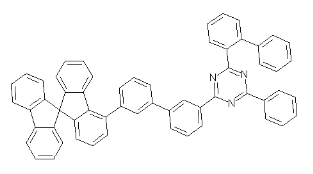 | 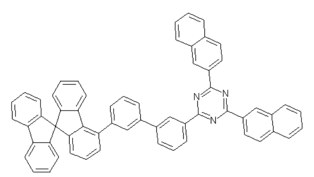 |
| 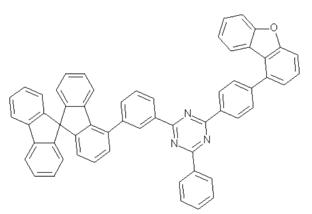 | 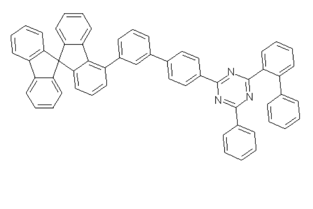 | 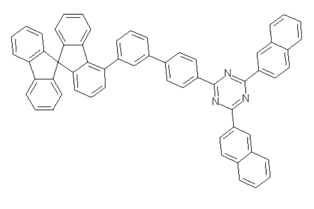 |
| 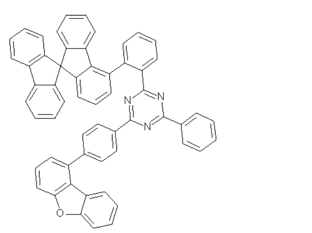 | 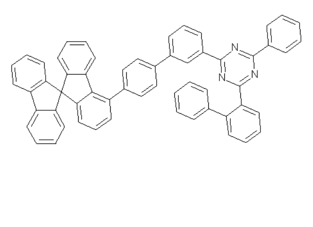 | 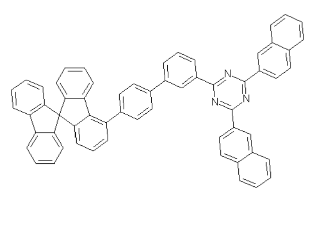 |
| 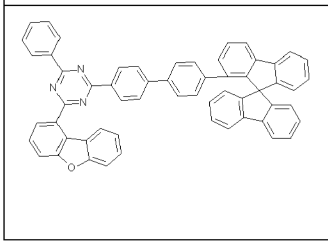 | 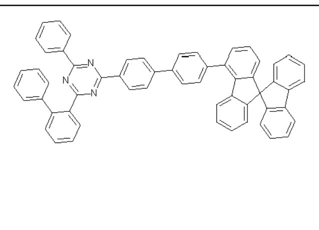 | 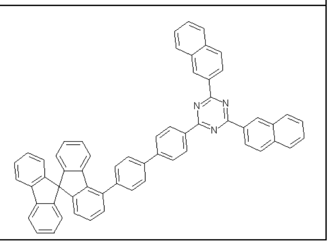 |

| | | |
|---|---|---|
| 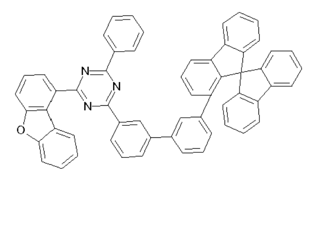 | 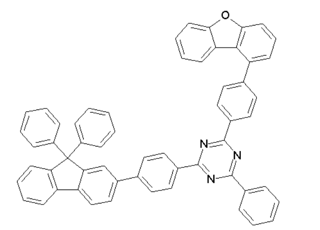 | 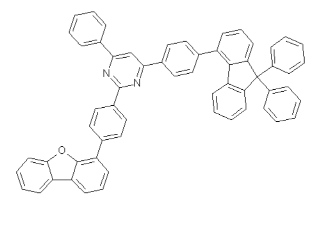 |
| 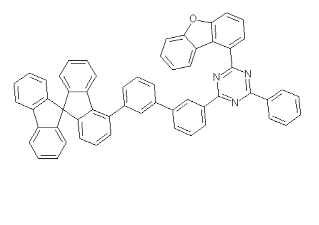 | 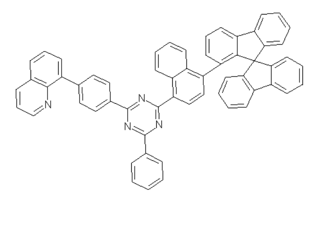 | 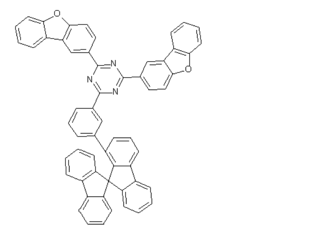 |
| 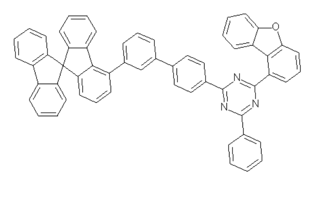 | 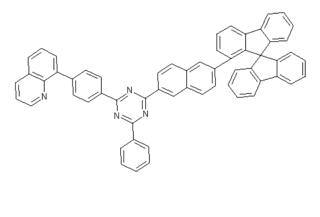 | 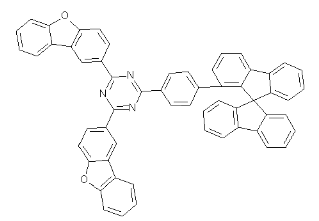 |
| 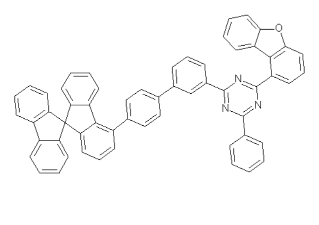 | 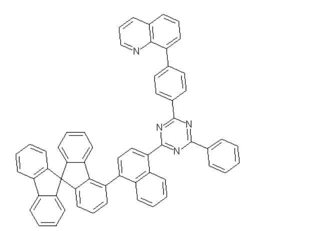 | 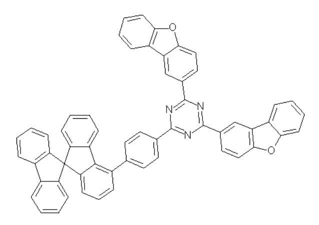 |
| 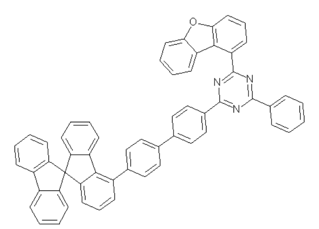 | 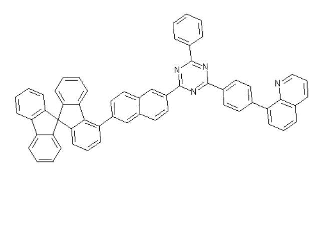 | 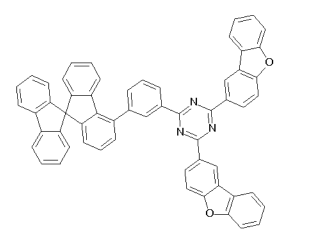 |
| 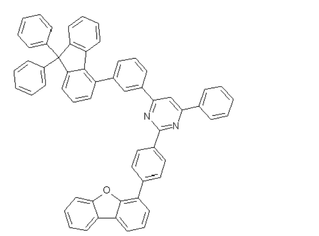 | 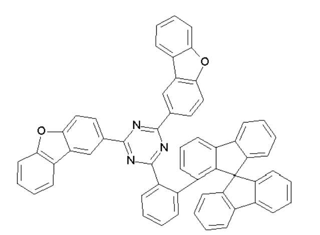 | 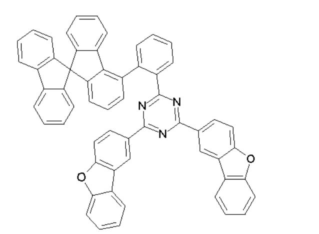 |
| 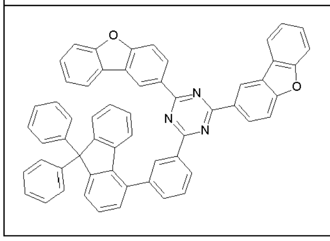 | 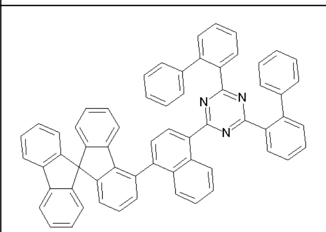 | 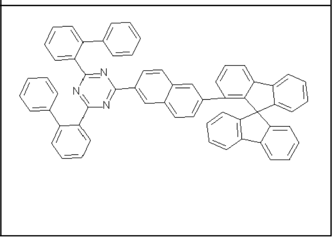 |

| | | |
|---|---|---|
| 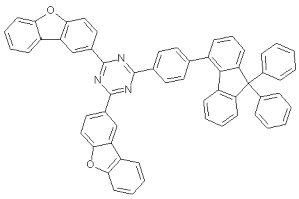 | 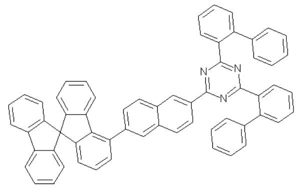 | 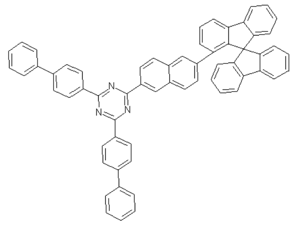 |
| 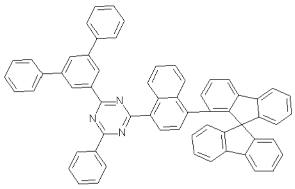 | 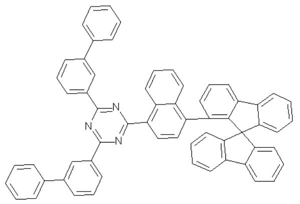 | 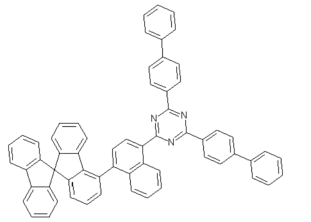 |
| 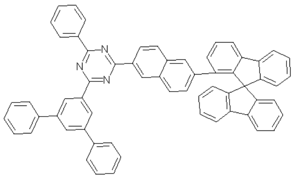 | 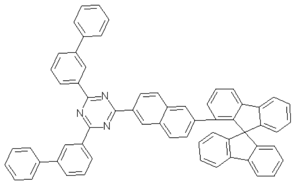 | 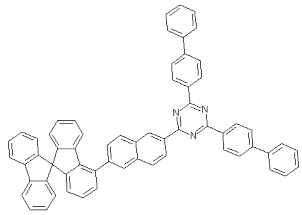 |
| 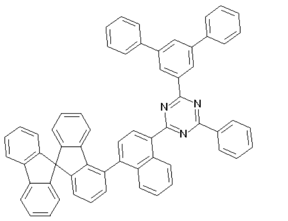 | 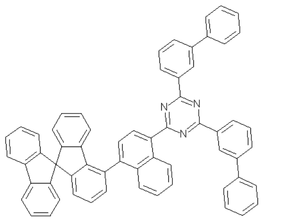 | 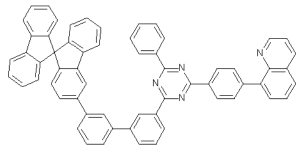 |
| 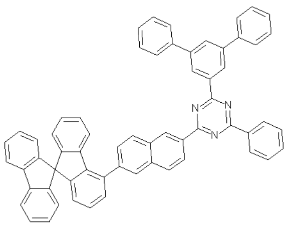 | 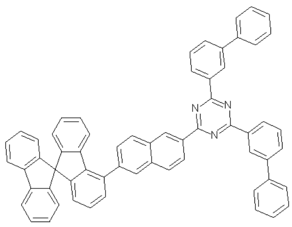 | 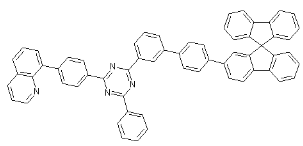 |
| 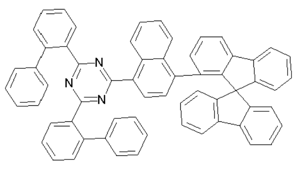 | 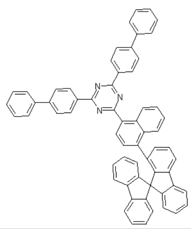 | 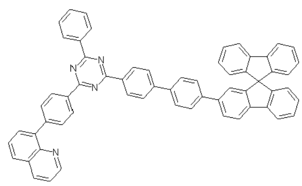 |
| 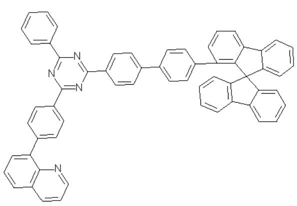 | 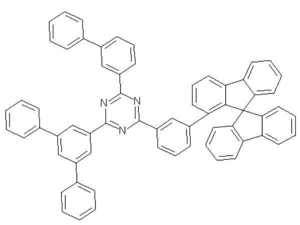 | 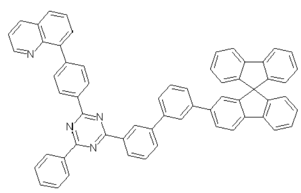 |

| | | |
|---|---|---|
| 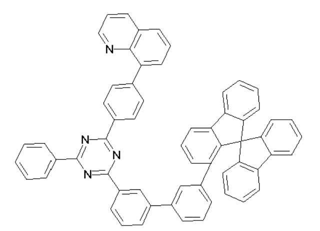 | 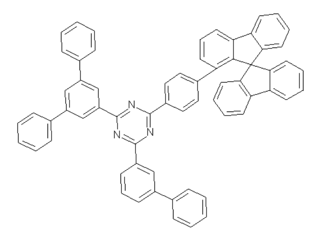 | 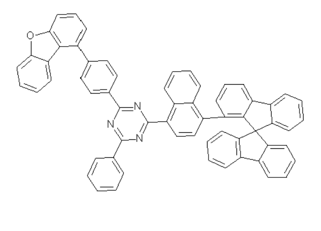 |
| 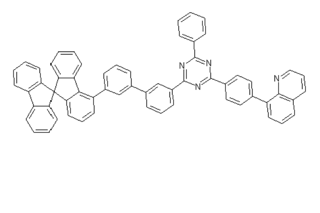 | 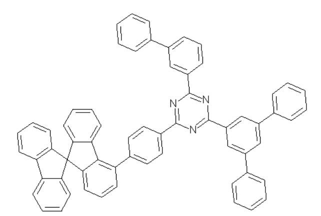 | 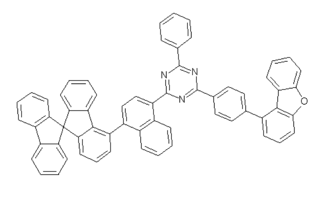 |
| 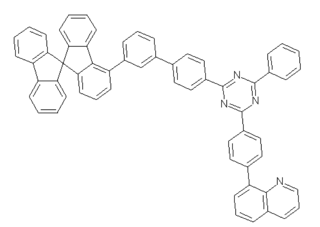 | 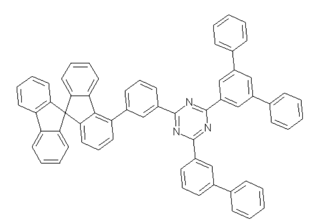 | 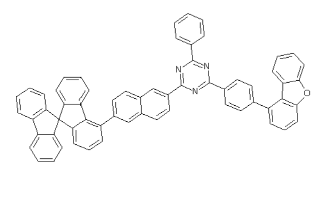 |
| 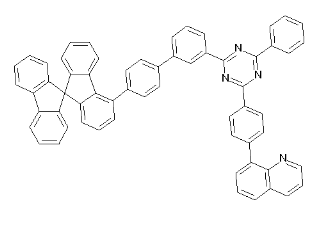 | 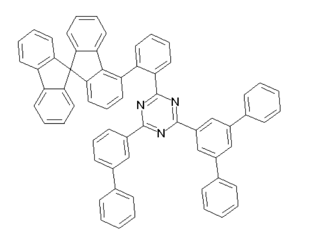 | 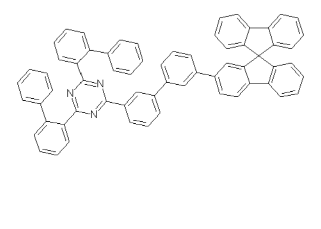 |
| 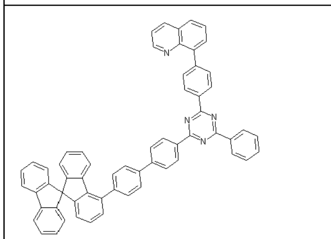 | 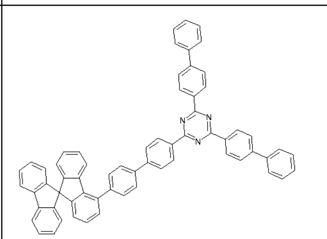 | 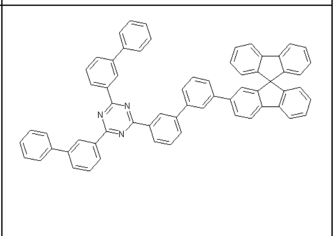 |
| 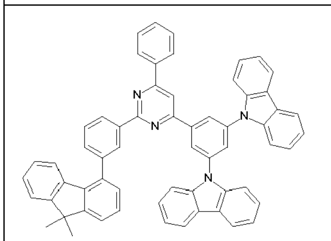 | 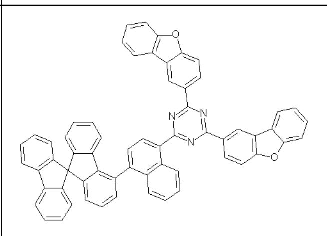 | 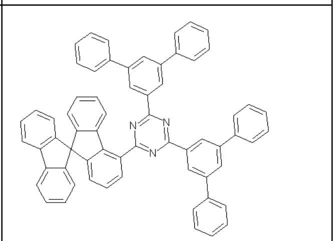 |
| 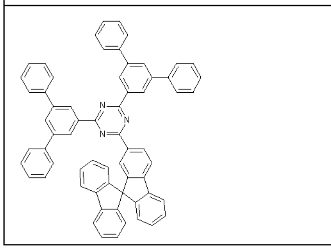 | 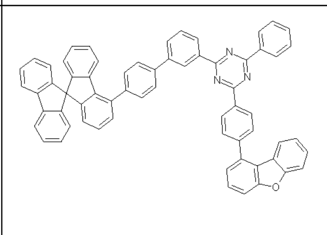 | 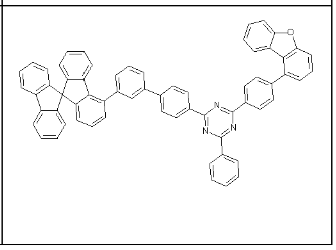 |

| | | |
|---|---|---|
| 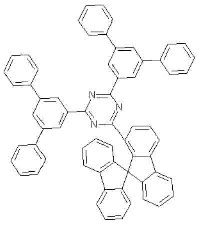 | 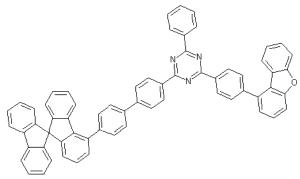 | 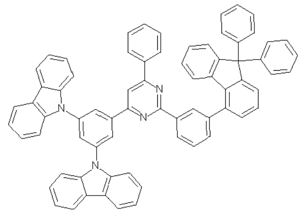 |
| 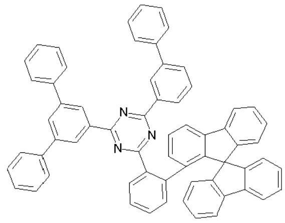 | 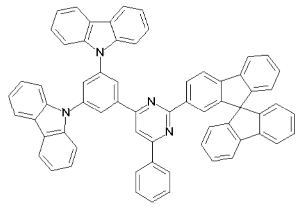 | 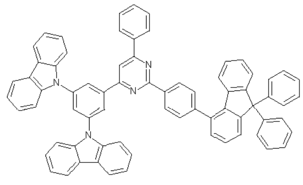 |
| 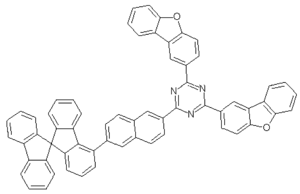 | 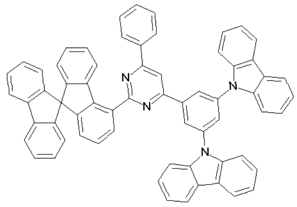 | 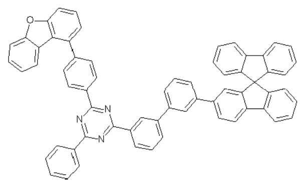 |
| 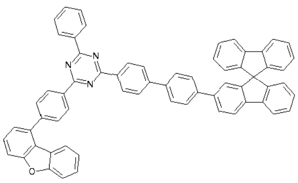 | 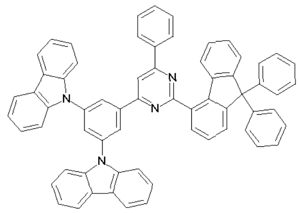 | 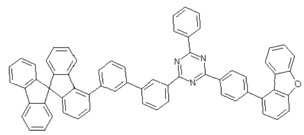 |
| 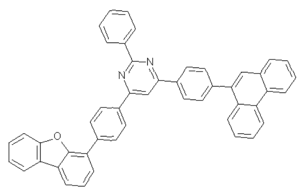 | 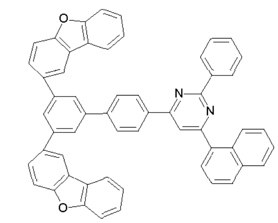 | 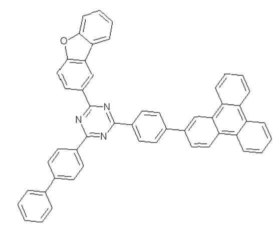 |
| 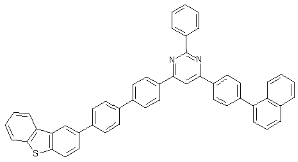 | 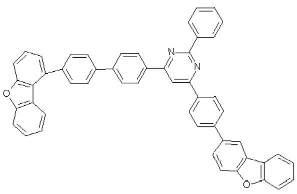 | 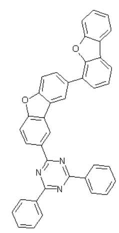 |
| 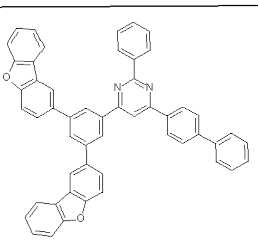 | 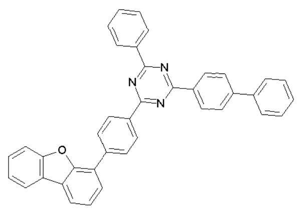 | 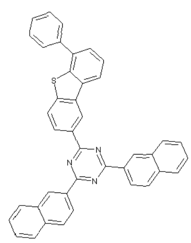 |

| | | |
|---|---|---|
| 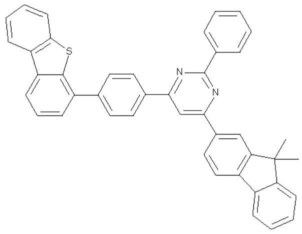 | 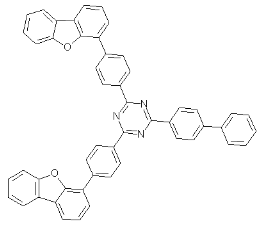 | 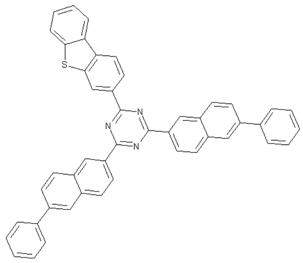 |
| 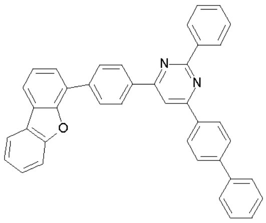 | 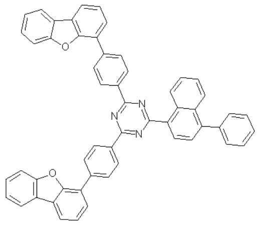 | 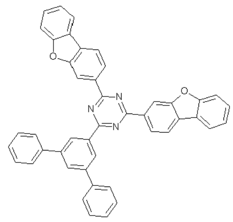 |
| 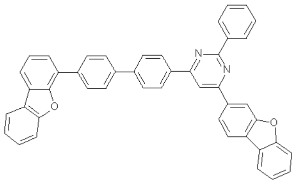 | 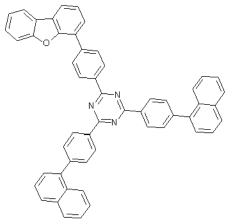 | 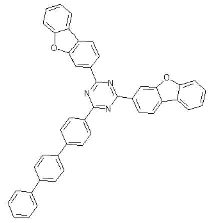 |
| 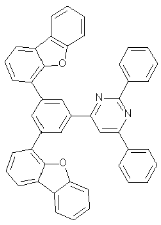 | 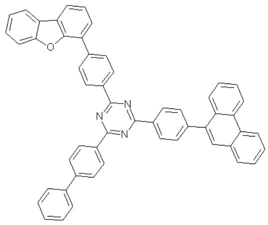 | 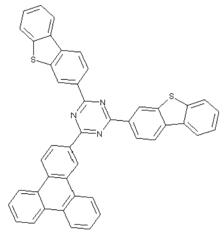 |
| 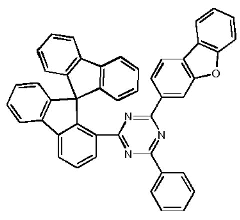 | 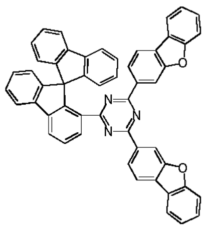 | 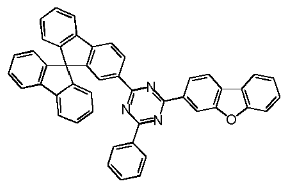 |
| 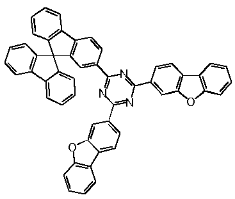 | 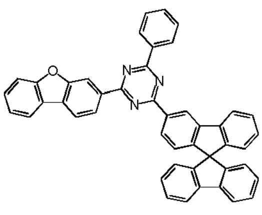 | 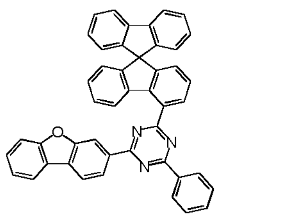 |

| | | |
|---|---|---|
| 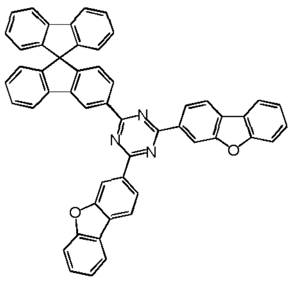 | 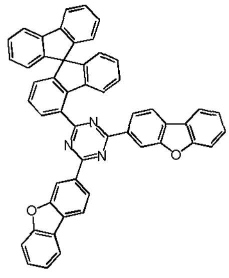 | 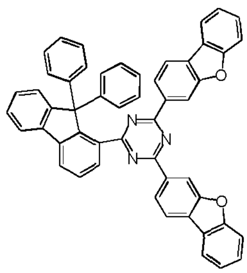 |
| 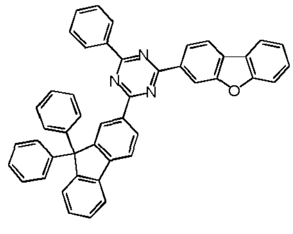 | 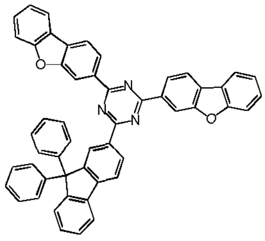 | 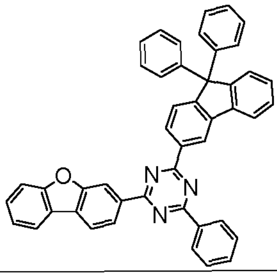 |
| 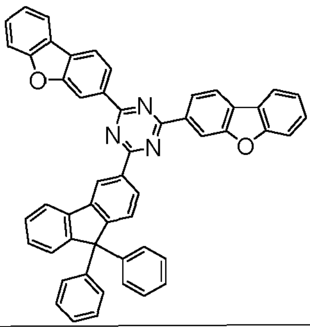 | 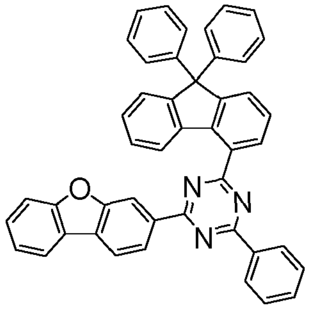 | 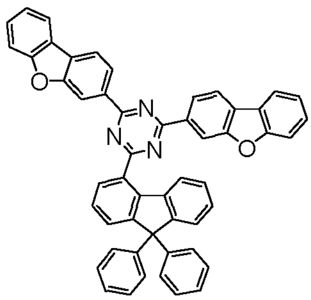 |
| 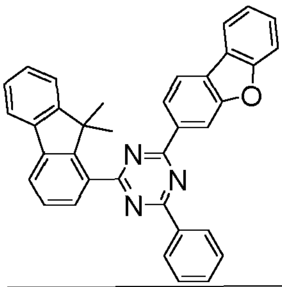 | 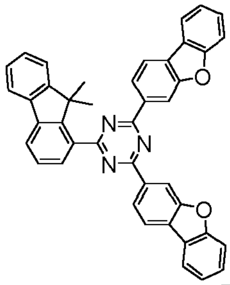 | 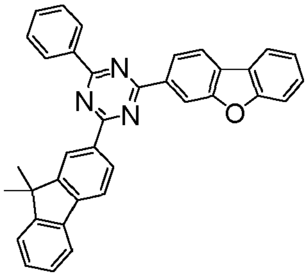 |
| 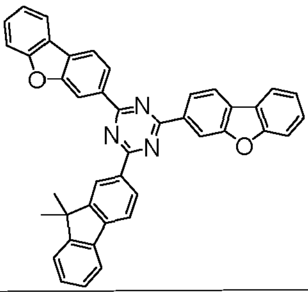 | 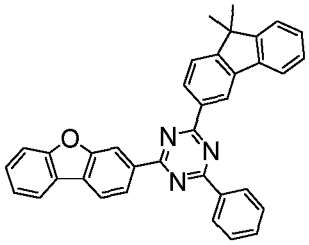 | 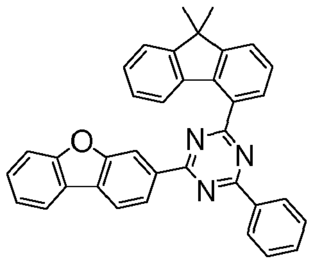 |

| | | |
|---|---|---|
| 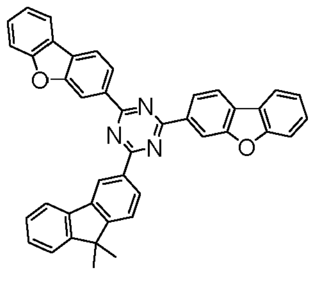 | 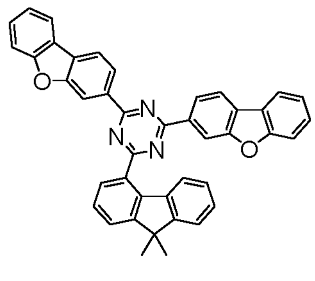 | 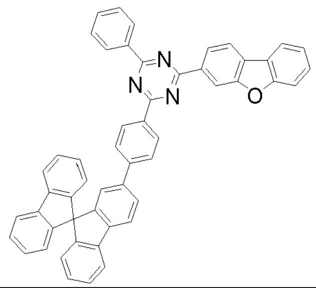 |
| 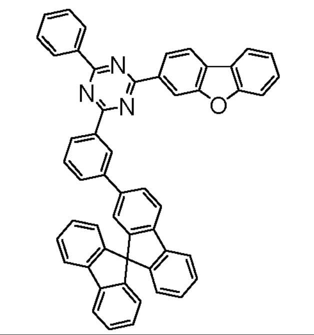 | 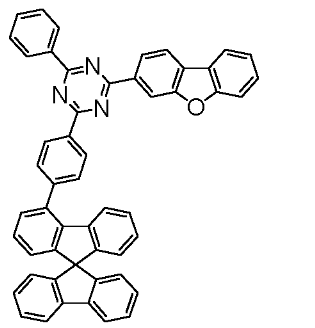 | 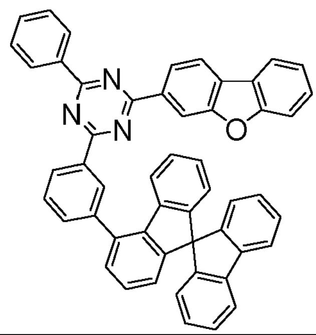 |
| 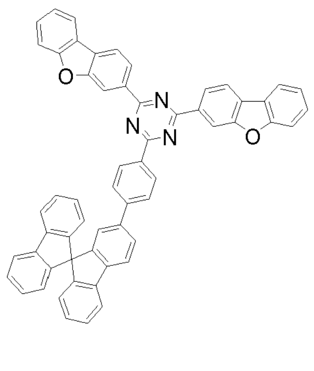 | 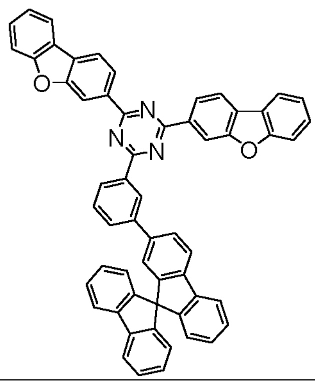 | 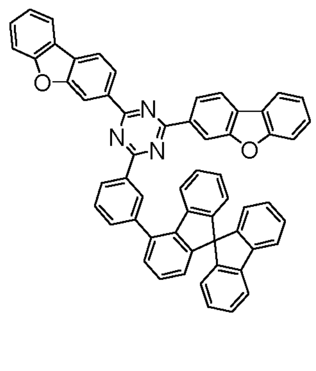 |
| 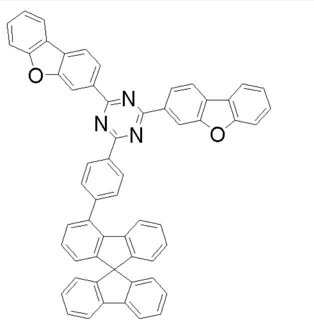 | 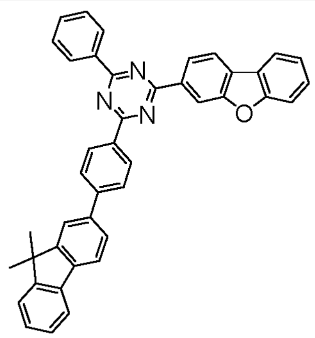 | 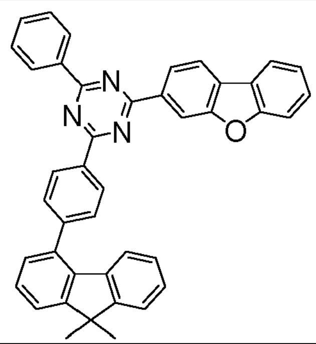 |
| 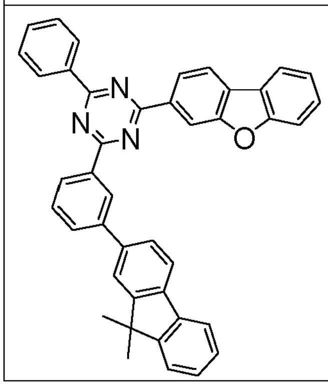 | 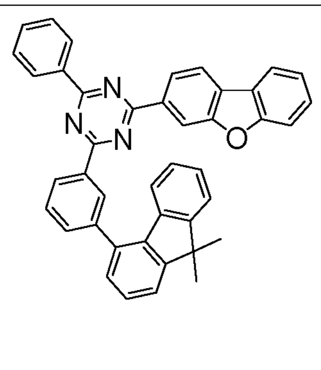 | 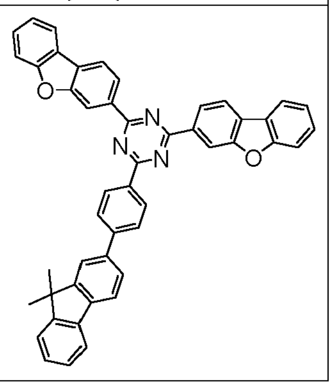 |

| | | |
|---|---|---|
| 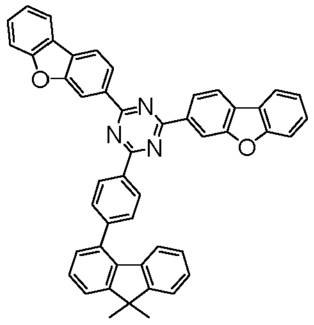 | 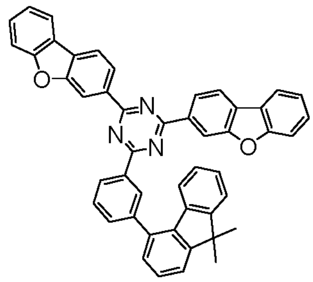 | 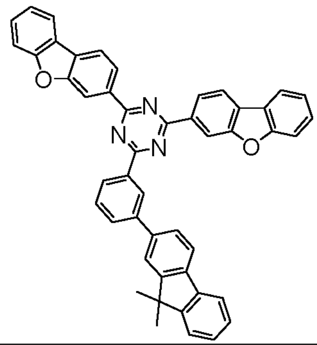 |

Die erfindungsgemäße elektronische Vorrichtung ist bevorzugt eine organische Elektrolumineszenzvorrichtung. Die erste Elektrode der Vorrichtung ist bevorzugt die Anode, und die zweite Elektrode ist bevorzugt die Kathode.

Gemäß einer bevorzugten Ausführungsform ist die Schicht E eine Elektronentransportschicht, insbesondere eine Schicht, die zwischen emittierender Schicht und Kathode angeordnet ist und nicht direkt an die emittierende Schicht angrenzt. In diesem Fall ist es bevorzugt, dass die Schicht E eine Verbindung der Formel (E-1) enthält, in der drei Gruppen V gleich N sind, und die restlichen Gruppen V gleich $CR^4$ sind. Besonders bevorzugt ist in diesem Fall die Gruppe

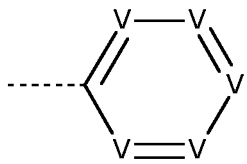

in Formel (E-1) gleich 1,3,5-Triazinyl, das mit Resten $R^4$ substituiert ist.

Gemäß einer bevorzugten Ausführungsform enthält die Schicht E, insbesondere wenn sie eine Elektronentransportschicht ist, eine Mischung aus einem Alkalimetallsalz und einer weitereren Verbindung. Bevorzugt ist die weitere Verbindung nicht ionisch. Weiterhin bevorzugt ist das Alkalimetallsalz ein Lithiumsalz. Das Alkalimetallsalz ist bevorzugt ein Salz mit einem organischen Anion, besonders bevorzugt 8-Hydroxychinolinat. Ganz besonders bevorzugt ist Lithium-8-Hydroxychinolinat (LiQ).

Als Kathode der elektronischen Vorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden.

Es kann auch bevorzugt sein, zwischen einer metallischen Kathode und dem organischen Halbleiter eine dünne Zwischenschicht eines Materials mit einer hohen Dielektrizitätskonstante einzubringen. Diese Schicht wird auch als Elektroneninjektionsschicht bezeichnet. Als Materialien für diese Schicht werden bevorzugt Alkalimetall- oder Erdalkalimetallfluoride, aber auch die entsprechenden Oxide oder Carbonate (z. B. LiF, $Li_2O$, $BaF_2$, MgO, NaF, CsF, $CS_2CO_3$, etc.) verwendet. Gemäß einer bevorzugten Ausführungsform wird dafür eine Mischung aus einem Lanthanoid und einem Salz gewählt aus Alkalimetallfluorid, Erdalkalimetallfluorid, Alkalimetalloxid, Erdalkalimetalloxid, Alkalimetallcarbonat und Erdalkalimetallcarbonat verwendet, insbesondere eine Mischung aus Ytterbium (Yb) und LiF. Gemäß einer alternativen bevorzugten Ausführungsform wird dafür Lithiumchinolinat (LiQ) verwendet. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOx, Al/PtOx) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid,

Molybdänoxid oder Vanadiumoxid.

Bevorzugt enthält die elektronische Vorrichtung zusätzlich zur emittierenden Schicht enthaltend eine Verbindung der Formel (EM-1) und zur Schicht E mindestens eine weitere Schicht. Besonders bevorzugt ist diese mindestens eine weitere Schicht zwischen der Anode und der emittierenden Schicht angeordnet. Weiterhin besonders bevorzugt ist diese mindestens eine weitere Schicht eine lochtransportierende Schicht. Unter dem Begriff lochtransportierende Schicht sind dabei die speziellen Ausführungsformen Lochinjektionsschicht (HIL), Lochtransportschicht (HTL) und Elektronenblockierschicht (EBL) zusammengefasst.

Im Speziellen wird unter einer Lochinjektionsschicht eine Schicht verstanden, die direkt an die Anode angrenzt. Gemäß einer bevorzugten Ausführungsform enthält diese Schicht einen p-Dotanden und mindestens eine lochtransportierende Verbindung. Letztere ist bevorzugt gewählt aus Triarylamin-Verbindungen, besonders bevorzugt aus Mono-Triarylaminverbindungen. Ganz besonders bevorzugt ist sie gewählt aus den weiter unten angegebenen bevorzugten Ausführungsformen von Lochtransportmaterialien. Die p-Dotanden sind ebenfalls bevorzugt gewählt aus den weiter unten angegebenen bevorzugten Ausführungsformen von p-Dotanden. Gemäß einer alternativen bevorzugten Ausführungsform enthält die Lochinjektionsschicht eine Verbindung mit niedrigem LUMO (LUMO = lowest unoccupied molecular orbital) als Hauptkomponente oder in Reinform. Die Verbindung ist bevorzugt gewählt aus Derivaten von Hexaazatriphenylen, wie in US 2007/0092755 beschrieben.

Es ist bevorzugt, dass die elektronische Vorrichtung eine Lochinjektionsschicht enthält. Bevorzugt entspricht sie den oben genannten bevorzugten Ausführungsformen. Insbesondere ist es bevorzugt, dass sie einen p-Dotanden und ein lochtransportierendes Material enthält, das eine Triarylaminverbindung ist.

Im Speziellen wird unter einer Elektronenblockierschicht (EBL) eine Schicht verstanden, die anodenseitig direkt an die emittierende Schicht angrenzt. Die Elektronenblockierschicht kann ein oder mehrere lochtransportierende Verbindungen enthalten, bevorzugt eine lochtransportierende Verbindung. Letztere ist bevorzugt gewählt aus Triarylamin-Verbindungen, besonders bevorzugt aus Mono-Triarylaminverbindungen. Ganz besonders bevorzugt sind sie gewählt aus den weiter unten angegebenen bevorzugten Ausführungsformen von Lochtransportmaterialien.

Im Speziellen wird unter einer Lochtransportschicht (HTL) eine Schicht verstanden, die zwischen der Lochinjektionsschicht und der Elektronenblockierschicht angeordnet ist. Gemäß einer bevorzugten Ausführungsform enthält diese Schicht einen p-Dotanden und mindestens eine lochtransportierende Verbindung. Letztere ist bevorzugt gewählt aus Triarylamin-Verbindungen, besonders bevorzugt aus Mono-Triarylaminverbindungen. Ganz besonders bevorzugt sind sie gewählt aus den weiter unten angegebenen bevorzugten Ausführungsformen von Lochtransportmaterialien. Die p-Dotanden sind ebenfalls bevorzugt gewählt aus den weiter unten angegebenen bevorzugten Ausführungsformen von p-Dotanden.

Gemäß einer alternativen bevorzugten Ausführungsform enthält die Lochtransportschicht eine Mischung aus zwei oder mehr lochtransportierenden Verbindungen. Diese sind bevorzugt gewählt aus Triarylamin-Verbindungen, besonders bevorzugt aus Mono-Triarylaminverbindungen. Ganz besonders bevorzugt sind sie gewählt aus den weiter unten angegebenen bevorzugten Ausführungsformen von Lochtransportmaterialien. Die zwei oder mehr lochtransportierenden Verbindungen liegen bevorzugt in einem Anteil von jeweils mindestens 20% in der Schicht vor, besonders bevorzugt jeweils in einem Anteil von mindestens 30%.

Unter Angaben in % werden in der vorliegenden Anmeldung Volumen-% verstanden, wenn Mischungen aus Verbindungen betroffen sind, die aus der Gasphase aufgebracht werden. Hingegen werden darunter Massen-% verstanden, wenn Mischungen aus Verbindungen betroffen sind, die aus Lösung aufgebracht werden.

Gemäß einer alternativen bevorzugten Ausführungsform enthält die Lochtransportschicht eine einzelne lochtransportierende Verbindung. Diese ist bevorzugt gewählt aus Triarylamin-Verbindungen, besonders bevorzugt aus Mono-Triarylaminverbindungen. Ganz besonders bevorzugt sind sie gewählt aus den weiter unten angegebenen bevorzugten Ausführungsformen von Lochtransportmaterialien.

Als p-Dotanden werden gemäß der vorliegenden Anmeldung bevorzugt solche organischen Elektronenakzeptorverbindungen eingesetzt, die eine oder mehrere der anderen Verbindungen in der Schicht, mit denen der p-Dotand gemischt ist, oxidieren können.

Besonders bevorzugt als p-Dotanden sind Chinodimethanverbindungen, Azaindenofluorendione, Azaphenalene, Azatriphenylene, $I_2$, Metallhalogenide, bevorzugt Übergangsmetallhalogenide, Metalloxide, bevorzugt Metalloxide enthaltend mindestens ein Übergangsmetall oder ein Metall der 3. Hauptgruppe, und Übergangsmetallkomplexe, bevorzugt Komplexe von Cu, Co, Ni, Pd und Pt mit Liganden enthaltend mindestens ein Sauerstoffatom als Bindungsstelle. Bevorzugt sind weiterhin Übergangsmetalloxide als Dotanden, bevorzugt Oxide von Rhenium, Molybdän und Wolfram, besonders bevorzugt $Re_2O_7$, $MoO_3$, $WO_3$ und $ReO_3$. Nochmals weiterhin bevorzugt sind Komplexe von Bismut in der Oxidationsstufe (III), insbesondere Bismut(III)-Komplexe mit elektronenarmen Liganden, insbesondere Carboxylat-Liganden.

Die p-Dotanden liegen bevorzugt weitgehend gleichmäßig verteilt in den p-dotierten Schichten vor. Dies kann beispielsweise durch Co-Verdampfung des p-Dotanden und der Lochtransportmaterial-Matrix erreicht werden. Der p-Dotand liegt bevorzugt in einem Anteil von 1 bis 10 % in der p-dotierten Schicht vor.

Bevorzugt sind als p-Dotanden insbesondere die folgenden Verbindungen:

| | | |
|---|---|---|
| 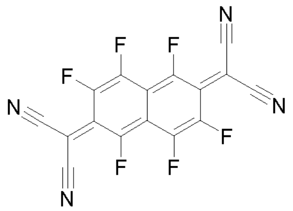 | 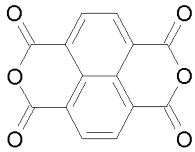 | 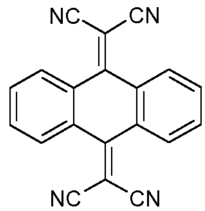 |
| (D-1) | (D-2) | (D-3) |
| 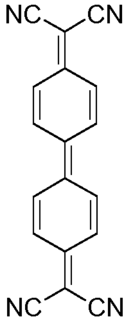 | 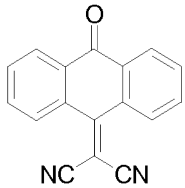 | 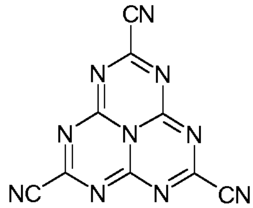 |
| (D-4) | (D-5) | (D-6) |
| 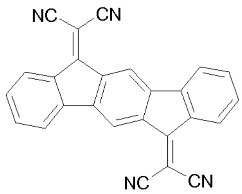 | 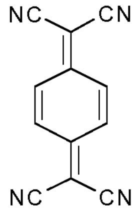 | 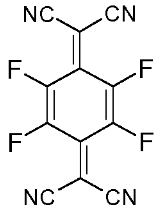 |
| (D-7) | (D-8) | (D-9) |
| 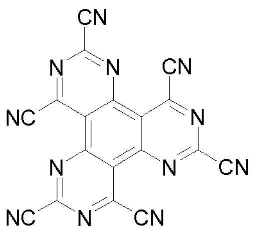 | 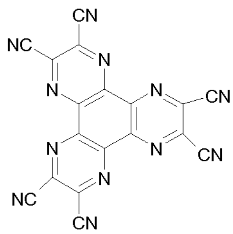 | 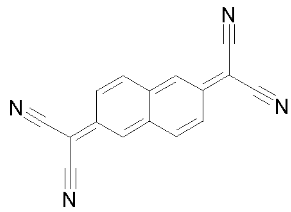 |
| (D-10) | (D-11) | (D-12) |
| 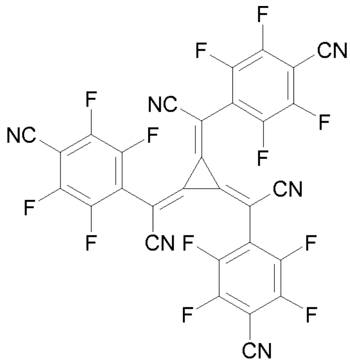 | | |
| (D-13) | | |

Als lochtransportierende Verbindungen werden bevorzugt Indenofluorenamin-Derivate, Aminderivate, Hexaazatriphenylenderivate, Aminderivate mit kondensierten Aromaten, Monobenzoindenofluorenamine, Dibenzoindenofluorenamine, Spirobifluoren-Amine, Fluoren-Amine, Spiro-Dibenzopyran-Amine, Dihydroacridin-Derivate, Spirodibenzofurane und Spirodibenzothiophene, Phenanthren-Diarylamine, Spiro-Tribenzotropolone, Spirobifluorene mit meta-Phenyldiamingruppen, Spiro-Bisacridine, Xanthen-Diarylamine, und 9,10-Dihydroanthracen-Spiroverbindungen mit Diarylaminogruppen eingesetzt. Die genannten Aminverbindungen sind bevorzugt Monoaminverbindungen. Explizite Beispiele für Verbindungen zur Verwendung in lochtransportierenden Schichten sind in der folgenden Tabelle gezeigt:

| | | |
|---|---|---|
| 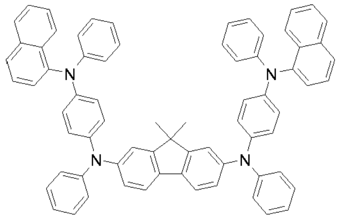 | 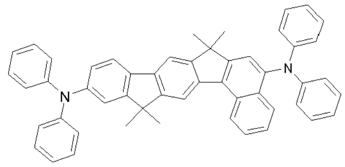 | 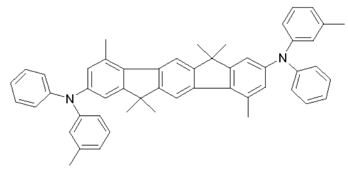 |
| 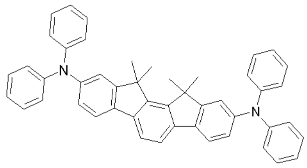 | 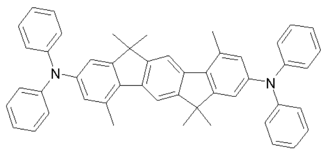 | 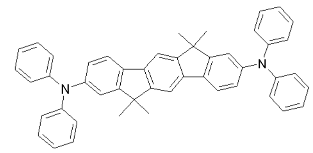 |
| 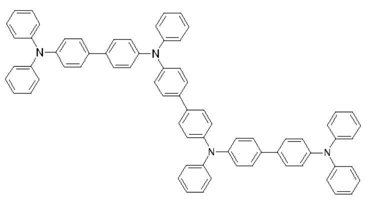 | 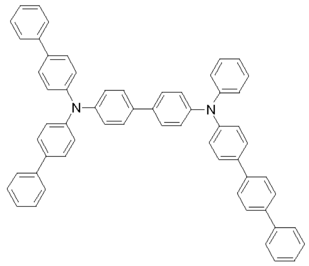 | 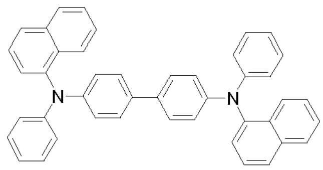 |
| 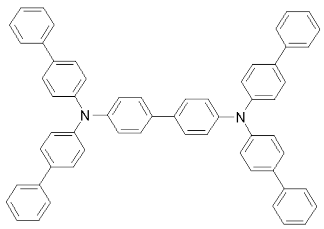 | 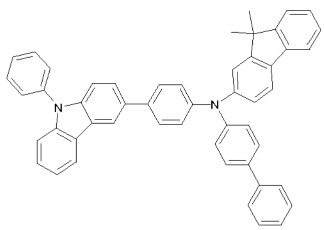 | 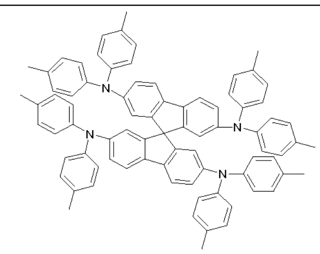 |
| 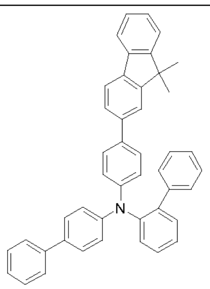 | 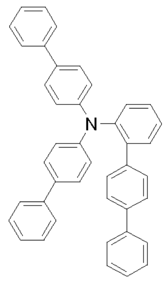 | 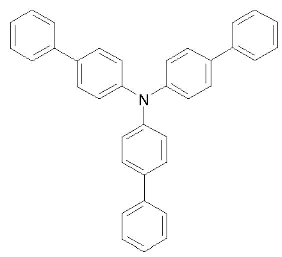 |
| 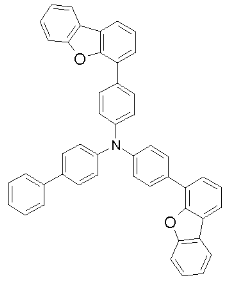 | 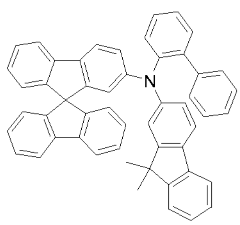 | 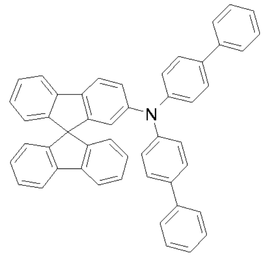 |

| | | |
|---|---|---|
| 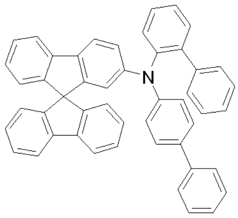 | 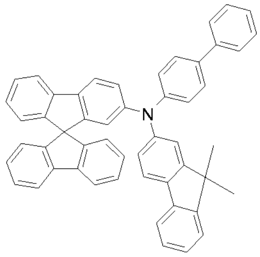 | 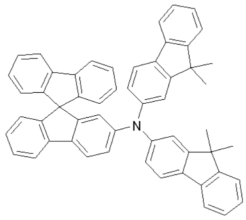 |
| 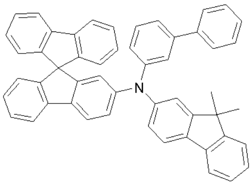 | 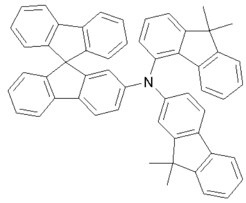 | 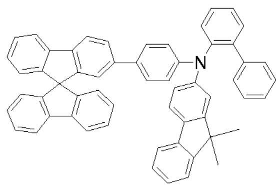 |
| 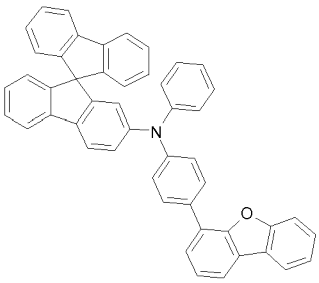 | 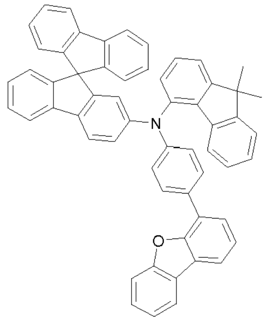 | 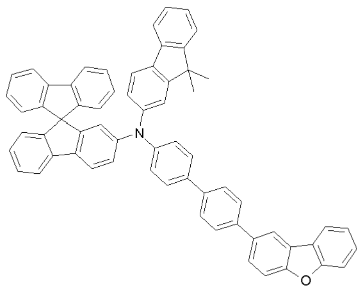 |
| 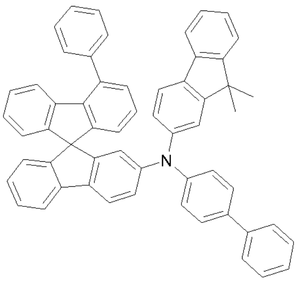 | 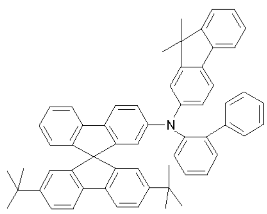 | 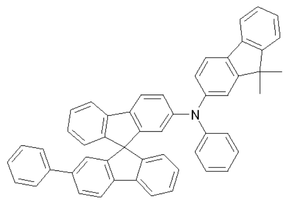 |
| 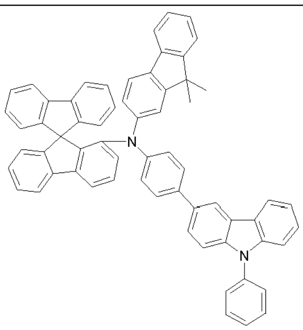 | 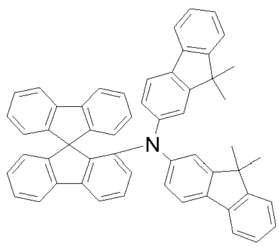 | 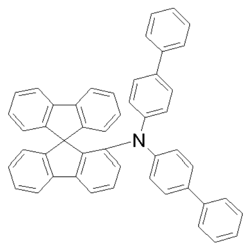 |

| | | |
|---|---|---|
| 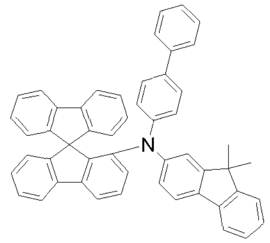 | 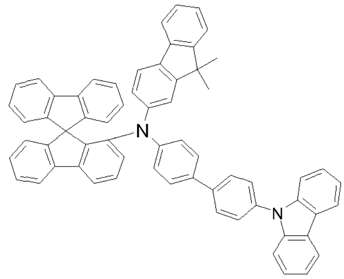 | 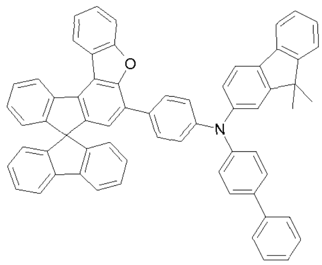 |
| 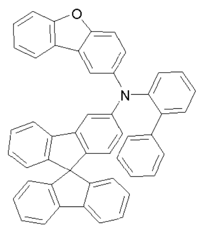 | 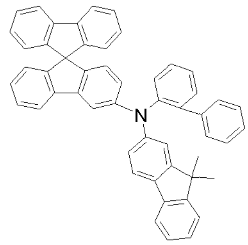 | 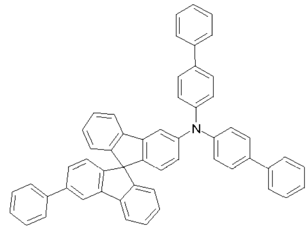 |
| 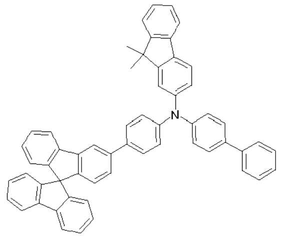 | 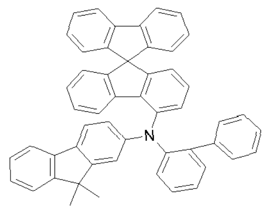 | 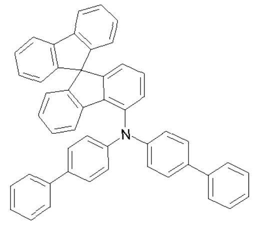 |
| 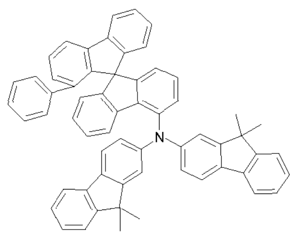 | 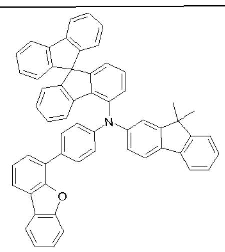 | 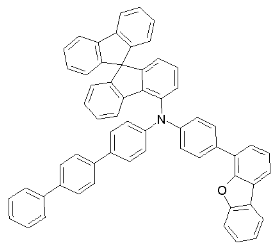 |
| 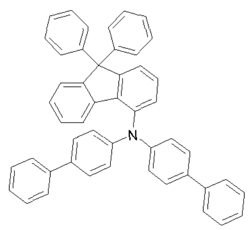 | 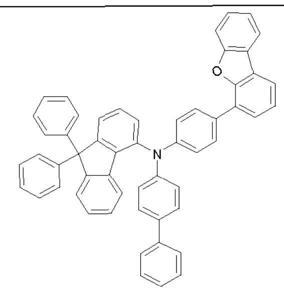 | 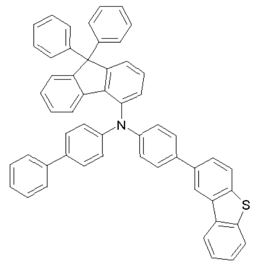 |
| 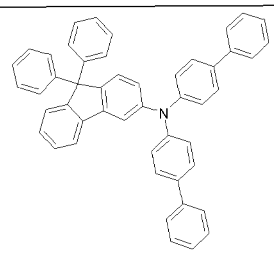 | 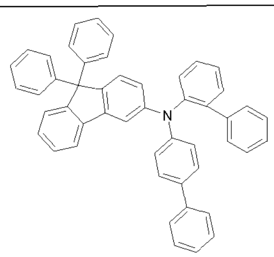 | 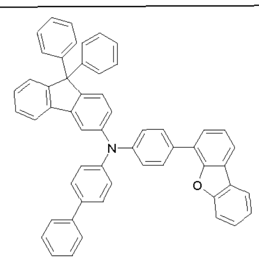 |

| | | |
|---|---|---|
| 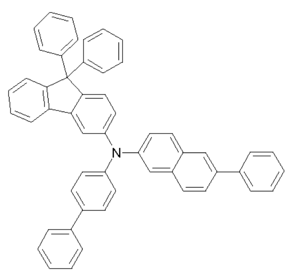 | 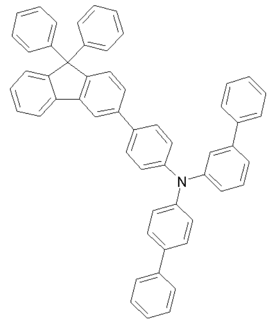 | 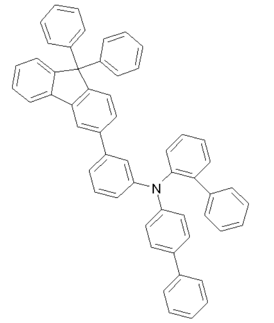 |
| 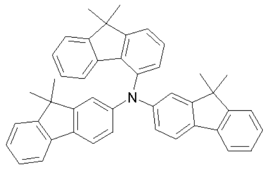 | 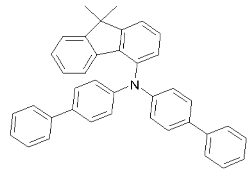 | 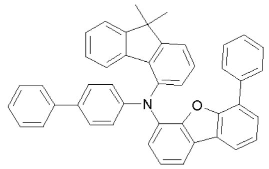 |
| 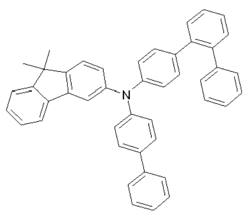 | 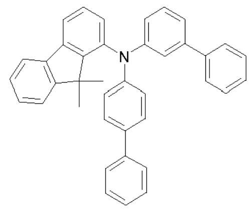 | 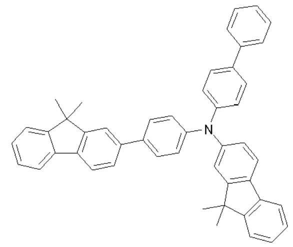 |
| 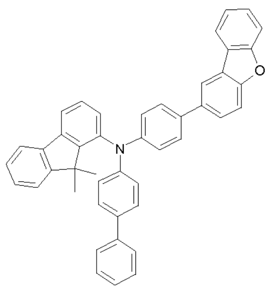 | 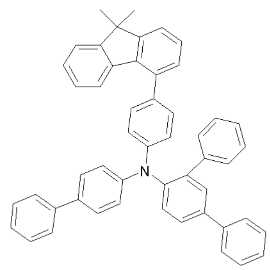 | 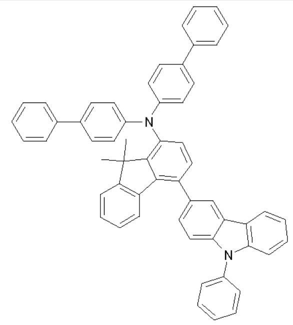 |
| 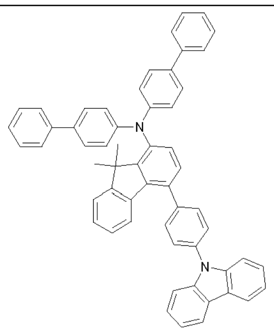 | 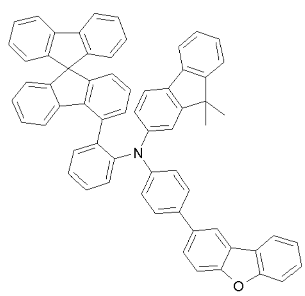 | 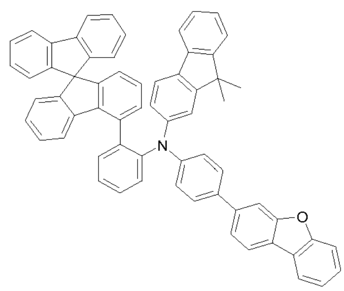 |

| | | |
|---|---|---|
| 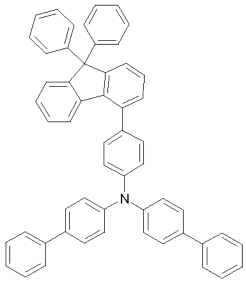 | 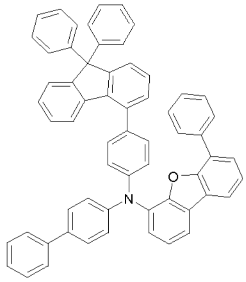 | |

Die erfindungsgemäße Vorrichtung enthält bevorzugt die folgenden Schichten zwischen Anode und Kathode:

- zwischen Anode und emittierender Schicht mindestens eine lochtransportierende Schicht;
- zwischen lochtransportierender Schicht und Kathode die emittierende Schicht; und
- zwischen emittierender Schicht und Kathode die Schicht E als Elektronentransportschicht.

Besonders bevorzugt enthält die erfindungsgemäße Vorrichtung die folgende Schichtenanordnung zwischen Anode und Kathode:

- direkt angrenzend an die Anode eine Lochinjektionsschicht;
- zwischen Lochinjektionsschicht und emittierender Schicht eine Lochtransportschicht, die bevorzugt p-dotiert ist;
- zwischen Lochtransportschicht und emittierender Schicht eine Elektronenblockierschicht;
- zwischen Elektronenblockierschicht und Kathode die emittierende Schicht;
- zwischen emittierender Schicht und Kathode, bevorzugt direkt an die emittierende Schicht angrenzend, eine Lochblockierschicht (HBL);
- zwischen Lochblockierschicht und Kathode die Schicht E als Elektronentransportschicht;
- zwischen der Schicht E und der Kathode, bevorzugt direkt an die Kathode angrenzend, eine Elektroneninjektionsschicht.

Insbesondere ist es bevorzugt, dass die elektronische Vorrichtung eine Lochblockierschicht enthält. Gemäß einer bevorzugten Ausführungsform kann die Schicht E eine Lochblockierschicht sein. Bevorzugt enthält die Lochblockierschicht eine Verbindung der Formel (E-1). Besonders bevorzugt sind in diesem Fall in der Verbindung der Formel (E-1) genau eine oder zwei Gruppen V gleich N, und die restlichen Gruppen V sind gleich $CR^4$. Ganz besonders bevorzugt sind zwei Gruppen V gleich N, und die restlichen Gruppen V sind gleich $CR^4$. Am stärksten bevorzugt ist in diesem Fall die Gruppe

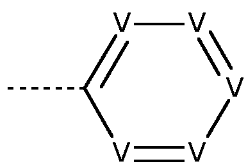

in Formel (E-1) gleich Pyrimidin, das mit Resten $R^4$ substituiert ist.

Kathodenseitig von der emittierenden Schicht enthält die Vorrichtung bevorzugt eine oder mehrere elektronentransportierende Schichten, von denen eine die Schicht E ist. Bevorzugt enthält die elektronische Vorrichtung die Schicht E als Elektronentransportschicht und kathodenseitig davon eine Elektroneninjektionsschicht. Zwischen der emittierenden Schicht und der Elektronentransportschicht liegt bevorzugt eine Lochblockierschicht vor. Besonders bevorzugt liegen daher zwischen der emittierenden Schicht und der Kathode, in dieser Reihenfolge, von der emittierenden Schicht aus gesehen, die folgenden Schichten vor: Lochblockierschicht, bevorzugt direkt an die emittierende Schicht angrenzend; Schicht E; Elektroneninjektionsschicht, bevorzugt direkt an die Kathode angrenzend.

Es ist bevorzugt, dass die elektronische Vorrichtung eine Elektronentransportschicht enthält, die eine Mischung enthaltend zwei oder mehr, bevorzugt zwei, Materialien enthält. Bevorzugt ist eines der Materialien ein Alkalimetallsalz, besonders bevorzugt ein Lithiumsalz. Das Alkalimetallsalz ist bevorzugt ein Salz mit einem organischen Anion, besonders bevorzugt 8-Hydroxychinolinat. Ganz besonders bevorzugt ist eines der Materialien Lithium-8-Hydroxychinolinat (LiQ). Das andere der Materialien ist bevorzugt gewählt aus organischen Verbindungen enthaltend einen elektronenarmen

stickstoffhaltigen Heteroaromaten, insbesondere Triazin, Pyrimidin und Benzimidazol.

Geeignete Materialien, wie sie in der Elektroneninjektionsschicht, in der Elektronentransportschicht und/oder der Lochblockierschicht der erfindungsgemäßen Vorrichtung verwendet werden können, sind neben den erfindungsgemäßen Verbindungen beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Insbesondere können als Materialien für diese Schichten alle Materialien verwendet werden, die gemäß dem Stand der Technik zur Verwendung in diesen Schichten bekannt sind. Insbesondere eignen sich Aluminiumkomplexe, beispielsweise $Alq_3$, Zirkoniumkomplexe, beispielsweise $Zrq_4$, Lithiumkomplexe, beispielsweise Liq, Benzimidazolderivate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Explizite Beispiele für geeignete Verbindungen sind in der folgenden Tabelle gezeigt.

| | | |
|---|---|---|
| 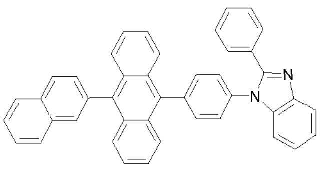 | 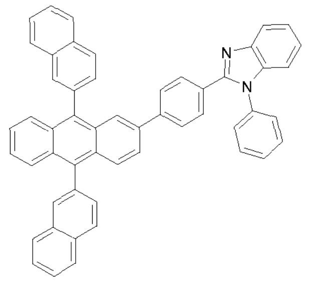 | 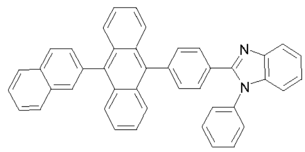 |
| 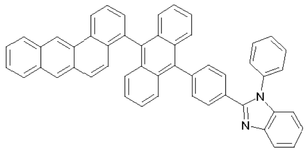 | 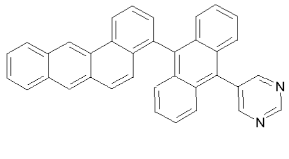 | 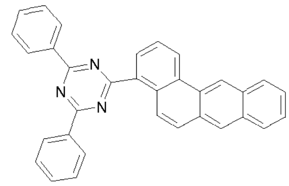 |
| 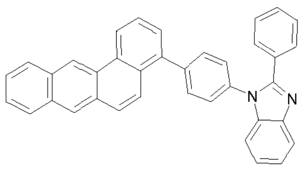 | 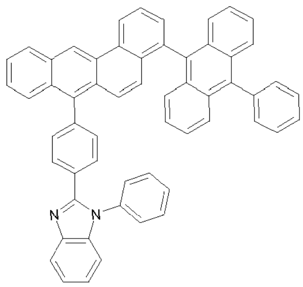 | 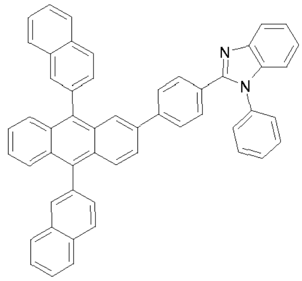 |
| 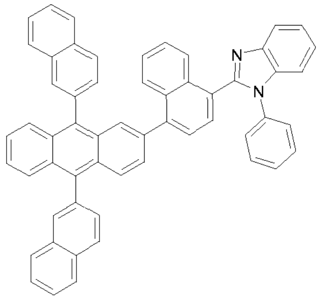 | 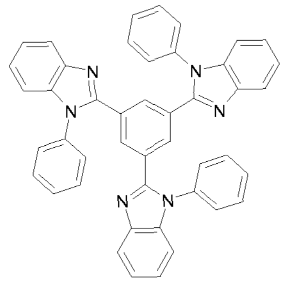 | 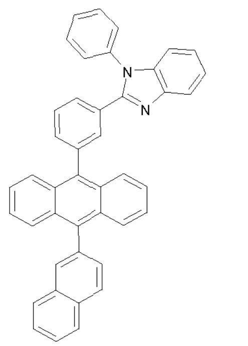 |
| 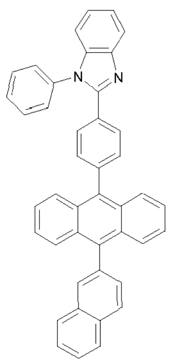 | 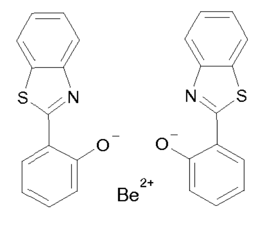 | 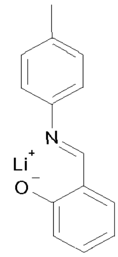 |

| | | |
|---|---|---|
| 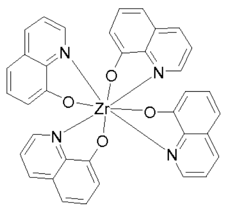 | 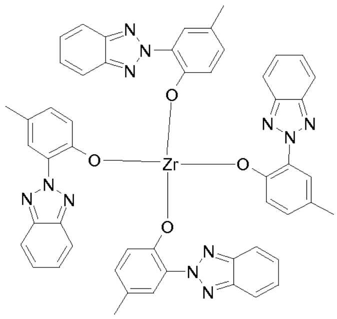 | 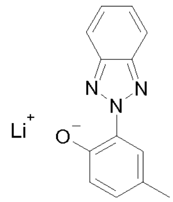 |
| 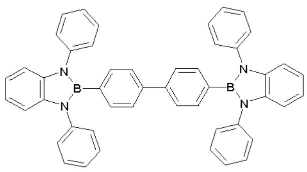 | 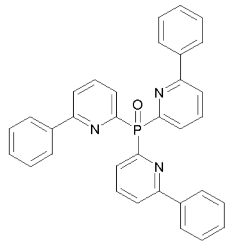 | 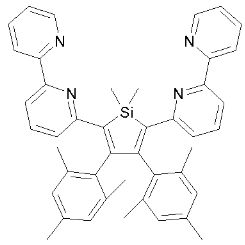 |
| 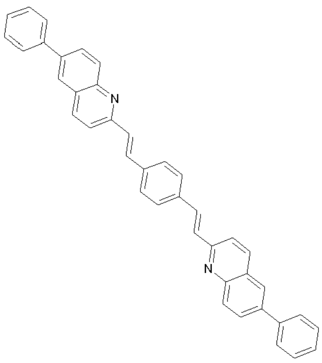 | 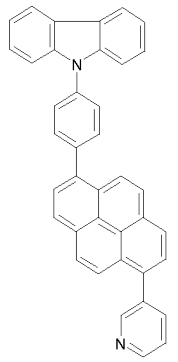 | 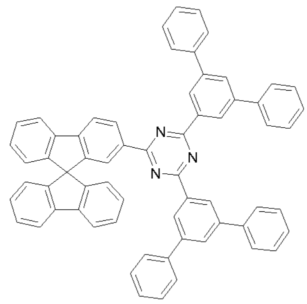 |
| 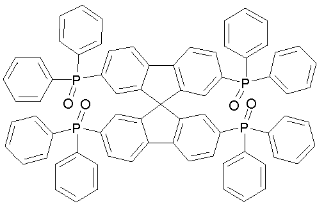 | 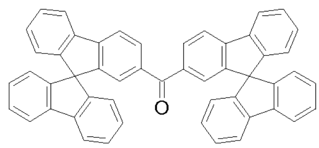 | 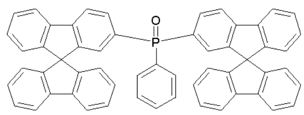 |
| 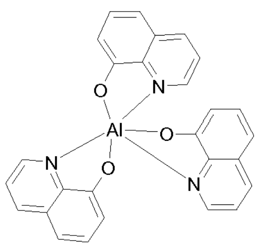 | | |

Die emittierende Schicht der Vorrichtung enthält neben der Verbindung der Formel (EM-1) bevorzugt eine oder mehrere weitere Verbindungen, bevorzugt genau eine weitere Verbindung. Die Verbindung der Formel (EM-1) stellt dabei die emittierende Verbindung dar, und die weitere Verbindung stellt dabei die Matrixverbindung dar. Die Verbindung der Formel (EM-1) ist dabei bevorzugt in einem Anteil von 0.5% bis 15%, bevorzugt 0.5% bis 10%, besonders bevorzugt 3%-6%, in der Schicht vorhanden. Die weitere Verbindung ist dabei bevorzugt in einem Anteil von 85% bis 99.5%, bevorzugt in einem Anteil von 90%-99.5% und besonders bevorzugt in einem Anteil von 94%-97% in der Schicht vorhanden.

Die weitere Verbindung ist bevorzugt gewählt aus Verbindungen, die als Matrixmaterialien für fluoreszierende Emitter im Stand der Technik bekannt sind, insbesondere Verbindungen ausgewählt aus den Klassen der Oligoarylene

(z. B. 2,2',7,7'-Tetraphenylspirobifluoren), insbesondere der Oligoarylene enthaltend kondensierte aromatische Gruppen, der Oligoarylenvinylene, der polypodalen Metallkomplexe, der lochleitenden Verbindungen, der elektronenleitenden Verbindungen, insbesondere Ketone, Phosphinoxide, und Sulfoxide; der Atropisomere, der Boronsäurederivate und der Benzanthracene. Besonders bevorzugte Matrixmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrixmaterialien sind ausgewählt aus den Klassen der Oligoarylene, enthaltend Anthracen, Benzanthracen, Benzphenanthren und/oder Pyren oder Atropisomere dieser Verbindungen. Am stärksten bevorzugt sind Anthracenderivate und Benzanthracenderivate. Unter einem Oligoarylen im Sinne dieser Erfindung wird eine Verbindung verstanden, in der mindestens drei Aryl- bzw. Arylengruppen aneinander gebunden sind.

Die Verbindung der Formel (EM-1) ist bevorzugt eine fluoreszierende Verbindung. Bevorzugt emittiert sie blaues Licht.

Die Verbindung kann auch nach dem Mechanismus der thermisch aktivierten verzögerten Fluoreszenz (TADF) Licht emittieren, ebenfalls bevorzugt blaues Licht. In diesem Fall ist es bevorzugt, dass für LUMO(EM), also das LUMO-Energieniveau der emittierenden Verbindung der Formel (EM-1), und HOMO(Matrix), also das HOMO-Energieniveau des Matrixmaterials, gilt:

$$\text{LUMO(EM)} - \text{HOMO(Matrix)} > S_1\text{(EM)} - 0.4\ \text{eV};$$

besonders bevorzugt:

$$\text{LUMO(EM)} - \text{HOMO(Matrix)} > S_1\text{(EM)} - 0.3\ \text{eV};$$

und ganz besonders bevorzugt:

$$\text{LUMO(E)} - \text{HOMO(Matrix)} > S_1\text{(EM)} - 0.2\ \text{eV}.$$

Dabei ist $S_1$(EM) die Energie des ersten angeregten Singulettzustands der Verbindung der Formel (EM-1).

Es ist weiterhin bevorzugt, dass die Energie des $T_1$-Zustands des Matrixmaterials der emittierenden Schicht, im Folgenden bezeichnet als $T_1$(Matrix), höchstens 0.1 eV niedriger ist als die Energie des $T_1$-Zustands der Verbindung der Formel (EM-1), im Folgenden bezeichnet als $T_1$(EM). Besonders bevorzugt ist $T_1(\text{Matrix}) \geq T_1(\text{EM})$. Ganz besonders bevorzugt gilt: $T_1(\text{Matrix}) - T_1(\text{EM}) \geq 0.1$ eV, am stärksten bevorzugt Ti(Matrix) - $T_1(\text{EM}) \geq 0.2$ eV.

Beispiele für geeignete Matrixmaterialien in der emittierenden Schicht sind im Fall von Emission der Verbindung der Formel (EM-1) nach dem TADF-Mechanismus Ketone, Phosphinoxide, Sulfoxide und Sulfone, Triarylamine, Carbazolderivate, z. B. CBP (N,N-Biscarbazolylbiphenyl), oder m-CBP, Indolocarbazolderivate, Indenocarbazolderivate, Azacarbazole, bipolare Matrixmaterialien, Silane, Azaborole oder Boronester, Diazasilolderivate, Diazaphospholderivate, Triazinderivate, Zinkkomplexe, oder verbrückte Carbazolderivate.

Bevorzugt sind für diese Verwendung weiterhin elektronentransportierende organische Verbindungen. Besonders bevorzugt sind elektronentransportierende organische Verbindungen, die ein LUMO-Energieniveau von höchstens -2.50 eV aufweisen, besonders bevorzugt höchstens -2.60 eV, ganz besonders bevorzugt höchstens -2.65 eV, und am stärksten bevorzugt höchstens -2.70 eV.

Besonders bevorzugte Matrixmaterialien in der emittierenden Schicht sind im Fall von Emission der Verbindung der Formel (EM-1) nach dem TADF-Mechanismus ausgewählt aus den Stoffklassen der Triazine, der Pyrimidine, der Lactame, der Metallkomplexe, insbesondere der Be-, Zn- bzw. Al-Komplexe, der aromatischen Ketone, der aromatischen Phosphinoxide, der Azaphosphole, der Azaborole, welche mit mindestens einem elektronenleitenden Substituenten substituiert sind, der Chinoxaline, der Chinoline und der Isochinoline.

Bevorzugt emittiert die emittierende Schicht der Vorrichtung blaues Licht.

Gemäß einer bevorzugten Ausführungsform der Erfindung enthält die Vorrichtung zwei oder drei, bevorzugt drei, gleiche oder verschiedene Schichtenabfolgen übereinander gestapelt, wobei jede der Schichtenabfolgen jeweils die folgenden Schichten umfasst: Lochinjektionsschicht, Lochtransportschicht, Elektronenblockierschicht, emittierende Schicht, und Elektronentransportschicht, und wobei wenigstens eine der Schichtabfolgen

- eine emittierende Schicht, enthaltend eine Verbindung der Formel (EM-1), und
- eine Schicht E, bevorzugt als Elektronentransportschicht, enthält.

Bevorzugt enthalten alle der zwei oder drei Schichtabfolgen

- eine emittierende Schicht, enthaltend eine Verbindung der Formel (EM-1),
- eine Schicht E, bevorzugt als Elektronentransportschicht.

Bevorzugt emittieren alle der zwei oder drei Schichtabfolgen blaues Licht.
Weiterhin ist es bevorzugt, dass alle der zwei oder drei Schichtabfolgen eine emittierende Schicht enthalten, die eine Verbindung der Formel (EM-1) enthält.
Zwischen den Schichtabfolgen ist bevorzugt jeweils eine Doppelschicht aus aneinandergrenzender n-CGL und p-CGL angeordnet, wobei die n-CGL anodenseitig angeordnet ist und die p-CGL entsprechend kathodenseitig.
CGL steht dabei für charge generation layer, also Ladungserzeugungsschicht. Materialien zur Verwendung in derartigen Schichten sind dem Fachmann bekannt. Bevorzugt wird in der p-CGL ein p-dotiertes Amin verwendet, besonders bevorzugt ein Material, das gewählt ist aus den oben genannten bevorzugten Strukturklassen von Lochtransportmaterialien.
Gemäß einer bevorzugten Ausführungsform der Erfindung emittiert die Vorrichtung Licht durch die Anode und die Substratschicht (bottom emission).
Gemäß einer alternativen, ebenfalls bevorzugten Ausführungsform der Erfindung, emittiert die Vorrichtung Licht durch die Kathode hindurch (top emission). In dieser Ausführungsform ist die Kathode teiltransparent und teilreflektiv ausgestaltet. Hierzu kann beispielsweise eine Legierung aus Ag und Mg als Kathode verwendet werden. Die Anode ist in dieser Ausführungsform stark reflektierend. Weiterhin enthält die Vorrichtung in diesem Fall bevorzugt eine Auskopplungsschicht, die auf die Kathode aufgebracht ist, und die bevorzugt eine Aminverbindung enthält. Die Schichtdicken sind in dieser Ausführungsform an die verwendeten Materialien anzupassen, insbesondere an den Brechungsindex der Schichten und an die Lage der Rekombinationszone in der emittierenden Schicht, um einen optimalen Resonanzeffekt zu erzielen.
In der Ausführungsform mit Top-Emission können eine hervorragende Effizienz der OLED, kombiniert mit einer schmalen Emissionsbande, erzielt werden.
Die Vorrichtung kann nach Auftragen der Schichten strukturiert, kontaktiert und schließlich versiegelt werden, um schädigende Effekte von Wasser und Luft auszuschließen.
In einer bevorzugten Ausführungsform ist die Vorrichtung dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.
Weiterhin bevorzugt ist, dass eine oder mehrere Schichten der Vorrichtung mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).
Weiterhin bevorzugt ist, dass eine oder mehrere Schichten der Vorrichtung aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden.
Weiterhin bevorzugt ist es, dass zur Herstellung der Vorrichtung eine oder mehrere Schichten aus Lösung und eine oder mehrere Schichten durch ein Sublimationsverfahren aufgetragen werden.
Ein Verfahren zur Herstellung der Vorrichtung umfasst zunächst die Bereitstellung eines Substrats mit Anode, in einem später folgenden Schritt das Aufbringen der emittierenden Schicht enthaltend die Verbindung der Formel (EM-1), in einem dann folgenden Schritt das Aufbringen der Schicht E, und in einem dann folgenden Schritt das Aufbringen der Anode. Bevorzugt werden die emittierende Schicht und die Schicht E aus der Gasphase aufgebracht. Besonders bevorzugt werden alle Schichten zwischen Anode und Kathode der Vorrichtung aus der Gasphase aufgebracht.
Die erfindungsgemäßen Vorrichtungen werden bevorzugt in Displays, als Lichtquellen in Beleuchtungsanwendungen sowie als Lichtquellen in medizinischen und/oder kosmetischen Anwendungen eingesetzt.

## Beispiele

A) Allgemeines Herstellungsverfahren für die OLEDs und Charakterisierung der OLEDs

Glasplättchen, die mit strukturiertem ITO (Indium-Zinn-Oxid) der Dicke 50 nm beschichtet sind, bilden die Substrate, auf welche die OLEDs aufgebracht werden.
Die OLEDs haben den folgenden Schichtaufbau: Substrat / Lochinjektionsschicht (HIL) / Lochtransportschicht

(HTL) / Elektronenblockierschicht (EBL) / Emissionsschicht (EML) / optionale Lochblockierschicht (HBL) / Elektronentransportschicht (ETL) / Elektroneninjektionsschicht (EIL) und abschließend eine Kathode. Die Kathode wird durch eine 100 nm dicke Aluminiumschicht gebildet. Der genaue Aufbau der OLEDs ist den folgenden Tabellen zu entnehmen. Die in den einzelnen Schichten der OLED vorhandenen Materialien sind in einer folgenden Tabelle gezeigt.

Alle Materialien werden in einer Vakuumkammer thermisch aufgedampft. Dabei besteht die Emissionsschicht aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie H:SEB (95%:5%) bedeutet hierbei, dass das Material H in einem Volumenanteil von 95% und das Material SEB in einem Volumenanteil von 5% in der Schicht vorliegt. Analog besteht auch die Elektronentransportschicht und die Lochinjektionsschicht aus einer Mischung von zwei Materialien.

Die OLEDs werden standardmäßig charakterisiert. Hierfür werden die Betriebsspannung und die externe Quanteneffizienz (EQE, gemessen in %) in Abhängigkeit der Leuchtdichte, berechnet aus Strom-Spannungs-Leuchtdichte-Kennlinien unter Annahme einer lambertschen Abstrahlcharakteristik bestimmt. Die Angabe EQE @ 10mA/$cm^2$ bezeichnet die externe Quanteneffizienz, die bei 10mA/$cm^2$ erreicht wird. Die Angabe U @ 10 mA/$cm^2$ bezeichnet die Betriebsspannung bei 10 mA/$cm^2$.

B) Leistungsdaten von erfindungsgemäßen OLEDs mit Bottom-Emission-Aufbau und Verbindung der Formel (E-1) in der ETL

Es werden OLEDs hergestellt, die in der Elektronentransportschicht eine Verbindung gewählt aus Verbindungen ETM1 - ETM17 enthalten:

| *Bsp.* | *HIL* | *HTL* | *EBL* | *EML* | *ETL* | *EIL* |
|---|---|---|---|---|---|---|
| | Dicke / nm | Dicke / nm | Dicke / nm | Dicke / nm | Dicke / nm | Dicke / nm |
| E1 | HTM: p-Dotand (5%) 20 nm | HTM 180 nm | EBM 10 nm | H:SEB(5%) 20 nm | ETM1:LiQ(50%) 30 nm | LiQ 1 nm |
| E2 | HTM: p-Dotand (5%) 20 nm | HTM 180 nm | EBM 10 nm | H:SEB(5%) 20 nm | ETM2:LiQ(50%) 30 nm | LiQ 1 nm |
| E3 | HTM: p-Dotand (5%) 20 nm | HTM 180 nm | EBM 10 nm | H:SEB(5%) 20 nm | ETM3:LiQ(50%) 30 nm | LiQ 1 nm |
| E4 | HTM: p-Dotand (5%) 20 nm | HTM 180 nm | EBM 10 nm | H:SEB(5%) 20 nm | ETM4:LiQ(50%) 30 nm | LiQ 1 nm |
| E5 | HTM: p-Dotand (5%) 20 nm | HTM 180 nm | EBM 10 nm | H:SEB(5%) 20 nm | ETM5:LiQ(50%) 30 nm | LiQ 1 nm |
| E6 | HTM: p-Dotand (5%) 20 nm | HTM 180 nm | EBM 10 nm | H:SEB(5%) 20 nm | ETM6:LiQ(50%) 30 nm | LiQ 1 nm |
| E7 | HTM: p-Dotand (5%) 20 nm | HTM 180 nm | EBM 10 nm | H:SEB(5%) 20 nm | ETM7:LiQ(50%) 30 nm | LiQ 1 nm |
| E8 | HTM: p-Dotand (5%) 20 nm | HTM 180 nm | EBM 10 nm | H:SEB(5%) 20 nm | ETM8:LiQ(50%) 30 nm | LiQ 1 nm |
| E9 | HTM: p-Dotand (5%) 20 nm | HTM 180 nm | EBM 10 nm | H:SEB(5%) 20 nm | ETM9:LiQ(50%) 30 nm | LiQ 1 nm |
| E10 | HTM: p-Dotand (5%) 20 nm | HTM 180 nm | EBM 10 nm | H:SEB(5%) 20 nm | ETM 10:LiQ(50%) 30 nm | LiQ 1 nm |
| E11 | HTM: p-Dotand (5%) 20 nm | HTM 180 nm | EBM 10 nm | H:SEB(5%) 20 nm | ETM11:LiQ(50%) 30 nm | LiQ 1 nm |
| E12 | HTM: p-Dotand (5%) 20 nm | HTM 180 nm | EBM 10 nm | H:SEB(5%) 20 nm | ETM 12:LiQ(50%) 30 nm | LiQ 1 nm |
| E13 | HTM: p-Dotand (5%) 20 nm | HTM 180 nm | EBM 10 nm | H:SEB(5%) 20 nm | ETM 13:LiQ(50%) 30 nm | LiQ 1 nm |

(fortgesetzt)

| Bsp. | HIL | HTL | EBL | EML | ETL | EIL |
|---|---|---|---|---|---|---|
| | Dicke / nm | Dicke / nm | Dicke / nm | Dicke / nm | Dicke / nm | Dicke / nm |
| E14 | HTM: p-Dotand (5%) 20 nm | HTM 180 nm | EBM 10 nm | H:SEB(5%) 20 nm | ETM14:LiQ(50%) 30 nm | LiQ 1 nm |
| E15 | HTM: p-Dotand (5%) 20 nm | HTM 180 nm | EBM 10 nm | H:SEB(5%) 20 nm | ETM 15:LiQ(50%) 30 nm | LiQ 1 nm |
| E16 | HTM: p-Dotand (5%) 20 nm | HTM 180 nm | EBM 10 nm | H:SEB(5%) 20 nm | ETM 16:LiQ(50%) 30 nm | LiQ 1 nm |
| E17 | HTM: p-Dotand (5%) 20 nm | HTM 180 nm | EBM 10 nm | H:SEB(5%) 20 nm | ETM 17:LiQ(50%) 30 nm | LiQ 1 nm |

Mit diesen OLEDs können die folgenden Leistungsdaten erhalten werden:

| **Bsp.** | **U @ 10 mA/cm$^2$ (V)** | **EQE @ 10 mA/cm$^2$ (%)** |
|---|---|---|
| E1 | 4.0 | 8.9 |
| E2 | 3.9 | 9.3 |
| E3 | 3.8 | 9.7 |
| E4 | 3.8 | 9.3 |
| E5 | 3.9 | 9.9 |
| E6 | 3.8 | 9.8 |
| E7 | 4.0 | 8.5 |
| E8 | 3.8 | 9.7 |
| E9 | 4.1 | 9.1 |
| E10 | 3.9 | 8.9 |
| E11 | 3.9 | 9.5 |
| E12 | 4.1 | 9.7 |
| E13 | 4.1 | 8.9 |
| E14 | 4.2 | 8.8 |
| E15 | 3.8 | 9.4 |
| E16 | 3.8 | 9.2 |
| E17 | 3.9 | 9.4 |

Alle OLEDs E1 bis E17 zeigen sehr hohe Werte für die Effizienz, bei niedriger Betriebsspannung.

B) Vergleich der Leistungsdaten zwischen erfindungsgemäßen OLEDs und OLEDs enthaltend die Verbindung SdT in der emittierenden Schicht

Zusätzlich zu den oben gezeigten OLEDs E1 und E9 werden OLEDs hergestellt, die in der emittierenden Schicht statt des Emitters SEB den Emitter SdT enthalten:

| Bsp. | HIL | HTL | EBL | EML | ETL | EIL |
|---|---|---|---|---|---|---|
| | Dicke / nm | Dicke / nm | Dicke / nm | Dicke / nm | Dicke / nm | Dicke / nm |
| V1 | HTM: p-Dotand (5%) 20 nm | HTM 180 nm | EBM 10 nm | H:SdT(5%) 20 nm | ETM1:LiQ(50%) 30 nm | LiQ 1 nm |
| E1 | HTM: p-Dotand (5%) 20 nm | HTM 180 nm | EBM 10 nm | H:SEB(5%) 20 nm | ETM1:LiQ(50%) 30 nm | LiQ 1 nm |
| V2 | HTM: p-Dotand (5%) 20 nm | HTM 180 nm | EBM 10 nm | H:SdT(5%) 20 nm | ETM9:LiQ(50%) 30 nm | LiQ 1 nm |
| E9 | HTM: p-Dotand (5%) 20 nm | HTM 180 nm | EBM 10 nm | H:SEB(5%) 20 nm | ETM9:LiQ(50%) 30 nm | LiQ 1 nm |

Dabei werden die folgenden Ergebnisse erhalten:

| Bsp. | U @ 10 mA/cm$^2$ (V) | EQE @ 10 mA/cm$^2$ (%) |
|---|---|---|
| V1 | 4.3 | 7.2 |
| E1 | 4.0 | 8.9 |
| V2 | 4.4 | 7.6 |
| E9 | 4.1 | 9.1 |

Die Ergebnisse zeigen, dass in beiden Fällen, d.h. mit der elektronentransportierenden Verbindung ETM1 und der elektronentransportierenden Verbindung ETM9 in der ETM, für die erfindungsgemäßen OLEDs deutlich bessere Ergebnisse für EQE und Betriebsspannung erhalten werden, als für die OLEDs enthaltend die Verbindung SdT in der emittierenden Schicht.

D) Leistungsdaten von erfindungsgemäßen OLEDs mit Bottom-Emission-Aufbau und Verbindung der Formel (E-1) in der HBL

Es werden OLEDs hergestellt, die in der Lochblockierschicht (HBL) eine Verbindung gewählt aus Verbindungen ETM18 und ETM19 enthalten, und in der ETL die Verbindung ETM1 enthalten. Zusätzlich wird eine Vergleichs-OLED hergestellt (V3), die identisch zur OLED E18 aufgebaut ist, mit dem einzigen Unterschied, dass sie die Verbindung SdT als Emitter in der emittierenden Schicht enthält, und nicht die Verbindung SEB:

| Bsp. | HIL | HTL | EBL | EML | HBL | ETL | EIL |
|---|---|---|---|---|---|---|---|
| | Dicke / nm | Dicke / nm | Dicke / nm | Dicke / nm | Dicke / nm | Dicke / nm | Dicke / nm |
| V3 | HTM: p-Dotand (5%) 20 nm | HTM 180 nm | EBM 10 nm | H:SdT(5%)20 nm | ETM18 10 nm | ETM1:LiQ(50%) 20 nm | LiQ 1 nm |
| E18 | HTM: p-Dotand (5%) 20 nm | HTM 180 nm | EBM 10 nm | H:SEB(5%) 20 nm | ETM18 10 nm | ETM1:LiQ(50%) 20 nm | LiQ 1 nm |
| E19 | HTM: p-Dotand (5%) 20 nm | HTM 180 nm | EBM 10 nm | H:SEB(5%) 20 nm | ETM19 10 nm | ETM1:LiQ(50%) 20 nm | LiQ 1 nm |

Mit diesen OLEDs können die folgenden Leistungsdaten erhalten werden:

| Bsp. | U @ 10 mA/cm$^2$ (V) | EQE @ 10 mA/cm$^2$ (%) |
|---|---|---|
| V3 | 4.2 | 6.7 |
| E18 | 3.9 | 8.3 |

(fortgesetzt)

| Bsp. | U @ 10 mA/cm² (V) | EQE @ 10 mA/cm² (%) |
|---|---|---|
| E19 | 4.0 | 8.5 |

Die erfindungsgemäßen OLEDs, die die Verbindung ETM18 bzw. ETM19 in der HBL enthalten, weisen sehr hohe Werte für die Effizienz auf, bei niedriger Betriebsspannung.

Bei der Vergleichs-OLED V3, die die Verbindung SdT als Emitter in der emittierenden Schicht enthält, anstelle der Verbindung SEB, sind die entsprechenden Leistungsdaten deutlich schlechter.

E) Verwendung der erfindungsgemäßen Verbindungen in der ETL von blau fluoreszierenden Devices mit Top-Emission-Aufbau

Es werden OLEDs mit dem folgenden Aufbau hergestellt:
Substrat / HIL / HTL / EBL / EML / ETL / EIL / Kathode / Auskopplungsschicht.

Dabei ist das Substrat jeweils ein Glasplättchen, das mit strukturiertem ITO (Indium-Zinn-Oxid) der Dicke 50 nm beschichtet ist. Die Kathode besteht aus einer 15 nm dicken Schicht aus einer Mischung aus 91% Ag und 9% Mg. Die Auskopplungsschicht besteht aus einer 70 nm dicken Schicht aus der Verbindung HTM. Der Aufbau der Schichten HIL, HTL, EBL, EML, ETL und EIL ist in der folgenden Tabelle gezeigt:

| Bsp. | HIL | HTL | EBL | EML | ETL | EIL |
|---|---|---|---|---|---|---|
| | Dicke / nm | Dicke / nm | Dicke / nm | Dicke / nm | Dicke / nm | Dicke / nm |
| E20 | HTM : p-Dotand (5%) 10 nm | HTM 118 nm | EBM 15 nm | H:SEB(4%) 20 nm | ETM1 : LiQ(50%) 30 nm | Yb:LiF(50%) 2 nm |

Die OLED E20, die die Verbindung ETM1 in der ETL enthält, weist Farbkoordinaten CIE x,y = 0.14, 0.05 auf. Sie erreicht eine sehr hohe EQE bei 10 mA/cm² von 16%-19%. Die Emissionsbande der OLEDs ist sehr schmal und hat eine Halbwertsbreite zwischen 17 und 18 nm.

Weiterhin können die folgenden OLEDs mit top-emission-Aufbau hergestellt werden, in denen verglichen mit der OLED E20 das Material ETM-1 gegen eines der Materialien ETM-2 bis ETM-17 ausgetauscht ist:

| Bsp. | HIL | HTL | EBL | EML | ETL | EIL |
|---|---|---|---|---|---|---|
| E21 | HTM : p-Dotand (5%) | HTM | EBM | H:SEB(4%) | ETM-2 : LiQ (50%) | Yb : LiF(50%) |
| E22 | HTM : p-Dotand (5%) | HTM | EBM | H:SEB(4%) | ETM-3 : LiQ (50%) | Yb : LiF(50%) |
| E23 | HTM : p-Dotand (5%) | HTM | EBM | H:SEB(4%) | ETM-4 : LiQ (50%) | Yb : LiF(50%) |
| E24 | HTM : p-Dotand (5%) | HTM | EBM | H:SEB(4%) | ETM-5 : LiQ (50%) | Yb : LiF(50%) |
| E25 | HTM : p-Dotand (5%) | HTM | EBM | H:SEB(4%) | ETM-6 : LiQ (50%) | Yb : LiF(50%) |
| E26 | HTM : p-Dotand (5%) | HTM | EBM | H:SEB(4%) | ETM-7 : LiQ (50%) | Yb : LiF(50%) |
| E27 | HTM : p-Dotand (5%) | HTM | EBM | H:SEB(4%) | ETM-8 : LiQ (50%) | Yb : LiF(50%) |
| E28 | HTM : p-Dotand (5%) | HTM | EBM | H:SEB(4%) | ETM-9 : LiQ (50%) | Yb : LiF(50%) |
| E29 | HTM : p-Dotand (5%) | HTM | EBM | H:SEB(4%) | ETM-10 : LiQ (50%) | Yb : LiF(50%) |
| E30 | HTM : p-Dotand (5%) | HTM | EBM | H:SEB(4%) | ETM-11 : LiQ (50%) | Yb : LiF(50%) |
| E31 | HTM : p-Dotand (5%) | HTM | EBM | H:SEB(4%) | ETM-12 : LiQ (50%) | Yb : LiF(50%) |
| E32 | HTM : p-Dotand (5%) | HTM | EBM | H:SEB(4%) | ETM-13 : LiQ (50%) | Yb : LiF(50%) |
| E33 | HTM : p-Dotand (5%) | HTM | EBM | H:SEB(4%) | ETM-14 : LiQ (50%) | Yb : LiF(50%) |
| E34 | HTM : p-Dotand (5%) | HTM | EBM | H:SEB(4%) | ETM-15 : LiQ (50%) | Yb : LiF(50%) |
| E35 | HTM : p-Dotand (5%) | HTM | EBM | H:SEB(4%) | ETM-16 : LiQ (50%) | Yb : LiF(50%) |

(fortgesetzt)

| Bsp. | HIL | HTL | EBL | EML | ETL | EIL |
|---|---|---|---|---|---|---|
| E36 | HTM : p-Dotand (5%) | HTM | EBM | H:SEB(4%) | ETM-17 : LiQ (50%) | Yb : LiF(50%) |

Dabei können OLEDs erhalten werden, die Farbkoordinaten CIE x,y = 0.14, 0.05 aufweisen. Nach Anpassung der Schichtdicken auf die verwendete Materialkombination, um den Resonanzeffekt zu optimieren, können für diese OLEDs sehr hohe Werte für die EQE bei 10 mA/cm$^2$ von 16%-19% erreicht werden, und sehr geringe Halbwertsbreiten der Emissionsbande von 17 bis 18 nm.

| **Verwendete Verbindungen** | | |
|---|---|---|
| 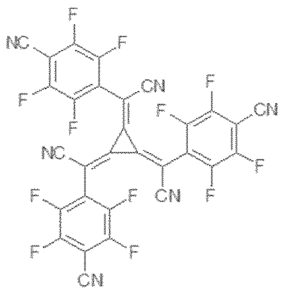 | 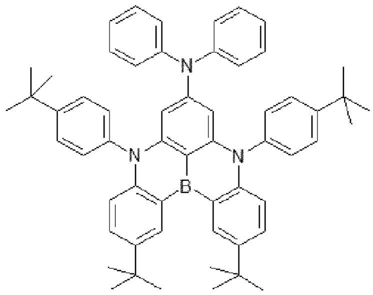 | 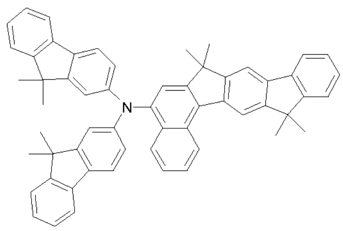 |
| p-Dotand | SEB | SdT |
| 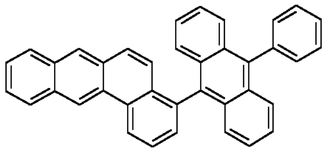 | 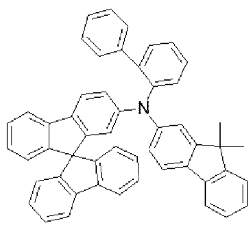 | 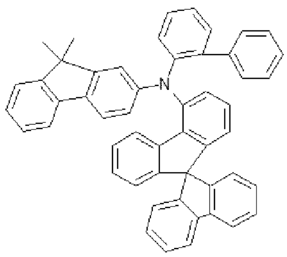 |
| H | HTM | EBM |
| 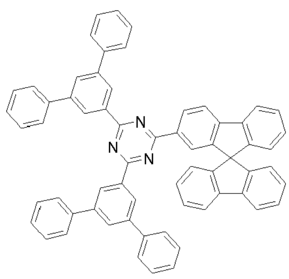 | 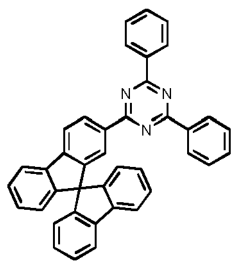 | 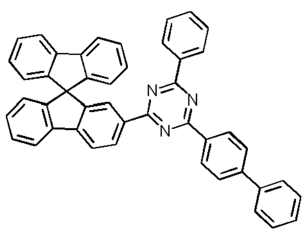 |
| ETM1 | ETM2 | ETM3 |
| 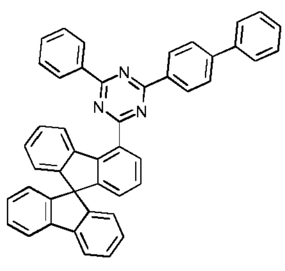 | 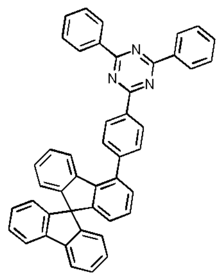 | 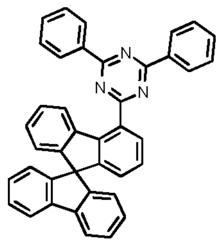 |
| ETM4 | ETM5 | ETM6 |

(fortgesetzt)

| **Verwendete Verbindungen** | | |
|---|---|---|
| 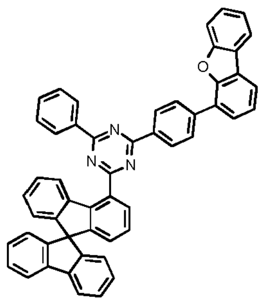 | 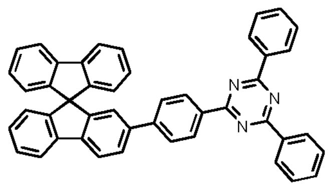 | 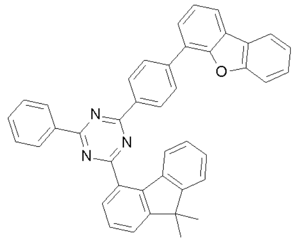 |
| ETM7 | ETM8 | ETM9 |
| 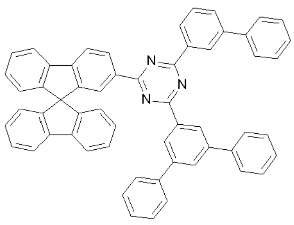 | 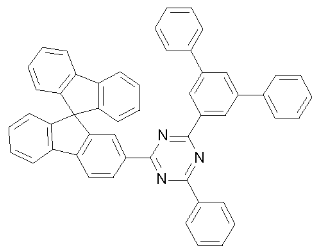 | 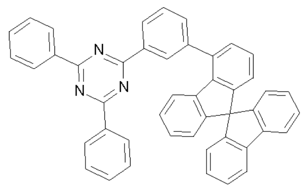 |
| ETM10 | ETM11 | ETM12 |
| 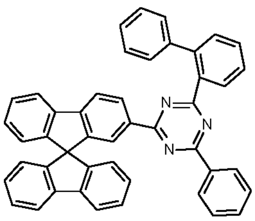 | 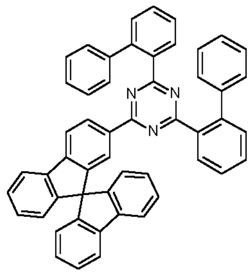 | 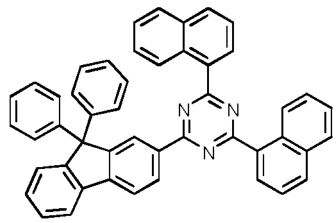 |
| ETM13 | ETM14 | ETM15 |
| 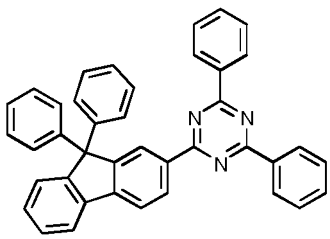 | 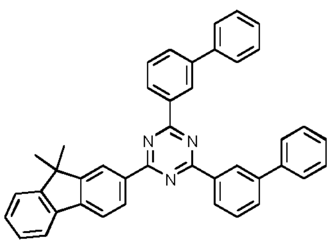 | 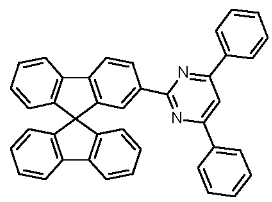 |
| ETM16 | ETM17 | ETM18 |
| 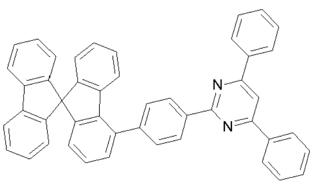 | 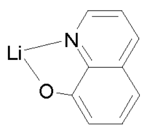 | |
| ETM19 | LiQ | |

## Patentansprüche

1. Elektronische Vorrichtung, enthaltend eine erste Elektrode, eine zweite Elektrode, und dazwischen angeordnet

- eine emittierende Schicht, enthaltend eine Verbindung einer Formel (EM-1),

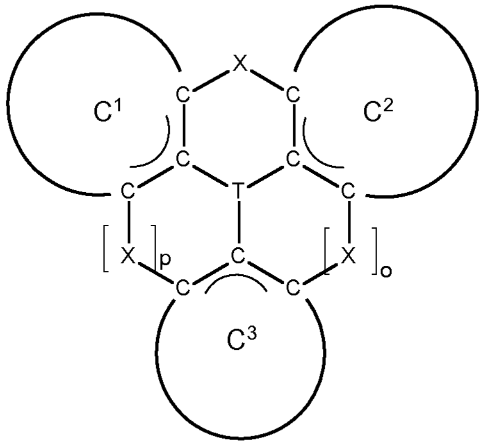

Formel (EM-1),

für die gilt:

T ist B, P, P(=O) oder $SiR^{E1}$;
X ist bei jedem Auftreten gleich oder verschieden gewählt aus O, S, $NR^{E2}$ und $C(R^{E2})_2$, wobei mindestens ein X vorhanden sein muss, das gewählt ist aus O, S und $NR^{E2}$;
$C^1$, $C^2$ und $C^3$ sind gleich oder verschieden gewählt aus Ringsystemen mit 5 bis 40 Ringatomen, die mit Resten $R^{E3}$ substituiert sind;
$R^{E1}$ ist gewählt aus H, D, F, Cl, Br, I, $C(=O)R^{E4}$, CN, $Si(R^{E4})_3$, $N(R^{E4})2$, $P(=O)(R^{E4})_2$, $OR^{E4}$, $S(=O)R^{E4}$, $S(=O)_2R^{E4}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit Resten $R^{E4}$ substituiert sind; und wobei eine oder mehrere $CH_2$-Gruppen in den genannten Alkyl-, Alkoxy-, Alkenyl- und Alkinylgruppen durch $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO oder $SO_2$ ersetzt sein können;
$R^{E2}$ ist bei jedem Auftreten gleich oder verschieden gewählt aus H, D, F, Cl, Br, I, $C(=O)R^{E4}$, CN, $Si(R^{E4})_3$, $N(R^{E4})2$, $P(=O)(R^{E4})_2$, $OR^{E4}$, $S(=O)R^{E4}$, $S(=O)_2R^{E4}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit Resten $R^{E4}$ substituiert sind; und wobei eine oder mehrere $CH_2$-Gruppen in den genannten Alkyl-, Alkoxy-, Alkenyl- und Alkinylgruppen durch $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO oder $SO_2$ ersetzt sein können; wobei zwei oder mehr Reste $R^{E2}$ miteinander verknüpft sein können und einen Ring bilden können, und wobei ein oder mehrere Reste $R^{E2}$ über ihre Reste $R^{E4}$ mit einem Ring gewählt aus $C^1$, $C^2$ und $C^3$ verknüpft sein können und einen Ring bilden können;
$R^{E3}$ ist bei jedem Auftreten gleich oder verschieden gewählt aus H, D, F, Cl, Br, I, $C(=O)R^{E4}$, CN, $Si(R^{E4})_3$, $N(R^{E4})2$, $P(=O)(R^{E4})_2$, $OR^{E4}$, $S(=O)R^{E4}$, $S(=O)_2R^{E4}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^{E3}$ miteinander verknüpft sein können und einen Ring bilden können; wobei die genannten Alkyl-,

Alkoxy-, Alkenyl- und Alkinylgruppen und die genannten aromatischen Ringsysteme und heteroaromatischen Ringsysteme jeweils mit Resten $R^{E4}$ substituiert sind; und wobei eine oder mehrere $CH_2$-Gruppen in den genannten Alkyl-, Alkoxy-, Alkenyl- und Alkinylgruppen durch $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO oder $SO_2$ ersetzt sein können;

$R^{E4}$ ist bei jedem Auftreten gleich oder verschieden gewählt aus H, D, F, Cl, Br, I, $C(=O)R^{E5}$, CN, $Si(R^{E5})_3$, $N(R^{E5})_2$, $P(=O)(R^{E5})_2$, $OR^{E5}$, $S(=O)R^{E5}$, $S(=O)_2R^{E5}$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^{E4}$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^{E5}$ substituiert sind; und wobei eine oder mehrere $CH_2$-Gruppen in den genannten Alkyl-, Alkoxy-, Alkenyl- und Alkinylgruppen durch $-R^{E5}C=CR^{E5}-$, -C=C-, $Si(R^{E5})_2$, C=O, $C=NR^{E5}$, -C(=O)O-, $-C(=O)NR^{E5}-$, $NR^{E5}$, $P(=O)(R^{E5})$, -O-, -S-, SO oder $SO_2$ ersetzt sein können;

$R^{E5}$ ist bei jedem Auftreten gleich oder verschieden gewählt aus H, D, F, Cl, Br, I, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^{E5}$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können;

o und p sind gleich oder verschieden 0 oder 1, wobei p=0 bzw. o = 0 bedeutet, dass die mit p bzw. o indizierte Gruppe X zusammen mit ihren Bindungen an die Ringe $C^1$, $C^2$ bzw. $C^3$ wegfällt;

- eine Schicht E, die zwischen der emittierenden Schicht und der zweiten Elektrode angeordnet ist, und die eine Verbindung einer Formel (E-1) enthält

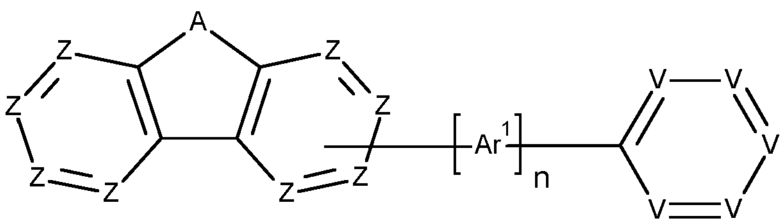

Formel (E-1),

wobei

A gleich

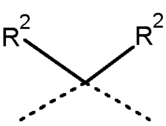

,

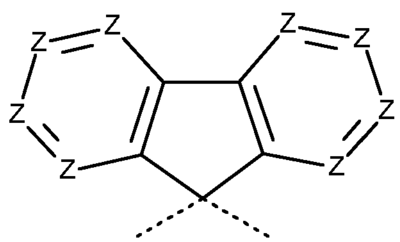

,

O oder S ist, wobei die gestrichelten Bindungen die Bindungen von A zum Rest der Formel kennzeichnen;

Z, wenn keine Gruppe

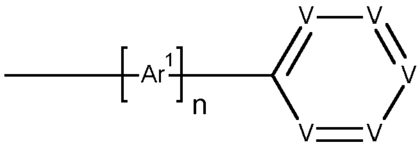

daran gebunden ist, bei jedem Auftreten gleich oder verschieden gewählt ist aus N und $CR^1$, und wenn eine Gruppe

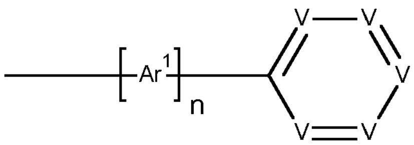

daran gebunden ist, gleich C ist;

V bei jedem Auftreten gleich oder verschieden gewählt ist aus N und $CR^4$, wobei mindestens zwei Gruppen V im Ring gleich N sein müssen;

$Ar^1$ bei jedem Auftreten gleich oder verschieden gewählt ist aus aromatischen Ringsystemen mit 6 bis 40 aromatischen Ringatomen, die mit Resten $R^3$ substituiert sind, und heteroaromatischen Ringsystemen mit 5 bis 40 aromatischen Ringatomen, die mit Resten $R^3$ substituiert sind;

$R^1$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^1$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C≡C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^2$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^2$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C≡C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^3$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^3$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C≡C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;

$R^4$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^4$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;
$R^5$ ist bei jedem Auftreten gleich oder verschieden gewählt aus H, D, F, Cl, Br, I, $C(=O)R^6$, CN, $Si(R^6)_3$, $N(R^6)_2$, $P(=O)(R^6)_2$, $OR^6$, $S(=O)R^6$, $S(=O)_2R^6$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^5$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^6$ substituiert sind; und wobei eine oder mehrere $CH_2$-Gruppen in den genannten Alkyl-, Alkoxy-, Alkenyl- und Alkinylgruppen durch $-R^6C=CR^6-$, -C=C-, $Si(R^6)_2$, C=O, $C=NR^6$, -C(=O)O-, $-C(=O)NR^6-$, $NR^6$, $P(=O)(R^6)$, -O-, -S-, SO oder $SO_2$ ersetzt sein können;
$R^6$ ist bei jedem Auftreten gleich oder verschieden gewählt aus H, D, F, Cl, Br, I, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^6$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können;
n gleich 0, 1, 2, 3, oder 4 ist.

2. Elektronische Vorrichtung nach Anspruch 1, **dadurch gekennzeichnet, dass** T gleich B ist.

3. Elektronische Vorrichtung nach Anspruch 1 oder 2, **dadurch gekennzeichnet, dass** X bei jedem Auftreten gleich gewählt ist und $NR^{E2}$ ist.

4. Elektronische Vorrichtung nach einem oder mehreren der Ansprüche 1 bis 3, **dadurch gekennzeichnet, dass**

- $R^{E2}$ bei jedem Auftreten gleich oder verschieden gewählt ist aus aromatischen Ringsystemen mit 6 bis 40 aromatischen Ringatomen, die jeweils mit Resten $R^{E4}$ substituiert sind, wobei zwei oder mehr Reste $R^{E2}$ miteinander verknüpft sein können und einen Ring bilden können und wobei ein oder mehrere Reste $R^{E2}$ über ihre Reste $R^{E4}$ mit einem Ring gewählt aus $C^1$, $C^2$ und $C^3$ verknüpft sein können und einen Ring bilden können; und
- $R^{E3}$ bei jedem Auftreten gleich oder verschieden gewählt ist aus H, D, F, CN, $Si(R^{E4})_3$, $N(R^{E4})_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^{E4}$ substituiert sind; und wobei in den genannten Alkyl- oder Alkoxygruppen eine oder mehrere $CH_2$-Gruppen durch $-C\equiv C-$, $-R^{E4}C=CR^{E4}-$, $Si(R^{E4})_2$, C=O, $C=NR^{E4}$, $-NR^{E4}-$, -O-, -S-, -C(=O)O- oder $-C(=O)NR^{E4}-$ ersetzt sein können; und
- $R^{E4}$ bei jedem Auftreten gleich oder verschieden gewählt ist aus H, D, F, CN, $Si(R^{E5})_3$, $N(R^{E5})_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^{E5}$ substituiert sind; und wobei in den genannten Alkyl- oder Alkoxygruppen eine oder mehrere $CH_2$-Gruppen durch $-C\equiv C-$, $-R^{E5}C=CR^{E5}-$, $Si(R^{E5})_2$, C=O, $C=NR^{E5}$, $-NR^{E5}-$, -O-, -S-, -C(=O)O- oder $-C(=O)NR^{E5}-$ ersetzt sein können.

5. Elektronische Vorrichtung nach einem oder mehreren der Ansprüche 1 bis 4, **dadurch gekennzeichnet, dass** mindestens ein Rest $R^{E3}$ in Formel (EM-1) gewählt ist aus Alkylgruppen mit 1 bis 10 C-Atomen, die mit Resten $R^{E4}$ substituiert sind, und $N(R^{E4})_2$.

6. Elektronische Vorrichtung nach einem oder mehreren der Ansprüche 1 bis 5, **dadurch gekennzeichnet, dass** einer der Indices o und p gleich 1 ist, und der andere der Indices o und p gleich 0 ist.

7. Elektronische Vorrichtung nach einem oder mehreren der Ansprüche 1 bis 6, **dadurch gekennzeichnet, dass** die Verbindung der Formel (EM-1) einer Formel gewählt aus Formeln (EM-1-1-1-1-1) und (EM-1-1-1-1-2) entspricht

| |
|---|
| 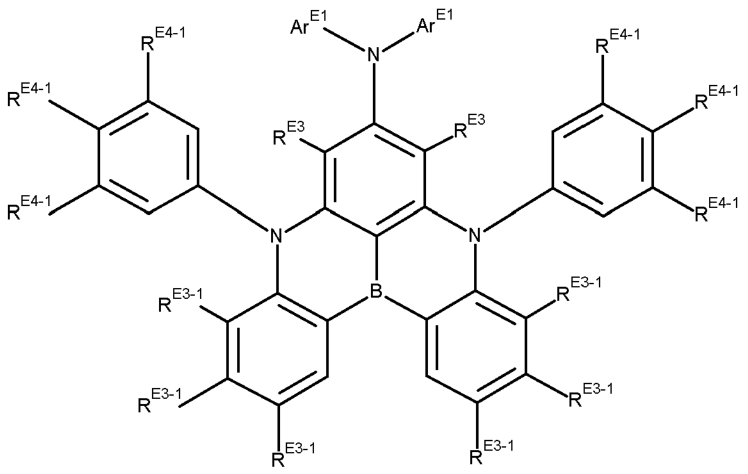 |
| Formel (EM-1-1-1-1-1) |
| 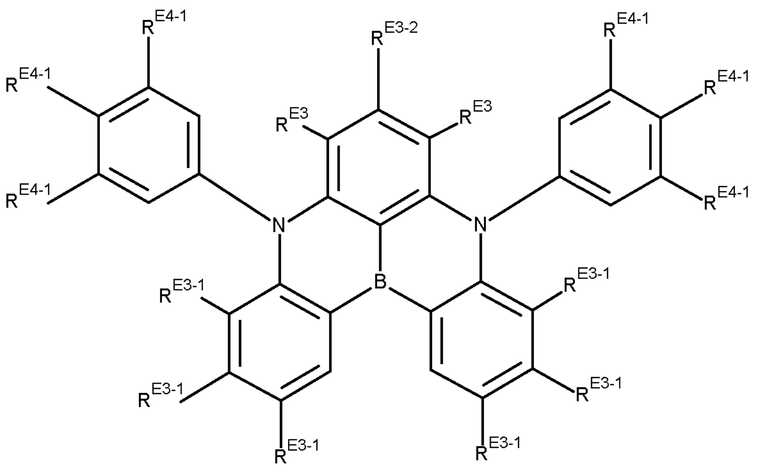 |
| Formel (EM-1-1-1-1-2), |

wobei $R^{E3-1}$ definiert ist wie $R^{E3}$; und $R^{E3-2}$ gewählt ist aus Alkylgruppen mit 1 bis 10 C-Atomen, die mit Resten $R^{E4}$ substituiert sind, bevorzugt Methyl, Ethyl, iso-Propyl und tert-Butyl, besonders bevorzugt Methyl; und $R^{E4-1}$ definiert ist wie $R^{E4}$.

8. Elektronische Vorrichtung nach einem oder mehreren der Ansprüche 1 bis 7, **dadurch gekennzeichnet, dass** Z gleich $CR^1$ ist, wenn keine Gruppe

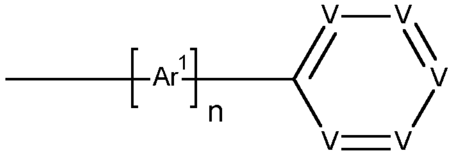

daran gebunden ist.

9. Elektronische Vorrichtung nach einem oder mehreren der Ansprüche 1 bis 8, **dadurch gekennzeichnet, dass** Gruppen

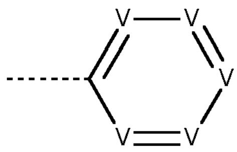

gewählt sind aus den folgenden Gruppen

| | |
|---|---|
| 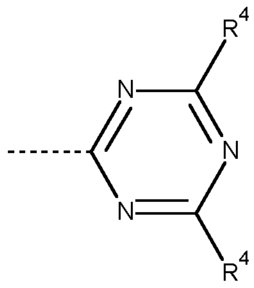 | 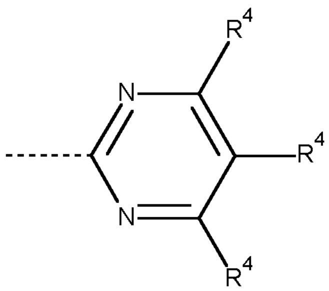 |
| Formel (H-1) | Formel (H-2) |
| 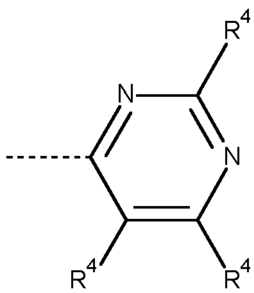 | 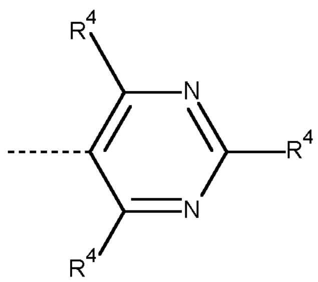 |
| Formel (H-3) | Formel (H-4), |

wobei die gestrichelte Linie die Bindung an den Rest der Formel darstellt.

**10.** Elektronische Vorrichtung nach einem oder mehreren der Ansprüche 1 bis 9, **dadurch gekennzeichnet, dass** $Ar^1$ bei jedem Auftreten gleich oder verschieden gewählt ist aus divalenten Gruppen abgeleitet von Benzol, Biphenyl, Terphenyl, Naphthalin, Fluoren, Indenofluoren, Indenocarbazol, Spirobifluoren, Dibenzofuran, Dibenzothiophen und Carbazol, die jeweils mit einem oder mehreren Resten $R^3$ substituiert sein können.

**11.** Elektronische Vorrichtung nach einem oder mehreren der Ansprüche 1 bis 10, **dadurch gekennzeichnet, dass**

- $R^1$ bei jedem Auftreten gleich oder verschieden gewählt ist aus H, F, aromatischen Ringsystemen mit 6 bis 40 aromatischen Ringatomen, und heteroaromatischen Ringsystemen mit 5 bis 40 aromatischen Ringatomen; wobei die aromatischen Ringsysteme und die heteroaromatischen Ringsysteme jeweils mit Resten $R^5$ substituiert sind; und
- $R^2$ bei jedem Auftreten gleich oder verschieden gewählt ist aus geradkettigen Alkylgruppen mit 1 bis 20 C-Atomen, verzweigten Alkylgruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkylgruppen, die genannten aromatischen Ringsysteme und die genannten heteroaromatischen Ringsysteme jeweils mit Resten $R^5$ substituiert sind; und
- $R^3$ bei jedem Auftreten gleich oder verschieden gewählt ist aus H, D, F, CN, $Si(R^5)_3$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^5$ substituiert sind; und wobei in den genannten Alkyl- oder Alkoxygruppen eine oder mehrere $CH_2$-Gruppen durch -C=C-, $-R^5C=CR^5-$, $Si(R^5)_2$, C=O, $C=NR^5$, $-NR^5-$, -O-, -S-, -C(=O)O- oder $-C(=O)NR^5-$ ersetzt sein können; und

- $R^4$ bei jedem Auftreten gleich oder verschieden gewählt ist aus H und aromatischen Ringsystemen mit 6 bis 40 aromatischen Ringatomen, die mit Resten $R^5$ substituiert sind; und
- $R^5$ bei jedem Auftreten gleich oder verschieden gewählt ist aus H, D, F, CN, $Si(R^6)_3$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^6$ substituiert sind; und wobei in den genannten Alkyl- oder Alkoxygruppen eine oder mehrere $CH_2$-Gruppen durch -C=C-, $-R^6C=CR^6-$, $Si(R^6)_2$, C=O, $C=NR^6$, $-NR^6-$, -O-, -S-, -C(=O)O- oder $-C(=O)NR^6-$ ersetzt sein können.

**12.** Elektronische Vorrichtung nach einem oder mehreren der Ansprüche 1 bis 11, **dadurch gekennzeichnet, dass** die Verbindung der Formel (E-1) einer Formel gewählt aus den folgenden Formeln entspricht:

| |
|---|
| 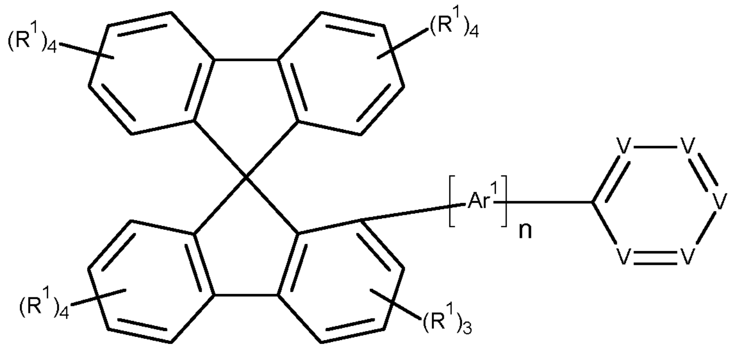 |
| Formel (E-1-1-1) |
| 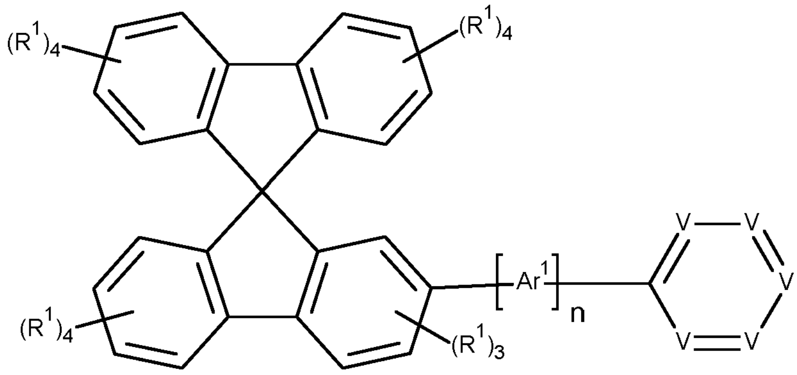 |
| Formel (E-1-1-2) |

(fortgesetzt)

| |
|---|
| 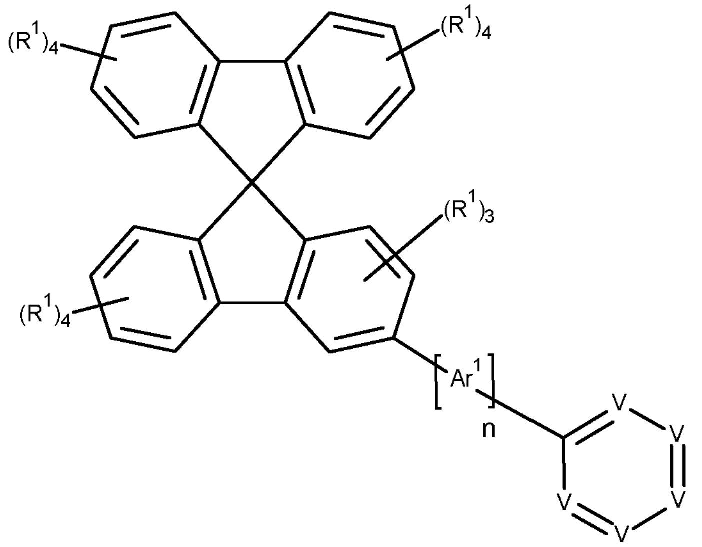 |
| Formel (E-1-1-3) |
| 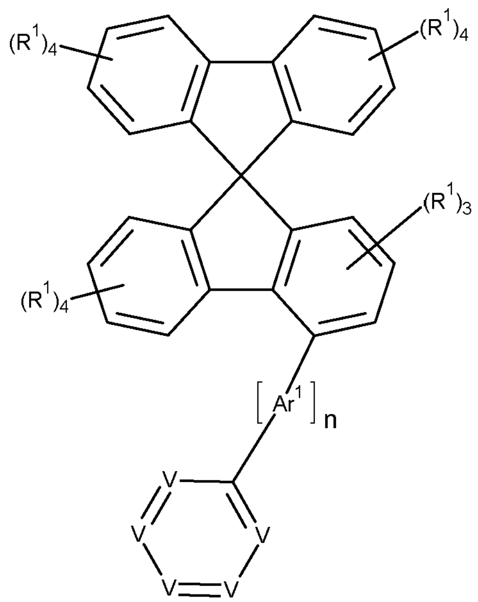 |
| Formel (E-1-1-4) |
| 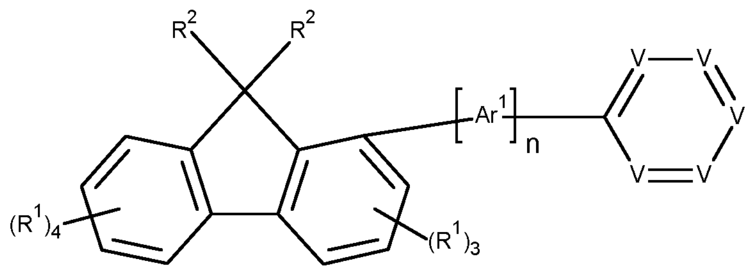 |
| Formel (E-1-2-1) |

(fortgesetzt)

| |
|---|
| 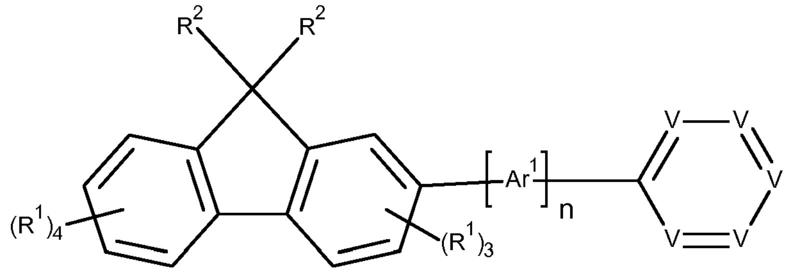 |
| Formel (E-1-2-2) |
| 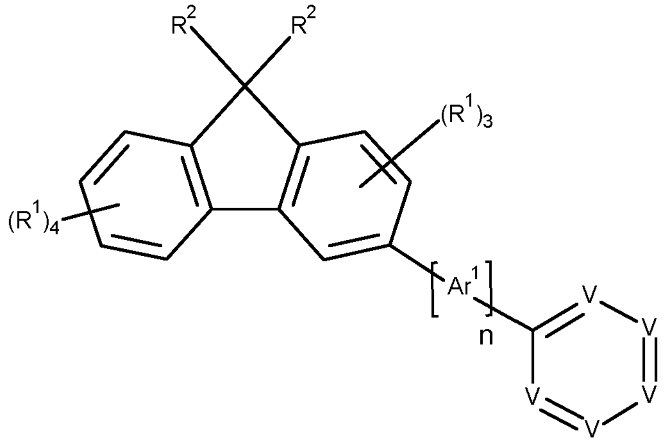 |
| Formel (E-1-2-3) |
| 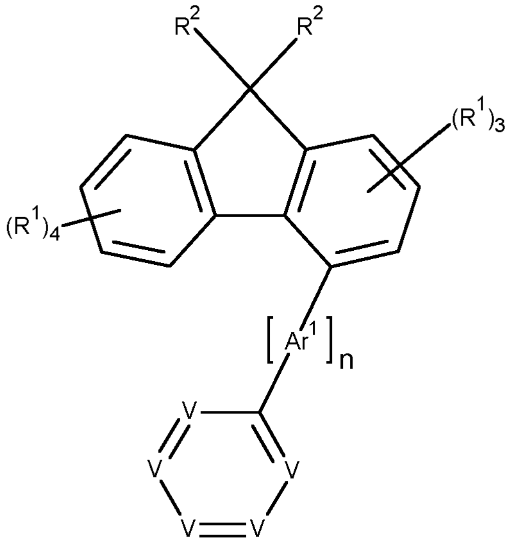 |
| Formel (E-1-2-4). |

**13.** Elektronische Vorrichtung nach einem oder mehreren der Ansprüche 1 bis 12, **dadurch gekennzeichnet, dass** sie eine organische Elektrolumineszenzvorrichtung ist, dass die erste Elektrode eine Anode ist, dass die zweite Elektrode eine Kathode ist, und dass die Schicht E eine Elektronentransportschicht ist.

**14.** Elektronische Vorrichtung nach einem oder mehreren der Ansprüche 1 bis 13, **dadurch gekennzeichnet, dass** die Schicht E eine Mischung aus einem Alkalimetallsalz und einer weitereren Verbindung enthält.

**15.** Elektronische Vorrichtung nach einem oder mehreren der Ansprüche 1 bis 14, **dadurch gekennzeichnet, dass** sie

die die folgenden Schichten zwischen Anode und Kathode enthält:

- zwischen Anode und emittierender Schicht mindestens eine lochtransportierende Schicht;
- zwischen lochtransportierender Schicht und Kathode die emittierende Schicht; und
- zwischen emittierender Schicht und Kathode die Schicht E als Elektronentransportschicht.

**16.** Elektronische Vorrichtung nach einem oder mehreren der Ansprüche 1 bis 15, **dadurch gekennzeichnet, dass** die emittierende Schicht der Vorrichtung neben der Verbindung der Formel (EM-1) eine oder mehrere weitere Verbindungen enthält, die gewählt sind aus Anthracenderivaten und Benzanthracenderivaten.

**17.** Elektronische Vorrichtung nach einem oder mehreren der Ansprüche 1 bis 16, **dadurch gekennzeichnet, dass** sie zwei oder drei gleiche oder verschiedene Schichtenabfolgen übereinander gestapelt enthält, wobei jede der Schichtenabfolgen jeweils die folgenden Schichten umfasst: Lochinjektionsschicht, Lochtransportschicht, Elektronenblockierschicht, emittierende Schicht, und Elektronentransportschicht, und wobei wenigstens eine der Schichtabfolgen

- eine emittierende Schicht, enthaltend eine Verbindung der Formel (EM-1), und
- eine Schicht E, bevorzugt als Elektronentransportschicht, enthält.

**18.** Elektronische Vorrichtung nach einem oder mehreren der Ansprüche 1 bis 17, **dadurch gekennzeichnet, dass** sie Licht durch die Kathode hindurch emittiert.

**19.** Verfahren zur Herstellung einer elektronischen Vorrichtung nach einem oder mehreren der Ansprüche 1 bis 18, **dadurch gekennzeichnet, dass** es die folgenden Schritte umfasst: zunächst die Bereitstellung eines Substrats mit Anode, in einem später folgenden Schritt das Aufbringen der emittierenden Schicht enthaltend die Verbindung der Formel (EM-1), in einem dann folgenden Schritt das Aufbringen der Schicht E, und in einem dann folgenden Schritt das Aufbringen der Anode.

**20.** Verwendung einer elektronischen Vorrichtung nach einem oder mehreren der Ansprüche 1 bis 18 in Displays, als Lichtquelle in Beleuchtungsanwendungen, oder als Lichtquelle in medizinischen und/oder kosmetischen Anwendungen.

**Claims**

**1.** Electronic device comprising a first electrode, a second electrode and, arranged inbetween,

- an emitting layer comprising a compound of a formula (EM-1)

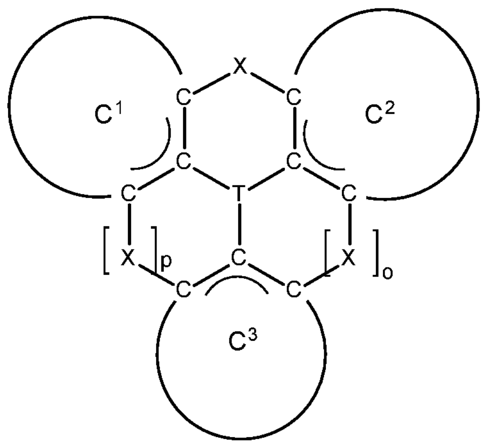

Formula (EM-1)

for which:

T is B, P, P(=O) or $SiR^{E1}$;

X is the same or different at each instance and is selected from O, S, $NR^{E2}$ and $C(R^{E2})_2$, where there must be at least one X present which is selected from O, S and $NR^{E2}$;

$C^1$, $C^2$ and $C^3$ are the same or different and are selected from ring systems which have 5 to 40 ring atoms and are substituted by $R^{E3}$ radicals;

$R^{E1}$ is selected from H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where the alkyl, alkoxy, alkenyl and alkynyl groups mentioned and the aromatic ring systems and heteroaromatic ring systems mentioned are each substituted by $R^{E4}$ radicals; and where one or more $CH_2$ groups in the alkyl, alkoxy, alkenyl and alkynyl groups mentioned may be replaced by $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO or $SO_2$;

$R^{E2}$ is the same or different at each instance and is selected from H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where the alkyl, alkoxy, alkenyl and alkynyl groups mentioned and the aromatic ring systems and heteroaromatic ring systems mentioned are each substituted by $R^{E4}$ radicals; and where one or more $CH_2$ groups in the alkyl, alkoxy, alkenyl and alkynyl groups mentioned may be replaced by $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO or $SO_2$; where two or more $R^{E2}$ radicals may be joined to one another and may form a ring, and where one or more $R^{E2}$ radicals may be joined via their $R^{E4}$ radicals to a ring selected from $C^1$, $C^2$ and $C^3$ and may form a ring;

$R^{E3}$ is the same or different at each instance and is selected from H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^{E3}$ radicals may be joined to one another and may form a ring; where the alkyl, alkoxy, alkenyl and alkynyl groups mentioned and the aromatic ring systems and heteroaromatic ring systems mentioned are each substituted by $R^{E4}$ radicals; and where one or more $CH_2$ groups in the alkyl, alkoxy, alkenyl and alkynyl groups mentioned may be replaced by $-R^{E4}C=CR^{E4}-$, -C=C-, $Si(R^{E4})_2$, C=O, $C=NR^{E4}$, -C(=O)O-, $-C(=O)NR^{E4}-$, $NR^{E4}$, $P(=O)(R^{E4})$, -O-, -S-, SO or $SO_2$;

$R^{E4}$ is the same or different at each instance and is selected from H, D, F, Cl, Br, I, $C(=O)R^{E5}$, CN, $Si(R^{E5})_3$, $N(R^{E5})_2$, $P(=O)(R^{E5})_2$, $OR^{E5}$, $S(=O)R^{E5}$, $S(=O)_2R^{E5}$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^{E4}$ radicals may be joined to one another and may form a ring; where the alkyl, alkoxy, alkenyl and alkynyl groups mentioned and the aromatic ring systems and heteroaromatic ring systems mentioned are each substituted by $R^{E5}$ radicals; and where one or more $CH_2$ groups in the alkyl, alkoxy, alkenyl and alkynyl groups mentioned may be replaced by $-R^{E5}C=CR^{E5}-$, -C=C-, $Si(R^{E5})_2$, C=O, $C=NR^{E5}$, -C(=O)O-, $-C(=O)NR^{E5}-$, $NR^{E5}$, $P(=O)(R^{E5})$, -O-, -S-, SO or $SO_2$;

$R^{E5}$ is the same or different at each instance and is selected from H, D, F, Cl, Br, I, CN, alkyl or alkoxy groups having 1 to 20 carbon atoms, alkenyl or alkynyl groups having 2 to 20 carbon atoms, aromatic ring systems having 6 to 40 aromatic ring atoms and heteroaromatic ring systems having 5 to 40 aromatic ring atoms; where two or more $R^{E5}$ radicals may be joined to one another and may form a ring; and where the alkyl, alkoxy, alkenyl and alkynyl groups, aromatic ring systems and heteroaromatic ring systems mentioned may be substituted by one or more radicals selected from F and CN;

o and p are the same or different and are 0 or 1, where p = 0 and o = 0 mean that the X group indicated by p or o together with its bonds to the rings $C^1$, $C^2$ and $C^3$ is absent;

- a layer E which is disposed between the emitting layer and the second electrode and comprises a compound of a formula (E-1)

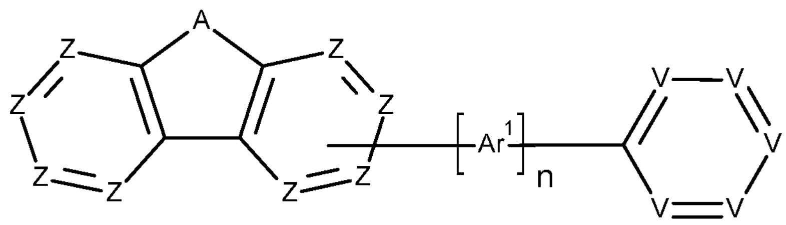

Formula (E-1)

where

A is

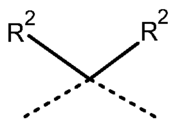
,
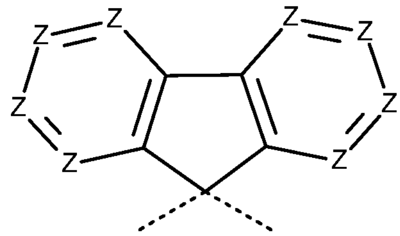
,

O or S , where the dotted bonds indicate the bonds of A to the rest of the formula;

Z, when no

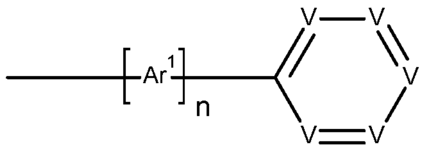

group is bonded thereto, is the same or different at each instance and is selected from N and $CR^1$, and, when a

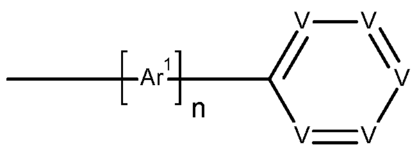

group is bonded thereto, is C;

V is the same or different at each instance and is selected from N and $CR^4$, where at least two V groups in the ring must be N;

$Ar^1$ is the same or different at each instance and is selected from aromatic ring systems which have 6 to 40 aromatic ring atoms and are substituted by $R^3$ radicals, and heteroaromatic ring systems which have 5 to 40 aromatic ring atoms and are substituted by $R^3$ radicals; $R^1$ is the same or different at each instance and is selected from H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^1$ radicals may be joined to one another and may form a ring; where the alkyl, alkoxy, alkenyl and alkynyl groups mentioned and the aromatic ring systems and heteroaromatic ring systems mentioned are each substituted by $R^5$ radicals; and where one or more $CH_2$ groups in the alkyl, alkoxy, alkenyl and alkynyl groups mentioned may be replaced by $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, - S-, SO or $SO_2$;

$R^2$ is the same or different at each instance and is selected from H, D, F, Cl, Br, I, $C(=O)R^5$, CN, $Si(R^5)_3$,

$N(R^5)_2$, $P(=O)(R^5)_2$, $OR^5$, $S(=O)R^5$, $S(=O)_2R^5$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^2$ radicals may be joined to one another and may form a ring; where the alkyl, alkoxy, alkenyl and alkynyl groups mentioned and the aromatic ring systems and heteroaromatic ring systems mentioned are each substituted by $R^5$ radicals; and where one or more $CH_2$ groups in the alkyl, alkoxy, alkenyl and alkynyl groups mentioned may be replaced by $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, - S-, SO or $SO_2$;

$R^3$ is the same or different at each instance and is selected from H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^3$ radicals may be joined to one another and may form a ring; where the alkyl, alkoxy, alkenyl and alkynyl groups mentioned and the aromatic ring systems and heteroaromatic ring systems mentioned are each substituted by $R^5$ radicals; and where one or more $CH_2$ groups in the alkyl, alkoxy, alkenyl and alkynyl groups mentioned may be replaced by $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, - S-, SO or $SO_2$;

$R^4$ is the same or different at each instance and is selected from H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^4$ radicals may be joined to one another and may form a ring; where the alkyl, alkoxy, alkenyl and alkynyl groups mentioned and the aromatic ring systems and heteroaromatic ring systems mentioned are each substituted by $R^5$ radicals; and where one or more $CH_2$ groups in the alkyl, alkoxy, alkenyl and alkynyl groups mentioned may be replaced by $-R^5C=CR^5-$, -C=C-, $Si(R^5)_2$, C=O, $C=NR^5$, -C(=O)O-, $-C(=O)NR^5-$, $NR^5$, $P(=O)(R^5)$, -O-, - S-, SO or $SO_2$;

$R^5$ is the same or different at each instance and is selected from H, D, F, Cl, Br, I, $C(=O)R^6$, CN, $Si(R^6)_3$, $N(R^6)_2$, $P(=O)(R^6)_2$, $OR^6$, $S(=O)R^6$, $S(=O)_2R^6$, straight-chain alkyl or alkoxy groups having 1 to 20 carbon atoms, branched or cyclic alkyl or alkoxy groups having 3 to 20 carbon atoms, alkenyl or alkynyl groups having 2 to 20 carbon atoms, aromatic ring systems having 6 to 40 aromatic ring atoms, and heteroaromatic ring systems having 5 to 40 aromatic ring atoms; where two or more $R^5$ radicals may be joined to one another and may form a ring; where the alkyl, alkoxy, alkenyl and alkynyl groups mentioned and the aromatic ring systems and heteroaromatic ring systems mentioned are each substituted by $R^6$ radicals; and where one or more $CH_2$ groups in the alkyl, alkoxy, alkenyl and alkynyl groups mentioned may be replaced by $-R^6C=CR^6-$, -C=C-, $Si(R^6)_2$, C=O, $C=NR^6$, -C(=O)O-, $-C(=O)NR^6-$, $NR^6$, $P(=O)(R^6)$, -O-, - S-, SO or $SO_2$;

$R^6$ is the same or different at each instance and is selected from H, D, F, Cl, Br, I, CN, alkyl or alkoxy groups having 1 to 20 carbon atoms, alkenyl or alkynyl groups having 2 to 20 carbon atoms, aromatic ring systems having 6 to 40 aromatic ring atoms and heteroaromatic ring systems having 5 to 40 aromatic ring atoms; where two or more $R^6$ radicals may be joined to one another and may form a ring; and where the alkyl, alkoxy, alkenyl and alkynyl groups, aromatic ring systems and heteroaromatic ring systems mentioned may be substituted by one or more radicals selected from F and CN;

n is 0, 1, 2, 3 or 4.

2. Electronic device according to Claim 1, **characterized in that** T is B.

3. Electronic device according to Claim 1 or 2, **characterized in that** X is selected to be the same at each instance and is $NR^{E2}$.

4. Electronic device according to one or more of Claims 1 to 3, **characterized in that**

- $R^{E2}$ is the same or different at each instance and is selected from aromatic ring systems which have 6 to 40 aromatic ring atoms and are each substituted by $R^{E4}$ radicals, where two or more $R^{E2}$ radicals may be joined to one another and may form a ring and where one or more $R^{E2}$ radicals may be joined via their $R^{E4}$ radicals to a ring selected from $C^1$, $C^2$ and $C^3$ and may form a ring; and
- $R^{E3}$ is the same or different at each instance and is selected from H, D, F, CN, $Si(R^{E4})_3$, $N(R^{E4})_2$, straight-chain alkyl or alkoxy groups having 1 to 20 carbon atoms, branched or cyclic alkyl or alkoxy groups having 3 to 20 carbon atoms, aromatic ring systems having 6 to 40 aromatic ring atoms, and heteroaromatic ring systems having 5 to 40 aromatic ring atoms; where the alkyl and alkoxy groups mentioned, the aromatic ring systems

mentioned and the heteroaromatic ring systems mentioned are each substituted by $R^{E4}$ radicals; and where one or more $CH_2$ groups in the alkyl or alkoxy groups mentioned may be replaced by -C≡C-, $-R^{E4}C=CR^{E4}-$, $Si(R^{E4})_2$, C=O, C=NRE4, $-NR^{E4}-$, -O-, -S-, -C(=O)O- or $-C(=O)NR^{E4}-$; and

- $R^{E4}$ is the same or different at each instance and is selected from H, D, F, CN, $Si(R^{E5})_3$, $N(R^{E5})_2$, straight-chain alkyl or alkoxy groups having 1 to 20 carbon atoms, branched or cyclic alkyl or alkoxy groups having 3 to 20 carbon atoms, aromatic ring systems having 6 to 40 aromatic ring atoms, and heteroaromatic ring systems having 5 to 40 aromatic ring atoms; where the alkyl and alkoxy groups mentioned, the aromatic ring systems mentioned and the heteroaromatic ring systems mentioned are each substituted by $R^{E5}$ radicals; and where one or more $CH_2$ groups in the alkyl or alkoxy groups mentioned may be replaced by -C=C-, $-R^{E5}C=CR^{E5}-$, $Si(R^{E5})_2$, C=O, $C=NR^{E5}$, $-NR^{E5}-$, -O-, -S-, -C(=O)O- or $-C(=O)NR^{E5}-$.

5. Electronic device according to one or more of Claims 1 to 4, **characterized in that** at least one $R^{E3}$ radical in formula (EM-1) is selected from alkyl groups which have 1 to 10 carbon atoms and are substituted by $R^{E4}$ radicals, and $N(R^{E4})_2$.

6. Electronic device according to one or more of Claims 1 to 5, **characterized in that** one of the indices o and p is 1, and the other of the indices o and p is 0.

7. Electronic device according to one or more of Claims 1 to 6, **characterized in that** the compound of the formula (EM-1) conforms to a formula selected from the formulae (EM-1-1-1-1-1) and (EM-1-1-1-1-2)

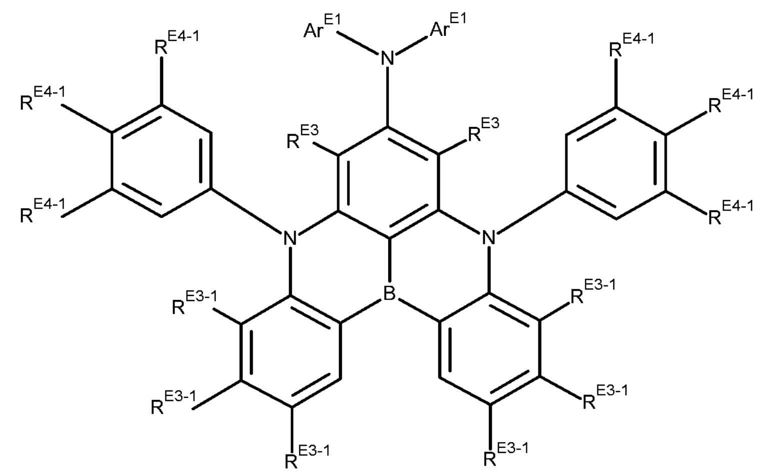

Formula (EM-1-1-1-1-1)

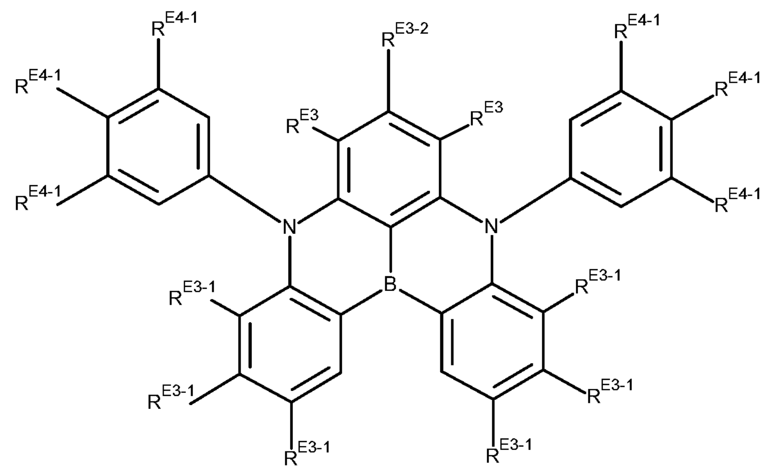

Formula (EM-1-1-1-1-2)

where $R^{E3-1}$ is as defined for $R^{E3}$; and $R^{E3-2}$ is selected from alkyl groups which have 1 to 10 carbon atoms and

are substituted by $R^{E4}$ radicals, preferably methyl, ethyl, isopropyl and tert-butyl, more preferably methyl; and $R^{E4-1}$ is as defined for $R^{E4}$.

**8.** Electronic device according to one or more of Claims 1 to 7, **characterized in that** Z is $CR^1$ when no

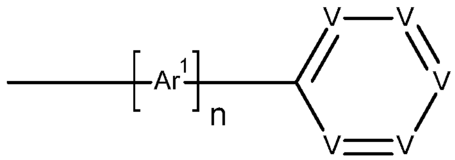

group is bonded thereto.

**9.** Electronic device according to one or more of Claims 1 to 8, **characterized in that**

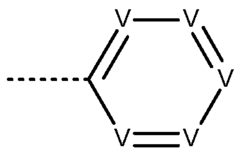

groups are selected from the following groups:

| | |
|---|---|
| 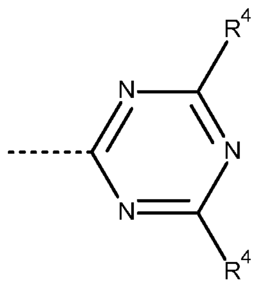 | 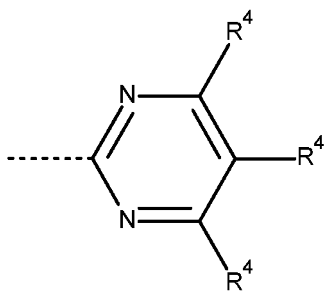 |
| Formula (H-1) | Formula (H-2) |
| 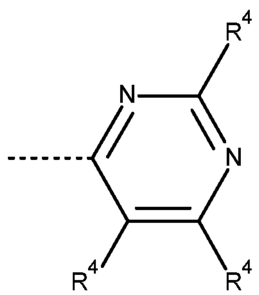 | 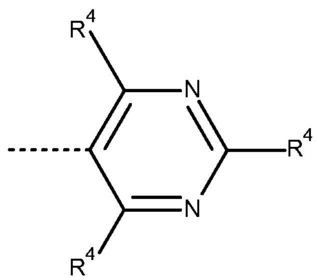 |
| Formula (H-3) | Formula (H-4) |

where the dotted line represents the bond to the rest of the formula.

**10.** Electronic device according to one or more of Claims 1 to 9, **characterized in that** $Ar^1$ is the same or different at each instance and is selected from divalent groups derived from benzene, biphenyl, terphenyl, naphthalene, fluorene, indenofluorene, indenocarbazole, spirobifluorene, dibenzofuran, dibenzothiophene, and carbazole, each of which may be substituted by one or more $R^3$ radicals.

**11.** Electronic device according to one or more of Claims 1 to 10, **characterized in that**

- $R^1$ is the same or different at each instance and is selected from H, F, aromatic ring systems having 6 to 40 aromatic ring atoms, and heteroaromatic ring systems having 5 to 40 aromatic ring atoms; where the aromatic ring systems and the heteroaromatic ring systems are each substituted by $R^5$ radicals; and
- $R^2$ is the same or different at each instance and is selected from straight-chain alkyl groups having 1 to 20 carbon atoms, branched alkyl groups having 3 to 20 carbon atoms, aromatic ring systems having 6 to 40 aromatic ring atoms, and heteroaromatic ring systems having 5 to 40 aromatic ring atoms; where said alkyl groups, said aromatic ring systems and said heteroaromatic ring systems are each substituted by $R^5$ radicals; and
- $R^3$ is the same or different at each instance and is selected from H, D, F, CN, $Si(R^5)_3$, straight-chain alkyl or alkoxy groups having 1 to 20 carbon atoms, branched or cyclic alkyl or alkoxy groups having 3 to 20 carbon atoms, aromatic ring systems having 6 to 40 aromatic ring atoms, and heteroaromatic ring systems having 5 to 40 aromatic ring atoms; where the alkyl and alkoxy groups mentioned, the aromatic ring systems mentioned and the heteroaromatic ring systems mentioned are each substituted by $R^5$ radicals; and where one or more $CH_2$ groups in the alkyl or alkoxy groups mentioned may be replaced by -C=C-, $-R^5C=CR^5-$, $Si(R^5)_2$, C=O, $C=NR^5$, $-NR^5-$, -O-, -S-, -C(=O)O- or $-C(=O)NR^5-$; and
- $R^4$ is the same or different at each instance and is selected from H and aromatic ring systems which have 6 to 40 aromatic ring atoms and are substituted by $R^5$ radicals; and
- $R^5$ is the same or different at each instance and is selected from H, D, F, CN, $Si(R^6)_3$, straight-chain alkyl or alkoxy groups having 1 to 20 carbon atoms, branched or cyclic alkyl or alkoxy groups having 3 to 20 carbon atoms, aromatic ring systems having 6 to 40 aromatic ring atoms, and heteroaromatic ring systems having 5 to 40 aromatic ring atoms; where the alkyl and alkoxy groups mentioned, the aromatic ring systems mentioned and the heteroaromatic ring systems mentioned are each substituted by $R^6$ radicals; and where one or more $CH_2$ groups in the alkyl or alkoxy groups mentioned may be replaced by -C=C-, $-R^6C=CR^6-$, $Si(R^6)_2$, C=O, $C=NR^6$, $-NR^6-$, -O-, -S-, -C(=O)O- or $-C(=O)NR^6-$.

**12.** Electronic device according to one or more of Claims 1 to 11, **characterized in that** the compound of the formula (E-1) conforms to a formula selected from the following formulae:

| |
|---|
| 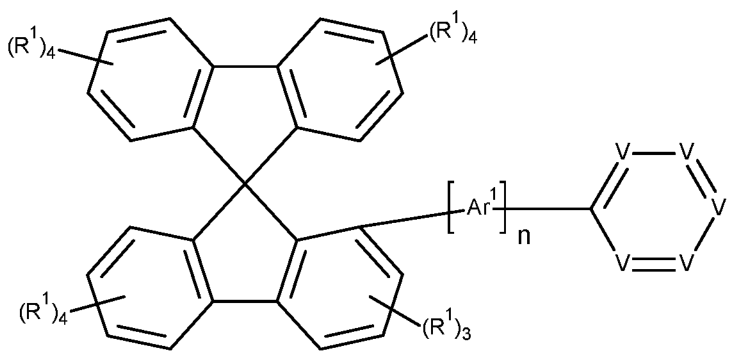 |
| Formula (E-1-1-1) |
| 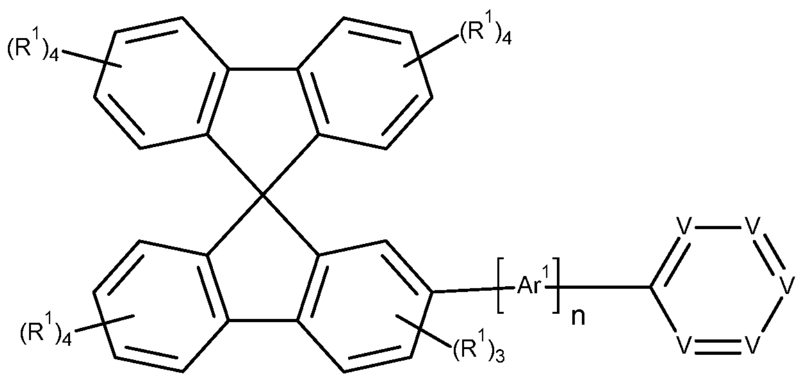 |
| Formula (E-1-1-2) |

(continued)

| |
|---|
| 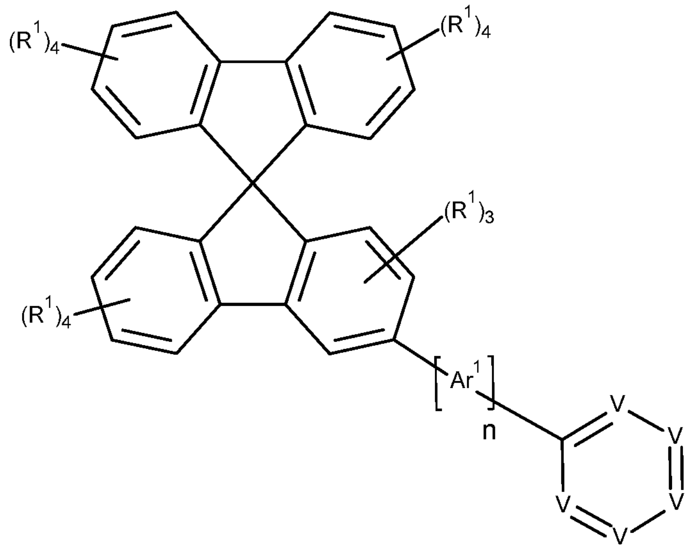 |
| Formula (E-1-1-3) |
| 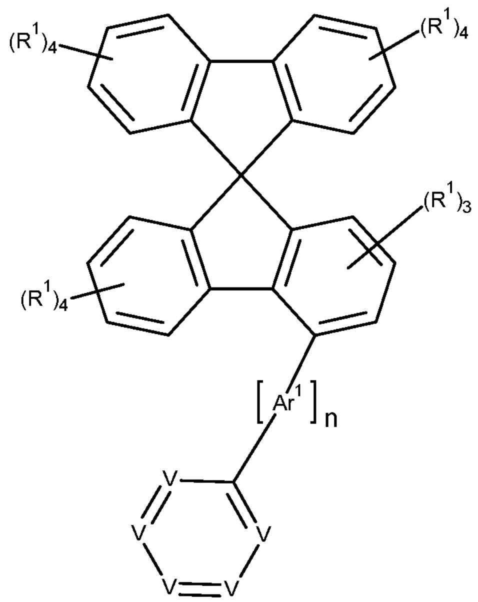 |
| Formula (E-1-1-4) |
| 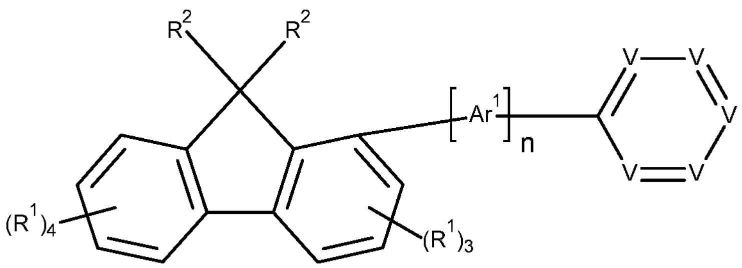 |
| Formula (E-1-2-1) |

(continued)

| |
|---|
| 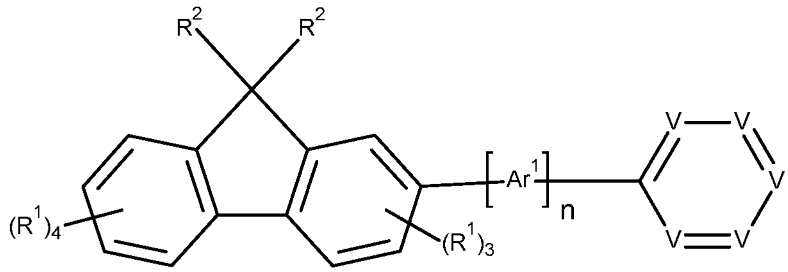 |
| Formula (E-1-2-2) |
| 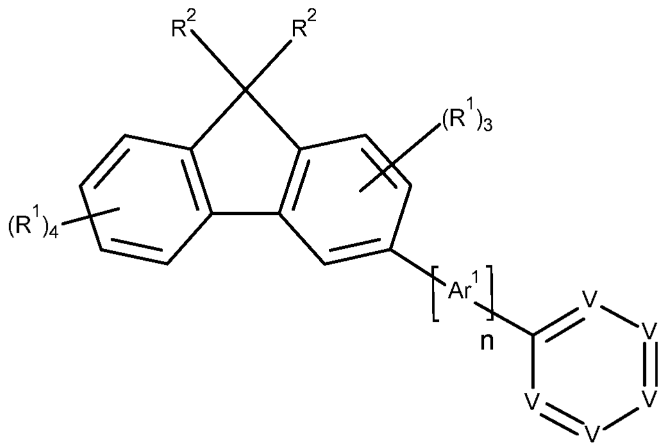 |
| Formula (E-1-2-3) |
| 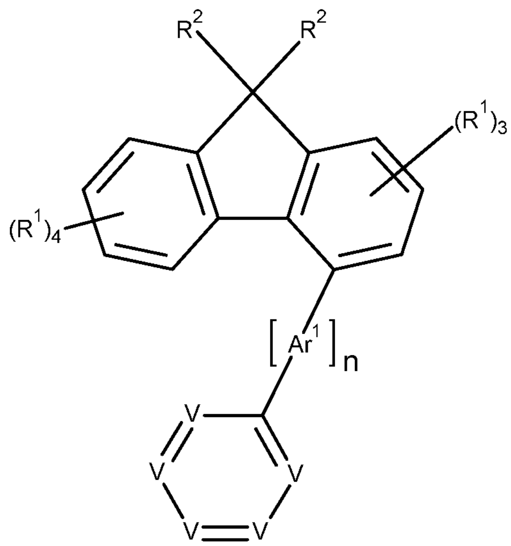 |
| Formula (E-1-2-4). |

**13.** Electronic device according to one or more of Claims 1 to 12, **characterized in that** it is an organic electroluminescent device, **in that** the first electrode is an anode, **in that** the second electrode is a cathode, and **in that** layer E is an electron transport layer.

**14.** Electronic device according to one or more of Claims 1 to 13, **characterized in that** layer E comprises a mixture of an alkali metal salt and a further compound.

**15.** Electronic device according to one or more of Claims 1 to 14, **characterized in that** it comprises the following layers

between anode and cathode:

- at least one hole-transporting layer between anode and emitting layer;
- the emitting layer between hole-transporting layer and cathode; and
- layer E as electron transport layer between emitting layer and cathode.

**16.** Electronic device according to one or more of Claims 1 to 15, **characterized in that** the emitting layer of the device, as well as the compound of the formula (EM-1), comprises one or more further compounds selected from anthracene derivatives and benzanthracene derivatives.

**17.** Electronic device according to one or more of Claims 1 to 16, **characterized in that** it comprises two or three identical or different layer sequences stacked one on top of another, where each of the layer sequences comprises the following layers: hole injection layer, hole transport layer, electron blocker layer, emitting layer, and electron transport layer, and wherein at least one of the layer sequences comprises

- an emitting layer comprising a compound of the formula (EM-1), and
- a layer E, preferably as electron transport layer.

**18.** Electronic device according to one or more of Claims 1 to 17, **characterized in that** it emits light through the cathode.

**19.** Process for producing an electronic device according to one or more of Claims 1 to 18, **characterized in that** it comprises the following steps: first providing a substrate with anode, in a later step applying the emitting layer comprising the compound of the formula (EM-1), in a subsequent step applying layer E, and in a subsequent step applying the anode.

**20.** Use of an electronic device according to one or more of Claims 1 to 18 in displays, as a light source in lighting applications, or as a light source in medical and/or cosmetic applications.

## Revendications

**1.** Dispositif électronique, contenant une première électrode, une seconde électrode, et, disposées entre celles-ci

- une couche émettrice, contenant un composé de formule (EM-1),

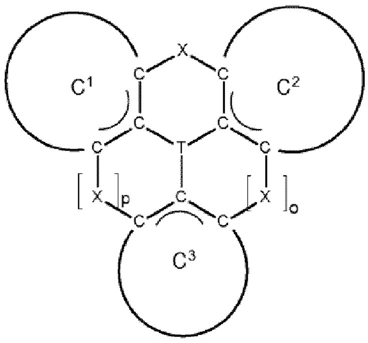

Formule (EM-1),

pour laquelle il s'applique que :

T est B, P, P(=O) ou $SiR^{E1}$ ;
X est choisi, le même ou différent à chaque occurrence, parmi O, S, $NR^{E2}$ et $C(R^{E2})_2$, au moins un X qui est choisi parmi O, S et $NR^{E2}$ devant être présent ;
$C^1$, $C^2$ et $C^3$ sont choisis, identiques ou différents, parmi des systèmes cycliques ayant de 5 à 40 atomes formant le cycle, qui sont substitués par des radicaux $R^{E3}$ ;
$R^{E1}$ est choisi parmi H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$,

$S(=O)_2R^{F4}$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle, alcoxy, alcényle et alcynyle mentionnés et les systèmes cycliques aromatiques et systèmes cycliques hétéroaromatiques mentionnés étant substitués chacun par des radicaux $R^{E4}$ ; et un ou plusieurs groupes $CH_2$ dans les groupes alkyle, alcoxy, alcényle et alcynyle mentionnés pouvant être remplacés par $-R^{E4}C=CR^{E4}-$, -CoC-, $Si(R^{E4})_2$, C=O, $C=NR^{E4}$, - C(=O)O-, $-C(=O)NR^{E4}-$, $NR^{E4}$, $P(=O)(R^{E4})$, -O-, -S-, SO ou $SO_2$ ;

$R^{E2}$ est choisi, le même ou différent à chaque occurrence, parmi H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle, alcoxy, alcényle et alcynyle mentionnés et les systèmes cycliques aromatiques et systèmes cycliques hétéroaromatiques mentionnés étant substitués chacun par des radicaux $R^{E4}$ ; et un ou plusieurs groupes $CH_2$ dans les groupes alkyle, alcoxy, alcényle et alcynyle mentionnés pouvant être remplacés par $-R^{E4}C=CR^{E4}-$, -CoC-, $Si(R^{E4})_2$, C=O, $C=NR^{E4}$, -C(=O)O-, - $C(=O)NR^{E4}-$, $NR^{E4}$, $P(=O)(R^{E4})$, -O-, -S-, SO ou $SO_2$ ; deux ou plus de deux radicaux $R^{E2}$ pouvant être liés l'un à l'autre/les uns aux autres et pouvant former un cycle, et un ou plusieurs radicaux $R^{E2}$ pouvant être liés par leurs radicaux $R^{E4}$ à un cycle choisi parmi $C^1$, $C^2$ et $C^3$ et pouvant former un cycle ;

$R^{E3}$ est choisi, le même ou différent à chaque occurrence, parmi H, D, F, Cl, Br, I, $C(=O)R^{E4}$, CN, $Si(R^{E4})_3$, $N(R^{E4})_2$, $P(=O)(R^{E4})_2$, $OR^{E4}$, $S(=O)R^{E4}$, $S(=O)_2R^{E4}$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; deux ou plus de deux radicaux $R^{E3}$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^{E4}$ ; et un ou plusieurs groupes $CH_2$ dans les groupes alkyle, alcoxy, alcényle et alcynyle mentionnés pouvant être remplacés par $-R^{E4}C=CR^{E4}-$, -CoC-, $Si(R^{E4})_2$, C=O, $C=NR^{E4}$, - C(=O)O-, $-C(=O)NR^{E4}-$, $NR^{E4}$, $P(=O)(R^{E4})$, -O-, -S-, SO ou $SO_2$ ;

$R^{E4}$ est choisi, le même ou différent à chaque occurrence, parmi H, D, F, Cl, Br, I, $C(=O)R^{E5}$, CN, $Si(R^{E5})_3$, $N(R^{E5})_2$, $P(=O)(R^{E5})_2$, $OR^{E5}$, $S(=O)R^{E5}$, $S(=O)_2R^{E5}$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; deux ou plus de deux radicaux $R^{E4}$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^{E5}$ ; et un ou plusieurs groupes $CH_2$ dans les groupes alkyle, alcoxy, alcényle et alcynyle mentionnés pouvant être remplacés par $-R^{E5}C=CR^{E5}-$, -CoC-, $Si(R^{E5})_2$, C=O, $C=NR^{E5}$, - C(=O)O-, $-C(=O)NR^{E5}-$, $NR^{E5}$, $P(=O)(R^{E5})$, -O-, -S-, SO ou $SO_2$ ;

$R^{E5}$ est choisi, le même ou différent à chaque occurrence, parmi H, D, F, Cl, Br, I, CN, des groupes alkyle ou alcoxy ayant de 1 à 20 atomes de carbone, des groupes alcényle ou alcynyle ayant de 2 à 20 atomes de carbone, des systèmes cycliques aromatiques ayant de 6 à 40 atomes formant le cycle aromatique et des systèmes cycliques hétéroaromatiques ayant de 5 à 40 atomes formant le cycle aromatique ; deux ou plus de deux radicaux $R^{E5}$ pouvant être liés l'un à l'autre/les uns aux autres et pouvant former un cycle ; et les groupes alkyle, alcoxy, alcényle et alcynyle, systèmes cycliques aromatiques et systèmes cycliques hétéroaromatiques mentionnés pouvant être substitués par un ou plusieurs radicaux choisis parmi F et CN ;

o et p sont, identiques ou différents, égaux à 0 ou 1, p = 0 ou, respectivement, o = 0 signifiant que le groupe X portant l'indice p ou respectivement o est absent, conjointement avec ses liaisons aux cycles $C^1$, C ou respectivement $C^3$ ;

- une couche E, qui est disposée entre la couche émettrice et la seconde électrode, et qui contient un composé de formule (E-1)

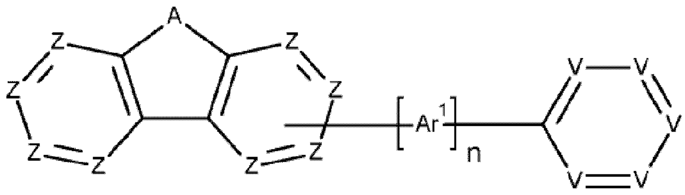

Formule (E-1),

dans laquelle

A est

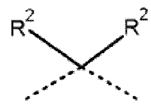 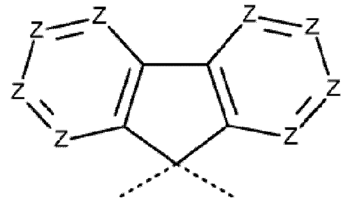 ,

O ou S, les liaisons en tireté désignant les liaisons de A au reste de la formule ;
Z, lorsqu'aucun groupe

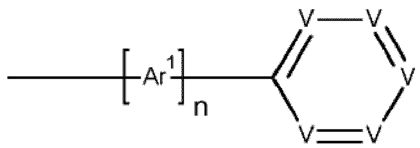

n' y est lié, est choisi, le même ou différent à chaque occurrence, parmi N et $CR^1$,
et lorsqu'un groupe

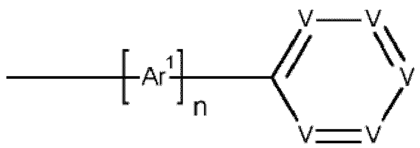

y est lié, est égal à C ;
V est choisi, le même ou différent à chaque occurrence, parmi N et $CR^4$, au moins deux groupes V dans le cycle devant être égaux à N ;
$Ar^1$ est choisi, le même ou différent à chaque occurrence, parmi des systèmes cycliques aromatiques ayant de 6 à 40 atomes formant le cycle aromatique, qui sont substitués par des radicaux $R^3$, et des systèmes cycliques hétéroaromatiques ayant de 5 à 40 atomes formant le cycle aromatique, qui sont substitués par des radicaux $R^3$ ;
$R^1$ est choisi, le même ou différent à chaque occurrence, parmi H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; deux ou plus de deux radicaux $R^1$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^5$ ; et un ou plusieurs groupes $CH_2$ dans les groupes alkyle, alcoxy, alcényle et alcynyle mentionnés pouvant être remplacés par $-R^5C=CR^5-$, -CoC-, $Si(R^5)_2$,

$C=O$, $C=NR^5$, - $C(=O)O$-, -$C(=O)NR^5$-, $NR^5$, $P(=O)(R^5)$, -O-, -S-, SO ou $SO_2$ ;
$R^2$ est choisi, le même ou différent à chaque occurrence, parmi H, D, F, Cl, Br, I, $C(=O)R^5$, CN, $Si(R^5)_3$, $N(R^5)_2$, $P(=O) (R^5)_2$, $OR^5$, $S(=O)R^5$, $S(=O)_2R^5$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; deux ou plus de deux radicaux $R^2$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^5$ ; et un ou plusieurs groupes $CH_2$ dans les groupes alkyle, alcoxy, alcényle et alcynyle mentionnés pouvant être remplacés par -$R^5C=CR^5$-, -C$\underline{o}$C-, $Si(R^5)_2$, $C=O$, $C=NR^5$, - $C(=O)O$-, -$C(=O)NR^5$-, $NR^5$, $P(=O)(R^5)$, -O-, -S-, SO ou $SO_2$ ;
$R^3$ est choisi, le même ou différent à chaque occurrence, parmi H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 6atomes formant le cycle aromatique ; deux ou plus de deux radicaux $R^3$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^5$ ; et un ou plusieurs groupes $CH_2$ dans les groupes alkyle, alcoxy, alcényle et alcynyle mentionnés pouvant être remplacés par -$R^5C=CR^5$-, -C$\underline{o}$C-, $Si(R^5)_2$, $C=O$, $C=NR^5$, - $C(=O)O$-, -$C(=O)NR^5$-, $NR^5$, $P(=O)(R^5)$, -O-, -S-, SO ou $SO_2$ ;
$R^4$ est choisi, le même ou différent à chaque occurrence, parmi H, D, F, Cl, Br, I, $C(=O)R^5$, CN, $Si(R^5)_3$, $N(R^5)_2$, $P(=O) (R^5)_2$, $OR^5$, $S(=O)R^5$, $S(=O)_2R^5$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; deux ou plus de deux radicaux $R^4$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^5$ ; et un ou plusieurs groupes $CH_2$ dans les groupes alkyle, alcoxy, alcényle et alcynyle mentionnés pouvant être remplacés par -$R^5C=CR^5$-, -C$\underline{o}$C-, $Si(R^5)_2$, $C=O$, $C=NR^5$, - $C(=O)O$-, -$C(=O)NR^5$-, $NR^5$, $P(=O)(R^5)$, -O-, -S-, SO ou $SO_2$ ;
$R^5$ est choisi, le même ou différent à chaque occurrence, parmi H, D, F, Cl, Br, I, $C(=O)R^6$, CN, $Si(R^6)_3$, $N(R^6)_2$, $P(=O) (R^6)_2$, $OR^6$, $S(=O)R^6$, $S(=O)_2R^6$, des groupes alkyle ou alcoxy à chaîne droite ayant de 1 à 20 atomes de carbone, des groupes alkyle ou alcoxy ramifiés ou cycliques ayant de 3 à 20 atomes de carbone, des groupes alcényle ou alcynyle ayant de 2 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; deux ou plus de deux radicaux $R^5$ pouvant être liés l'un à l'autre/les uns aux autres et pouvant former un cycle ; les groupes alkyle, alcoxy, alcényle et alcynyle mentionnés et les systèmes cycliques aromatiques et systèmes cycliques hétéroaromatiques mentionnés étant substitués chacun par des radicaux $R^6$ ; et un ou plusieurs groupes $CH_2$ dans les groupes alkyle, alcoxy, alcényle et alcynyle mentionnés pouvant être remplacés par -$R^6C=CR^6$-, -C$\underline{o}$C-, $Si(R^6)_2$, $C=O$, $C=NR^6$, - $C(=O)O$-, -$C(=O)NR^6$-, $NR^6$, $P(=O)(R^6)$, -O-, -S-, SO ou $SO_2$ ;
$R^6$ est choisi, le même ou différent à chaque occurrence, parmi H, D, F, Cl, Br, I, CN, des groupes alkyle ou alcoxy ayant de 1 à 20 atomes de carbone, des groupes alcényle ou alcynyle ayant de 2 à 20 atomes de carbone, des systèmes cycliques aromatiques ayant de 6 à 40 atomes formant le cycle aromatique et des systèmes cycliques hétéroaromatiques ayant de 5 à 40 atomes formant le cycle aromatique ; deux ou plus de deux radicaux $R^6$ pouvant être liés l'un à l'autre/les uns aux autres et pouvant former un cycle ; et les groupes alkyle, alcoxy, alcényle et alcynyle, systèmes cycliques aromatiques et systèmes cycliques hétéroaromatiques mentionnés pouvant être substitués par un ou plusieurs radicaux choisis parmi F et CN ;
n est égal à 0, 1, 2, 3 ou 4.

**2.** Dispositif électronique selon la revendication 1, **caractérisé en ce que** T est égal à B.

**3.** Dispositif électronique selon la revendication 1 ou 2, **caractérisé en ce que** X est choisi le même à chaque occurrence et est $NR^{E2}$.

**4.** Dispositif électronique selon une ou plusieurs des revendications 1 à 3, **caractérisé en ce que**

- $R^{E2}$ est choisi, le même ou différent à chaque occurrence, parmi des systèmes cycliques aromatiques ayant de 6 à 40 atomes formant le cycle aromatique, qui sont substitués chacun par des radicaux $R^{E4}$, deux ou plus de deux radicaux $R^{E2}$ pouvant être liés l'un à l'autre/les uns aux autres et pouvant former un cycle et un ou plusieurs radicaux $R^{E2}$ pouvant être liés par leurs radicaux $R^{E4}$ à un cycle choisi parmi $C^1$, $C^2$ et $C^3$ et pouvant former un cycle ; et
- $R^{E3}$ est choisi, le même ou différent à chaque occurrence, parmi H, D, F, CN, $Si(R^{E4})_3$, $N(R^{E4})_2$, des groupes alkyle ou alcoxy à chaîne droite ayant de 1 à 20 atomes de carbone, des groupes alkyle ou alcoxy ramifiés ou cycliques ayant de 3 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle et alcoxy mentionnés, les systèmes cycliques aromatiques mentionnés et les systèmes cycliques hétéroaromatiques mentionnés étant substitués chacun par des radicaux $R^{E4}$ ; et dans les groupes alkyle ou alcoxy mentionnés un ou plusieurs groupes $CH_2$ pouvant être remplacés par -C=C-, $-R^{E4}C=CR^{E4}-$, $Si(R^{E4})_2$, C=O, $C=NR^{E4}$, $-NR^{E4}-$, -O-, -S-, - C(=O)O- ou $-C(=O)NR^{E4}-$ ; et
- $R^{E4}$ est choisi, le même ou différent à chaque occurrence, parmi H, D, F, CN, $Si(R^{E5})_3$, $N(R^{E5})_2$, des groupes alkyle ou alcoxy à chaîne droite ayant de 1 à 20 atomes de carbone, des groupes alkyle ou alcoxy ramifiés ou cycliques ayant de 3 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle et alcoxy mentionnés, les systèmes cycliques aromatiques mentionnés et les systèmes cycliques hétéroaromatiques mentionnés étant substitués chacun par des radicaux $R^{E5}$ ; et dans les groupes alkyle ou alcoxy mentionnés un ou plusieurs groupes $CH_2$ pouvant être remplacés par -C=C-, $-R^{E5}C=CR^{E5}-$, $Si(R^{E5})_2$, C=O, $C=NR^{E5}$, $-NR^{E5}-$, -O-, -S-, -C(=O)O- ou $-C(=O)NR^{E5}-$.

**5.** Dispositif électronique selon une ou plusieurs des revendications 1 à 4, **caractérisé en ce qu'**au moins un radical $R^{E3}$ dans la formule (EM-1) est choisi parmi des groupes alkyle ayant de 1 à 10 atomes de carbone, qui sont substitués par des radicaux $R^{E4}$, et $N(R^{E4})_2$.

**6.** Dispositif électronique selon une ou plusieurs des revendications 1 à 5, **caractérisé en ce que** l'un des indices o et p est égal à 1, et l'autre des indices o et p est égal à 0.

**7.** Dispositif électronique selon une ou plusieurs des revendications 1 à 6, **caractérisé en ce que** le composé de formule (EM-1) correspond à une formule choisie parmi les formules (EM-1-1-1-1-1) et (EM-1-1-1-1-2)

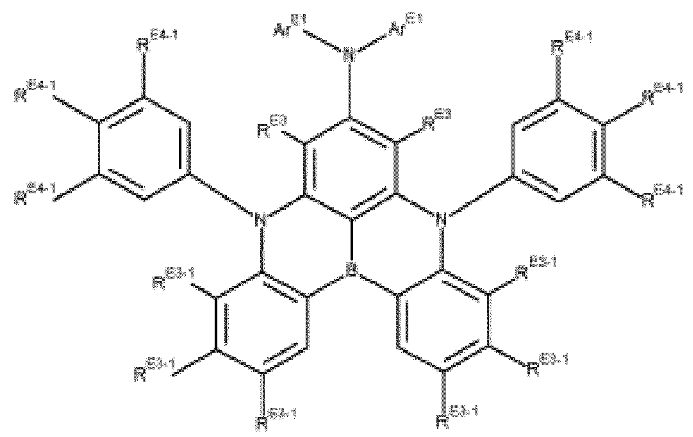

Formule (EM-1-1-1-1-1)

(suite)

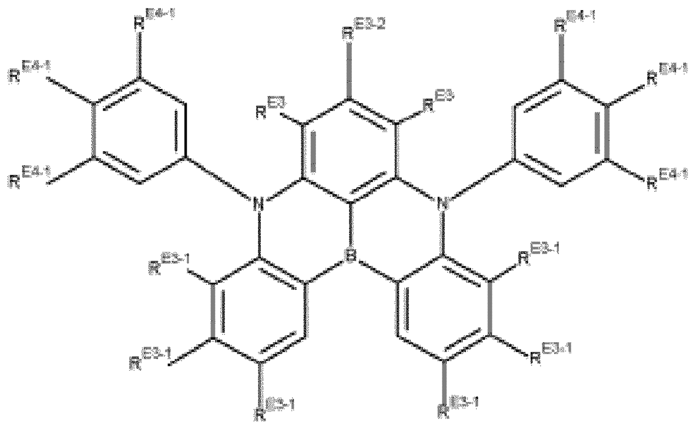

Formule (EM-1-1-1-1-2),

dans lesquelles $R^{E3-1}$ est défini comme $R^{E3}$ ; et $R^{E3-2}$ est choisi parmi des groupes alkyle ayant de 1 à 10 atomes de carbone, qui sont substitués par des radicaux $R^{E4}$, de préférence les groupes méthyle, éthyle, isopropyle et tert-butyle, de façon particulièrement préférée méthyle ; et $R^{E4-1}$ est défini comme $R^{E4}$.

8. Dispositif électronique selon une ou plusieurs des revendications 1 à 7, **caractérisé en ce que** Z est égal à $CR^1$, lorsqu'aucun groupe

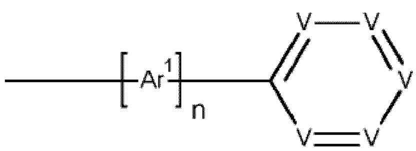

n'y est lié.

9. Dispositif électronique selon une ou plusieurs des revendications 1 à 8, **caractérisé en ce que** les groupes

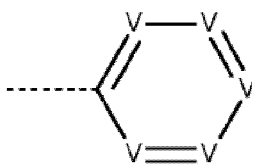

sont choisis parmi les groupes suivants

| | |
|---|---|
| 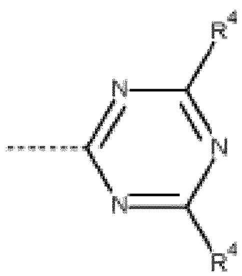 | 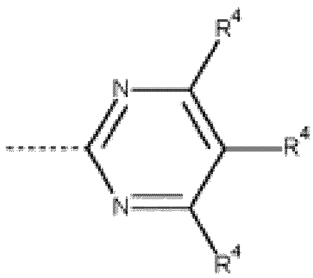 |
| Formule (H-1) | Formule (H-2) |

(suite)

| | |
|---|---|
| 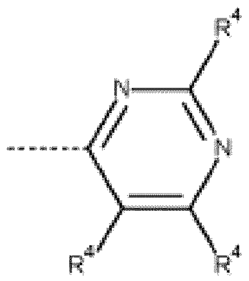 | 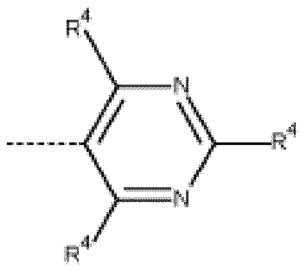 |
| Formule (H-3) | Formule (H-4), |

dans lesquels la ligne en tireté représente la liaison au reste de la formule.

**10.** Dispositif électronique selon une ou plusieurs des revendications 1 à 9, **caractérisé en ce que** $Ar^1$ est choisi, le même ou différent à chaque occurrence, parmi des groupes divalents dérivés de benzène, biphényle, terphényle, naphtalène, fluorène, indénofluorène, indénocarbazole, spirobifluorène, dibenzofurane, dibenzothiophène et carbazole, qui peuvent être substitués chacun par un ou plusieurs radicaux $R^3$.

**11.** Dispositif électronique selon une ou plusieurs des revendications 1 à 10, **caractérisé en ce que**

- $R^1$ est choisi, le même ou différent à chaque occurrence, parmi H, F, des systèmes cycliques aromatiques ayant de 6 à 40 atomes formant le cycle aromatique, et des systèmes cycliques hétéroaromatiques ayant de 5 à 40 atomes formant le cycle aromatique ; les systèmes cycliques aromatiques et les systèmes cycliques hétéroaromatiques étant substitués chacun par des radicaux $R^5$; et
- $R^2$ est choisi, le même ou différent à chaque occurrence, parmi des groupes alkyle à chaîne droite ayant de 1 à 20 atomes de carbone, des groupes alkyle ramifiés ayant de 3 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle mentionnés, les systèmes cycliques aromatiques mentionnés et les systèmes cycliques hétéroaromatiques mentionnés étant substitués chacun par des radicaux $R^5$; et
- $R^3$ est choisi, le même ou différent à chaque occurrence, parmi H, D, F, CN, $Si(R^5)_3$, des groupes alkyle ou alcoxy à chaîne droite ayant de 1 à 20 atomes de carbone, des groupes alkyle ou alcoxy ramifiés ou cycliques ayant de 3 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle et alcoxy mentionnés, les systèmes cycliques aromatiques mentionnés et les systèmes cycliques hétéroaromatiques mentionnés étant substitués chacun par des radicaux $R^5$ ; et dans les groupes alkyle ou alcoxy mentionnés un ou plusieurs groupes $CH_2$ pouvant être remplacés par -C=C-, $-R^5C=CR^5-$, $Si(R^5)_2$, C=O, $C=NR^5$, $-NR^5-$, -O-, -S-, -C(=O)O- ou $-C(=O)NR^5-$ ; et
- $R^4$ est choisi, le même ou différent à chaque occurrence, parmi H et des systèmes cycliques aromatiques ayant de 6 à 40 atomes formant le cycle aromatique, qui sont substitués par des radicaux $R^5$ ; et
- $R^5$ est choisi, le même ou différent à chaque occurrence, parmi H, D, F, CN, $Si(R^6)_3$, des groupes alkyle ou alcoxy à chaîne droite ayant de 1 à 20 atomes de carbone, des groupes alkyle ou alcoxy ramifiés ou cycliques ayant de 3 à 20 atomes de carbone, des systèmes cycliques aromatiques ayant de 6 à 40 atomes formant le cycle aromatique, et des systèmes cycliques hétéroaromatiques ayant de 5 à 40 atomes formant le cycle aromatique ; les groupes alkyle et alcoxy mentionnés, les systèmes cycliques aromatiques mentionnés et les systèmes cycliques hétéroaromatiques mentionnés étant substitués chacun par des radicaux $R^6$ ; et dans les groupes alkyle ou alcoxy mentionnés un ou plusieurs groupes $CH_2$ pouvant être remplacés par -C=C-, $-R^6C=CR^6-$, $Si(R^6)_2$, C=O, $C=NR^6$, $-NR^6-$, -O-, -S-, -C(=O)O- ou $-C(=O)NR^6-$.

**12.** Dispositif électronique selon une ou plusieurs des revendications 1 à 11, **caractérisé en ce que** le composé de formule (E-1) correspond à une formule choisie parmi les formules suivantes :

| |
|---|
| 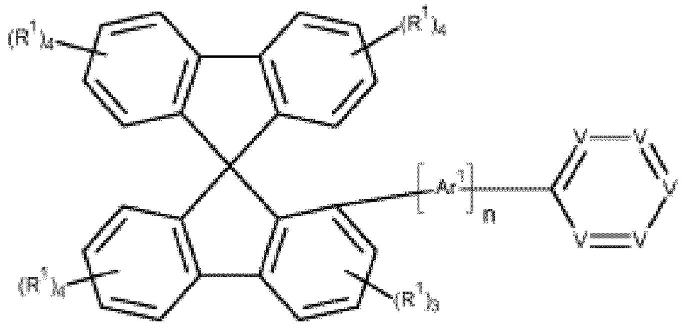 |
| Formule (E-1-1-1) |
| 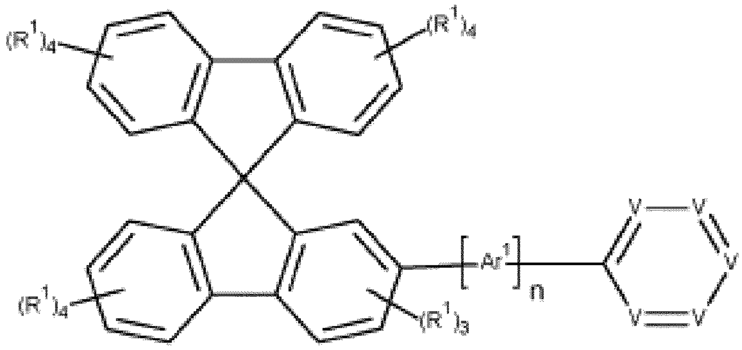 |
| Formule (E-1-1-2) |
| 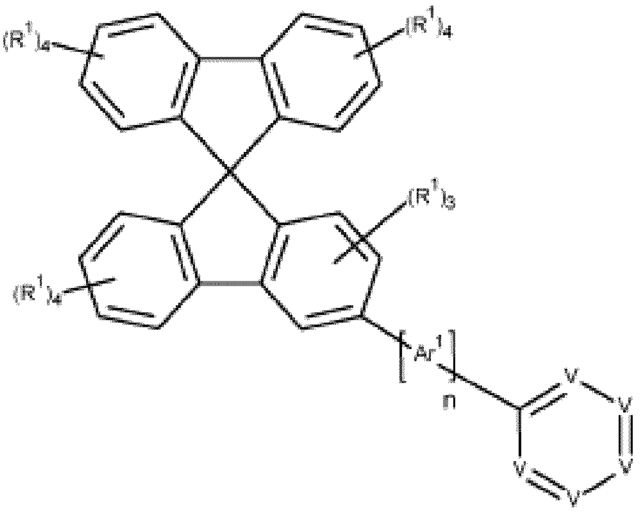 |
| Formule (E-1-1-3) |

(suite)

| |
|---|
| 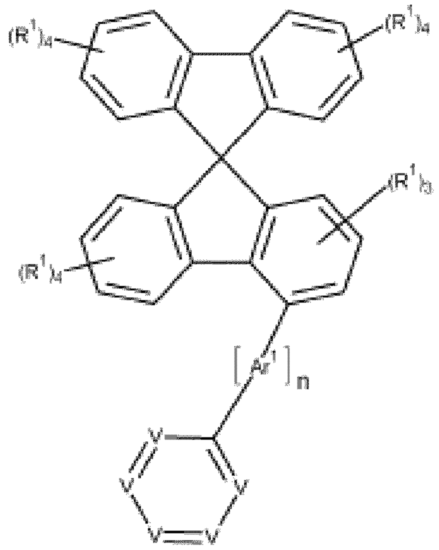 |
| Formule (E-1-1-4) |
| 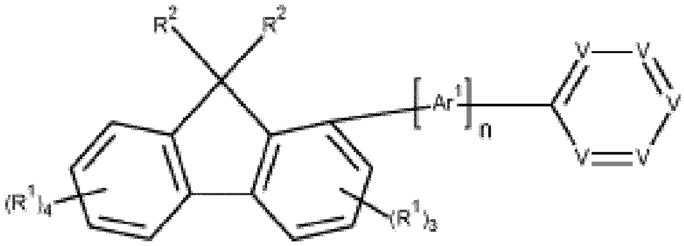 |
| Formule (E-1-2-1) |
| 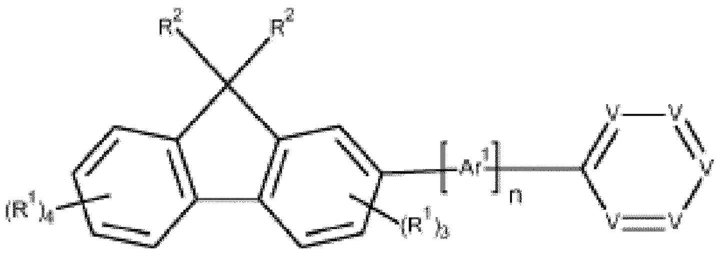 |
| Formule (E-1-2-2) |
| 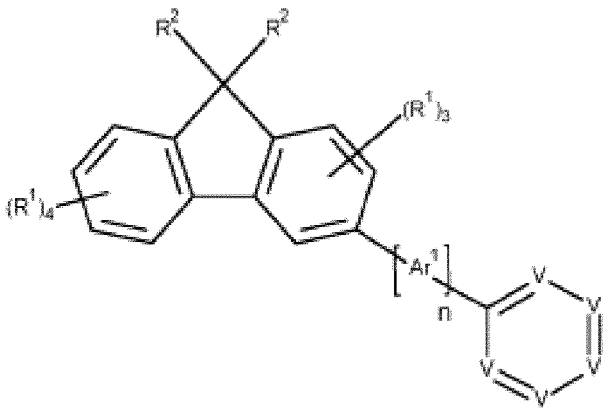 |
| Formule (E-1-2-3) |

(suite)

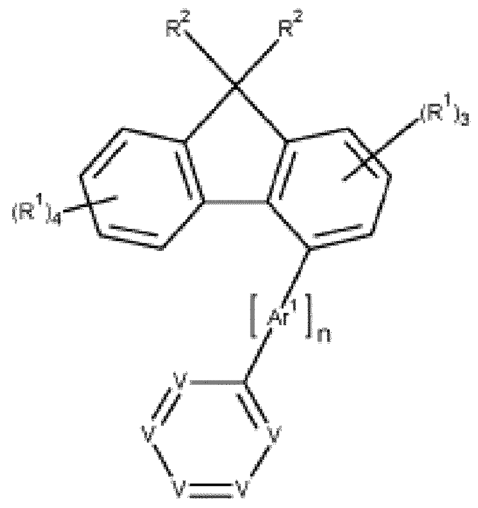

Formule (E-1-2-4).

**13.** Dispositif électronique selon une ou plusieurs des revendications 1 à 12, **caractérisé en ce qu'**il est un dispositif d'électroluminescence organique, **en ce que** la première électrode est une anode, **en ce que** la seconde électrode est une cathode, et **en ce que** la couche E est une couche de transport d'électrons.

**14.** Dispositif électronique selon une ou plusieurs des revendications 1 à 13, **caractérisé en ce que** la couche E contient un mélange d'un sel de métal alcalin et d'un autre composé.

**15.** Dispositif électronique selon une ou plusieurs des revendications 1 à 14, **caractérisé en ce qu'**il contient les couches suivantes entre anode et cathode :

- entre anode et couche émettrice au moins une couche transporteuse de trous ;
- entre couche transporteuse de trous et cathode la couche émettrice ; et
- entre couche émettrice et cathode la couche E en tant que couche de transport d'électrons.

**16.** Dispositif électronique selon une ou plusieurs des revendications 1 à 15, **caractérisé en ce que** la couche émettrice du dispositif contient en plus du composé de formule (EM-1) un ou plusieurs autres composés qui sont choisis parmi des dérivés d'anthracène et des dérivés de benzanthracène.

**17.** Dispositif électronique selon une ou plusieurs des revendications 1 à 16, **caractérisé en ce qu'**il contient deux ou trois successions de couches identiques ou différentes, empilées l'une sur l'autre/les unes sur les autres, chacune des successions de couches comprenant chaque fois les couches suivantes : couche d'injection de trous, couche de transport de trous, couche de blocage d'électrons, couche émettrice, et couche de transport d'électrons, et au moins l'une des successions de couches contenant

- une couche émettrice, contenant un composé de formule (EM-1) et
- une couche E, de préférence en tant que couche de transport d'électrons.

**18.** Dispositif électronique selon une ou plusieurs des revendications 1 à 17, **caractérisé en ce qu'**il émet de la lumière à travers la cathode.

**19.** Procédé pour la production d'un dispositif électronique selon une ou plusieurs des revendications 1 à 18, **caractérisé en ce qu'**il comprend les étapes suivantes : en premier lieu la fourniture d'un substrat avec anode, dans une étape suivante ultérieure l'application de la couche émettrice contenant le composé de formule (EM-1), dans une étape y faisant suite l'application de la couche E, et dans une étape y faisant suite l'application de l'anode.

**20.** Utilisation d'un dispositif électronique selon une ou plusieurs des revendications 1 à 18 dans des afficheurs, en tant que source de lumière dans des applications d'éclairage, ou en tant que source de lumière dans des applications

médicales et/ou cosmétiques.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2018069167 A1
- WO 2018095394 A1
- US 20070092755 A


### In der Beschreibung aufgeführte Nicht-Patentliteratur


- **Y. SHIROTA et al.** *Chem. Rev.,* 2007, vol. 107 (4), 953-1010
- **B. M. S. ARNOLD et al.** *Appl. Phys. Lett.,* 2008, vol. 92, 053301